# EUROPEAN PATENT SPECIFICATION

(11) **EP 3 174 121 B1**
(45) Date of publication and mention of the grant of the patent: **17.11.2021**
(21) Application number: 16200995.5
(22) Date of filing: 28.11.2016
(51) Int. Cl.: H01L 51/52, H01L 51/54, H01L 27/32

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 30.11.2015 KR 20150169276
(43) Date of publication of application: 31.05.2017
(73) Proprietor: Samsung Display Co., Ltd., Gyeonggi-do (KR)
(72) Inventor: YOO, Byeongwook, Gyeonggi-do (KR); KWON, Jiyoung, Gyeonggi-do (KR); SONG, Yoonmo, Gyeonggi-do (KR); YOO, Jihwan, Gyeonggi-do (KR); PYO, Sangwoo, Gyeonggi-do (KR)
(74) Representative: Russell, Tim

(56) References cited:
- US-A1- 2011 057 182
- US-A1- 2011 227 036
- US-A1- 2012 286 246
- US-A1- 2012 286 249
- US-A1- 2013 001 532
- US-A1- 2014 284 566

## Description

### FIELD OF THE INVENTION

The present invention relates to an organic light-emitting device.

### BACKGROUND OF THE INVENTION

Organic light-emitting devices are self-emission devices that may have wide viewing angles, high contrast ratios, short response times, and/or excellent brightness, driving voltage, and/or response speed characteristics, and may produce full-color images.

An organic light-emitting device may comprise a first electrode on a substrate, and a hole transport region, an emission layer, an electron transport region, and a second electrode sequentially positioned on the first electrode. Holes provided from the first electrode may move toward the emission layer through the hole transport region, and electrons provided from the second electrode may move toward the emission layer through the electron transport region. Carriers (such as holes and electrons) may recombine in the emission layer to produce excitons. These excitons may transition (e.g., radiatively decay) from an excited state to a ground state to thereby generate light.

US2013001532 discloses an OLED display having three sub-pixels, wherein the first and the second sub-pixel comprises an auxiliary layer between the hole transport layer and the emission layer.

### SUMMARY OF THE INVENTION

The present invention provides an organic light-emitting device having low driving voltage, high efficiency, and long lifespan.

Accordingly the present invention provides an organic light-emitting device comprising:
a substrate comprising a first sub-pixel, a second sub-pixel, and a thrd sub-pixel;
   a first set of electrodes comprising an electrode on the first sub-pixel of the substrate, an electrode on the second sub-pixel of the substrate, and an electrode on the third sub-pixel of the substrate of the substrate;
   a second electrode facing the first set of electrodes;
an emission layer between the first set of electrodes and the second electrode, the emission layer comprising: i) a first emission layer positioned between the electrode on the first sub-pixel and the second electrode configured to emit a first color light, ii) a second emission layer positioned between the electrode on the second sub-pixel and the second electrode configured to emit a second color light, and iii) a third emission layer positioned between the electrode on the third sub-pixel and the second electrode configured to emit a third color light;
a hole transport region between the first set of electrodes and the emission layer; and
   at least one selected from a first auxiliary layer and a second auxiliary layer, the first auxiliary layer being between the hole transport region and the first emission layer, and the second auxiliary layer being between the hole transport region and the second emission layer,
the first color light being red color light, the second color light being green color light, and/or the third color light being blue color light, and
at least one selected from the first auxiliary layer and the second auxiliary layer comprising a first compound represented by Formula 1: 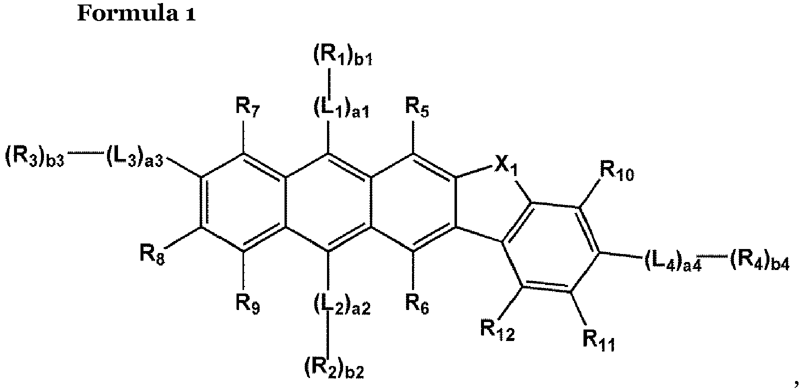
wherein, in Formula 1,
X₁ is selected from C(R₂₁)(R₂₂), Si(R₂₁)(R₂₂), N(R₂₁), O, S, S(=O), and S(=O)2, L₁ to L₄ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group,
a1 to a4 are each independently selected from 0, 1, 2, and 3, and when a1 is 2 or more, 2 or more L₁(s) are identical to or different from each other, when a2 is 2 or more, 2 or more L₂(s) are identical to or different from each other, when a3 is 2 or more, 2 or more L₃(s) are identical to or different from each other, and when a4 is 2 or more, 2 or more L₄(s) are identical to or different from each other,
R₁ to R₁₂, R₂₁, and R₂₂ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, a substituted or unsubstituted monovalent non-aromatic condensed 8- to 60-membered heteropolycyclic group, -Si(Q₁)(Q₂)(Q₃),-N(Q₁)(Q₂), -B(Q₁)(Q₂), -C(=O)(Q₁), -S(=O)₂(Q₁), and -P(=O)(Q₁)(Q₂), wherein a first group selected from R₁ to R₁₂ may optionally be linked to a second group selected from R1 to R12 to form a substituted or unsubstituted C₅-C₆₀ carbocyclic or a substituted or unsubstituted C₁-C₆₀ heterocyclic group, provided that the first group is adjacent to the second group in Formula 1, and provided that the first group or the second group is not R₁ R₂ R₃ or R₄ when a1 a2 a3 or a4 is greater than zero, respectively; and wherein when R₂₁ and R₂₂ are both present they may optionally be linked to form a substituted or unsubstituted C₅-C₆₀ carbocyclic or a substituted or unsubstituted C₁-C₆₀ heterocyclic group,
at least one selected from R₁ to R₄ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, and a substituted or unsubstituted monovalent non-aromatic condensed 8- to 60-membered heteropolycyclic group,
bi to b4 are each independently selected from 1, 2, and 3, and when b1 is 2 or more, 2 or more R₁(s) are identical to or different from each other, when b2 is 2 or more, 2 or more R₂(s) are identical to or different from each other, when b3 is 2 or more, 2 or more R₃(s) are identical to or different from each other, and when b4 is 2 or more, 2 or more R₄(s) are identical to or different from each other, and
the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8 to 60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8 to 60 polycyclic group, and the substituted monovalent non-aromatic condensed 8- to 60-membered heteropolycyclic group, the substituted C₅-C₆₀ carbocyclic group, and the substituted C₁-C₆₀ heterocyclic group is substituted with at least one substituent selected from the group consisting of:
   deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, a monovalent non-aromatic condensed 8- to 60-membered heteropolycyclic group, -Si(Q₁₁)(Q₁₂)(Q₁₃), -N(Q₁₁)(Q₁₂),-B(Q₁₁)(Q₁₂), -C(=O)(Q₁₁), -S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, and a monovalent non-aromatic condensed 8- to 60-membered heteropolycyclic group;
      a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁),-S(=O)₂(Q₂₁), and -P(=O)(Q₂₁)(Q₂₂); and
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P( =O)(Q₃₁)(Q₃₂),
   wherein Q₁ to Q₃, Qn to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a biphenyl group, a terphenyl group, a C₁-C₆₀ heteroaryl group, a monovalent non-aromatic condensed C8 to 60 polycyclic group, and a monovalent non-aromatic condensed 8- to 60-membered heteropolycyclic group.

Compounds falling under formula 1 are disclosed in US2012286249, US2011057182 and US2012286246.

### BRIEF DESCRIPTION OF THE DRAWING

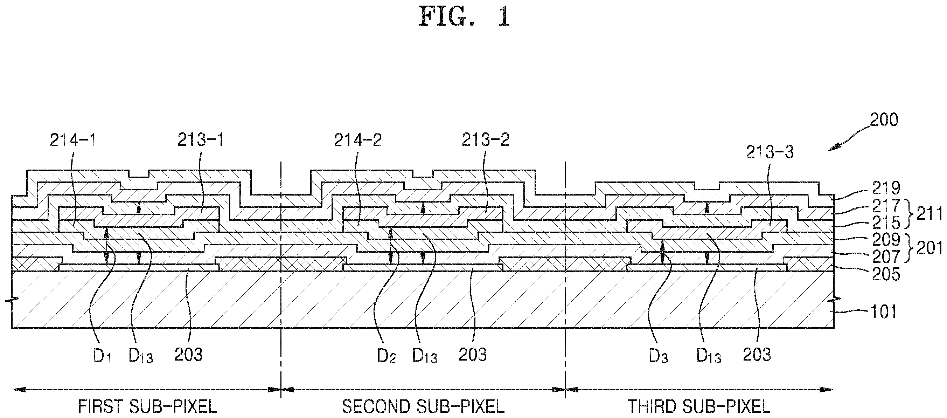

Figure 1 is a schematic cross-sectional diagram illustrating the structure of an organic light-emitting device according to an embodiment of the present disclosure.

### DETAILED DESCRIPTION OF THE INVENTION

As used herein, the term "and/or" includes any and all combinations of one or more of the associated listed items. Expressions such as "at least one of', "one of', and " selected from", when preceding a list of elements, modify the entire list of elements and do not modify the individual elements of the list.

In the drawing, the thicknesses of layers, films, panels, regions, etc., may be exaggerated for clarity. It will be understood that when an element such as a layer, film, region, or substrate is referred to as being "on" another element, it can be directly on the other element or intervening element(s) may also be present. In contrast, when an element is referred to as being "directly on" another element, no intervening elements are present.

The drawing is a schematic cross-sectional view illustrating the structure of an organic light-emitting device according to an embodiment of the present disclosure. Hereinafter, the structure of an organic light-emitting device according to an embodiment of the present disclosure and a method of manufacturing an organic light-emitting device according to an embodiment of the present disclosure will be described in connection with the drawing.

The organic light-emitting device 200 of the drawing comprises a substrate 101 comprising a first sub-pixel, a second sub-pixel, and a third sub-pixel.

In the organic light-emitting device 200, a first set of electrodes 203 (that is, a plurality of first electrodes 203) comprised an electrode on the first sub-pixel, an electrode on the second sub-pixel, and an electrode on the third sub-pixel, and the first set of electrodes 203 may be separated from each other by a pixel defining layer 205. A hole transport region 201, which is a common layer to the first sub-pixel, the second sub-pixel, and the third sub-pixel, may be on the first set of electrodes 203. The hole transport region 201 may comprise a hole injection layer 207 and a hole transport layer 209.

An emission layer comprising a first emission layer 213-1, a second emission layer 213-2, and a third emission layer 213-3 may be on the hole transport region 201. The first emission layer 213-1, which may emit a first color light, may be patterned in the first sub-pixel; the second emission layer 213-2, which may emit a second color light, may be patterned in the second sub-pixel; and the third emission layer 213-3, which may emit a third color light, may be patterned in the third sub-pixel.

A first auxiliary layer 214-1 that is patterned exclusively in the first sub-pixel may be between the first emission layer 213-1 and the hole transport region 201, and a second auxiliary layer 214-2 that is patterned exclusively in the second sub-pixel may be between the second emission layer 213-2 and the hole transport region 201.

An electron transport region 211, which is a common layer to the first sub-pixel, the second sub-pixel, and the third sub-pixel, may be on the emission layer. The electron transport region 211 may comprise an electron transport layer 215 and an electron injection layer 217. A second electrode 219 may be on the electron transport region 211.

In the drawing of the organic light-emitting device 200, D₁ refers to the distance between the electrode 203 on the first sub-pixel and the first emission layer 213-1, D₂ refers to the distance between the electrode 203 on the second sub-pixel and the second emission layer 213-2, D₃ refers to the distance between the electrode 203 on the third sub-pixel and the third emission layer 213-3, and D₁₃ refer to a distance between the electrode 203 on the third sub-pixel and the second electrode 219

The term "common layer" as used herein refers to a layer that is patterned on all of the first sub-pixel, the second sub-pixel, and the third sub-pixel at once (e.g., at the same time), instead of being separately patterned according to the first sub-pixel, the second sub-pixel, and the third sub-pixel.

The first color light, the second color light, and the third color light may be red color light, green color light, and blue color light, respectively. Accordingly, the organic light-emitting device 200 may implement full-color light emission. However, the first color light, the second color light, and the third color light are not limited to the above combination as long as the first color light, the second color light, and the third color light may be mixed to form white color light.

For use as the substrate 101, any suitable substrate that is available for organic light-emitting devices in the related art may be used, and the substrate 101 may be a glass substrate or a transparent plastic substrate, each having excellent mechanical strength, thermal stability, transparency, surface smoothness, ease of handling, and/or water resistance.

A first set of electrodes 203 is on the substrate 101, wherein one of each of the first set of electrodes 203 is on the first sub-pixel, the second sub-pixel, and the third sub-pixel. The first set of electrodes 203 may be a set of reflective electrodes, a set of transmissive electrodes, or a set of semi-transmissive electrodes.

The first set of electrodes 203 may be formed by depositing and/or sputtering a material for forming the first set of electrodes 203 on the substrate 101. When the first set of electrodes 203 is an anode, the material for forming the first set of electrodes 203 may be selected from materials having a high work function in order to facilitate hole injection to each of the first emission layer 213-1, the second emission layer 213-2, and the third emission layer 213-3.

To form a reflective electrode, the first set of electrodes 203 may comprise at least one selected from magnesium (Mg), silver (Ag), aluminum (Al), aluminum-lithium (Al-Li), calcium (Ca), magnesium-indium (Mg-In), and magnesium-silver (Mg-Ag). The first set of electrodes 203 may also comprise, in addition to the metals as described above, a transparent and highly conductive material (such as indium tin oxide (ITO), indium zinc oxide (IZO), tin oxide (SnO₂), and/or zinc oxide (ZnO)).

The first set of electrodes 203 may have a single-layer structure, or a multi-layer structure comprising two or more layers. For example, the first set of electrodes 203 may have a three-layered structure of ITO/Ag/ITO, but embodiments of the structure of the first set of electrodes 203 are not limited thereto.

The pixel definition layer 205 may be adjacent to the edge parts of each of the first set of electrodes 203. The pixel definition layer 205 defines a pixel region and may comprise one or more suitable organic insulating materials (for example, a silicon-based material and/or the like), inorganic insulating materials, and/or organic/inorganic composite insulating materials.

The hole transport region 201 may be on the first set of electrodes 203.

The hole transport region 201 may have i) a single-layer structure including a single layer including a single material, ii) a single-layer structure including a single layer comprising a plurality of different materials, or iii) a multi-layer structure comprising a plurality of layers comprising a plurality of different materials.

The hole transport region 201 may comprise at least one layer selected from a hole injection layer (HIL), a hole transport layer(HTL), an emission auxiliary layer, and an electron blocking layer (EBL).

For example, the hole transport region 201 may have a single-layer structure including a single layer comprising a plurality of different materials, or may have a multi-layer structure having a structure of hole injection layer/hole transport layer, a structure of hole injection layer/hole transport layer/emission auxiliary layer, a structure of hole injection layer/emission auxiliary layer, a structure of hole transport layer/emission auxiliary layer, or a structure of hole injection layer/hole transport layer/electron blocking layer, wherein layers of each structure are sequentially stacked on the first set of electrodes 203 in these stated orders, but embodiments of the structure of the hole transport region 201 are not limited thereto.

The hole transport region 201 may comprise at least one selected from m-MTDATA, TDATA, 2-TNATA, NPB (also referred to as NPD), β-NPB, TPD, spiro-TPD, spiro-NPB, methylated NPB, TAPC, HMTPD, 4,4',4"-tris(*N*-carbazolyl)triphenylamine (TCTA), polyaniline/dodecylbenzenesulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201, and a compound represented by Formula 202:

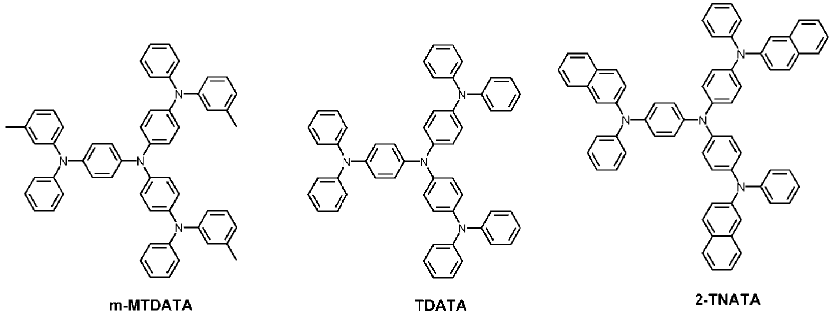

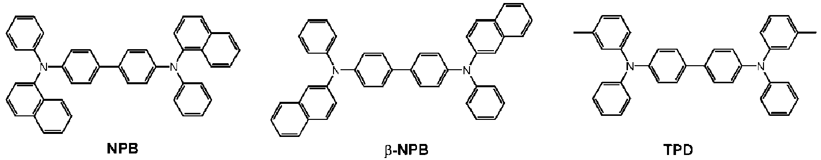

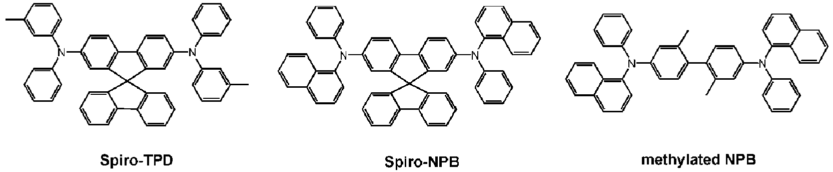

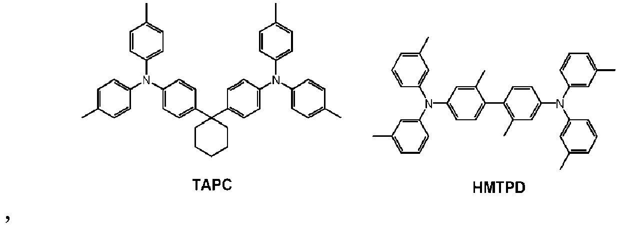

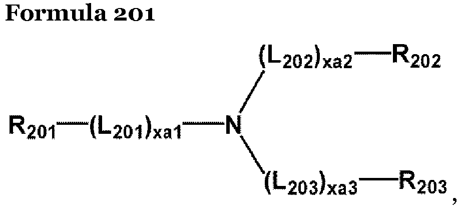

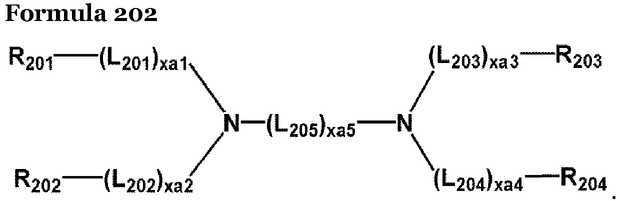

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group,
L₂₀₅ may be selected from ^{∗}-O-^{∗}', ^{∗}-S-^{∗}', ^{∗}-N(Q₂₀₁)-^{∗}', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, and a substituted or unsubstituted monovalent non-aromatic condensed 8- to 60-membered heteropolycyclic group.

For example, in Formula 202, R₂₀₁ and R₂₀₂ may be optionally linked through a single bond, a dimethyl-methylene group, or a diphenyl-methylene group, and R₂₀₃ and R₂₀₄ may be optionally linked through a single bond, a dimethyl-methylene group, or a diphenyl-methylene group.

In one embodiment, in Formulae 201 and 202,
L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, in Formula 202, xa1 to xa4 may each independently be selected from 0, 1, and 2.

In one or more embodiments, in Formula 202, xa5 may be selected from 1, 2, 3, and 4.

In one or more embodiments, in Formula 202, R₂₀₁ to R₂₀₄ and Q₂₀₁ may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be the same as described above.

In one or more embodiments, in Formula 201, at least one selected from R₂₀₁ to R₂₀₃ may be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments of the present disclosure are not limited thereto.

In one or more embodiments, in Formula 202, i) R₂₀₁ and R₂₀₂ may be linked through a single bond and/or ii) R₂₀₃ and R₂₀₄ may be linked through a single bond.

In one or more embodiments, in Formula 202, at least one selected from R₂₀₁ to R₂₀₄ may be selected from the group consisting of:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments of the present disclosure are not limited thereto.

The compound of Formula 201 may be represented by Formula 201A:

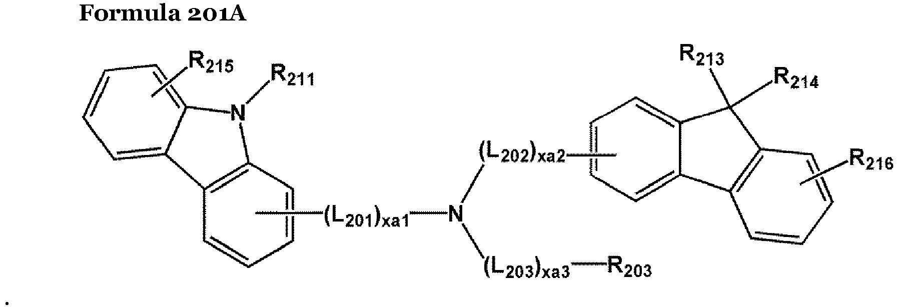

In some embodiments, the compound of Formula 201 may be represented by Formula 201A(1), but embodiments of the present disclosure are not limited thereto:

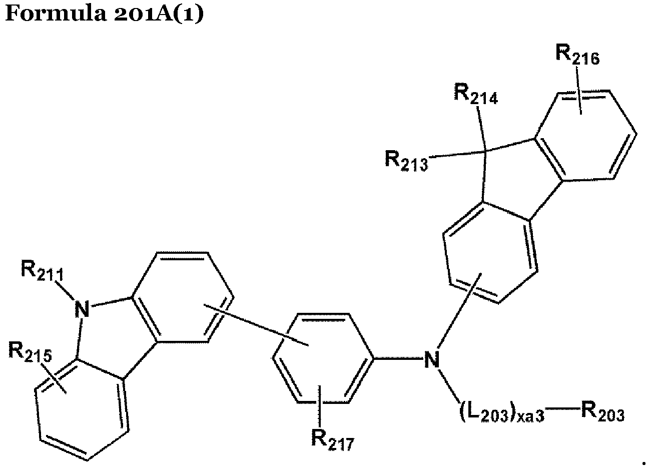

In some embodiments, the compound of Formula 201 may be represented by Formula 201A-1, but embodiments of the present disclosure are not limited thereto:

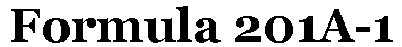

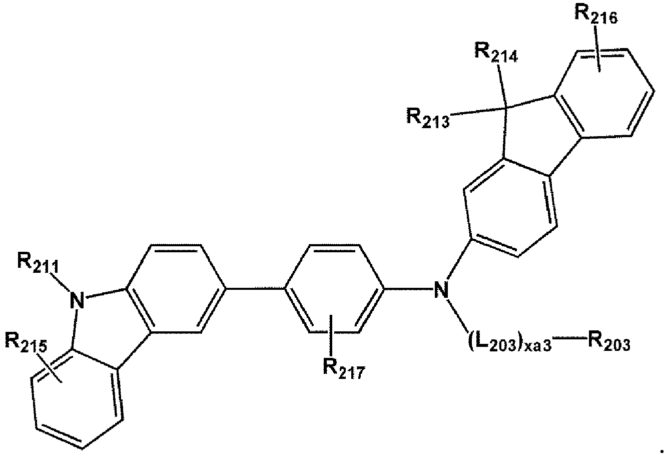

The compound of Formula 202 may be represented by Formula 202A:

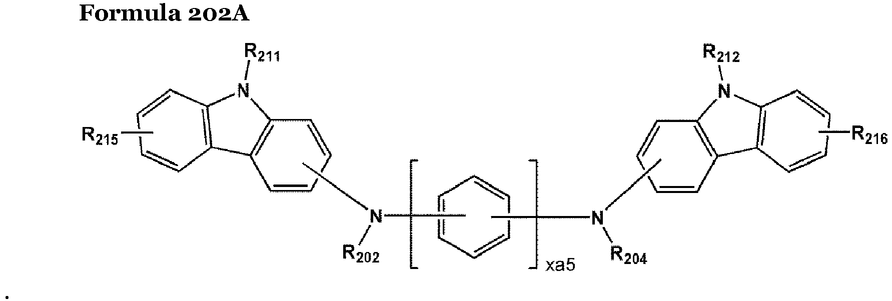

In some embodiments, compound of Formula 202 may be represented by Formula 202A-1:

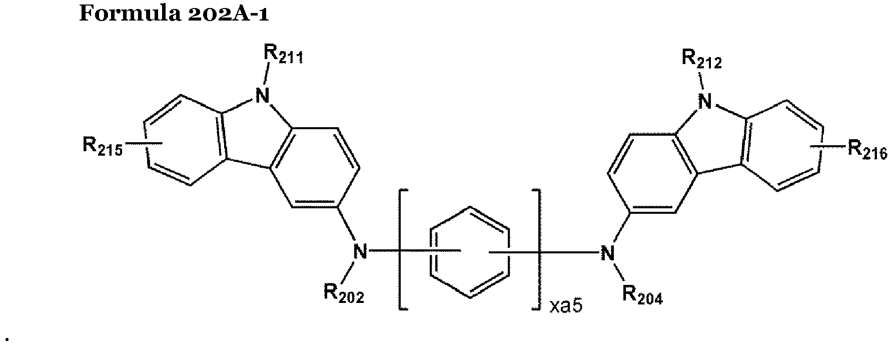

In Formulae 201A, 201A(1), 201A-1, 202A, and 202A-1,
L₂₀₁ to L₂₀₃, xa1 to xa3, xa5, and R₂₀₂ to R₂₀₄ may each independently be the same as described herein in connection with Formulae 201 and 202,
R₂₁, and R₂₁₂ may each independently be the same as described herein in connection with R₂₀₃,
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region 201 may comprise at least one compound selected from Compounds HT1 to HT₃₉, but embodiments of the present disclosure are not limited thereto:

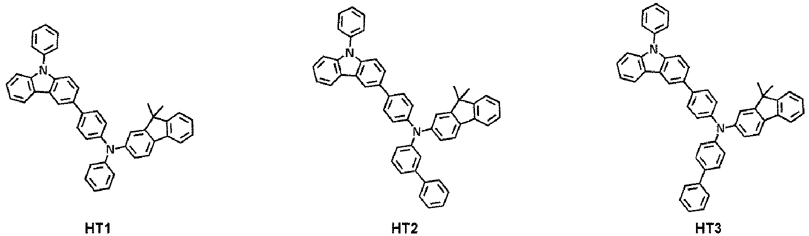

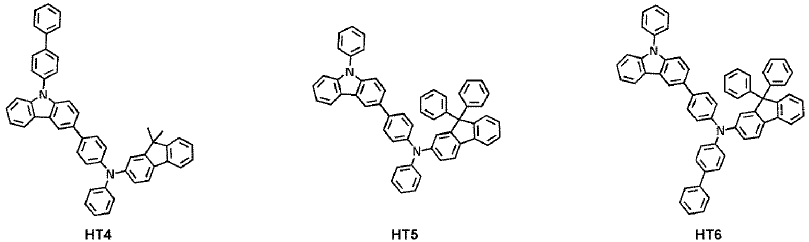

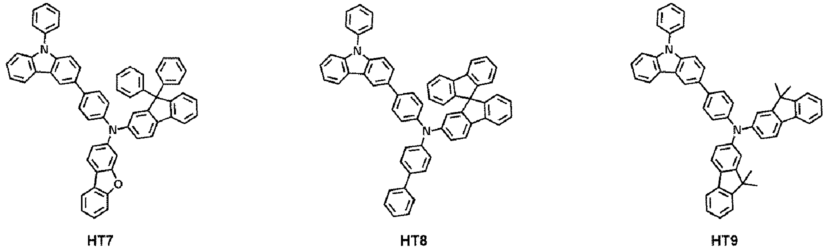

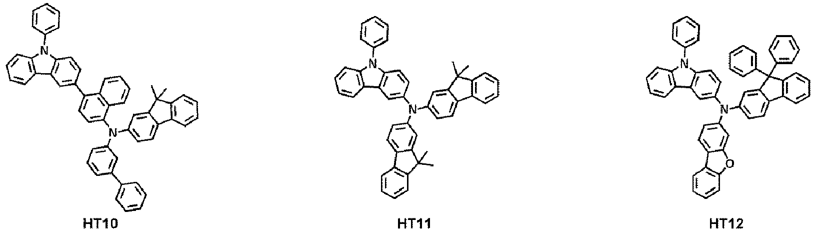

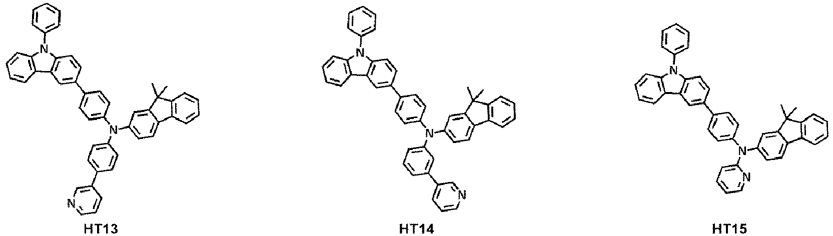

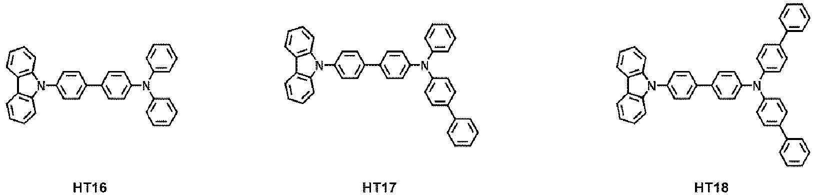

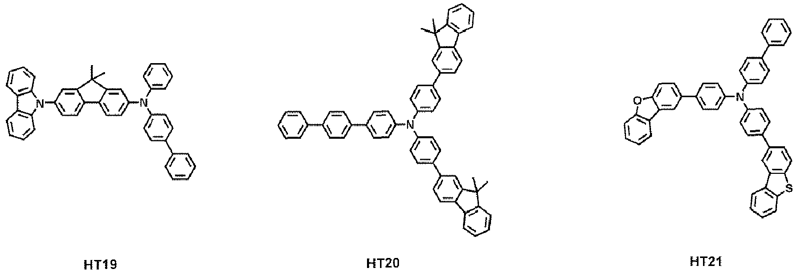

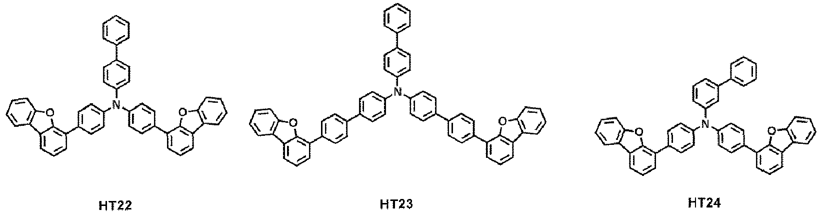

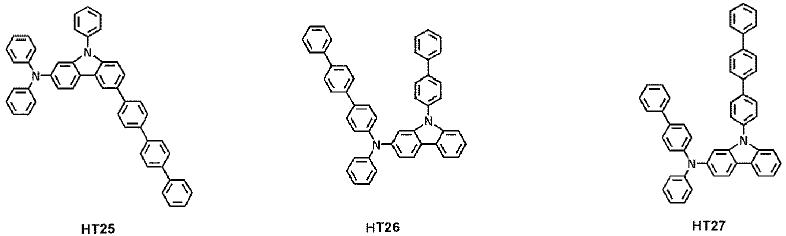

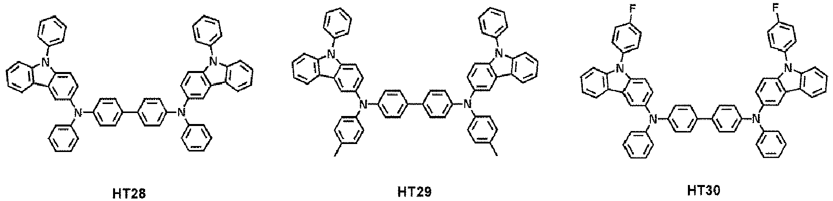

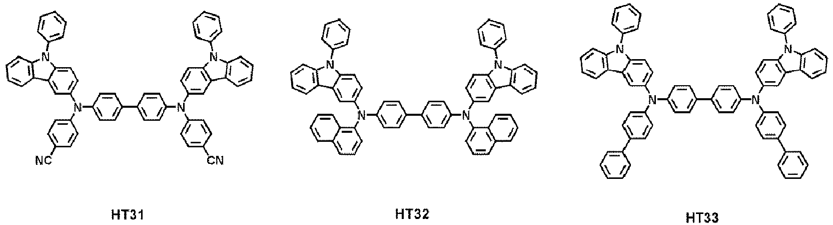

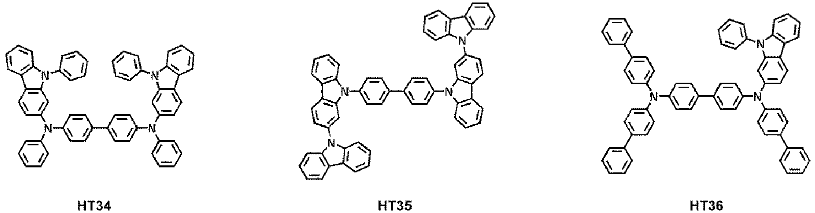

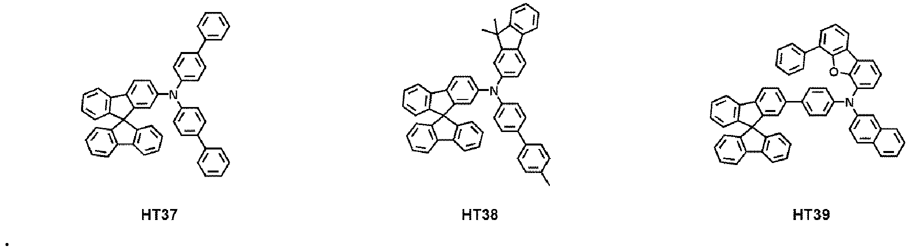

The electron blocking layer may prevent or reduce injection of electrons from the electron transport region 211. The electron blocking layer may comprise the materials as described above.

In one embodiment, the hole transport region 201 may comprise a second compound represented by Formula 201 or a compound represented by Formula 202, but embodiments of the present disclosure are not limited thereto.

The thickness of the hole transport region 201 may be about 100 Å to about 10,000 Å, and in some embodiments, about 100 Å to about 1,000 Å; the thickness of the hole injection layer 207 may be about 50 Å to about 8,000 Å, and in some embodiments, about 100 Å to about 1,000 Å; the thickness of hole transport layer 209 may be about 50 Å to about 2,000 Å, and in some embodiments, about 100 Å to about 1,500 Å. When the thicknesses of the hole transport region 201, the hole injection layer 207, and the hole transport layer 209 are within these ranges, satisfactory hole transport characteristics may be obtained without a substantial increase in driving voltage.

The hole transport region 201 may further comprise, in addition to the materials as described above, a charge-generation material for the improvement of conductive properties. The charge-generation material may be homogeneously or non-homogeneously dispersed in the hole transport region 201.

The charge-generation material may be, for example, a p-dopant.

In some embodiments, the p-dopant may have a lowest unoccupied molecular orbital (LUMO) energy level of -3.5 eV or less.

The p-dopant may comprise at least one selected from a quinone derivative, a metal oxide, and a cyano group-containing compound, but embodiments of the present disclosure are not limited thereto.

For example, the p-dopant may comprise at least one selected from the group consisting of:
a quinone derivative (such as tetracyanoquinodimethane (TCNQ) and/or 2,3,5,6-tetrafluoro-7,7,8,8-tetracyanoquinodimethane (F₄-TCNQ));
a metal oxide (such as a tungsten oxide and/or a molybdenum oxide);
1,4,5,8,9,11-hexaazatriphenylene-hexacarbonitrile (HAT-CN); and
a compound represented by Formula 221, but embodiments of the present disclosure are not limited thereto:

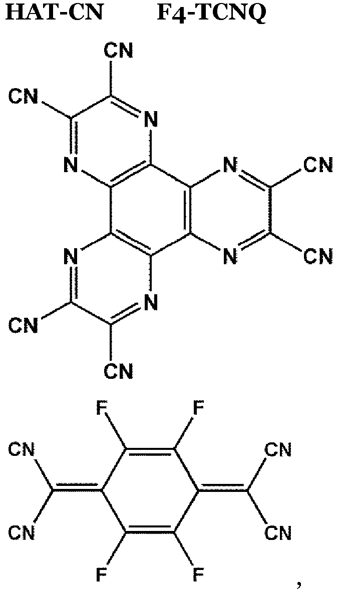

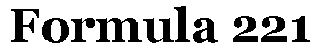

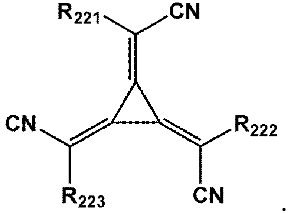

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C8 to 60 polycyclic group, and a substituted or unsubstituted monovalent non-aromatic condensed 8- to 60-membered heteropolycyclic group, wherein at least one selected from R₂₂₁ to R₂₂₃ may be a group substituted with at least one substituent selected from a cyano group, - F, -Cl, -Br, -I, a C₁-C₂₀ alkyl group substituted with -F, a C₁-C₂₀ alkyl group substituted with -Cl, a C₁-C₂₀ alkyl group substituted with ―Br, and a C₁-C₂₀ alkyl group substituted with -I.

The first auxiliary layer 214-1 and the first emission layer 213-1 may be positioned on a portion of the hole transport region corresponding to the first sub-pixel; the second auxiliary layer 214-2 and the second emission layer 213-2 may be positioned on a portion of the hole transport region corresponding to the second sub-pixel, and the third emission layer 213-3 may be positioned on a portion of the hole transport region corresponding to the third sub-pixel.

The first auxiliary layer 214-1, the second auxiliary layer 214-2, the first emission layer 213-1, the second emission layer 213-2, and the third emission layer 213-3 may each independently be formed using one or more suitable methods selected from vacuum deposition, spin coating, casting, a Langmuir-Blodgett (LB) method, ink-jet printing, laser-printing, and laser induced thermal imaging (LITI).

The first auxiliary layer 214-1 and the first emission layer 213-1 may be formed concurrently (e.g., at the same time) using a thermal imaging method, or the second auxiliary layer 214-2 and the second emission layer 213-2 may be formed concurrently (e.g., at the same time) using a thermal imaging method, but embodiments of the present disclosure are not limited thereto.

At least one of the first auxiliary layer 214-1 and the second auxiliary layer 214-2 comprise the first compound represented by Formula 1:

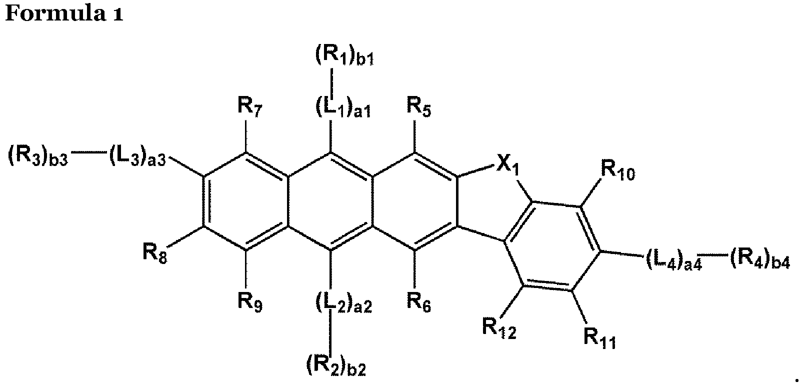

In Formula 1,
X₁ is selected from C(R₂₁)(R₂₂), Si(R₂₁)(R₂₂), N(R₂₁), O, S, S(=O), and S(=O)2, R₁ to R₄, b1 to b4, L₁ to L₄, a1 to a4, R₅ to R₁₂, R₂₁, and R₂₂ are as described above.

In one embodiment, in Formula 1, X₁ may be selected from C(R₂₁)(R₂₂) and Si(R₂₁)(R₂₂), but embodiments of the present disclosure are not limited thereto.

In one or more embodiments, R₂₁ and R₂₂ may be optionally linked through a single bond; or may be optionally linked through one selected from a C₁-C₅ alkylene group and a C₂-C₅ alkenylene group, each substituted with at least one selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In Formula 1, L₁ to L₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group.

For example, in Formula 1, L₁ to L₄ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a purinylene group, a carbazolylene group, a benzofuranylene group, a benzothiophenylene group, a dibenzofuranylene group, a dibenzothiophenylene group, a benzocarbazolylene group, a dibenzocarbazolylene group, a benzonaphthofuranylene group, a benzonaphthothiophenylene group, a dinaphthofuranylene group, and a dinaphthothiophenylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a purinylene group, a carbazolylene group, a benzofuranylene group, a benzothiophenylene group, a dibenzofuranylene group, a dibenzothiophenylene group, a benzocarbazolylene group, a dibenzocarbazolylene group, a benzonaphthofuranylene group, a benzonaphthothiophenylene group, a dinaphthofuranylene group, and a dinaphthothiophenylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a purinyl group, a carbazolyl group, a benzofuranyl group, a benzothiophenyl group, a dibenzofuranyl group, a dibenzothiophenyl group, a benzocarbazolyl group, a dibenzocarbazolyl group, and -Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one embodiment, in Formula 1, L₁ to L₄ may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, and a perylenylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, and a perylenylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenylene group, a chrysenyl group, and a perylenyl group.

In one or more embodiments, in Formula 1, L₁ to L₄ may each independently be selected from groups represented by Formulae 3-1 to 3-46:

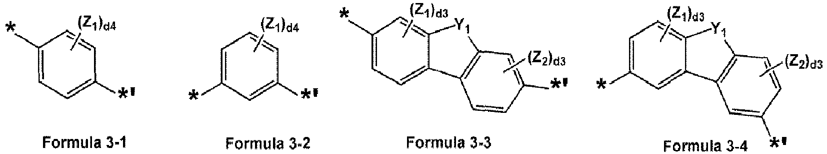

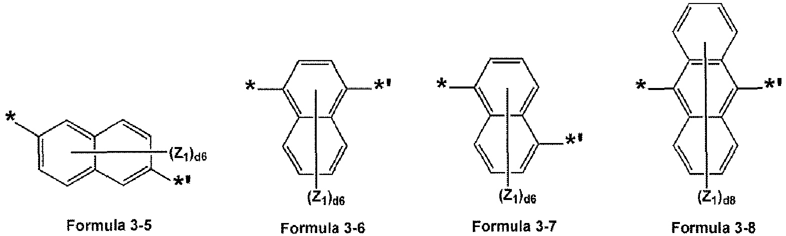

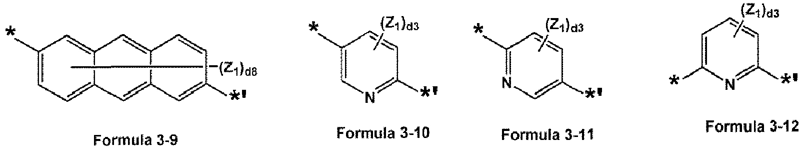

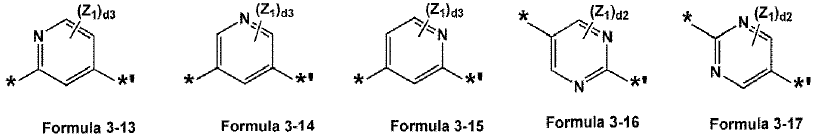

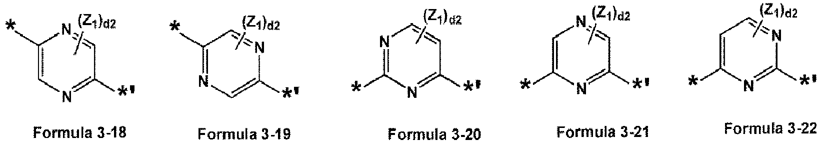

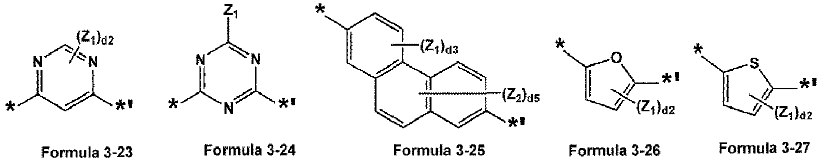

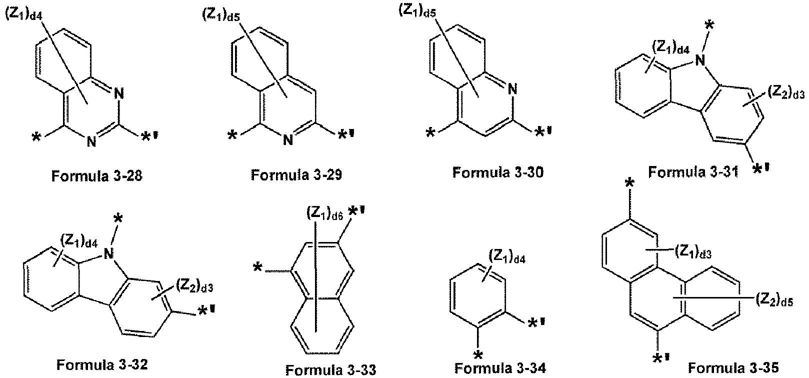

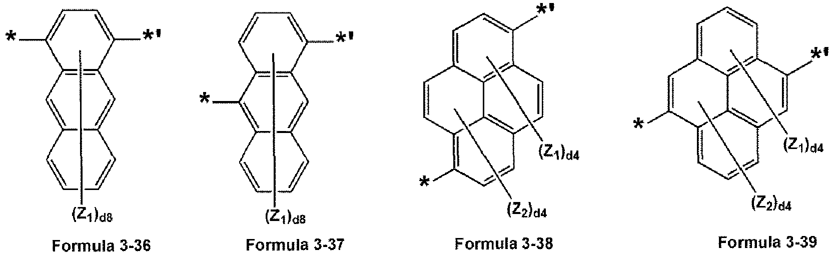

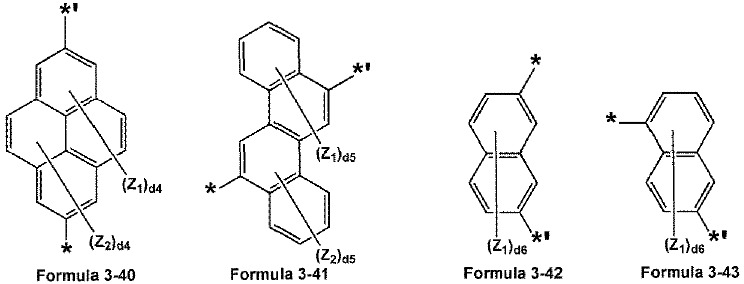

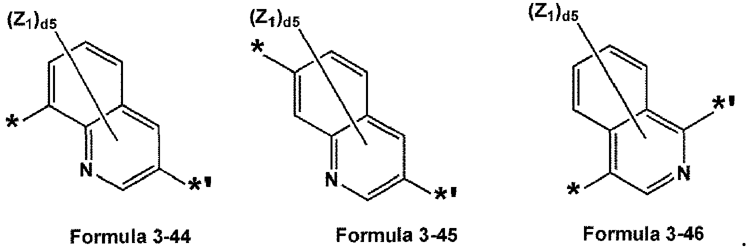

In Formulae 3-1 to 3-46,
Y₁ may be selected from O, S, C(Z₃)(Z₄), N(Z₅), and Si(Z₆)(Z₇),
Z₁ to Z₇ may each independently be selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a dibenzofuranyl group, a dibenzothiophenyl group, a triazinyl group, a benzimidazolyl group, a phenanthrolinyl group, and -Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group,
d2 may be an integer selected from 0 to 2,
d3 may be an integer selected from 0 to 3,
d4 may be an integer selected from 0 to 4,
d5 may be an integer selected from 0 to 5,
d6 may be an integer selected from 0 to 6,
d8 may be an integer selected from 0 to 8, and
^{∗} and ^{∗}' may each indicate a binding site to a neighboring atom.

In one or more embodiments, in Formula 1, L₁ to L₄ may each independently be selected from the groups represented by Formulae 3-1 to 3-9, Formulae 3-25 to 3-27, and Formulae 3-31 to 3-43,
wherein, in Formulae 3-1 to 3-9, Formulae 3-25 to 3-27, and Formulae 3-31 to 3-43, Z₁ to Z₇ may each independently be selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a carbazolyl group, a dibenzofuranyl group, and a dibenzothiophenyl group, but embodiments of the present disclosure are not limited thereto.

In Formula 1, a1 indicates the number of L₁(s), and may be selected from 0, 1, 2, and 3. When a1 is 0, ^{∗}-(L₁)ₐ₁-^{∗}' is a single bond, and when a1 is 2 or more, 2 or more L₁(s) may be identical to or different from each other. a2 to a4 may each independently be the same as described herein in connection with the structure of Formula 1 and with ai.

In one embodiment, in Formula 1, a1 to a4 may each independently be selected from 0, 1, and 2.

In one or more embodiments, in Formula 1, a1 to a4 may each independently be selected from 0 and 1, but embodiments of the present disclosure are not limited thereto.

In one or more embodiments, in Formula 1, R₁to R₁₂, R₂₁, and R₂₂ may each independently be selected from the group consisting of:
hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), wherein Q₁ to Q₃ may each independently be the same as described above, and
at least two selected from R₁ to R₁₂ may be optionally linked to form a saturated or unsaturated ring, wherein at least one selected from R₁ to R₄ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, and a substituted or unsubstituted monovalent non-aromatic condensed 8- to 60-membered heteropolycyclic group.

In one or more embodiments, in Formula 1, R₁ to R₄, R₂₁, and R₂₂ may each independently be selected from the group consisting of:
hydrogen, deuterium, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a biphenyl group, and a terphenyl group;
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, a thiadiazolyl group, an imidazopyridinyl group, and an imidazopyrimidinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, a thiadiazolyl group, an imidazopyridinyl group, and an imidazopyrimidinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a benzonaphthofuranyl group, a benzonaphthothiophenyl group, a dinaphthofuranyl group, a dinaphthothiophenyl group, a thiadiazolyl group, an imidazopyridinyl group, an imidazopyrimidinyl group, and -Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, in Formula 1, R₁ to R₄, R₂₁, and R₂₂ may each independently be selected from the group consisting of:
hydrogen, deuterium, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a biphenyl group, and a terphenyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, and -Si(Q₃₁)(Q₃₂)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, in Formula 1, R₁ to R₄ may each independently be selected from hydrogen, deuterium, a C₁-C₂₀ alkyl group, and a group represented by any of Formulae 5-1 to 5-46, wherein at least one selected from R₁ to R₄ may be selected from groups represented by Formulae 5-1 to 5-46, and

R21 and R₂₂ may each independently be selected from a C₁-C₂₀ alkyl group and a group represented by any of Formulae 5-1 to 5-46:

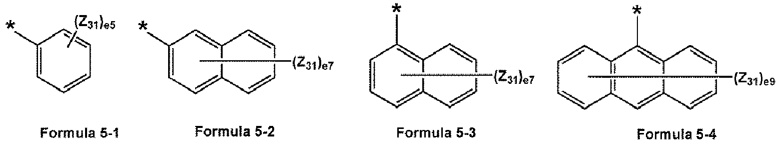

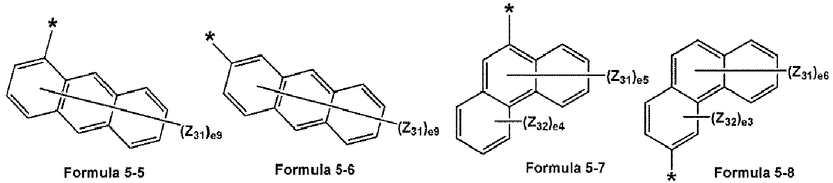

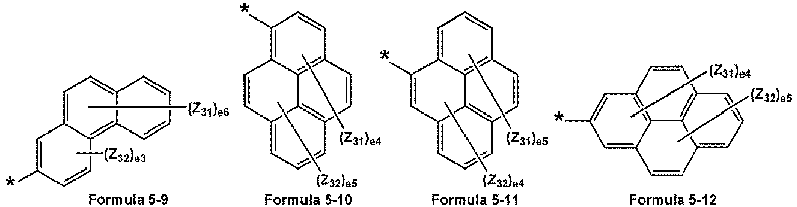

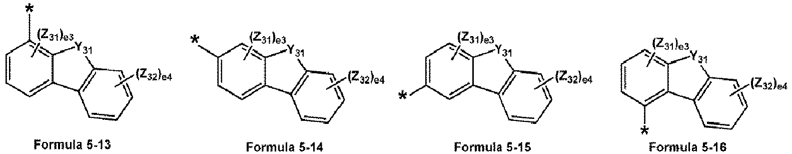

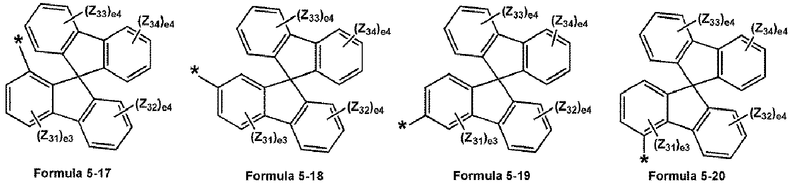

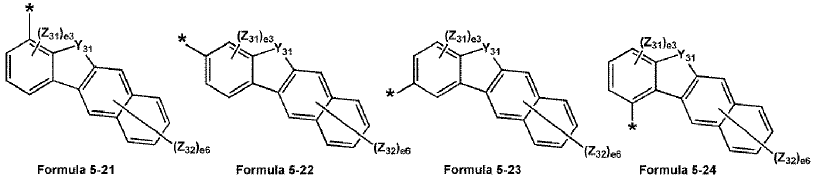

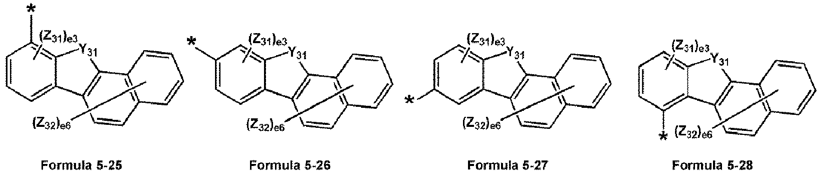

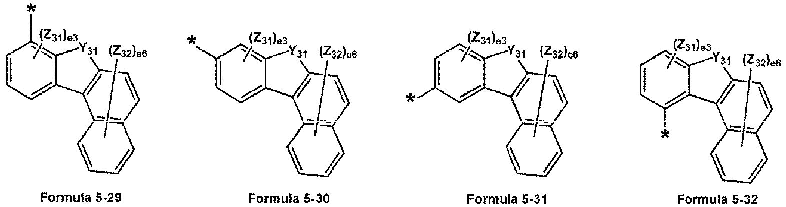

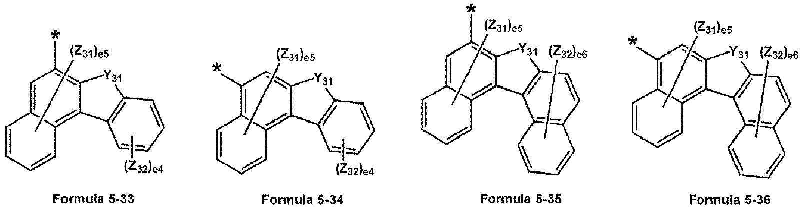

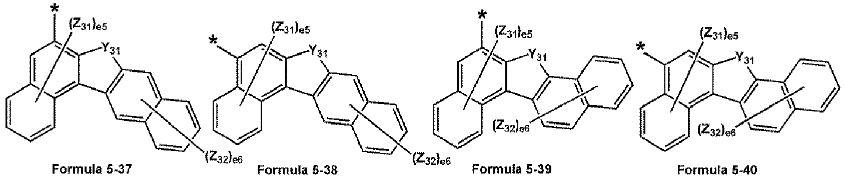

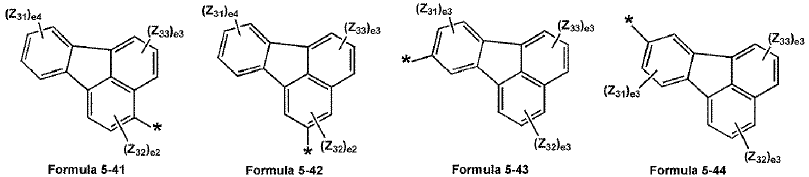

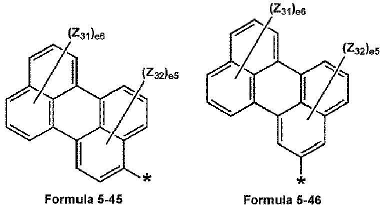

In Formulae 5-1 to 5-46,
Y₃₁ may be selected from O, S, C(Z₃₃)(Z₃₄), N(Z₃₅), and Si(Z₃₆)(Z₃₇),
Z₃₁ to Z₃₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, and -Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group,
e2 may be an integer selected from 0 to 2,
e3 may be an integer selected from 0 to 3,
e4 may be an integer selected from 0 to 4,
e5 may be an integer selected from 0 to 5,
e6 may be an integer selected from 0 to 6,
e7 may be an integer selected from 0 to 7,
e9 may be an integer selected from 0 to 9, and
^{∗} may indicate a binding site to a neighboring atom.

In one or more embodiments, in Formula 1, R₁to R₄ may each independently be selected from hydrogen, deuterium, a C₁-C₂₀ alkyl group, and a group represented by any of Formulae 6-1 to 6-179, wherein at least one selected from R₁ to R₄ may be selected from groups represented by Formulae 6-1 to 6-179, and

R₂₁ and R₂₂ may each independently be selected from a C₁-C₂₀ alkyl group and a group represented by any of Formulae 6-1 to 6-179, but embodiments of the present disclosure are not limited thereto:

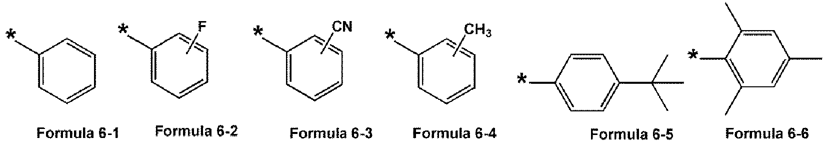

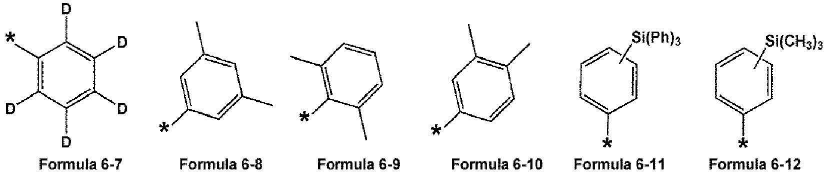

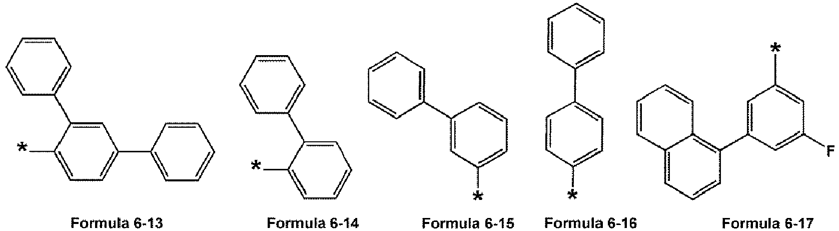

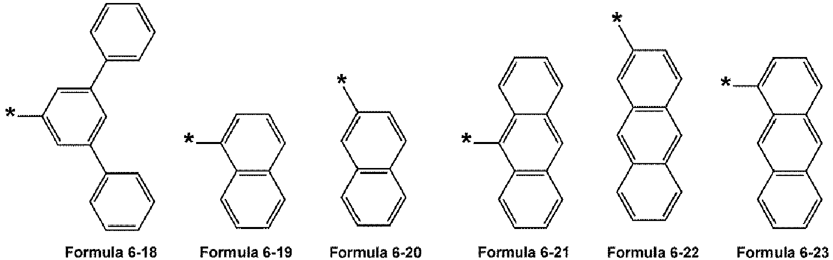

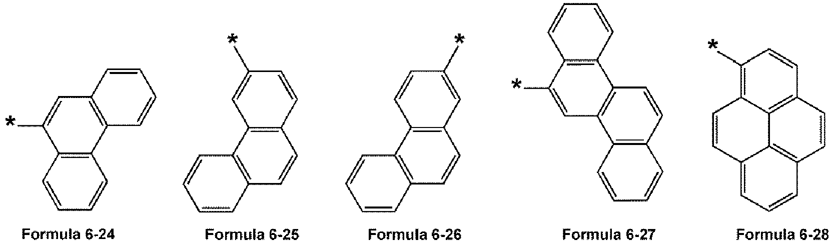

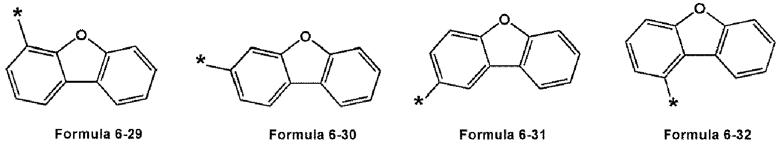

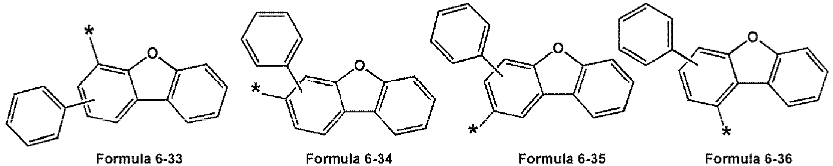

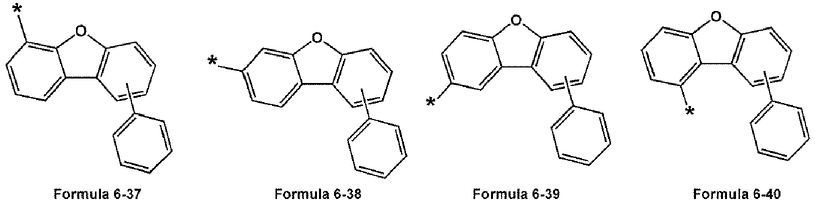

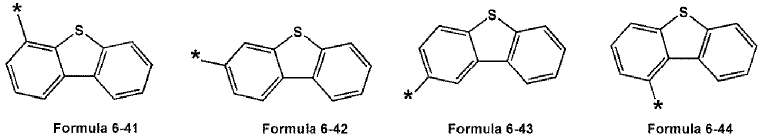

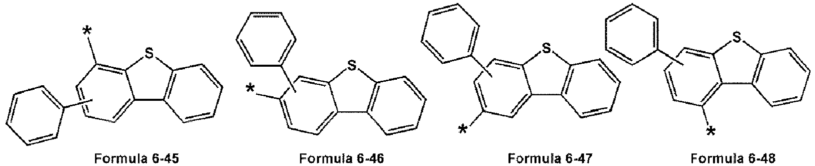

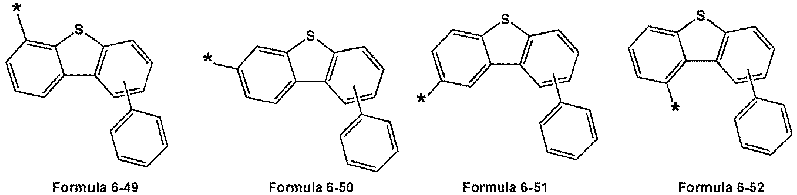

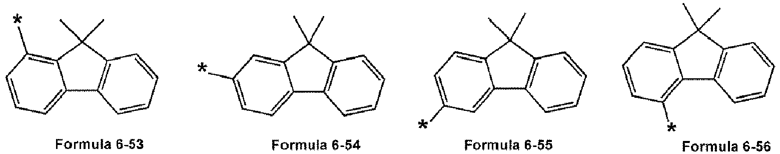

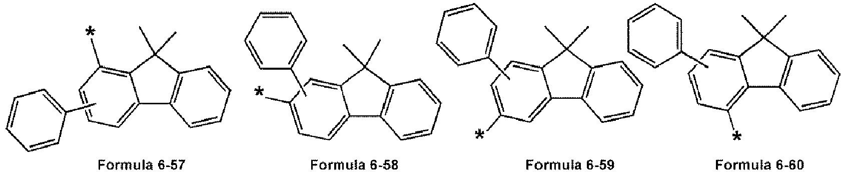

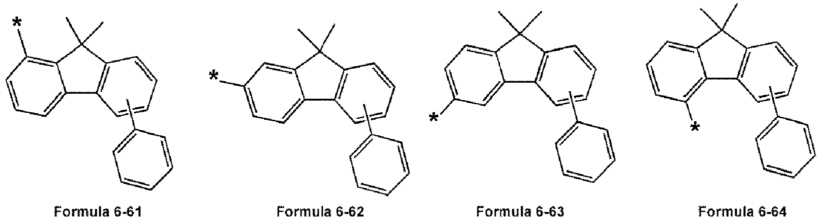

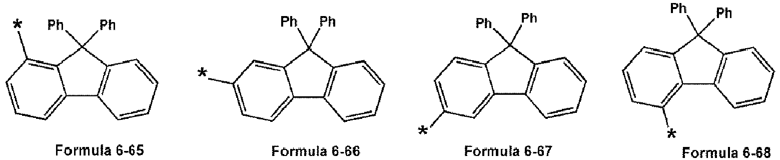

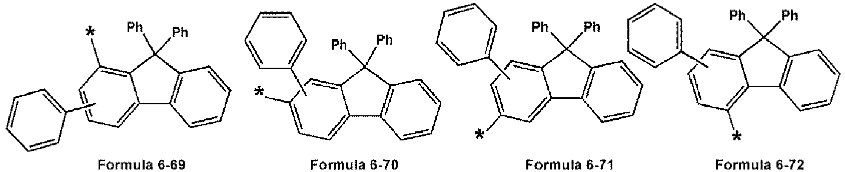

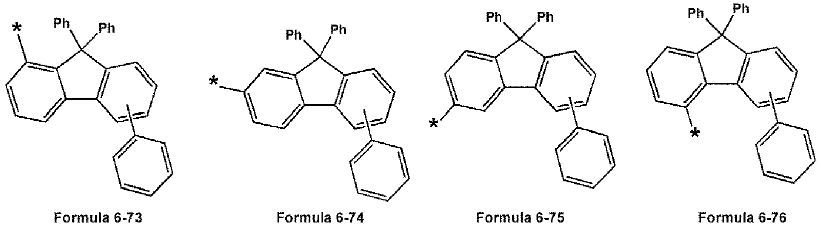

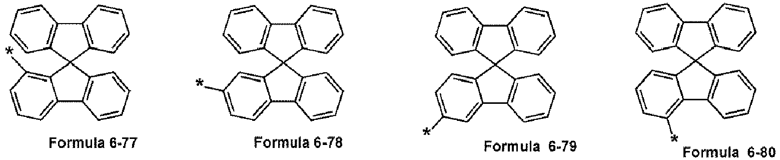

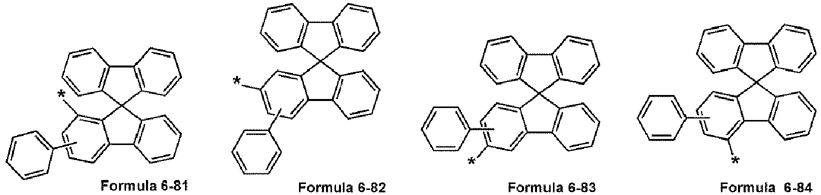

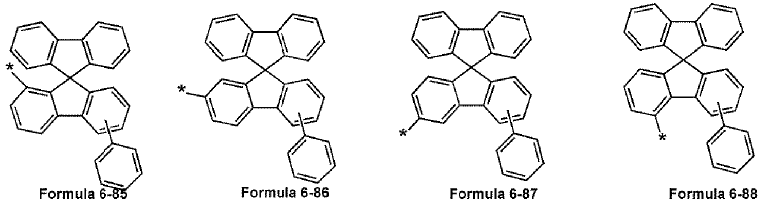

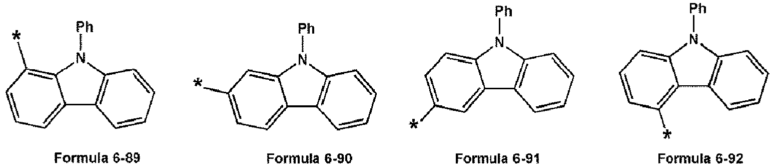

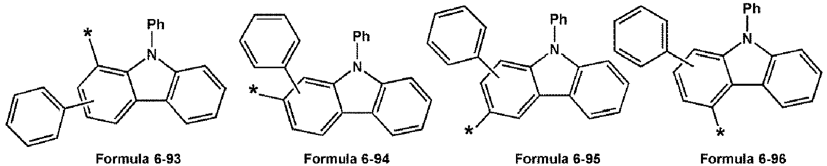

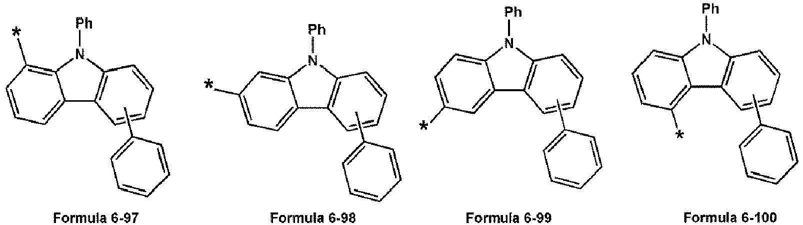

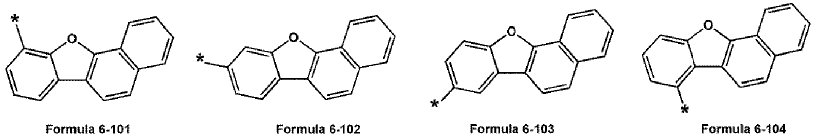

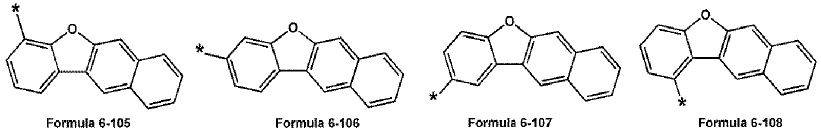

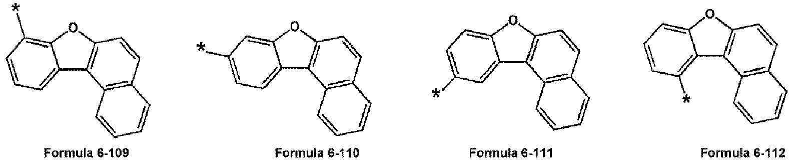

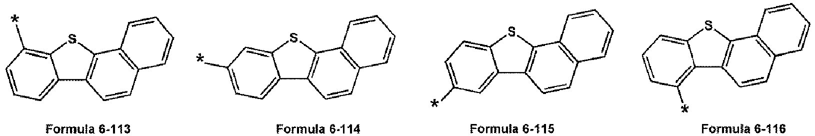

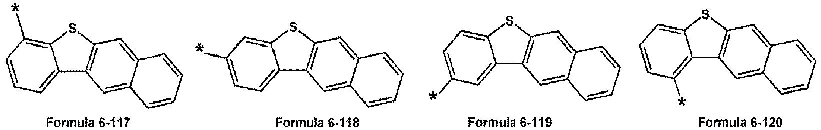

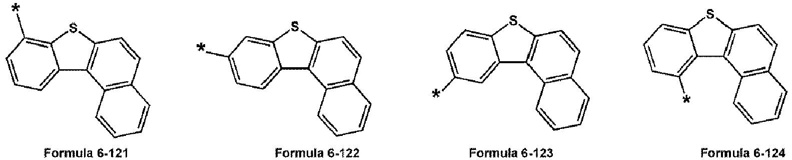

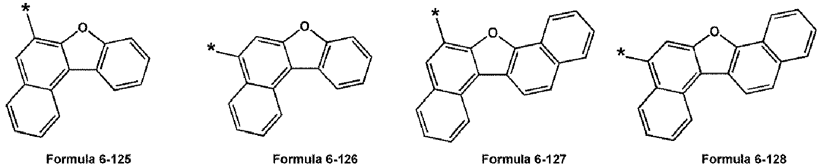

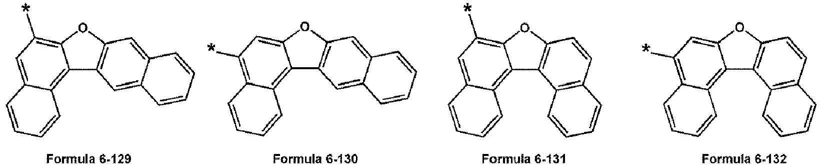

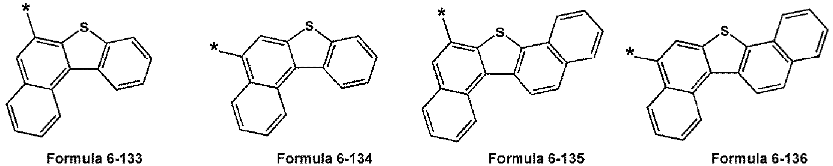

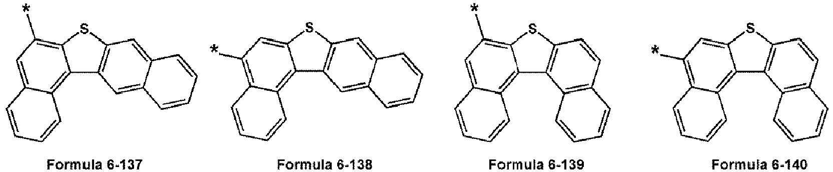

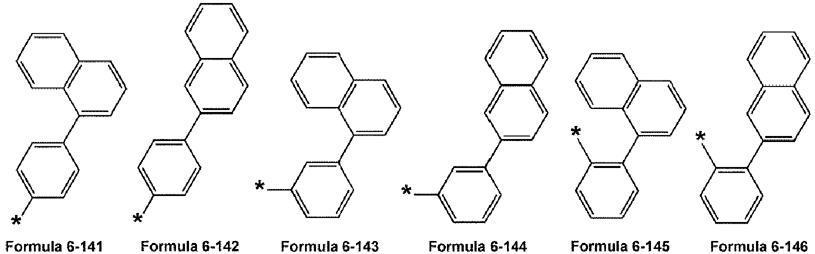

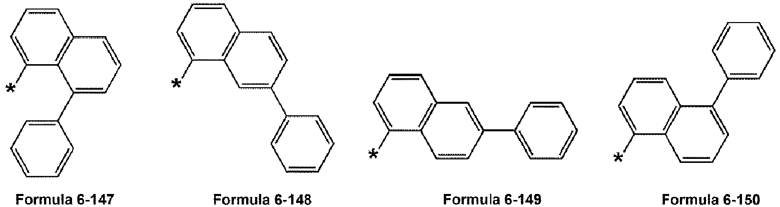

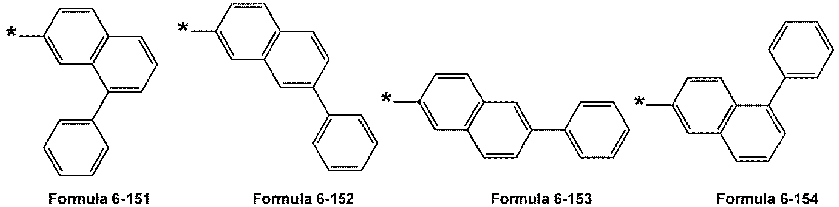

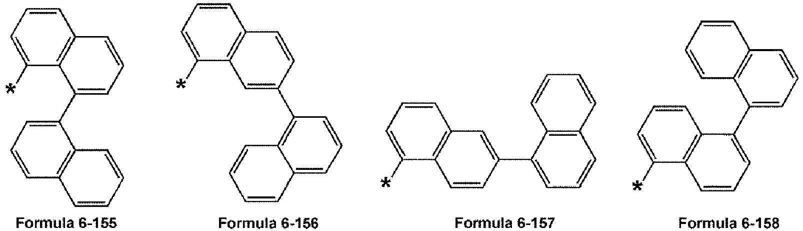

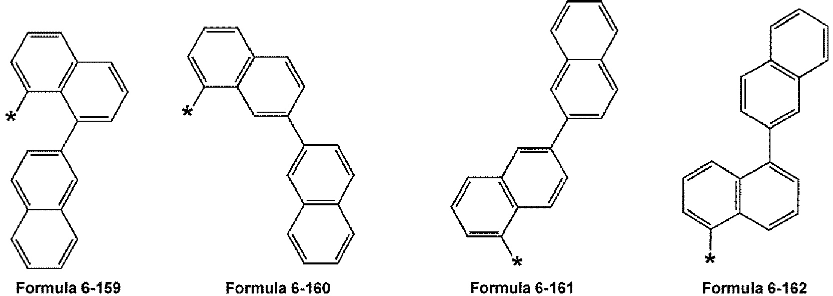

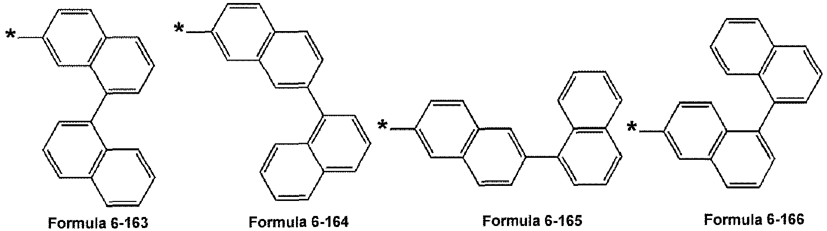

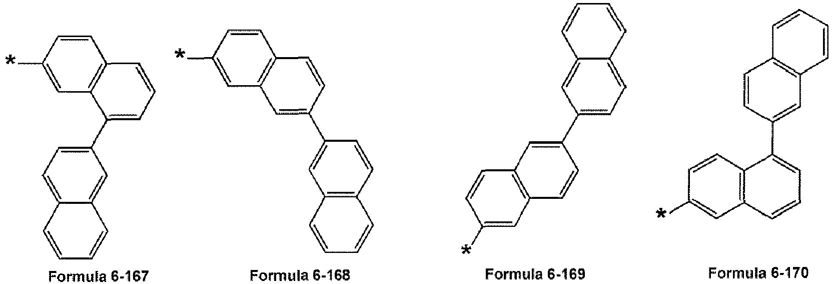

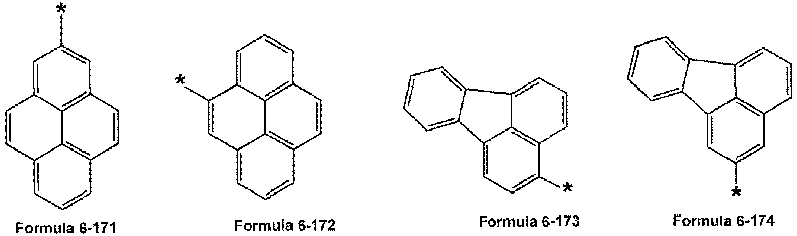

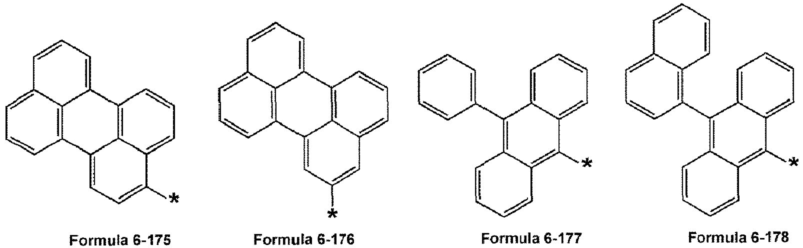

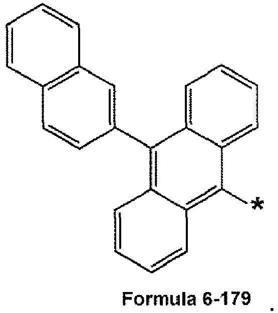

In Formulae 6-1 to 6-179, Ph may indicate a phenyl group, and ^{∗} may indicate a binding site to a neighboring atom.

In one or more embodiments, in Formula 1,
X₁ may be selected from C(R₂₁)(R₂₂) and Si(R₂₁)(R₂₂),
R₂₁ and R₂₂ may each independently be selected from the group consisting of:
   a C₁-C₁₀ alkyl group, a phenyl group, a biphenyl group, a terphenyl group, a naphthyl group, and an anthracenyl group; and
   a phenyl group, a biphenyl group, a terphenyl group, a naphthyl group, and an anthracenyl group, each substituted with at least one selected from deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, and an anthracenyl group,
   wherein R₂₁ and R₂₂ may be optionally linked through a single bond; or may be optionally linked through a C₁-C₃ alkylene group substituted with at least one selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In one or more embodiments, in Formula 1, R₅ to R₁₂ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, and -Si(Q₁)(Q₂)(Q₃) (wherein Q₁ to Q₃ may each independently be selected from a C₁-C₂₀ alkyl group, a C₁-C₂₀ alkoxy group, a phenyl group, a biphenyl group, a terphenyl group, and a naphthyl group).

For example, the first compound of Formula 1 may be represented by one selected from Formulae 1-1 to 1-10:

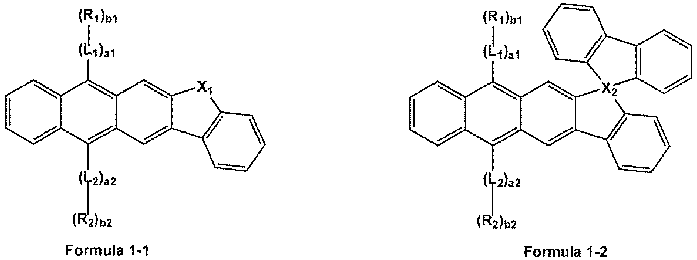

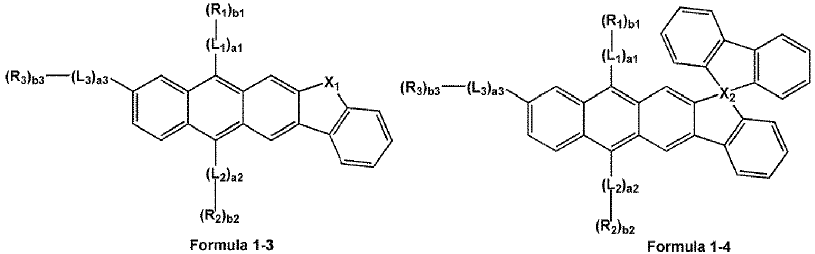

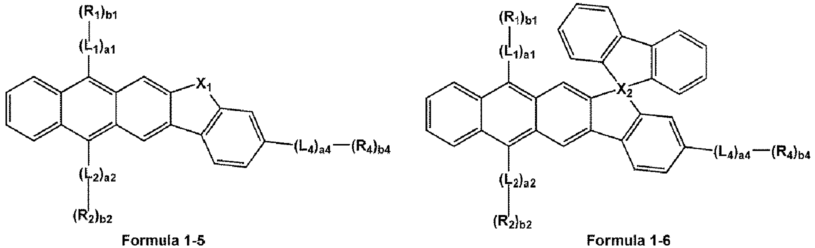

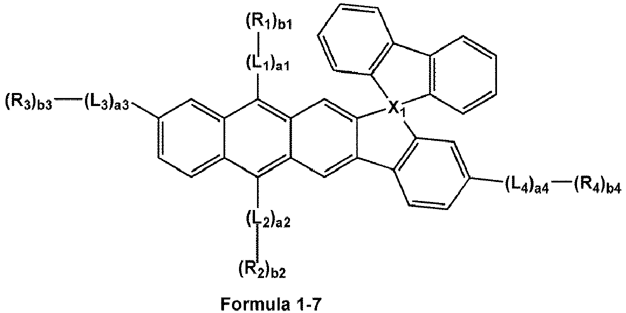

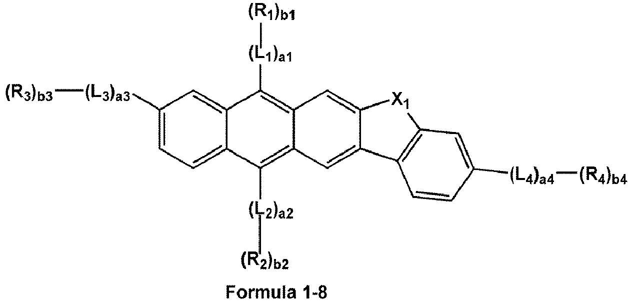

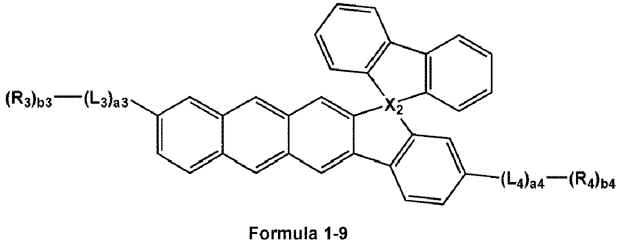

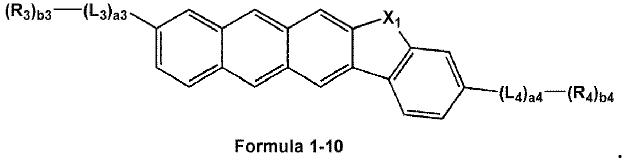

In Formulae 1-1 to 1-10,
X₁, L₁ to L₄, and a1 to a4 may each independently be the same as described herein in connection with Formula 1,
X₂ may be selected from carbon (C) and silicon (Si),
R₁ to R₄ may each independently be selected from the group consisting of:
   a C₁-C₂₀ alkyl group and a C₁-C₂₀ alkoxy group;
   a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a biphenyl group, and a terphenyl group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group; and
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, and -Si(Q₃₁)(Q₃₂)(Q₃₃),
   wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, and
   b1 to b4 may each independently be selected from 1 and 2.

In one embodiment, in Formulae 1-1 to 1-10, R₁ to R₄ may each independently be selected from the group consisting of:
a C₁-C₂₀ alkyl group and a C₁-C₂₀ alkoxy group; and
a group represented by any of Formulae 5-1 to 5-46.

In one or more embodiments, in Formulae 1-1 to 1-10, R₁ to R₄ may each independently be selected from the group consisting of:
a C₁-C₂₀ alkyl group and a C₁-C₂₀ alkoxy group; and
a group represented by any of Formulae 6-1 to 6-179.

In one or more embodiments, at least one selected from R₁ and R₂ in Formulae 1-1 and 1-2, at least one selected from R₁ to R₃ in Formulae 1-3 and 1-4, at least one selected from R₁, R₂, and R₄ in Formulae 1-5 and 1-6, at least one selected from R₁ to R₄ in Formulae 1-7 and 1-8, and at least one selected from R₃ and R₄ in Formulae 1-9 and 1-10 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, and -Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, at least one selected from R₁ and R2 in Formulae 1-1 and 1-2, at least one selected from R₁ to R₃ in Formulae 1-3 and 1-4, at least one selected from R₁, R₂, and R₄ in Formulae 1-5 and 1-6, at least one selected from R₁ to R₄ in Formulae 1-7 and 1-8, and at least one selected from R₃ and R₄ in Formulae 1-9 and 1-10 may each independently be selected from groups represented by Formulae 5-1 to 5-46 (for example, groups represented by Formulae 6-1 to 6-179).

The first compound represented by Formula 1 may be selected from Compounds A1 to A60, Compounds Bi to B48, Compounds C1 to C30, Compounds D1 to D30, Compounds E1 to E60, and Compounds F1 to F48, but embodiments of the present disclosure are not limited thereto:

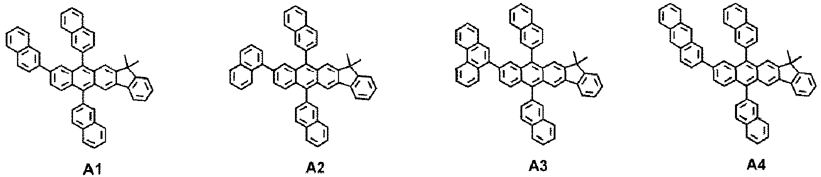

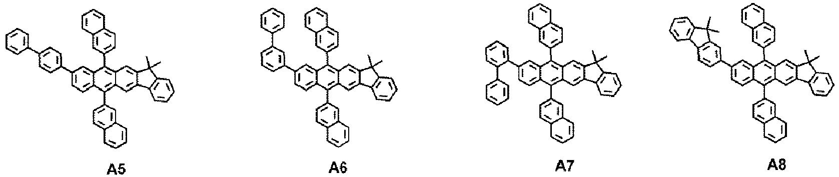

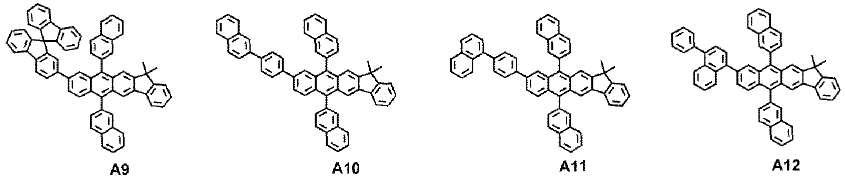

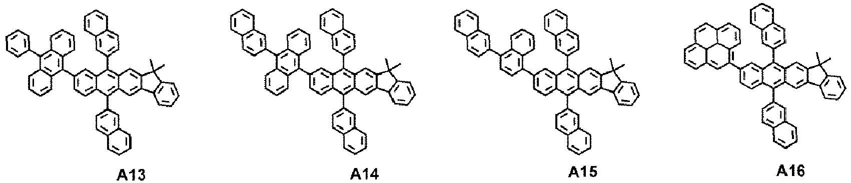

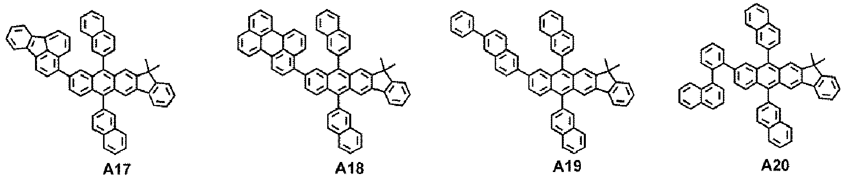

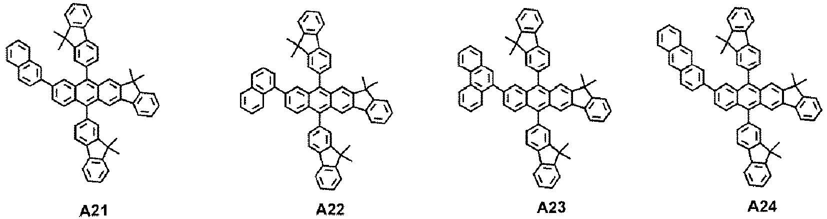

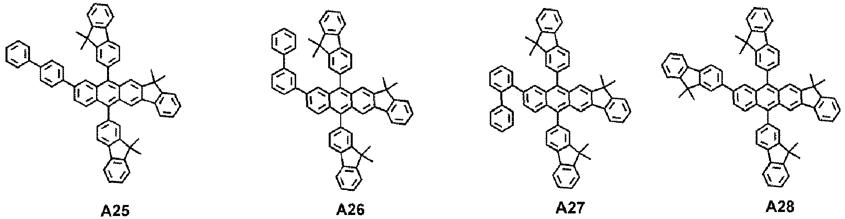

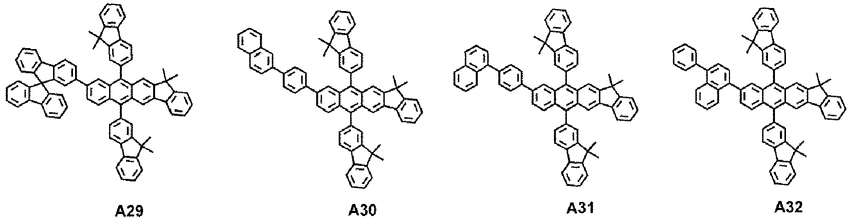

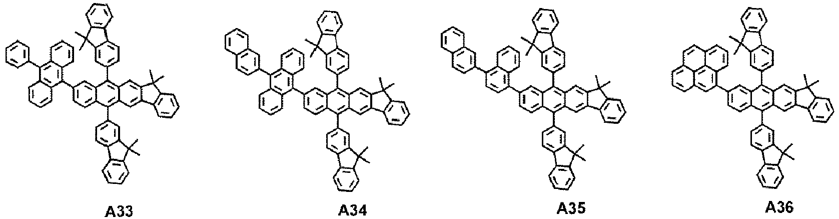

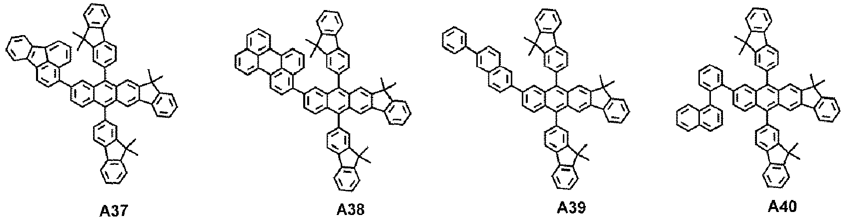

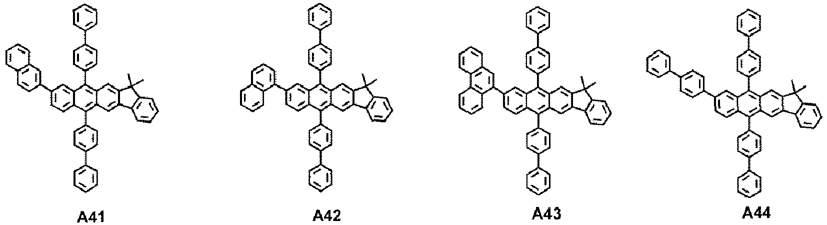

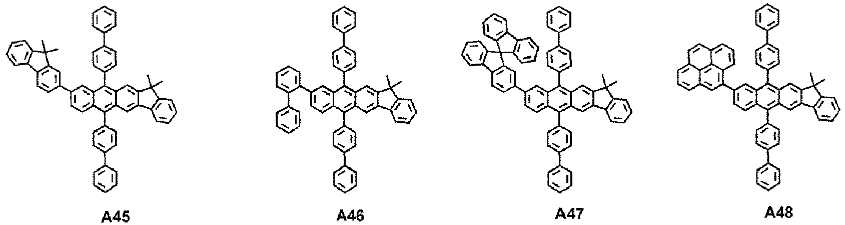

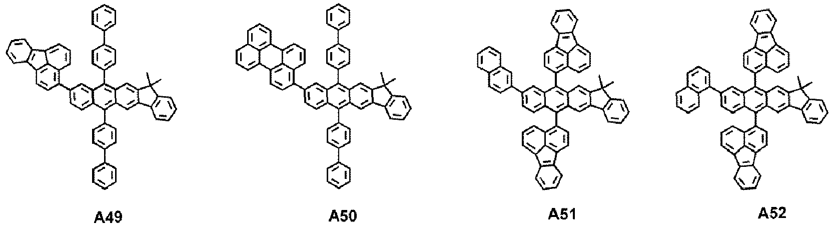

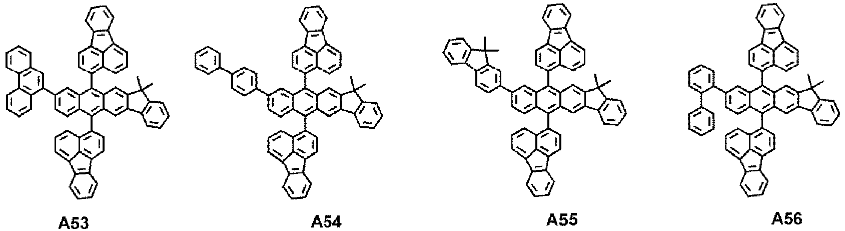

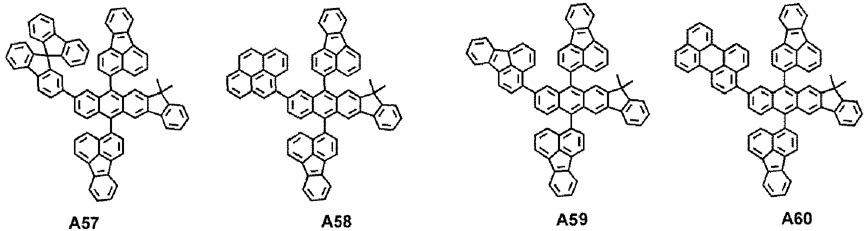

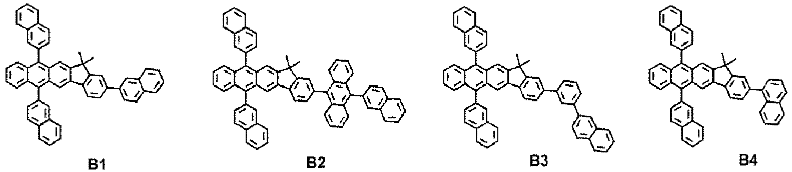

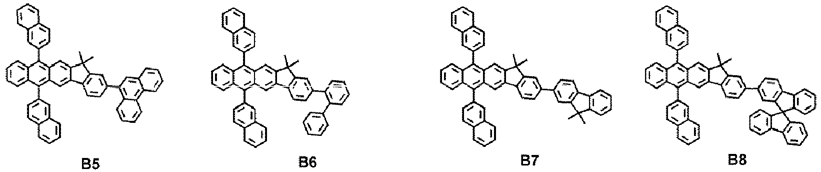

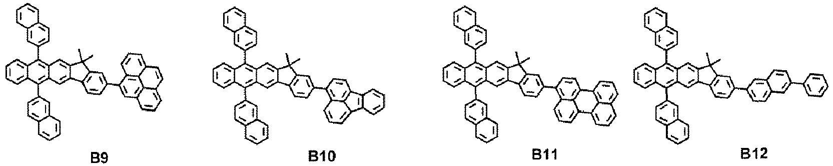

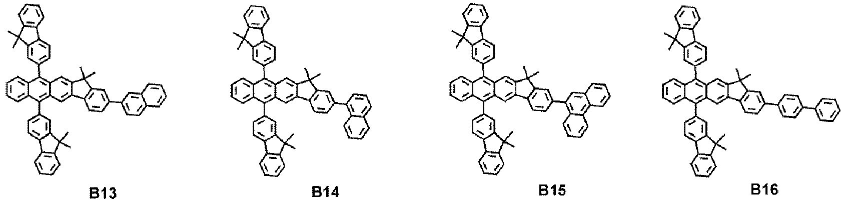

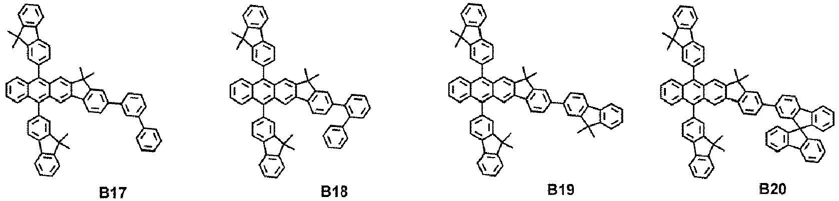

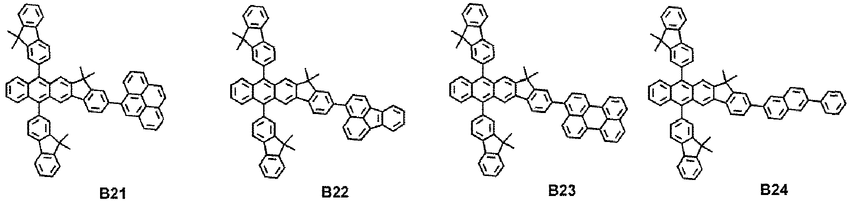

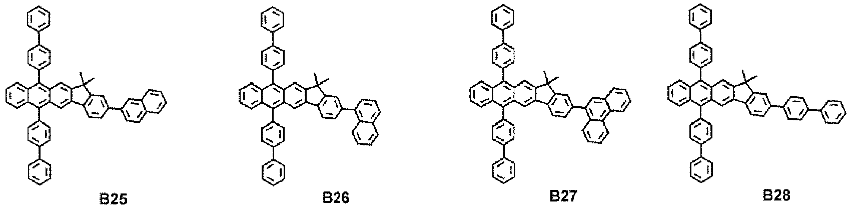

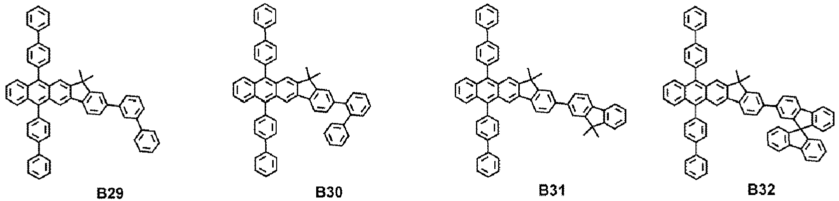

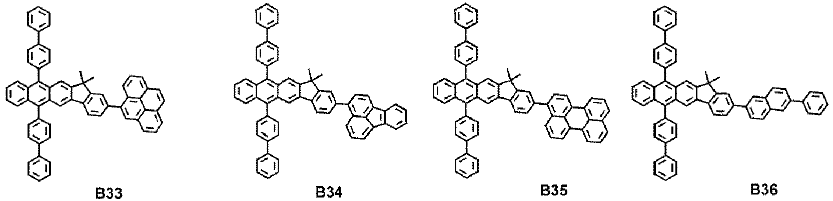

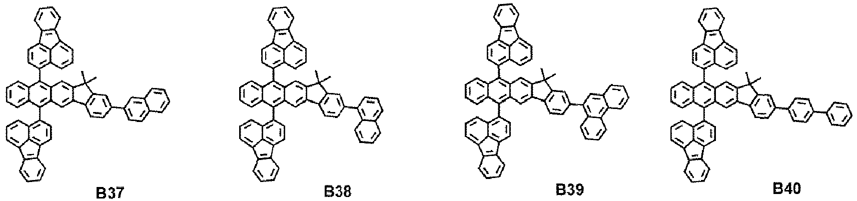

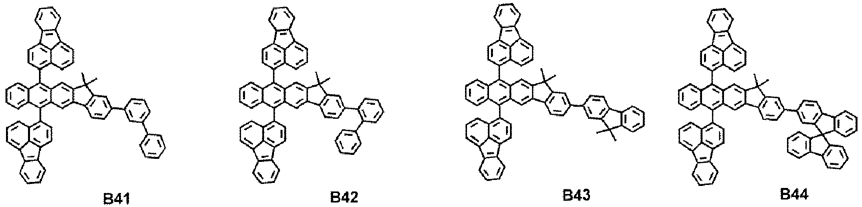

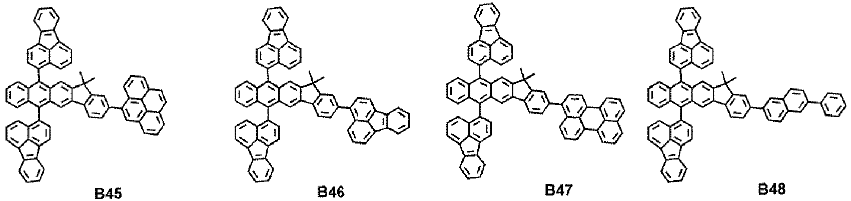

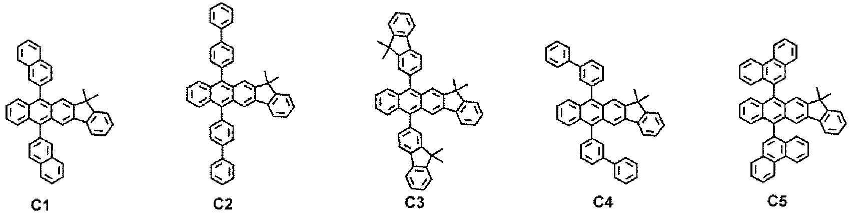

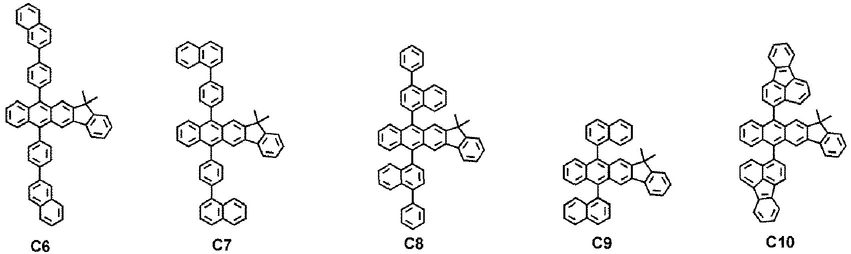

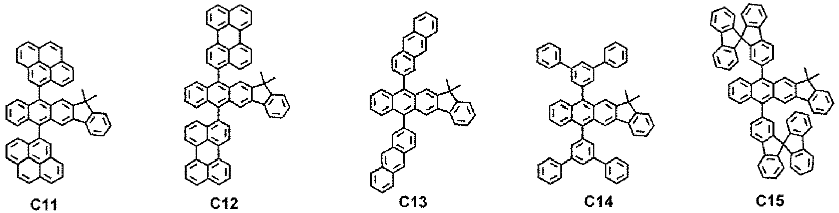

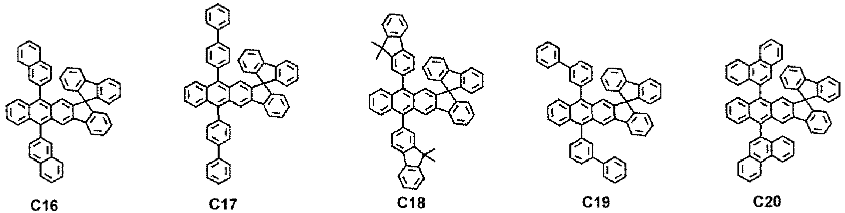

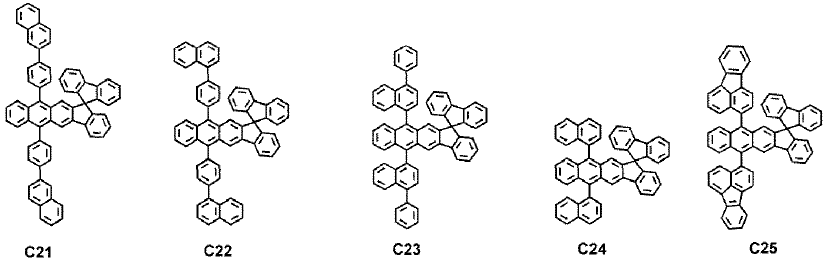

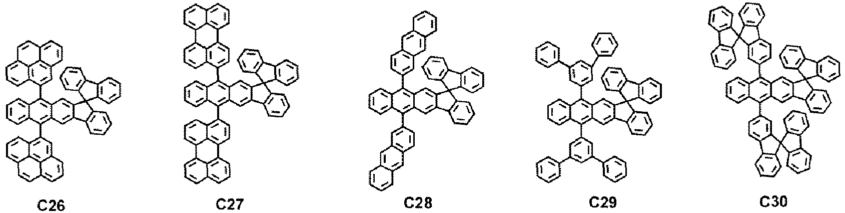

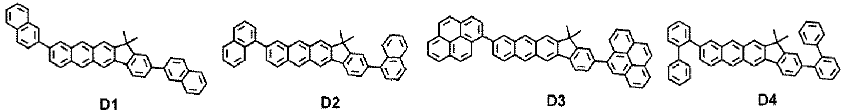

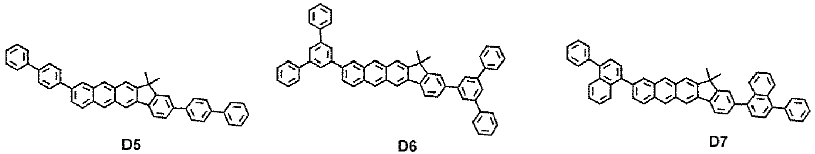

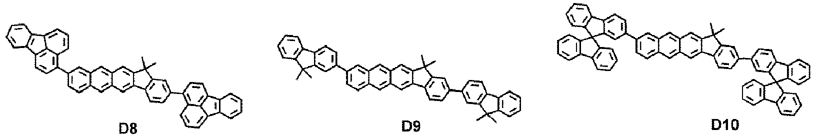

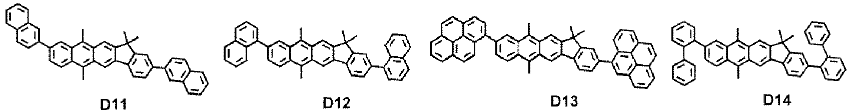

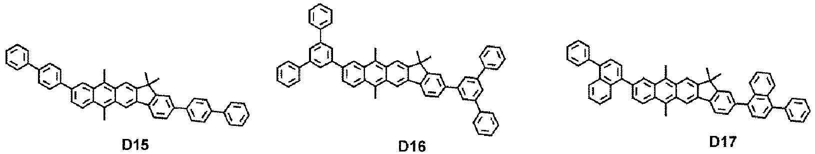

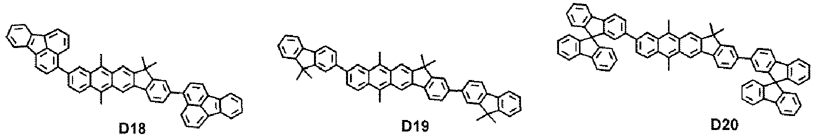

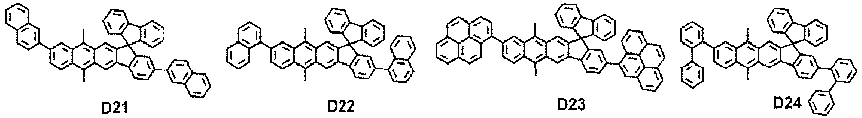

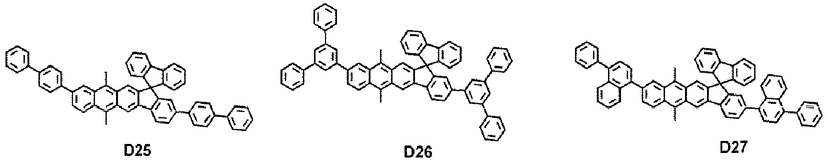

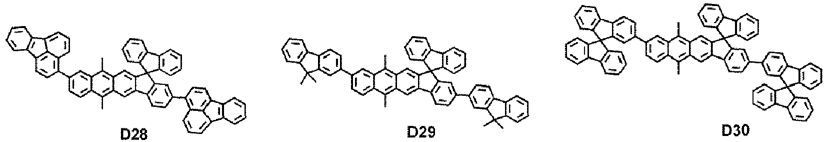

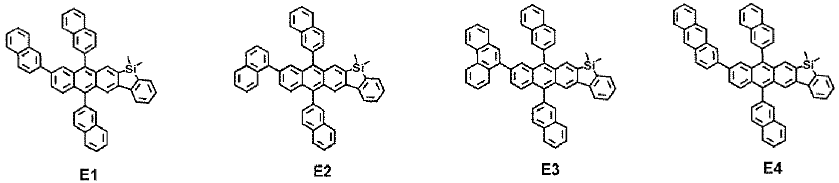

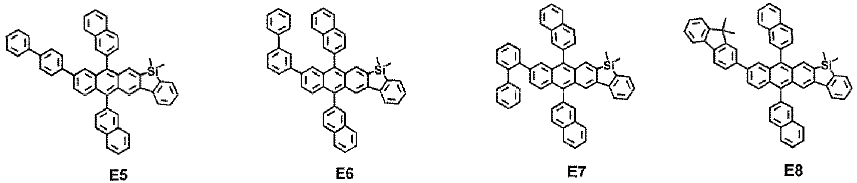

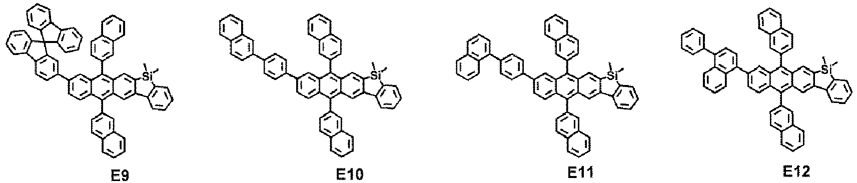

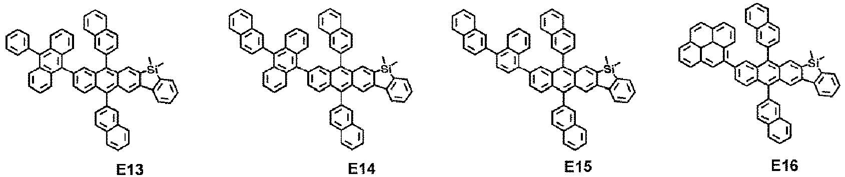

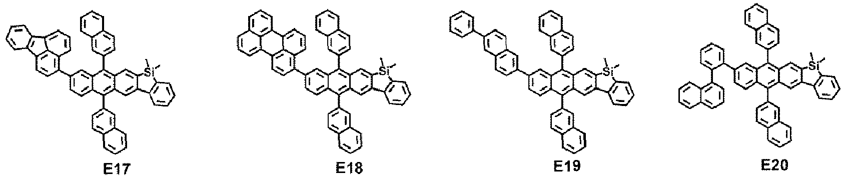

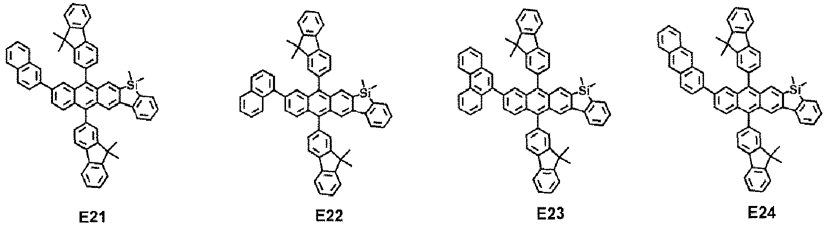

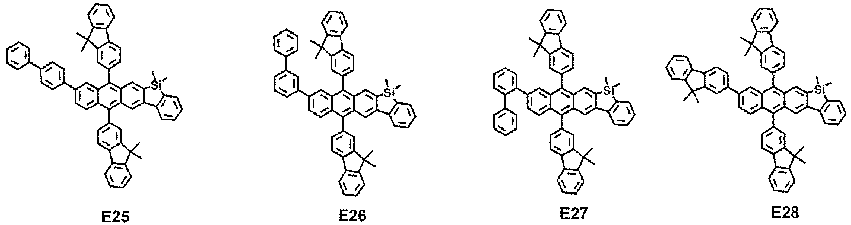

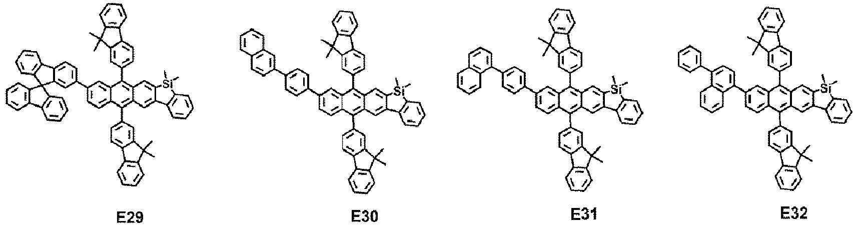

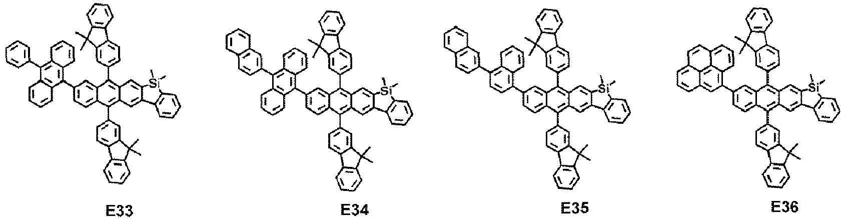

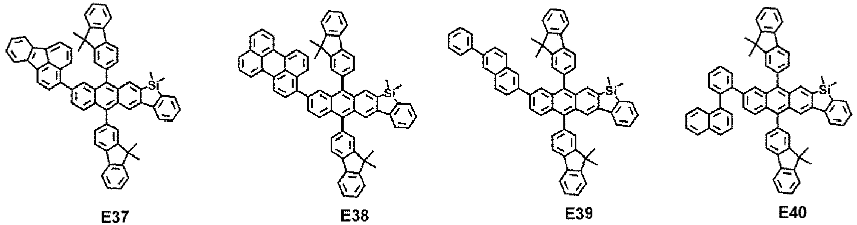

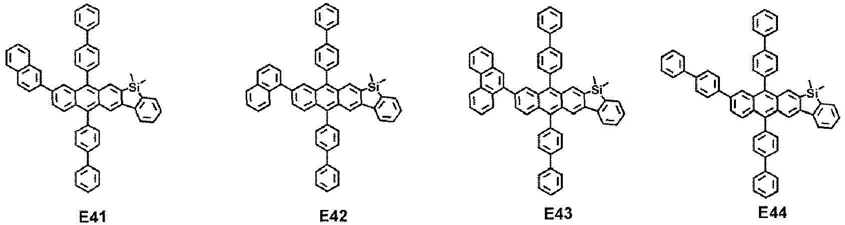

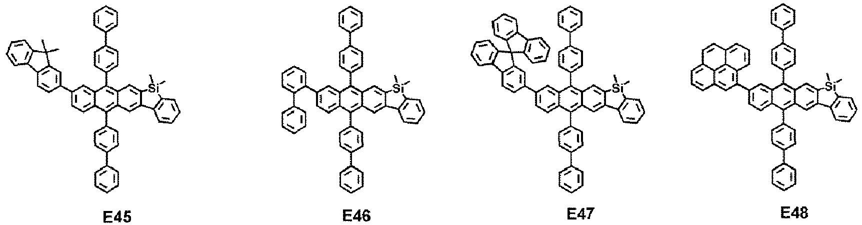

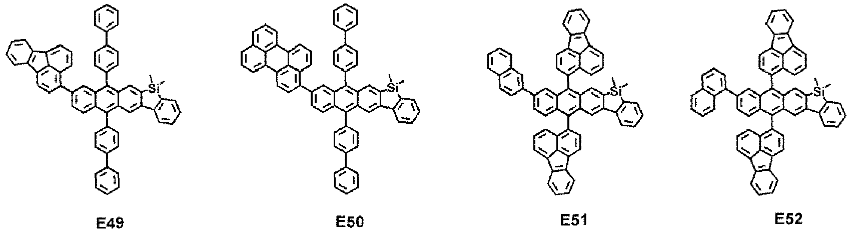

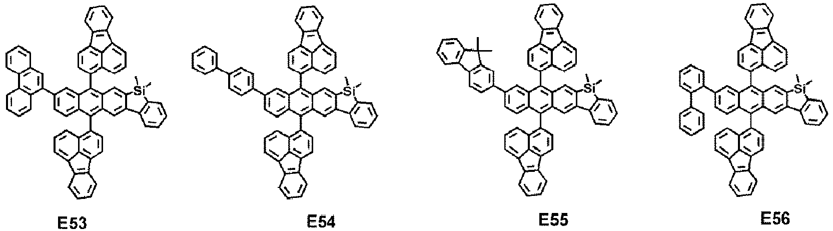

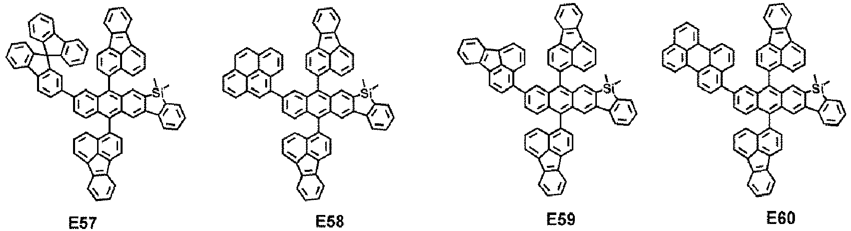

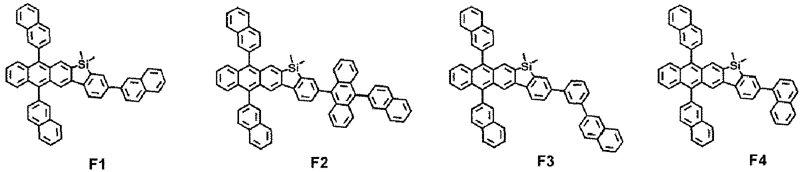

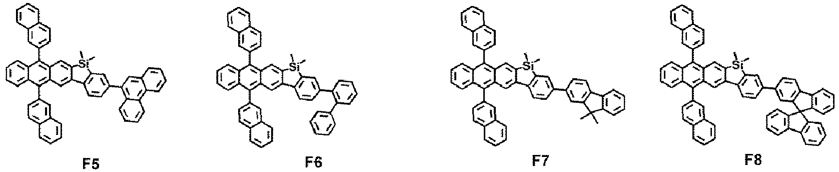

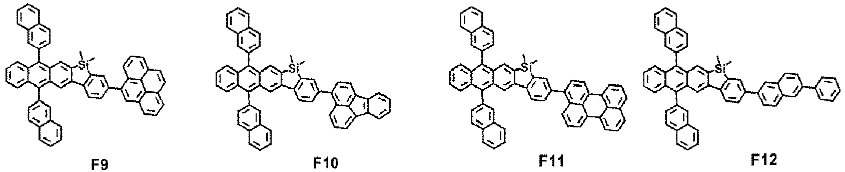

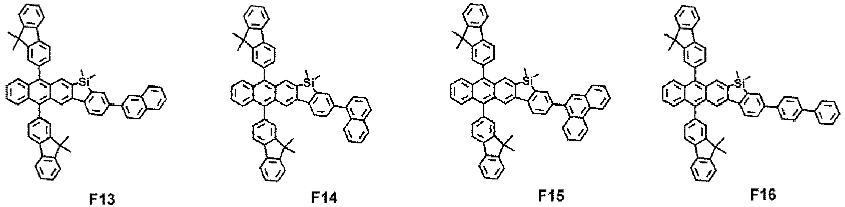

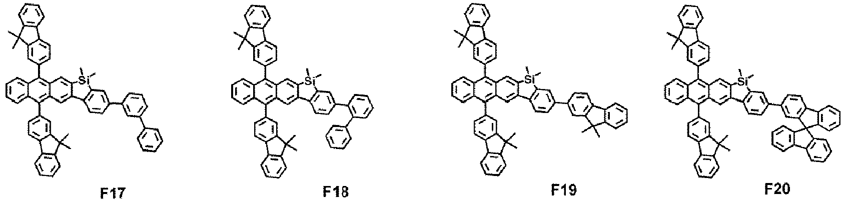

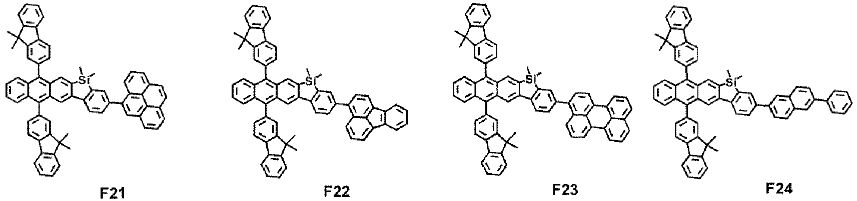

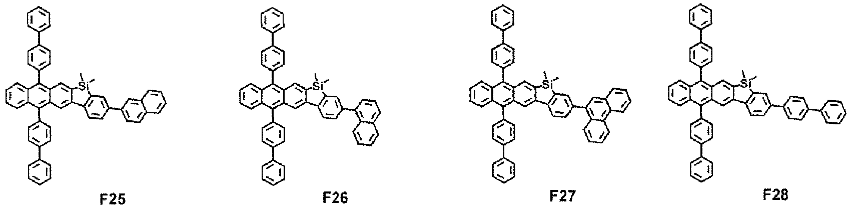

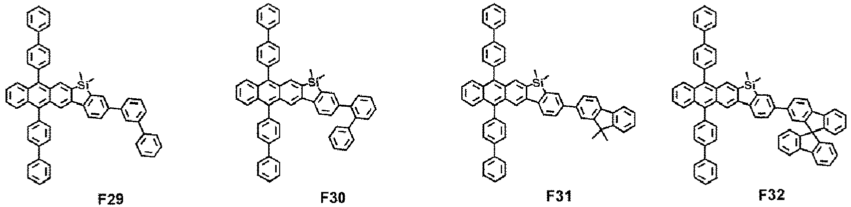

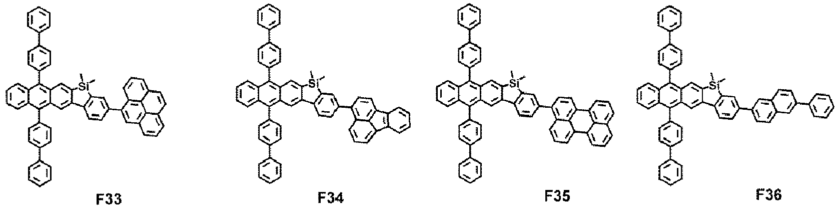

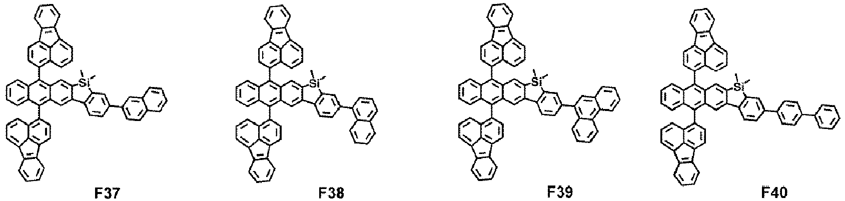

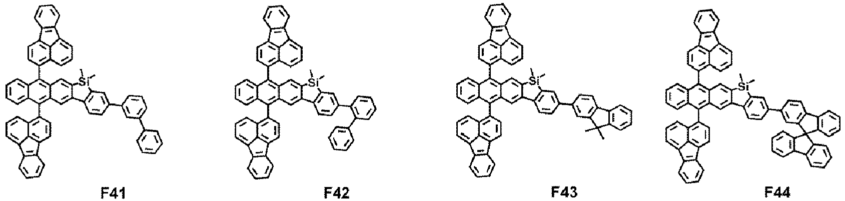

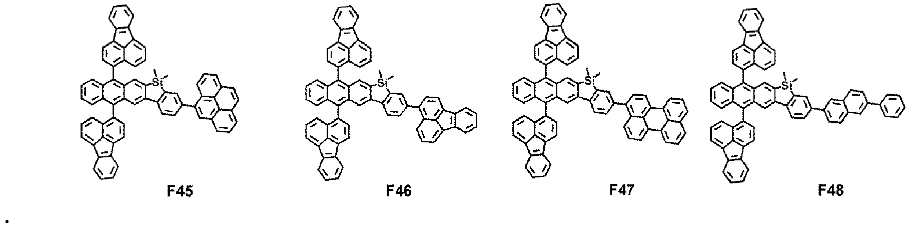

The first auxiliary layer 214-1 and the second auxiliary layer 214-2 may each independently serve to provide (e.g., be used to adjust) a resonant distance so that the first color light from the first emission layer 213-1 and the second color light from the second emission layer 213-2 may each independently be emitted toward the outside of the organic light-emitting device 200 with maximum (e.g., increased) efficiency according to the principle of constructive interference. The first auxiliary layer 214-1 and the second auxiliary layer 214-2 may each independently have a single-layer structure or a multi-layer structure comprising different materials, but embodiments of the structure of the first auxiliary layer 214-1 and the second auxiliary layer 214-2 are not limited thereto.

The first auxiliary layer 214-1 and the second auxiliary layer 214-2 may each independently comprise the first compound as described above, and accordingly, electrons that may be provided by the emission layer as described below may be prevented from being transferred to the hole transport region 201 (e.g., transfer of electrons to the hole transport region 201 may be reduced). In this regard, the organic light-emitting device 200 comprising at least one selected from the first auxiliary layer 214-1 and the second auxiliary layer 214-2 may have high efficiency and long lifespan.

In one embodiment, the first compound comprised in the first auxiliary layer 214-1 may be identical to the first compound comprised in the second auxiliary layer 214-2.

In one or more embodiments, the first compound comprised in the first auxiliary layer 214-1 may be different from the first compound comprised in the second auxiliary layer 214-2.

In one or more embodiments, at least one selected from the first auxiliary layer 214-1 and the second auxiliary layer 214-2 may further comprise, in addition to the first compound as described above, an amine-based compound. When at least one selected from the first auxiliary layer 214-1 and the second auxiliary layer 214-2 further comprises, in addition to the first compound as described above, an amine-based compound, the effect of the amine-based compound in improving the hole transport characteristics of the device may be increased or enhanced, thereby achieving improvement of efficiency and lifespan of the organic light-emitting device 200.

For example, at least one selected from the first auxiliary layer 214-1 and the second auxiliary layer 214-2 may further comprise, in addition to the first compound as described above, the second compound of Formula 201 and/or the third compound of Formula 202.

In one embodiment, the hole transport region 201 may comprise the second compound, and
the first auxiliary layer 214-1 and the second auxiliary layer 214-2 may each independently comprise the first compound and the second compound.

The second compound comprised in the hole transport region 201 may be identical to the second compound comprised in the first auxiliary layer 214-1 and to the second compound comprised in the second auxiliary layer 214-2.

In one or more embodiments, the hole transport region 201 may comprise the third compound,
the first auxiliary layer 214-1 and the second auxiliary layer 214-2 may each independently comprise the first compound and the third compound, and
the third compound comprised in the hole transport region 201 may be identical to the third compound comprised in the first auxiliary layer 214-1 and to the third compound comprised in the second auxiliary layer 214-2.

The first emission layer 213-1, the second emission layer 213-2, and the third emission layer 213-3 may each independently comprise a host and a dopant.

The hosts comprised in the first emission layer 213-1, the second emission layer 213-2, and the third emission layer 213-3 may each independently comprise a compound represented by Formula 301:

**Formula 301** [Ar₃₀₁]_{xb11}-[(L₃₀₁)_{xb1}-R₃₀₁]_{xb21}.

In Formula 301,
Ar₃₀₁ may be selected from a substituted or unsubstituted C₅-C₆₀ carbocyclic group and a substituted or unsubstituted C₁-C₆₀ heterocyclic group,
xb11 may be selected from 1, 2, and 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group,
xb1 may be an integer selected from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, a substituted or unsubstituted monovalent non-aromatic condensed 8- to 60-membered heteropolycyclic group, -Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), and -P(=O)(Q₃₀₁)(Q₃₀₂), and
xb2i may be an integer selected from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In one embodiment, in Formula 301, Ar₃₀₁ may be selected from the group consisting of:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ are each independently selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In Formula 301, when xb11 is 2 or more, 2 or more Ar₃₀₁(s) may be linked through a single bond.

In one or more embodiments, the compound represented by Formula 301 may be represented by Formulae 301-1 or 301-2:

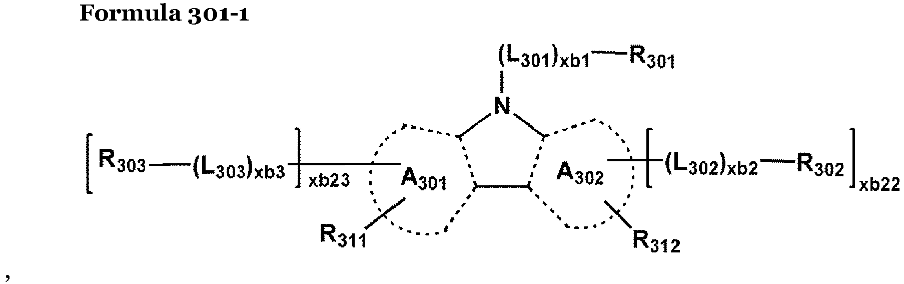

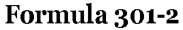

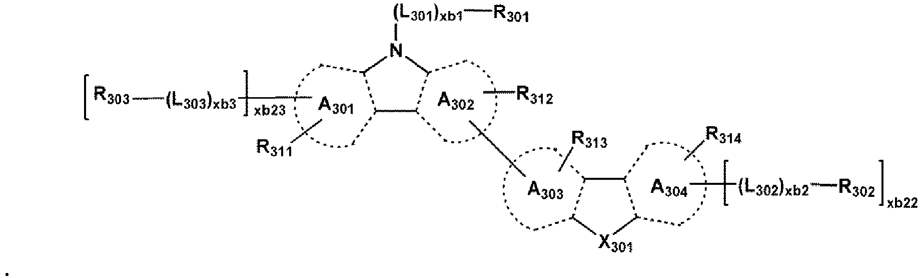

In Formulae 301-1 and 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and a dinaphthothiophene group,
X₃₀₁ may be selected from O, S, and N-[(L₃₀₄)_{xb4}-R₃₀₄],
R₃₁₁ to R₃₁₄ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
xb22 and xb23 may each independently be selected from 0, 1, and 2,
L₃₀₁, xb1, R₃₀₁, and Q₃₁ to Q₃₃ may each independently be the same as described herein in connection with Formula 301,
L₃₀₂ to L₃₀₄ may each independently be the same as described herein in connection with L₃₀₁,
xb2 to xb4 may each independently be the same as described herein in connection with xb1, and
R₃₀₂ to R₃₀₄ may each independently be the same as described herein in connection with R₃₀₁.

For example, in Formulae 301, 301-1, and 301-2, L₃₀₁ to L₃₀₄ may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be the same as described above.

In one or more embodiments, in Formulae 301, 301-1, and 301-2, R₃₀₁ to R₃₀₄ may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂),-B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may each independently be the same as described above.

In one or more embodiments, the host may comprise an alkaline earth metal complex. For example, the host may comprise a complex selected from a beryllium (Be) complex (for example, Compound H55) and a Mg complex. In one or more embodiments, the host may comprise a zinc (Zn) complex.

The host may comprise at least one selected from 9,10-di(2-naphthyl)anthracene (ADN), 2-methyl-9,10-bis(naphthalen-2-yl)anthracene (MADN), 9,10-di-(2-naphthyl)-2-*t*-butyl-anthracene (TBADN), 4,4'-bis(*N*-carbazolyl)-1,1'-biphenyl (CBP), 1,3-di-9-carbazolylbenzene (mCP), 1,3,5-tri(carbazol-9-yl)benzene (TCP), and Compounds H1 to H55, but embodiments of the present disclosure are not limited thereto:

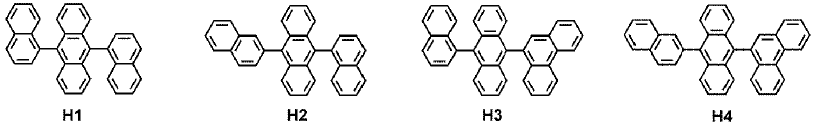

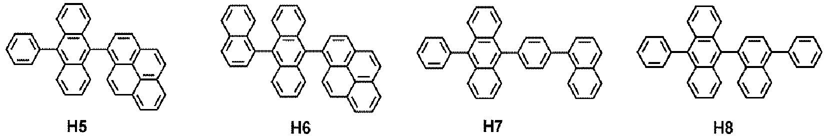

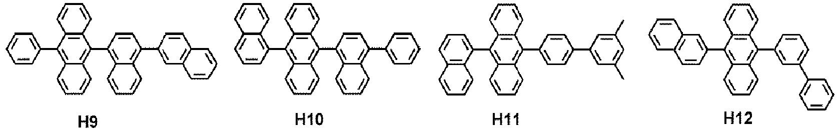

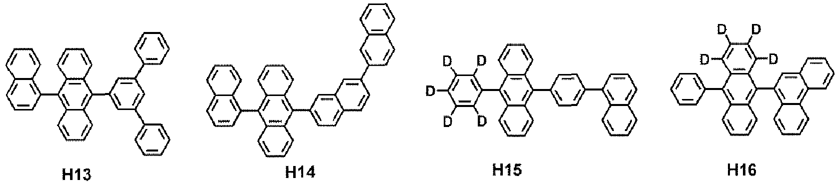

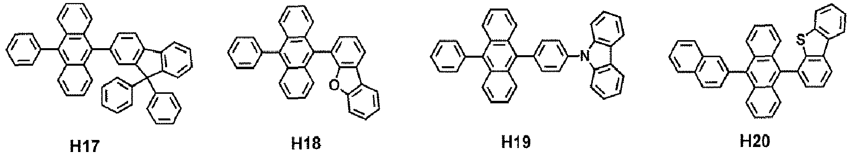

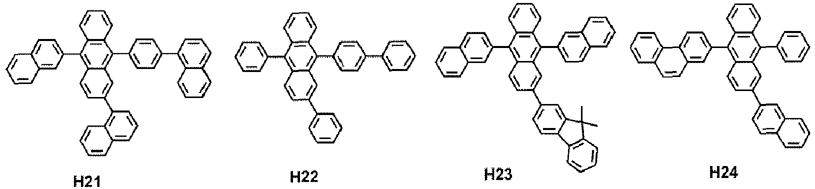

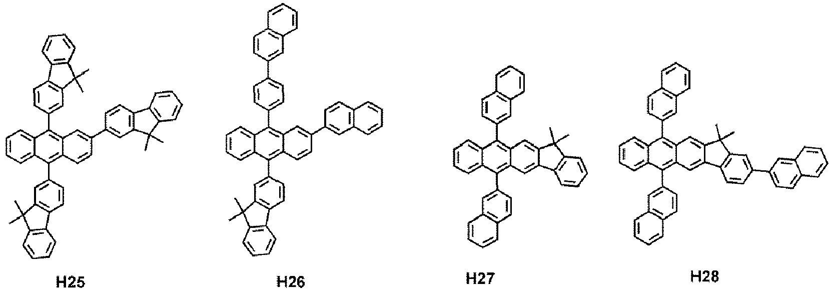

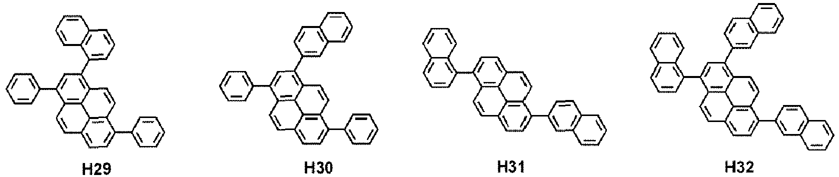

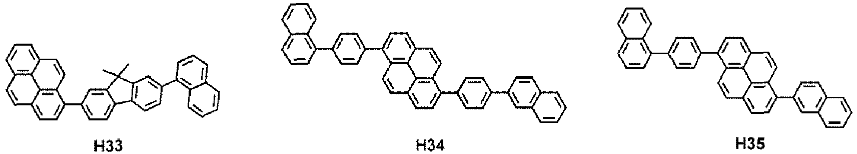

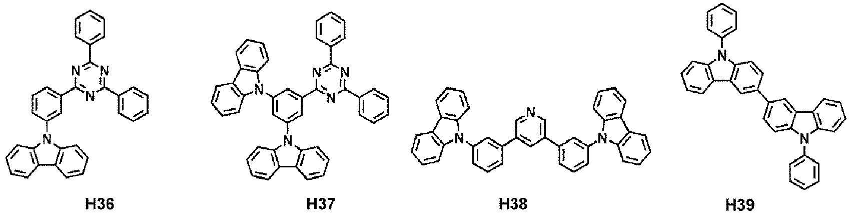

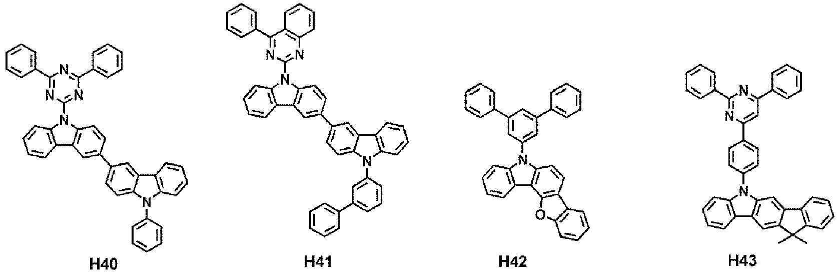

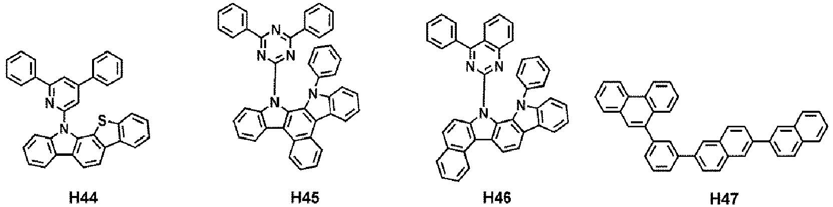

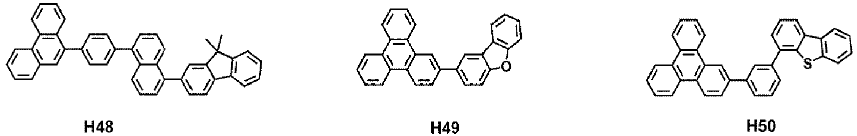

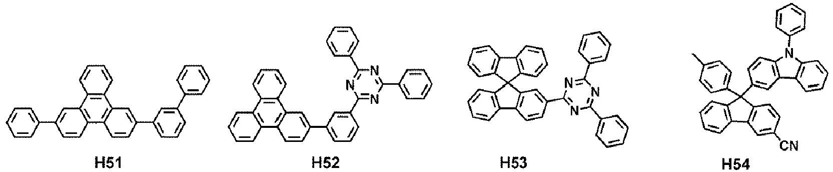

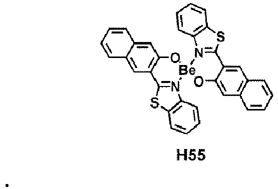

Alternatively, the hosts comprised in the first emission layer 213-1, the second emission layer 213-2, and the third emission layer 213-3 may each independently comprise the first compound represented by Formula 1, but embodiments of the present disclosure are not limited thereto.

The dopants comprised in the first emission layer 213-1, the second emission layer 213-2, and the third emission layer 213-3 may each independently comprise a phosphorescent dopant or a fluorescent dopant.

For example, the phosphorescent dopants comprised in the first emission layer 213-1, the second emission layer 213-2, and the third emission layer 213-3 may each independently comprise an organic metal complex represented by Formula 401:

**Formula 401** M(L₄₀₁)_{xc1}(L₄₀₂)_{xc2},

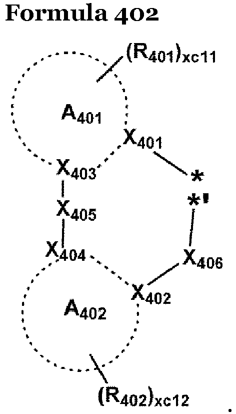

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be a ligand represented by Formula 402, xc1 may be selected from 1, 2, and 3, and when xc1 is 2 or more, 2 or more L₄₀₁(s) may be identical to or different from each other,
L₄₀₂ may be an organic ligand, xc2 may be an integer selected from 0 to 4, and when xc2 is 2 or more, 2 or more L₄₀₂(s) may be identical to or different from each other,
X₄₀₁ to X₄₀₄ may each independently be selected from nitrogen and carbon,
X₄₀₁ and X₄₀₃ may be linked through a single bond or a double bond, and X₄₀₂ and X₄₀₄ may be linked through a single bond or a double bond,
A₄₀₁ and A₄₀₂ may each independently be selected from a C₅-C₆₀ carbocyclic group and a C₁-C₆₀ heterocyclic group,
X₄₀₅ may be selected from a single bond, ^{∗}-O-^{∗}', ^{∗}-S-^{∗}', ^{∗}-C(=O)-^{∗}', ^{∗}-N(Q₄₁₁)-^{∗}', ^{∗}-C(Q₄₁₁)(Q₄₁₂)-^{∗}', ^{∗}-C(Q₄₁₁)=C(Q₄₁₂)-^{∗}', ^{∗}-C(Q₄₁₁)=^{∗}', and ^{∗}=C(Q₄₁₁)=^{∗}', wherein Q₄₁₁ and Q₄₁₂ may each independently be selected from hydrogen, deuterium, a C₁-C₂₀ alkyl group, a C₁-C₂₀ alkoxy group, a phenyl group, a biphenyl group, a terphenyl group, and a naphthyl group,
X₄₀₆ may be selected from a single bond, O, and S,
R₄₀₁ and R₄₀₂ may each independently be selected from hydrogen, deuterium, - F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, and a substituted or unsubstituted monovalent non-aromatic condensed 8- to 60-membered heteropolycyclic group -Si(Q₄₀₁)(Q₄₀₂)(Q₄₀₃), -N(Q₄₀₁)(Q₄₀₂), -B(Q₄₀₁)(Q₄₀₂),-C(=O)(Q₄₀₁), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from 0 to 10, and
in Formula 402, ^{∗} and ^{∗}' may each indicate a binding site to M of Formula 401.

In one embodiment, in Formula 402, A₄₀₁ and A₄₀₂ may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen and X₄₀₂ may be carbon, or ii) both X₄₀₁ and X₄₀₂ may be nitrogen.

In one or more embodiments, in Formula 402, R₄₀₁ and R₄₀₂ may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornanyl group, and a norbornenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, in Formula 401, when xc1 is 2 or more, two A₄₀₁(s) selected from 2 or more L₄₀₁(s) may be optionally linked through a linking group (e.g., X₄₀₇ or X₄₀₈), as in Compounds PD1 to PD4 and PD7. X₄₀₇ and X₄₀₈ may each independently be selected from a single bond, ^{∗}-O-^{∗}', ^{∗}-S-^{∗}', ^{∗}-C(=O)-^{∗}', ^{∗}-N(Q₄₁₃)-^{∗}', ^{∗}-C(Q₄₁₃)(Q₄₁₄)-^{∗}', and ^{∗}-C(Q₄₁₃)=C(Q₄₁₄)-^{∗}' (wherein Q₄₁₃ and Q₄₁₄ may each independently be selected from hydrogen, deuterium, a C₁-C₂₀ alkyl group, a C₁-C₂₀ alkoxy group, a phenyl group, a biphenyl group, a terphenyl group, and a naphthyl group), but embodiments of the present disclosure are not limited thereto.

In Formula 401, L₄₀₂ may be a monovalent, divalent, or trivalent organic ligand. For example, L₄₀₂ in Formula 401 may be selected from halogen, a diketone (for example, an acetylacetonate), a carboxylic acid (for example, a picolinate), -C(=O), an isonitrile, -CN, and a phosphorus-based ligand (for example, a phosphine and/or a phosphite), but embodiments of the present disclosure are not limited thereto.

In some embodiments, the phosphorescent dopant may be, for example, selected from Compounds PD1 to PD25, but embodiments of the present disclosure are not limited thereto:

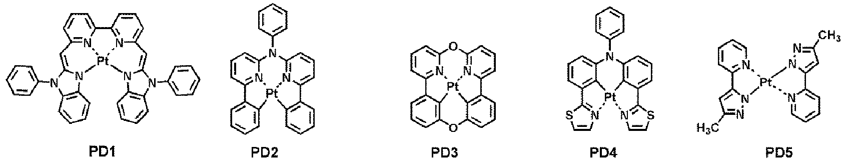

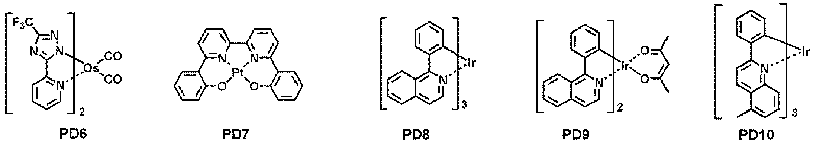

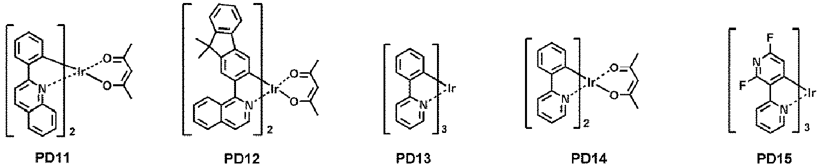

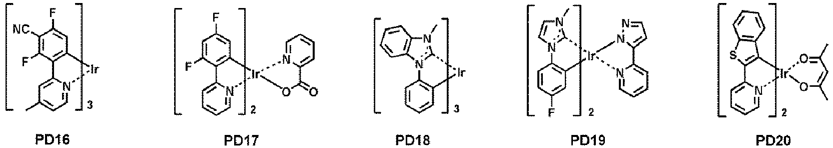

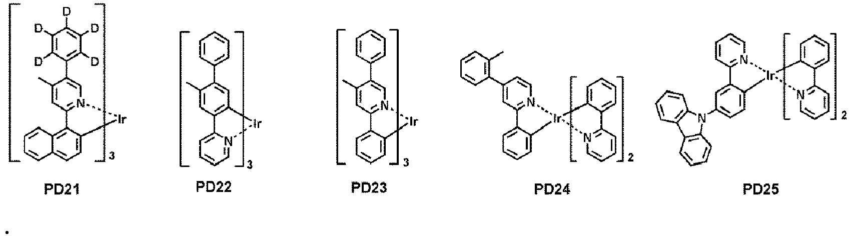

The fluorescent dopants comprised in each of the first emission layer 213-1, the second emission layer 213-2, and the third emission layer 213-3 may each independently comprise an arylamine compound or a styrylamine compound.

In one embodiment, the fluorescent dopants comprised in the first emission layer 213-1, the second emission layer 213-2, and the third emission layer 213-3 may each independently comprise a compound represented by Formula 501:

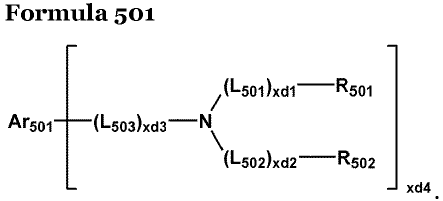

In Formula 501,
Ar₅₀₁ may be selected from a substituted or unsubstituted C₅-C₆₀ carbocyclic group and a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group,
xd1 to xd3 may each independently be an integer selected from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, and a substituted or unsubstituted monovalent non-aromatic condensed 8- to 60-membered heteropolycyclic group, and
xd4 may be an integer selected from 1 to 6.

In one embodiment, in Formula 501, Ar₅₀₁ may be selected from the group consisting of:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, in Formula 501, L₅₀₁ to L₅₀₃ may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, in Formula 501, R₅₀₁ and R₅₀₂ may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, in Formula 501, xd4 may be 2, but embodiments of the present disclosure are not limited thereto.

For example, the fluorescent dopant may be selected from Compounds FD1 to FD22:

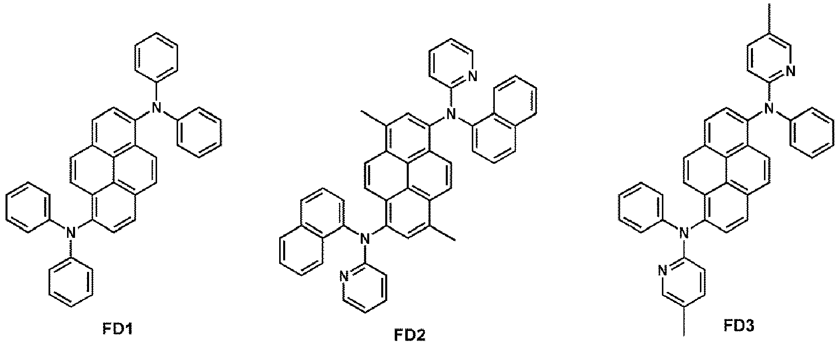

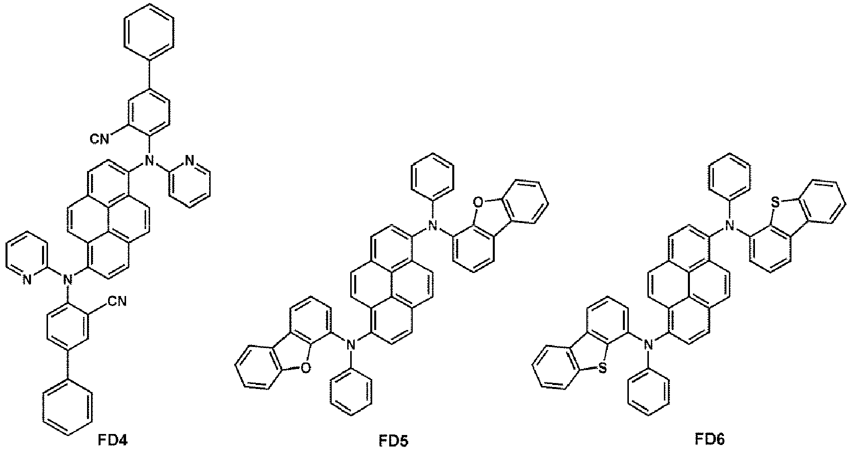

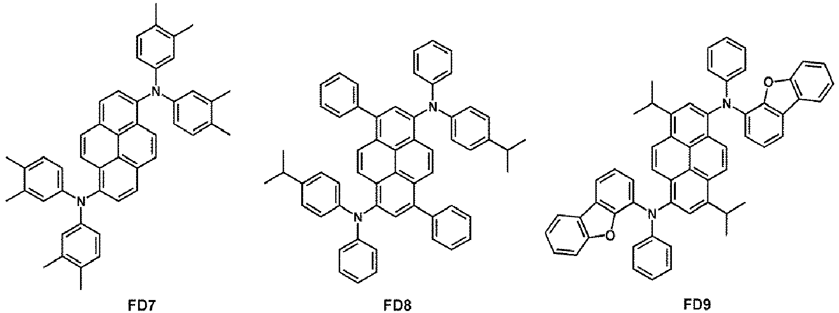

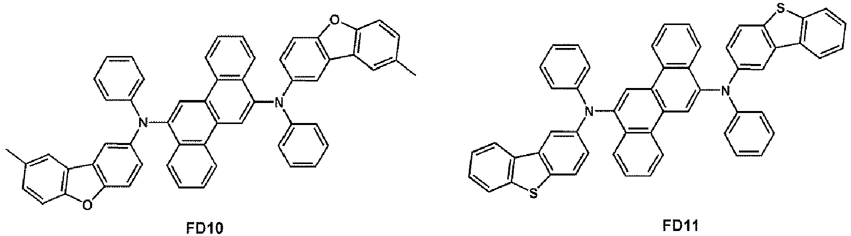

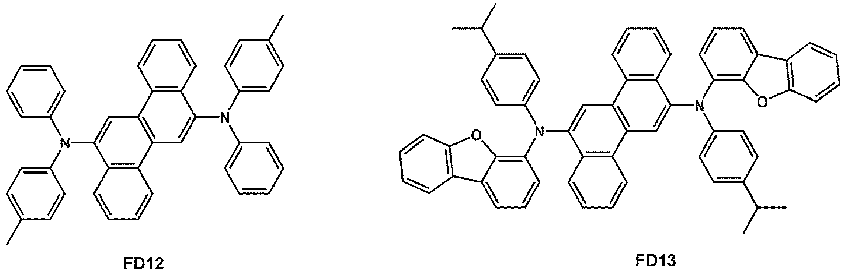

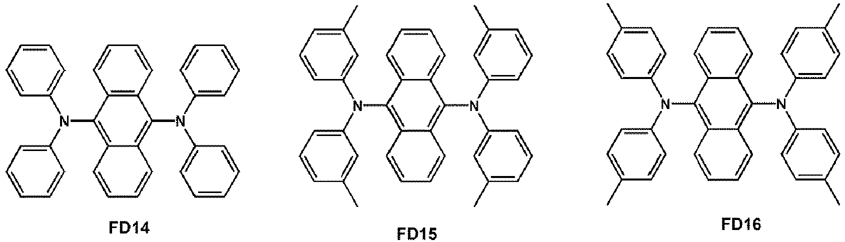

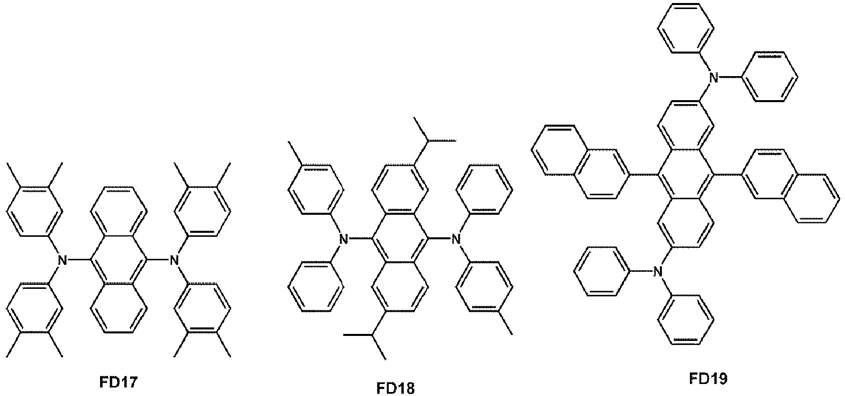

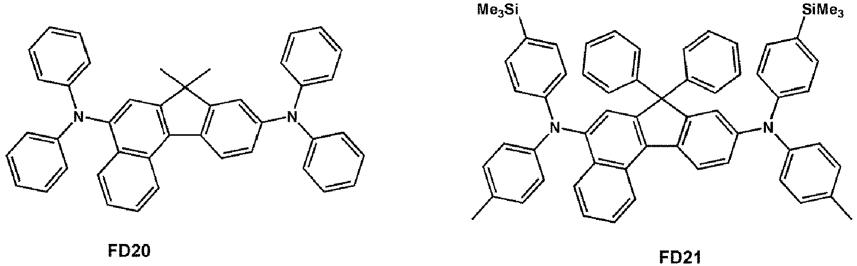

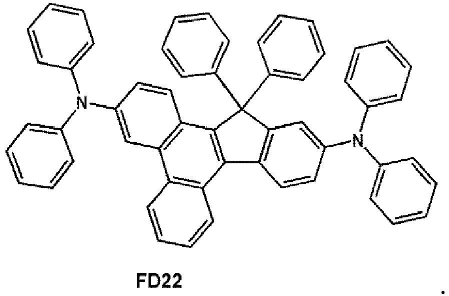

Alternatively, the fluorescent dopant may be selected from the compounds below, but embodiments of the present disclosure are not limited thereto:

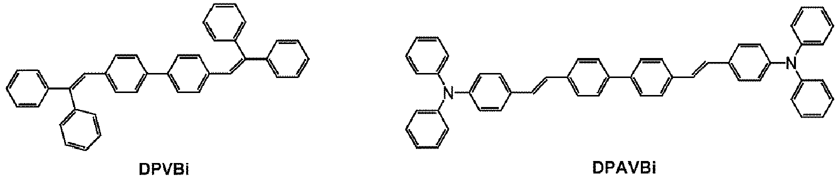

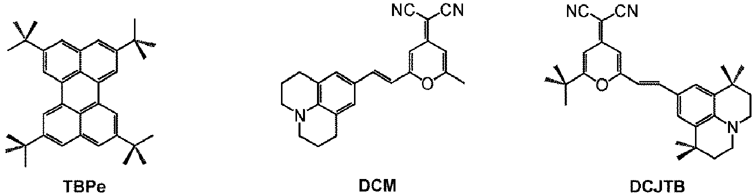

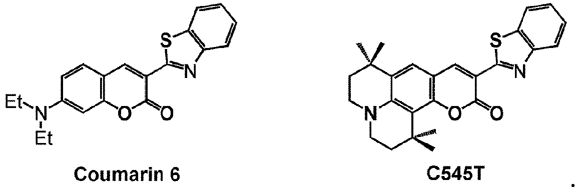

The amounts of the dopants comprised in the first emission layer 213-1, the second emission layer 213-2, and the third emission layer 213-3 may each independently be about 0.01 to about 15 parts by weight based on 100 parts by weight of the host, but embodiments of the present disclosure are not limited thereto.

The thicknesses of the first emission layer 213-1, the second emission layer 213-2, and the third emission layer 213-3 may each independently be about 100 Å to about 1,000 Å, and in some embodiments, about 200 Å to about 600 Å. When the thicknesses of the first emission layer 213-1, the second emission layer 213-2, and the third emission layer 213-3 are each independently within these ranges, excellent emission characteristics may be obtained without a substantial increase in driving voltage.

The electron transport region 211 may be on the emission layer, and the electron transport region 211 may comprise the electron transport layer 215 and the electron injection layer 217.

The electron transport layer 215 and the electron injection layer 217 may each independently be formed using one or more suitable methods selected from vacuum deposition, spin coating, casting, an LB method, ink-jet printing, laser-printing, and LITI.

The electron transport region 211 may have i) a single-layer structure including a single layer including a single material, ii) a single-layer structure including a single layer comprising a plurality of different materials, or iii) a multi-layer structure comprising a plurality of layers comprising a plurality of different materials.

The electron transport region 211 may comprise a buffer layer, a hole blocking layer, an electron control layer, an electron transport layer (ETL), an electron injection layer, or a combination thereof, but embodiments of the layers are not limited thereto. As used herein, the terms "combination", "combination thereof" and "combinations thereof" may refer to a chemical combination (e.g., an alloy or chemical compound), a mixture, or a laminated structure of components.

For example, the electron transport region 211 may have a structure of electron transport layer/electron injection layer, a structure of hole blocking layer/electron transport layer/electron injection layer, a structure electron control layer/electron transport layer/electron injection layer, or a structure of buffer layer/electron transport layer/electron injection layer, wherein layers of each structure are sequentially stacked on the emission layer in these stated orders, but embodiments of the structure of the electron transport region 211 are not limited thereto. In the drawing, the electron transport region 211 comprises the electron transport layer 215 and the electron injection layer 217.

The electron transport region 211 (for example, a buffer layer, a hole blocking layer, an electron control layer, and/or an electron transport layer 215 in the electron transport region 211) may comprise a metal-free compound containing at least one π electron-depleted nitrogen-containing ring.

The term "π electron-depleted nitrogen-containing ring" indicates a C₁-C₆₀ heterocyclic group comprising at least one ^{∗}-N=^{∗}' moiety as a ring-forming moiety.

For example, the "π electron-depleted nitrogen-containing ring" may be i) a 5-membered to 7 membered heteromonocyclic group having at least one ^{∗}-N=^{∗}' moiety, ii) a heteropolycyclic group in which at least two or more 5-membered to 7 membered heteromonocyclic groups each having at least one ^{∗}-N=^{∗}' moiety are condensed (e.g., fused) with each other, or iii) a heteropolycyclic group in which at least one 5-membered to 7-membered hetero monocyclic group having at least one ^{∗}-N=^{∗}' moiety is condensed (e.g., fused) with at least one C₅-C₆₀ carbocyclic group.

Non-limiting examples of the π electron-depleted nitrogen-containing ring may include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, a thiadiazole, an imidazopyridine, an imidazopyrimidine, and/or an azacarbazole, but embodiments of the present disclosure are not limited thereto.

In some embodiments, the electron transport region 211 may comprise a compound represented by Formula 601:

**Formula 601** [Ar₆₀₁]ₓₑ₁₁-[(L₆₀₁)ₓₑ₁-R₆₀₁]ₓₑ₂₁.

In Formula 601,
Ar₆₀₁ may be selected from a substituted or unsubstituted C₅-C₆₀ carbocyclic group and a substituted or unsubstituted C₁-C₆₀ heterocyclic group,
xe11 may be selected from 1, 2, and 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group,
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, a substituted or unsubstituted monovalent non-aromatic condensed 8- to 60-membered heteropolycyclic group, -Si(Q₆₀₁)(Q₆₀₂)(Q₆₀₃), - -C(=O)(Q₆₀₁), -S(=O)₂(Q₆₀₁), and - P(=O)(Q₆₀₁)(Q₆₀₂), wherein Q₆₀₁ to Q₆₀₃ may each independently be selected from a C₁-C₁₀ alkyl group, a C₁-C₁₀ alkoxy group, a phenyl group, a biphenyl group, a terphenyl group, and a naphthyl group, and
xe2i may be an integer selected from 1 to 5.

In one embodiment, at least one selected from the xe11 Ar₆₀₁(s) and one selected from the xe21 R₆₀₁(S) may comprise the π electron-depleted nitrogen-containing ring as described above.

In one embodiment, in Formula 601, ring Ar₆₀₁ may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In Formula 601, when xe11 is 2 or more, 2 or more Ar₆₀₁(s) may be linked through a single bond.

In one or more embodiments, in Formula 601, Ar₆₀₁ may comprise an anthracene group.

In one or more embodiments, the compound of Formula 601 may be represented by Formula 601-1:

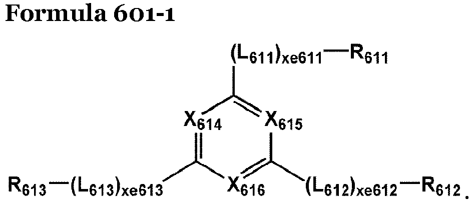

In Formula 601-1,
X₆₁₄ may be selected from N and C(R₆₁₄), X₆₁₅ may be selected from N and C(R₆₁₅), and X₆₁₆ may be selected from N and C(R₆₁₆), wherein at least one selected from X₆₁₄ to X₆₁₆ may be N,
L₆₁₁ to L₆₁₃ may each independently be the same as described herein in connection with L₆₀₁,
xe611 to xe613 may each independently be the same as described herein in connection with xei,
R₆₁₁ to R₆₁₃ may each independently be the same as described herein in connection with R₆₀₁, and
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one embodiment, in Formulae 601 and 601-1, L₆₀₁ and L₆₁₁ to L₆₁₃ may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but embodiments of the present disclosure are not limited thereto.

In one or more embodiments, in Formulae 601 and 601-1, xe1 and xe611 to xe613 may each independently be selected from 0, 1, and 2.

In one or more embodiments, in Formulae 601 and 601-1, R₆₀₁ and R₆₁₁ to R₆₁₃ may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

   -S(=O)₂(Q₆₀₁) and -P(=O)(Q₆₀₁)(Q₆₀₂),
wherein Q₆₀₁ and Q₆₀₂ may each independently be the same as described above.

The electron transport region 211 may comprise at least one compound selected from Compounds ET1 to ET36, but embodiments of the present disclosure are not limited thereto:

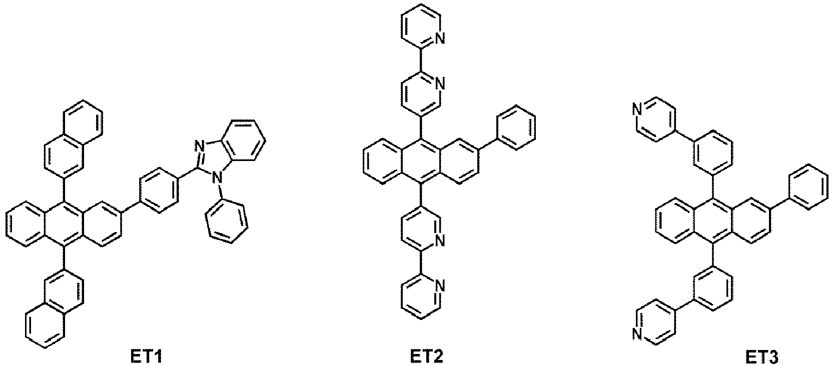

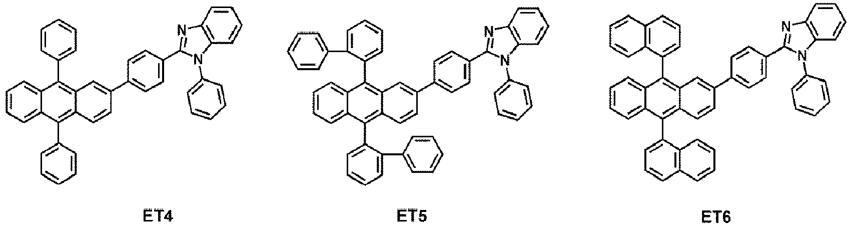

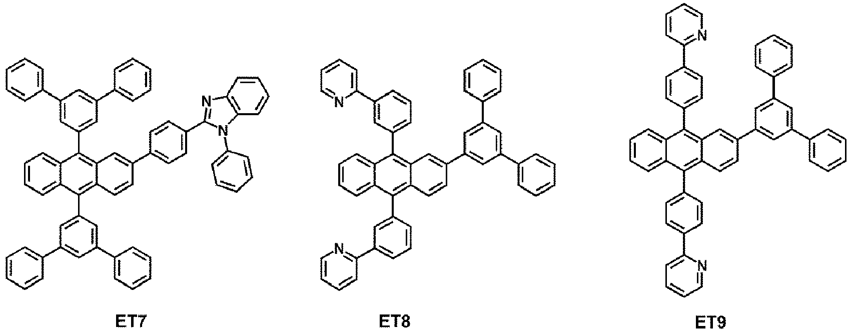

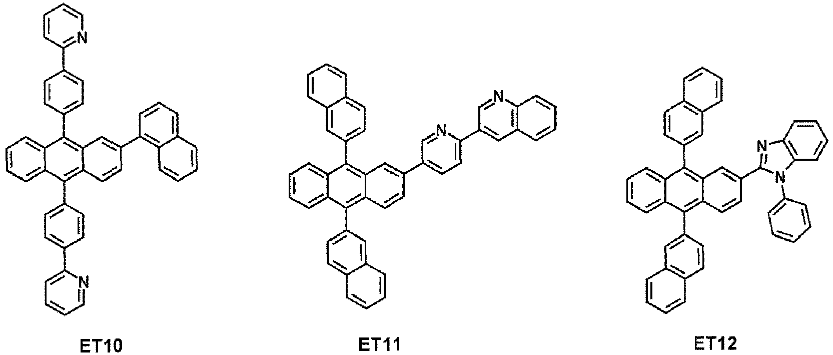

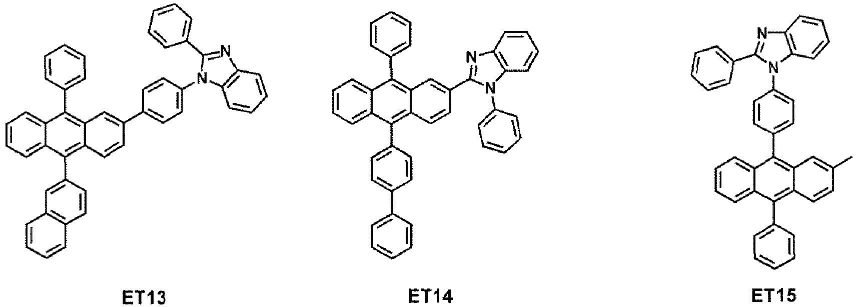

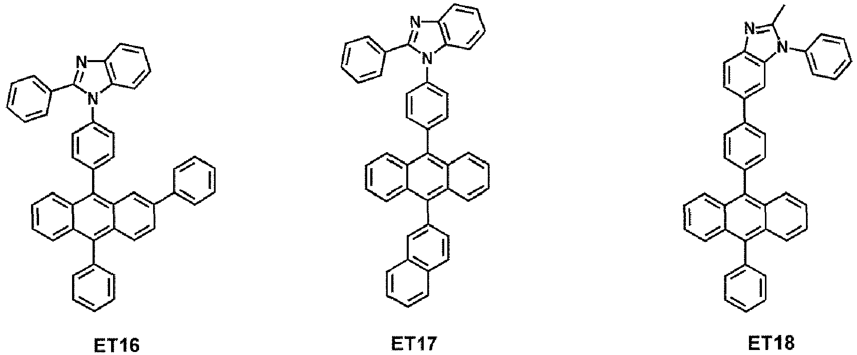

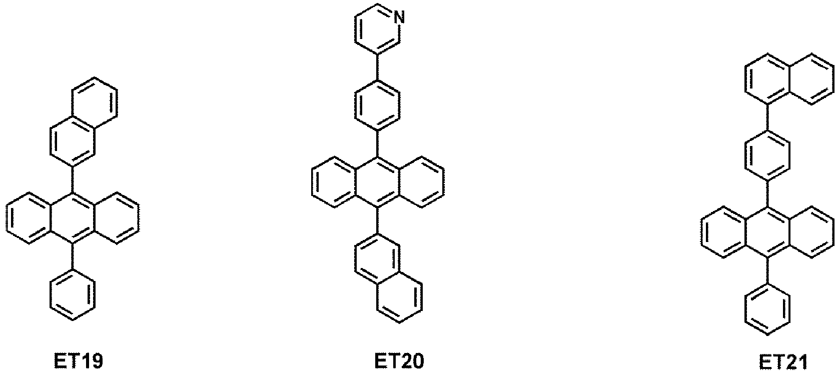

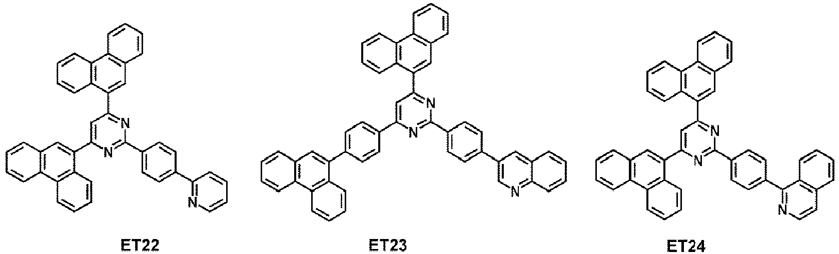

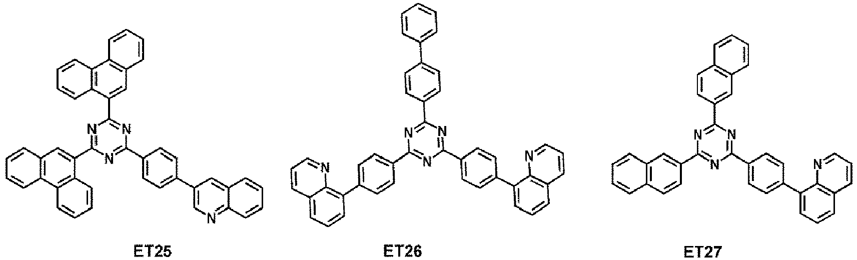

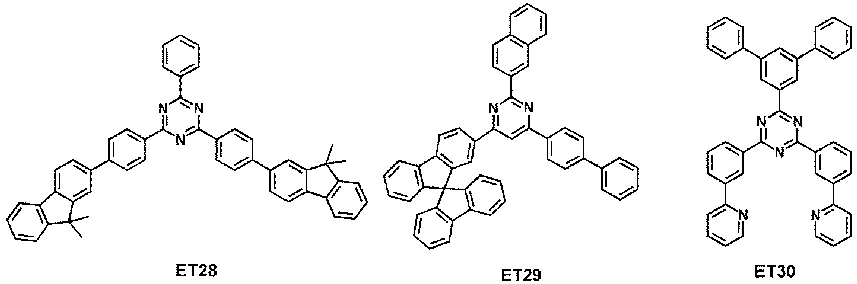

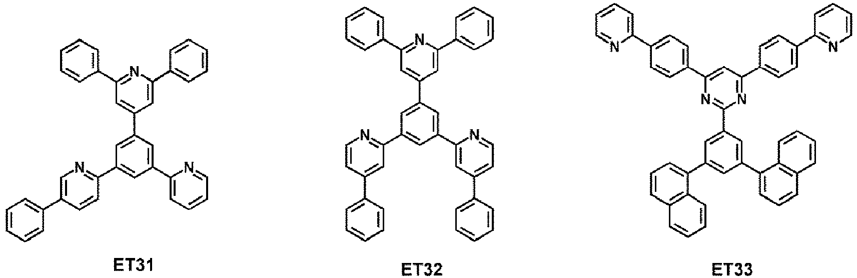

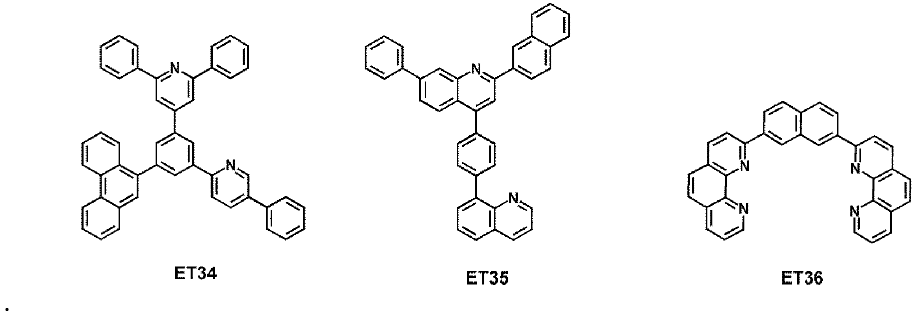

Alternatively, the electron transport region 211 may comprise at least one selected from 2,9-dimethyl-4,7-diphenyl-1,10-phenanthroline (BCP), 4,7-diphenyl-1,10-phenanthroline (Bphen), Alq₃, Balq, 3-(biphenyl-4-yl)-5-(4-*tert*-butylphenyl)-4-phenyl-4*H*-1,2,4-triazole (TAZ), and NTAZ:

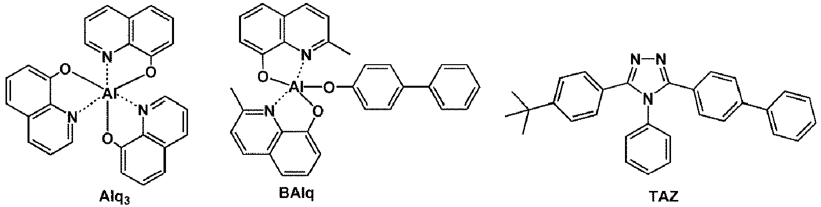

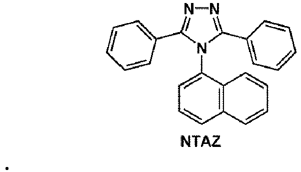

The thicknesses of the buffer layer, the hole blocking layer, and/or the electron control layer may each independently be about 20 Å to about 1,000 Å, and in some embodiments, about 30 Å to about 300 Å. When the thicknesses of the buffer layer, the hole blocking layer, and/or the electron control layer are each independently within these ranges, excellent hole blocking characteristics and/or electron adjustment characteristics may be obtained without a substantial increase in driving voltage.

The thickness of the electron transport layer 215 may be about 100 Å to about 1,000 Å, and in some embodiments, about 150 Å to about 500 Å. When the thickness of the electron transport layer 215 is within these ranges, satisfactory electron transport characteristics may be obtained without a substantial increase in driving voltage.

The electron transport region 211 (for example, the electron transport layer 217 comprised in the electron transport region 211) may further comprise, in addition to the materials as described above, a metal-containing material.

The metal-containing material may comprise at least one selected from an alkali metal complex and an alkaline earth metal complex. The alkali metal complex may comprise a metal ion selected from a Li ion, a sodium (Na) ion, a potassium (K) ion, a rubidium (Rb), and a cesium (Cs) ion, and the alkaline earth metal complex may comprise a metal ion selected from a Be ion, a Mg ion, a Ca ion, a strontium (Sr) ion, and a barium (Ba) ion. Each ligand coordinated with the metal ion of the alkali metal complex or the alkaline earth-metal complex may independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments of the present disclosure are not limited thereto.

For example, the metal-containing material may comprise a Li complex. The Li complex may comprise, for example, Compound ET-D1 (8-hydroxyquinolinolato-lithium, LiQ) and/or Compound ET-D2:

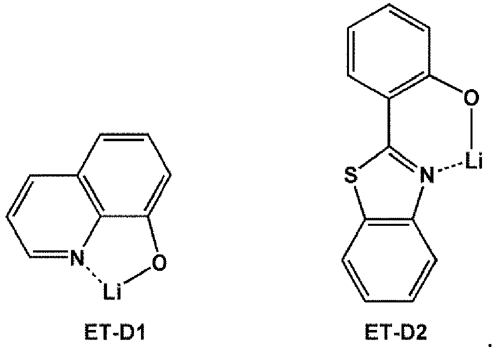

The electron transport region 211 may comprise the electron injection layer 217 that facilitates injection of electrons from the second electrode 219. The electron injection layer 217 may directly contact the second electrode 219.

The electron injection layer 217 may have i) a single-layer structure including a single layer including a single material, ii) a single-layer structure including a single layer comprising a plurality of different materials, or iii) a multi-layer structure comprising a plurality of layers formed of a plurality of different materials.

The electron injection layer 217 may comprise an alkali metal, an alkaline earth metal, a rare earth based metal, an alkali metal compound, an alkaline earth metal compound, a rare earth based metal compound, an alkali metal complex, an alkaline earth metal complex, a rare earth based metal complex, or a combination thereof.

The alkali metal may be selected from lithium (Li), sodium (Na), potassium (K), rubidium (Rb), and cesium (Cs). In one embodiment, the alkali metal may be selected from Li, Na, and Cs. In one embodiment, the alkali metal may be selected from Li and Cs, but embodiments of the present disclosure are not limited thereto.

The alkali earth metal may be selected from magnesium (Mg), calcium (Ca), strontium (Sr), and barium (Ba).

The rare earth metal may be selected from scandium (Sc), yttrium (Y), cerium (Ce), ytterbium (Yb), gadolinium (Gd), and terbium (Tb).

The alkali metal compound, the alkaline earth metal compound, and the rare earth metal compound may be respectively selected from oxides and halides (for example, fluorides, chlorides, bromides, and/or idodides) of the alkali metal, the alkaline earth metal, and rare earth metal.

The alkali metal compound may be selected from alkali metal oxides (such as Li₂O, Cs₂O, and/or K₂O), and alkali metal halides (such as LiF, NaF, CsF, KF, LiI, NaI, CsI, and/or KI). In one or more embodiments, the alkali metal compound may be selected from LiF, Li₂O, NaF, LiI, NaI, CsI, and KI, but embodiments of the present disclosure are not limited thereto.

The alkaline earth metal compound may be selected from alkaline earth metal oxides (such as BaO, SrO, CaO, BaxSr₁₋ₓO (0<x<1), and/or BaₓCa₁₋ₓO (0<x<1)). In one or more embodiments, the alkaline earth metal compound may be selected from BaO, SrO, and CaO, but embodiments of the present disclosure are not limited thereto.

The rare earth metal compound may be selected from YbF₃, ScF₃, ScO₃, Y₂O₃, Ce₂O₃, GdF₃, and TbF₃. In one or more embodiments, the rare earth metal compound may be selected from YbF₃, ScF₃, TbF₃, YbI₃, ScI₃, and TbI₃, but embodiments of the present disclosure are not limited thereto.

The alkali metal complex, the alkaline earth metal complex, and the rare earth metal complex may each comprise an alkali metal ion, an alkaline earth metal ion, and a rare earth metal ion as described above, respectively, and each ligand coordinated with a metal ion of the alkali metal complex, the alkaline earth metal complex, and the rare earth metal complex may independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments of the present disclosure are not limited thereto.

The electron injection layer 217 may comprise only the alkali metal, the alkaline earth metal, the rare earth based metal, the alkali metal compound, the alkaline earth metal compound, the rare earth based metal compound, the alkali metal complex, the alkaline earth metal complex, the rare earth based metal complex, or a combination thereof as described above. In some embodiments, the electron injection layer 217 may further comprise (in addition to the alkali metal, the alkaline earth metal, the rare earth metal, the alkali metal compound, the alkaline earth metal compound, the rare earth metal compound, the alkali metal complex, the alkaline earth metal complex, the rare earth metal complex, or a combination thereof) an organic material. When the electron injection layer 217 comprises the organic material, the alkali metal, the alkaline earth metal, the rare earth based metal, the alkali metal compound, the alkaline earth metal compound, the rare earth metal compound, the alkali metal complex, the alkaline earth metal complex, the rare earth metal complex, or the combination thereof may be homogeneously or non-homogeneously dispersed in a matrix comprising the organic material.

The thickness of the electron injection layer 217 may be about 1 Å to about 100 Å, and in some embodiments, about 3 Å to about 90 Å. When the thickness of the electron injection layer 217 is within these ranges, satisfactory electron injection characteristics may be obtained without a substantial increase in driving voltage.

The electron transport region 211 may further comprise a hole blocking layer. Here, the hole blocking layer may be between the emission layer and the electron transport layer 215.

The hole blocking layer may comprise, for example, at least one selected from BCP and Bphen, but embodiments of the present disclosure are not limited thereto:

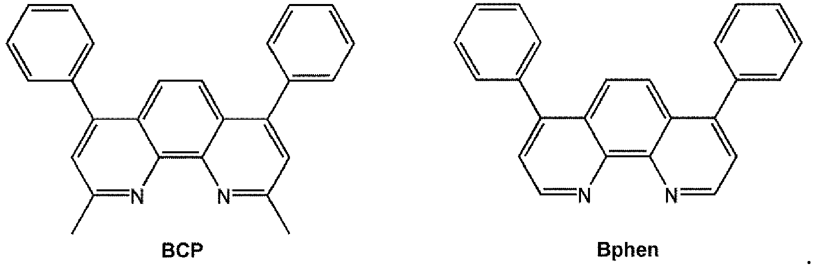

The thickness of the hole blocking layer may be about 20 Å to about 1,000 Å, and in some embodiments, about 30 Å to about 300 Å. When the thickness of the hole blocking layer is within these ranges, excellent hole blocking characteristics may be obtained without a substantial increase in driving voltage.

The second electrode 219 may be on the electron transport region 211. The second electrode 219 may be a cathode which is an electron injection electrode, and in this regard, a material for forming the second electrode 219 may be selected from a metal, an alloy, an electrically conductive compound, and a mixture thereof, each having a relatively low work function. Non-limiting examples of the material for forming the second electrode 219 may comprise Li, Mg, Ag, Al, Al-Li, Ca, Mg-In, and Mg-Ag. In some embodiments, the material for forming the second electrode 219 may be selected from ITO and IZO. The second electrode 219 may be a reflective electrode, a semi-transmissive electrode, or a transmissive electrode.

The first set of electrodes 203 and the second electrode 219 may be selected such that the organic light-emitting device 200 comprising the first set of electrodes 203 and the second electrode 219 has a resonance structure (e.g., uses the resonance or microcavity effect to achieve high efficiency and/or color purity). For example, when the first set of electrodes 203 is a reflective electrode and the second electrode 219 is a semi-transmissive electrode, the organic light-emitting device 200 comprising the first set of electrodes 203 and the second electrode 219 may be a top-emitting device having a resonance structure. Alternatively, when the first set of electrodes 203 is a semi-transmissive set of electrodes and the second electrode 219 is a reflective electrode, the organic light-emitting device 200 comprising the first set of electrodes 203 and the second electrode 219 may be a bottom-emitting device having a resonance structure.

For example, when first set of electrodes 203 is a reflective set of electrode and the second electrode 219 is a semi-transmissive electrode, the organic light-emitting device 200 comprising the first set of electrodes 203 and the second electrode 219 may satisfy Equations 1 to 3 such that the first color light, the second color light, and the third color light may exhibit resonance between the first set of electrodes 203 (which is a reflective set of electrodes) and the second electrode 210 (which is a semi-transmissive electrode): $\frac{{λ}_{1}}{2 {n}_{1}} ⋅ {m}_{1} - \frac{{λ}_{1}}{10} \leq {D}_{11} \leq \frac{{λ}_{1}}{2 {n}_{1}} ⋅ {m}_{1} + \frac{{λ}_{1}}{10} ,$ $\frac{{λ}_{2}}{2 {n}_{2}} ⋅ {m}_{2} - \frac{{λ}_{2}}{10} \leq {D}_{12} \leq \frac{{λ}_{2}}{2 {n}_{2}} ⋅ {m}_{2} + \frac{{λ}_{2}}{10} ,$ $\frac{{λ}_{3}}{2 {n}_{3}} ⋅ {m}_{3} - \frac{{λ}_{3}}{10} \leq {D}_{13} \leq \frac{{λ}_{3}}{2 {n}_{3}} ⋅ {m}_{3} + \frac{{λ}_{3}}{10} .$

In Equations 1 to 3,
D₁₁ indicates the distance between the electrode 203 on the first sub-pixel and the second electrode 219,
D₁₂ indicates the distance between the electrode 203 on the second sub-pixel and the second electrode 219,
D₁₃ indicates the distance between the electrode 203 on the third sub-pixel and the second electrode 219,
λ₁, λ₂, and λ₃ independently indicate a wavelength of the first color light, a wavelength of the second color light, and a wavelength of the third color light, respectively,
n₁ indicates the refractive index of the layers between the electrode 203 on the first sub-pixel and the second electrode 219;
n₂ indicates the refractive index of the layers between the electrode 203 on the second sub-pixel and the second electrode 219;
n₃ indicates the refractive index of the layers between the electrode 203 on the third sub-pixel and the second electrode 219, and
m₁, m₂, and m₃ are each independently a natural number. For example, m1, m2, and m3 may be each independently a natural number in the range of 1 to 10.

When the organic light-emitting device 200 satisfies Equations 1 to 3, the first color light, the second color light, and the third color light may be emitted toward the organic light-emitting device 200 by traveling (in a resonant manner) through the space between the first set of electrodes 203 and the second electrode 219 and by passing through the second electrode 219 according to the principle of constructive interference, thereby improving the efficiency of the organic light-emitting device 200.

In Equations 1 to 3, m₁, m₂, and m₃ may each be 1.

In Equations 1 to 3, when m₁, m₂, and m₃ are each 1, the distance D₁ between the electrode 203 on the first sub-pixel and the first emission layer 213-1 may be about 400 Å to 1,000 Å, and in some embodiments, about 500 Å to about 900 Å; the distance D₂ between the electrode 203 on the second sub-pixel and the second emission layer 213-2 may be about 300 Å to about 900 Å, and in some embodiments, about 400 Å to about 800 Å; and a distance D₃ between the electrode 203 on the third sub-pixel and the third emission layer 213-3 may be about 200 Å to about 800 Å, and in some embodiments, about 300 Å to about 700 Å, but embodiments of the distances D₁ to D₃ are not limited thereto.

In some embodiments, in Equations 1 to 3, m₁, m₂, and m₃ may each be 2.

In Equations 1 to 3, when m₁, m₂, and m₃ are each 2, the distance D₁ between the electrode 203 on the first sub-pixel and the first emission layer 213-1 may be about 1,600 Å to 2,300 Å, and in some embodiments, about 1,700 Å to about 2,100 Å; the distance D₂ between the electrode 203 on the second sub-pixel and the second emission layer 213-2 may be about 1,300 Å to 2,000 Å, and in some embodiments, about 1,400 Å to about 1,900 Å; and the distance D₃ between the electrode 203 on the third sub-pixel and the third emission layer 213-3 may be about 900 Å to 1,800 Å, and in some embodiments, about 1,000 Å to about 1,600 Å.

When the distances D₁ to D₃ are within these ranges, suitable (e.g., optimum) constructive interference may occur during the resonance associated with each of the first color light, the second color light, and the third color light. In some embodiments, the organic light-emitting device 200 emits light upon radiation of excitons (e.g., exciton-derived radiation). Here, the radiation of excitons may be considered as electric dipole radiation. A weak microcavity phenomenon refers to a case in which the damping rate of dipoles is reduced under the influence of a reflector-induced image dipole when dipole radiation is targeted at a position at a distance equal to or less than the wavelength of light to be emitted in a powerful reflector, and accordingly, the intensity of the radiation is changed. When the distances D₁ to D₃ are within these ranges described above, the emission efficiencies of the first color light, the second color light, and the third color light may be improved using the weak microcavity phenomenon.

The distances D₁ to D₃ may satisfy the relationship D₁>D₂=D₃.

In one embodiment, the thickness of the first auxiliary layer 214-1 may be greater than the thickness of the second auxiliary layer 214-2, but embodiments of the present disclosure are not limited thereto.

In one or more embodiments, the thicknesses of the first auxiliary layer 214-1 and the second auxiliary layer 214-2 may each independently be about 50 Å to about 5,000 Å, and in some embodiments, about 200 Å to about 1,000 Å. When the thicknesses of the first auxiliary layer 214-1 and the second auxiliary layer 214-2 are within these ranges, satisfactory hole transport characteristics may be obtained without a substantial increase in driving voltage.

Hereinbefore, the organic light-emitting device 200 has been described with reference to the drawing, but embodiments of the present disclosure are not limited thereto.

For example, one or more suitable modifications of the organic light-emitting device 200 may comprise the following:
the hole transport region 201 in the organic light-emitting device 200 may have a single-layer structure comprising one selected from the hole injection layer 207 and the hole transport layer 209,
the organic light-emitting device 200 may comprise one selected from the first auxiliary layer 214-1 and the second auxiliary layer 214-2, or
the organic light-emitting device 200 may comprise both the first auxiliary layer 214-1 and the second auxiliary layer 214-2, wherein one selected from the first auxiliary layer 214-1 and the second auxiliary layer 214-2 comprises the first compound of Formula 1, and the other of the first auxiliary layer 214-1 and the second auxiliary layer 214-2 comprises the material which may be comprised in the hole transport region 201.

In some embodiments, the organic light-emitting device 200 may further comprise a capping layer arranged along the emission path of light produced from the emission layer.

The capping layer may increase the external luminescent efficiency according to the principle of constructive interference.

The capping layer may be an organic capping layer comprising an organic material, an inorganic capping layer comprising an inorganic material, or a composite capping layer comprising an organic material and an inorganic material.

The capping layer may comprise at least one selected from carbocyclic compounds, heterocyclic compounds, amine-based compounds, porphyrin derivatives, phthalocyanine derivatives, naphthalocyanine derivatives, alkali metal complexes, and alkaline earth-based complexes. The carbocyclic compound, the heterocyclic compound, and the amine-based compound may each be optionally substituted with a substituent containing at least one element selected from O, N, sulfur (S), selenium (Se), silicon (Si), fluorine (F), chlorine (Cl), bromine (Br), and iodine (I).

In one or more embodiments, the capping layer may comprise an amine-based compound.

In one or more embodiments, the capping layer may comprise a compound represented by Formula 201 and/or a compound represented by Formula 202.

In one or more embodiments, the capping layer may comprise a compound selected from Compounds HT28 to HT33 and Compounds CP1 to CP5, but embodiments of the present disclosure are not limited thereto:

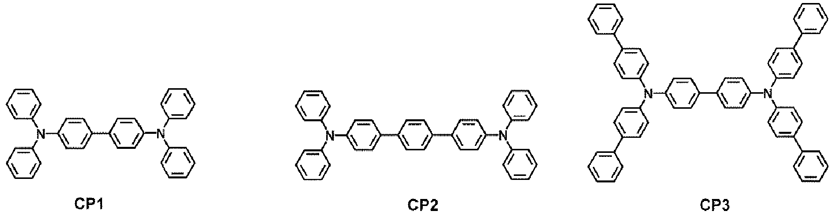

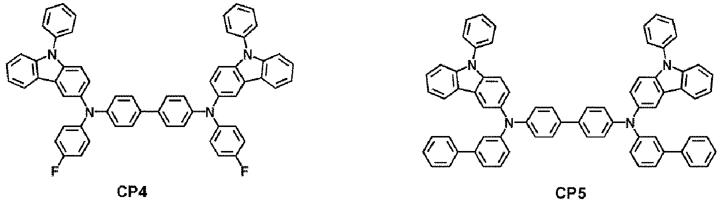

The layers constituting the hole transport region 201, the emission layer, the layers constituting the electron transport region 211, the first auxiliary layer 214-1, and the second auxiliary layer 214-2 may each be formed in a specific region using one or more suitable methods selected from vacuum deposition, spin coating, casting, an LB method, ink-jet printing, laser-printing, and LITI.

When the layers constituting the hole transport region 201, the emission layer, the layers constituting the electron transport region 211, the first auxiliary layer 214-1, and the second auxiliary layer 214-2 are each formed by vacuum deposition, for example, the vacuum deposition may be performed at a deposition temperature of about 100°C to about 500°C, at a vacuum degree of about 10⁻⁸ to about 10⁻³ torr, and at a deposition rate of about 0.01 Å/sec to about 100 Å/sec, depending on the compound to be comprised in each layer, and the intended structure of each layer.

When the layers constituting the hole transport region 201, the emission layer, the layers constituting the electron transport region 211, the first auxiliary layer 214-1, and the second auxiliary layer 214-2 are formed by spin coating, for example, the spin coating may be performed at a coating rate of about 2,000 rpm to about 5,000 rpm and at a temperature of about 80°C to 200°C, depending on the compound to be comprised in each layer, and the intended structure of each layer.

The term "C₁-C₆₀ alkyl group" as used herein refers to a linear or branched monovalent aliphatic hydrocarbon group having 1 to 60 carbon atoms atoms e.g. 1 to 30 carbon atoms, 1 to 20 carbon atoms, 1 to 10 carbon atoms, 1 to 6 carbon atoms or 1 to 4 carbon atoms. Non-limiting examples thereof may include a methyl group, an ethyl group, a propyl group, an isobutyl group, a sec-butyl group, a *tert*-butyl group, a pentyl group, an iso-amyl group, and a hexyl group. The term "C₁-C₆₀ alkylene group" as used herein refers to a divalent group having substantially the same structure as the C₁-C₆₀ alkyl group.

The term "C₂-C₆₀ alkenyl group" as used herein refers to a hydrocarbon group having at least one carbon-carbon double bond in the body (e.g., middle) or at the terminus of the C₂-C₆₀ alkyl group, and non-limiting examples thereof may include an ethenyl group, a propenyl group, and a butenyl group. The term "C₂-C₆₀ alkenylene group" as used herein refers to a divalent group having substantially the same structure as the C₂-C₆₀ alkenyl group.

The term "C₂-C₆₀ alkynyl group" as used herein refers to a hydrocarbon group having at least one carbon-carbon triple bond in the body (e.g., middle) or at the terminus of the C₂-C₆₀ alkyl group, and non-limiting examples thereof may include an ethynyl group and a propynyl group. The term "C₂-C₆₀ alkynylene group" as used herein refers to a divalent group having substantially the same structure as the C₂-C₆₀ alkynyl group.

The term "C₁-C₆₀ alkoxy group" as used herein refers to a monovalent group represented by -O-A₁₀₁, (wherein A₁₀₁ is a C₁-C₆₀ alkyl group), and non-limiting examples thereof may include a methoxy group, an ethoxy group, and an isopropyloxy group.

The term "C₃-C₁₀ cycloalkyl group" as used herein refers to a monovalent saturated hydrocarbon monocyclic group having 3 to 10 carbon atoms, and non-limiting examples thereof may include a cyclopropyl group, a cyclobutyl group, a cyclopentyl group, a cyclohexyl group, and a cycloheptyl group. The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent monocyclic group having at least one heteroatom (e.g. 1, 2, 3, 4 or 5 hereoatoms) selected from N, O, Si, P, and S as a ring-forming atom and 1 to 10 carbon atoms, and non-limiting examples thereof may include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent monocyclic group that has 3 to 10 carbon atoms and at least one double bond in the ring thereof, and does not have aromaticity. Non-limiting examples of the C₃-C₁₀ cycloalkenyl group may include a cyclopentenyl group, a cyclohexenyl group, and a cycloheptenyl group. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent monocyclic group that has at least one heteroatom (e.g. 1, 2, 3, 4 or 5 hereoatoms) selected from N, O, Si, P, and S as a ring-forming atom, 1 to 10 carbon atoms, and at least one double bond in its ring. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system having 6 to 60 carbon atoms, e.g. 6 to 20 ring carbon atoms, 6 to 14 ring cabon atoms or 6 to 10 ring carbon atoms. The term "C₆-C₆₀ arylene group" as used herein refers to a divalent group having a carbocyclic aromatic system having 6 to 60 carbon atoms e.g. 6 to 20 ring carbon atoms, 6 to 14 ring cabon atoms or 6 to 10 ring carbon atoms. Non-limiting examples of the C₆-C₆₀ aryl group may include a phenyl group, a naphthyl group, an anthracenyl group, a phenanthrenyl group, a pyrenyl group, and a chrysenyl group. When the C₆-C₆₀ aryl group and the C₆-C₆₀ arylene group each comprise two or more rings, the rings may be fused (e.g., condensed).

The term "C₁-C₆₀ heteroaryl group" as used herein refers to a monovalent group having a carbocyclic aromatic system that has at least one heteroatom (e.g. 1, 2, 3, 4 or 5 hereoatoms) selected from N, O, Si, P, and S as a ring-forming atom and 1 to 60 carbon atoms. The term "C₁-C₆₀ heteroarylene group" as used herein refers to a divalent group having a carbocyclic aromatic system that has at least one heteroatom selected from N, O, P, and S as a ring-forming atom, and 1 to 60 carbon atoms e.g. 1 to 19 ring carbon atoms, 1 to 13 ring cabon atoms or 1 to 9 ring carbon atoms. Non-limiting examples of the C₁-C₆₀ heteroaryl group may include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each comprise two or more rings, the rings may be fused (e.g., condensed).

The term "C₆-C₆₀ aryloxy group" as used herein indicates -O-A₁₀₂ (wherein A₁₀₂ is a C₆-C₆₀ aryl group), and the term "C₆-C₆₀ arylthio group" as used herein indicates -S-A₁₀₃ (wherein A₁₀₃ is a C₆-C₆₀ aryl group).

The term "monovalent non-aromatic condensed C8 to 60 polycyclic group" as used herein refers to a monovalent group that has two or more rings condensed (e.g., fused), 8 to 60 carbon atoms as the only ring-forming atoms (for example, 8 to 20, 8 to 14 or 8 to 10 ring carbon atoms), and non-aromaticity in the entire molecular structure. Non-limiting examples of the monovalent non-aromatic condensed C8 to 60 polycyclic group include a fluorenyl group and a spiro-bifluorenyl group. The term "divalent non-aromatic condensed C8 to 60 polycyclic group" as used herein refers to a divalent group having substantially the same structure as the monovalent non-aromatic condensed C8 to 60 polycyclic group.

The term "monovalent non-aromatic condensed 8- to 60-membered heteropolycyclic group" as used herein refers to a monovalent group that has two or more rings condensed (e.g., fused), has a heteroatom (e.g. 1, 2, 3, 4 or 5 hereoatoms) selected from N, O, Si, P, and S, other than carbon atoms (for example, 1 to 59, 2 to 59, 2 to 19, 2 to 13 or 2 to 9 ring carbon atoms), as a ring-forming atom, and has non-aromaticity in the entire molecular structure. An example of the monovalent non-aromatic hetero-condensed C8 to 60 polycyclic group is a carbazolyl group. The term "divalent non-aromatic condensed C8 to 60 heteropolycyclic group" as used herein refers to a divalent group having substantially the same structure as the monovalent non-aromatic condensed C8 to 60 heteropolycyclic group.

The term "C₅-C₆₀ carbocyclic group" as used herein refers to a C₅-C₆₀ monocyclic or polycyclic group including 5 to 60 carbon atoms as ther only ring-forming atoms e.g. 5 to 20 ring carbon atoms, 5 to 14 ring cabon atoms or 5 to 10 ring carbon atoms,. The C₅-C₆₀ carbocyclic group may be a saturated carbocyclic group or an unsaturated carbocyclic group. The C₅-C₆₀ carbocyclic group may include an aromatic carbocyclic group or a non-aromatic carbocyclic group. The C₅-C₆₀ carbocyclic group may include a ring (such as a benzene), a monovalent group (such as a phenyl group), or a divalent group (such as a phenylene group). Depending on the number of substituents linked with the C₅-C₆₀ carbocyclic group, the C₅-C₆₀ carbocyclic group may include a trivalent or tetravalent group.

The term "C₁-C₆₀ heterocyclic group" as used herein refers to a group (for example, having 1 to 60 carbon atoms) having substantially the same structure as the C₅-C₆₀ carbocyclic group, and at least one heteroatom (e.g. 1, 2, 3, 4 or 5 hereoatoms) selected from N, O, Si, P, and S as a ring-forming atom in addition to the carbon atoms.

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8 to 60 polycyclic group, a monovalent non-aromatic condensed 8- to 60-membered heteropolycyclic group, a biphenyl group, and a terphenyl group.

The expression "Ph" as used herein refers to a phenyl group, the expression "Me" as used herein refers to a methyl group, the expression "Et" as used herein refers to an ethyl group, the expression "*ter*-Bu" or "Bu^{t}" as used herein refers to a *tert*-butyl group, and the expression "OMe" as used herein refers to a methoxy group.

The term "biphenyl group" as used herein refers to "a phenyl group substituted with a phenyl group". In other words, a biphenyl group is a substituted phenyl group having a C₆-C₆₀ aryl group as a substituent.

The term "terphenyl group" as used herein refers to "a phenyl group substituted with a biphenyl group". In other words, a terphenyl group is a substituted phenyl group having a C₆-C₆₀ aryl group substituted with a C₆-C₆₀ aryl group as a substituent.

The symbols ^{∗} and ^{∗}' used herein, unless defined otherwise, refer to a binding site to a neighboring atom in a corresponding formula.

Hereinafter, an organic light-emitting device according to an embodiment of the present disclosure will be described in more detail with reference to Synthesis Examples and Examples. The wording "B was used instead of A" used in describing Synthesis Examples refers to that an identical number of molar equivalents of B was used in place of molar equivalents of A.

### Examples

### Example 1

As an anode, a glass substrate comprising an aluminum (Al) film having a thickness of 100 nm thereon was cut to a size of 50 mm × 50 mm × 0.7 mm, sonicated using isopropyl alcohol and pure water for 5 minutes each, cleaned by exposure to ultraviolet rays for 30 minutes, cleaned by exposure to ozone, and mounted on a vacuum deposition apparatus.

m-MTDATA was deposited on the Al anode to form a hole transport region having a thickness of 1,250 Å.

Compound A1 was deposited on the hole transport region to form a second auxiliary layer having a thickness of 350 Å. CBP (as a host) and Ir(ppy)₃ (as a dopant) were co-deposited on the second auxiliary layer at a weight ratio of 1:0.15, thereby forming a green emission layer having a thickness of 400 Å.

Compound Alq₃ was deposited on the green emission layer to form an electron transport layer having a thickness of 350 Å. LiQ was deposited on the electron transport layer to form an electron injection layer having a thickness of 10 Å, and MgAg was deposited on the electron injection layer to form a second electrode (i.e., a cathode) having a thickness of 140 Å, thereby completing the manufacture of an organic light-emitting device:

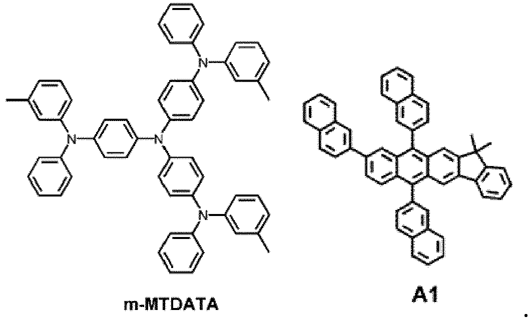

### Example 2

An organic light-emitting device was manufactured in substantially the same manner as in Example 1, except that Compound A1 and NPB were co-deposited at a weight ratio of 1:1 in forming the second auxiliary layer:

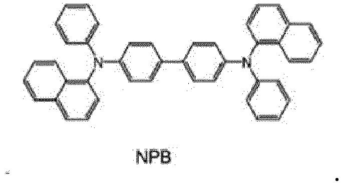

### Comparative Example 1

An organic light-emitting device was manufactured in substantially the same manner as in Example 1, except that ADN was used instead of Compound A1 in forming the second auxiliary layer.

### Evaluation Example 1

The driving voltage, efficiency, color coordinate, and lifespan (T₉₇) of each of the organic light-emitting devices of Examples 1 and 2 and Comparative Example 1 were measured using a Keithley MU 236 meter and a PR650 brightness measuring meter. The results thereof are shown in Table 1. Here, the lifespan (T₉₇) results were obtained by measuring the time at which the brightness of the organic light-emitting devices reached 97% of the initial brightness (e.g., compared to 100%) after being operated.

**Table 1**

| | Material for forming second auxiliary layer | Driving voltage (V) | Efficiency (cd/A) | Color coordinate (CIEx) | Lifespan (T₉₇) at 400 nits (hr) |
|---|---|---|---|---|---|
| Example 1 | Compound A1 | 6.0 | 100.2 | 0.228 | 50 |
| Example 2 | Compound A1 and NPB | 4.8 | 108.8 | 0.212 | 70 |
| Comparative Example 1 | ADN | 6.2 | 95.0 | 0.267 | 40 |

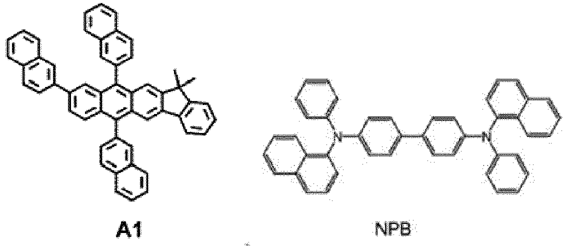

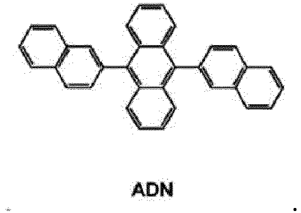

Referring to Table 1, it was confirmed that the organic light-emitting devices of Examples 1 and 2 each had lower driving voltage, higher efficiency, and longer lifespan than the organic light-emitting device of Comparative Example 1.

An organic light-emitting device according to an embodiment of the present disclosure may have low driving voltage, high efficiency, and long lifespan.

It should be understood that the embodiments described herein should be considered in a descriptive sense only and not for purposes of limitation. Descriptions of features or aspects within each embodiment should typically be considered as being available for other similar features or aspects in other embodiments.

As used herein, the terms "use", "using", and "used" may be considered synonymous with the terms "utilize", "utilizing", and "utilized", respectively. Further, the use of "may" when describing embodiments of the present disclosure refers to "one or more embodiments of the present disclosure".

As used herein, the terms "substantially", "about", and similar terms are used as terms of approximation and not as terms of degree, and are intended to account for the inherent deviations in measured or calculated values that would be recognized by those of ordinary skill in the art.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

While one or more embodiments have been described with reference to the drawings, it will be understood by those of ordinary skill in the art that various changes in form and details may be made therein without departing from the scope of the present invention as defined by the following claims.

## Claims

1. An organic light-emitting device comprising:
a substrate comprising a first sub-pixel, a second sub-pixel, and a third sub-pixel;
a first set of electrodes comprising an electrode on the first sub-pixel of the substrate, an electrode on the second sub-pixel of the substrate, and an electrode on the third sub-pixel of the substrate of the substrate;
a second electrode facing the first set of electrodes;
an emission layer between the first set of electrodes and the second electrode, the emission layer comprising: i) a first emission layer positioned between the electrode on the first sub-pixel and the second electrode configured to emit a first color light, ii) a second emission layer positioned between the electrode on the second sub-pixel and the second electrode configured to emit a second color light, and iii) a third emission layer positioned between the electrode on the third sub-pixel and the second electrode configured to emit a third color light;
a hole transport region between the first set of electrodes and the emission layer; and
at least one selected from a first auxiliary layer and a second auxiliary layer, the first auxiliary layer being between the hole transport region and the first emission layer, and the second auxiliary layer being between the hole transport region and the second emission layer,
the first color light being red color light, the second color light being green color light, and/or the third color light being blue color light, and
**characterised in that** at least one selected from the first auxiliary layer and the second auxiliary layer comprises a first compound represented by Formula 1: 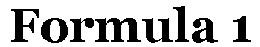 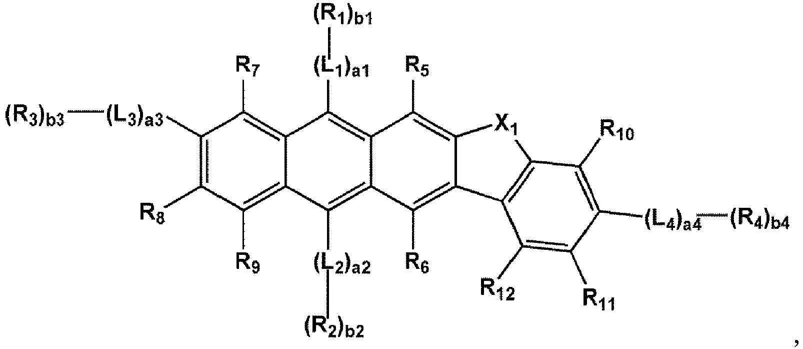
wherein, in Formula 1,
X₁ is selected from C(R₂₁)(R₂₂), Si(R₂₁)(R₂₂), N(R₂₁), O, S, S(=O), and S(=O)₂, L₁ to L₄ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8 to 60 polycyclic group, and a substituted or unsubstituted divalent non-aromatic condensed 8- to 60-membered heteropolycyclic group,
a1 to a4 are each independently selected from 0, 1, 2, and 3, and when a1 is 2 or more, 2 or more L₁(s) are identical to or different from each other, when a2 is 2 or more, 2 or more L₂(s) are identical to or different from each other, when a3 is 2 or more, 2 or more L₃(s) are identical to or different from each other, and when a4 is 2 or more, 2 or more L₄(s) are identical to or different from each other,
R₁ to R₁₂, R₂₁, and R₂₂ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁(Q₂), -C(=O)(Q₁), -S(=O)₂(Q₁), and -P(=O)(Q₁)(Q₂), wherein a first group selected from R₁ to R₁₂ may optionally be linked to a second group selected from R1 to R12 to form a substituted or unsubstituted C₅-C₆₀ carbocyclic or a substituted or unsubstituted C₁-C₆₀ heterocyclic group, provided that the first group is adjacent to the second group in Formula 1, and provided that the first group or the second group is not R₁ R₂ R₃ or R₄ when a1 a2 a3 or a4 is greater than zero, respectively; and wherein when R₂₁ and R₂₂ are both present they may optionally be linked to form a substituted or unsubstituted C₅-C₆₀ carbocyclic or a substituted or unsubstituted C₁-C₆₀ heterocyclic group,
at least one selected from R₁ to R₄ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8 to 60 polycyclic group, and a substituted or unsubstituted monovalent non-aromatic condensed 8- to 60-membered heteropolycyclic group,
b1 to b4 are each independently selected from 1, 2, and 3, and when b1 is 2 or more, 2 or more R₁(s) are identical to or different from each other, when b2 is 2 or more, 2 or more R₂(s) are identical to or different from each other, when b3 is 2 or more, 2 or more R₃(s) are identical to or different from each other, and when b4 is 2 or more, 2 or more R₄(s) are identical to or different from each other, and
the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8 to 60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8 to 60 polycyclic group, and the substituted monovalent non-aromatic condensed 8- to 60-membered heteropolycyclic group, the substituted C₅-C₆₀ carbocyclic group, and the substituted C₁-C₆₀ heterocyclic group is substituted with at least one substituent selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8 to 60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a biphenyl group, a terphenyl group, a C₁-C₆₀ heteroaryl group, a monovalent non-aromatic condensed C8 to 60 polycyclic group, and a monovalent non-aromatic condensed 8- to 60-membered heteropolycyclic group.

2. The organic light-emitting device of claim 1, wherein X₁ is selected from C(R₂₁)(R₂₂) and Si(R₂₁)(R₂₂);
preferably R₂₁ and R₂₂ are linked through a single bond; or linked through one selected from a C₁-C₅ alkylene group and a C₂-C₅ alkenylene group, each substituted with at least one selected from a C₁-C₁₀ alkyl group, a C₁-C₁₀ alkoxy group, a phenyl group, a biphenyl group, a terphenyl group, and a naphthyl group.

3. The organic light-emitting device of claim 1 or claim 2, wherein L₁ to L₄ are each independently selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, and a perylenylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, and a perylenylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenylene group, a chrysenyl group, and a perylenyl group.

4. The organic light-emitting device of claim 1 or claim 2, wherein L₁ to L₄ are each independently selected from groups represented by Formulae 3-1 to 3-46: 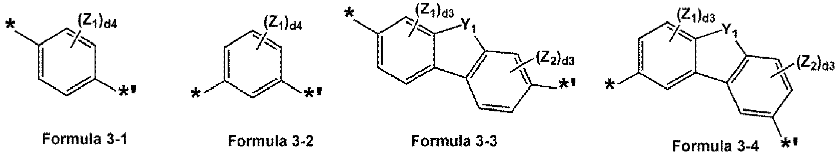 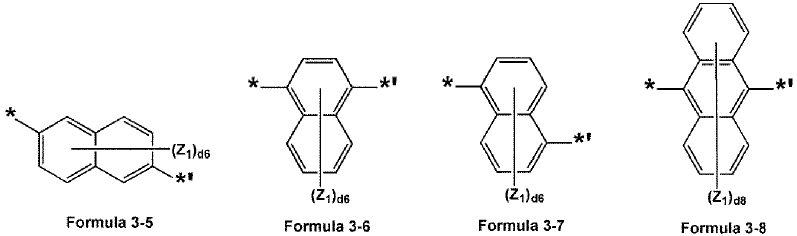 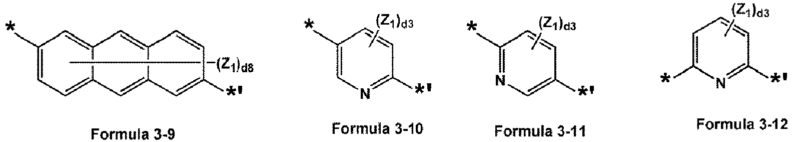 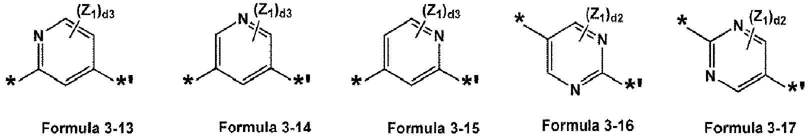 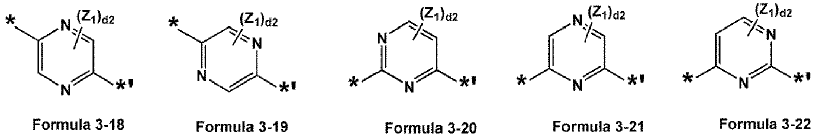 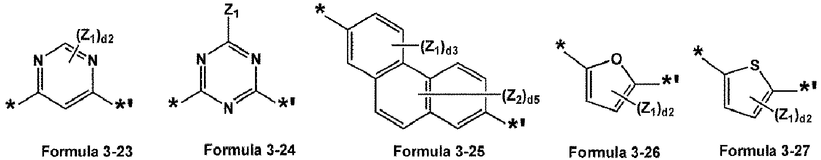 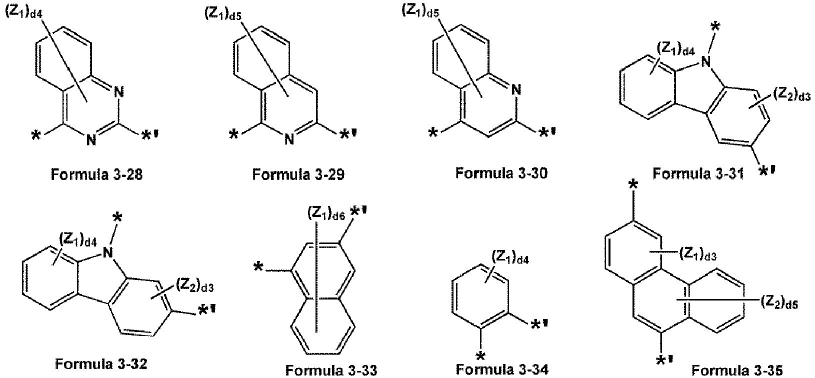 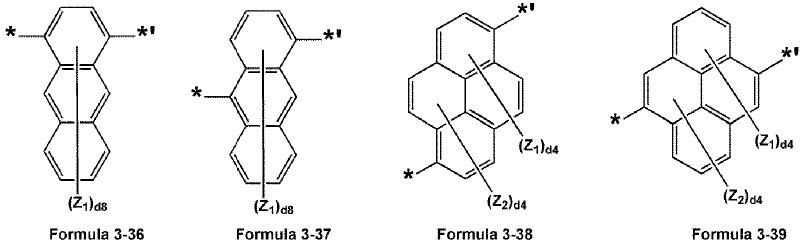 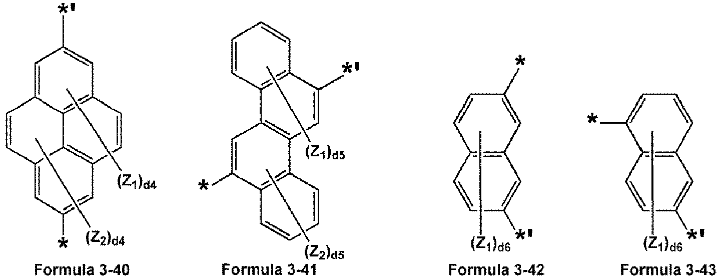 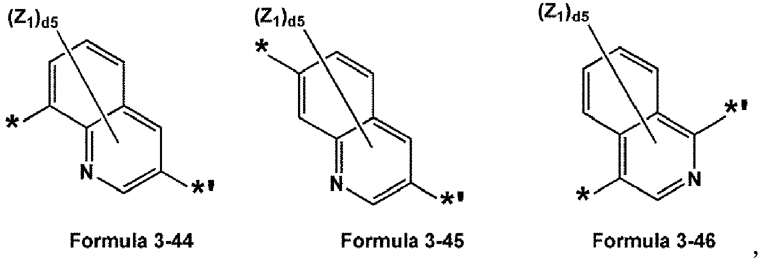 wherein, in Formulae 3-1 to 3-46,
Y₁ is selected from O, S, C(Z₃)(Z₄), N(Z₅), and Si(Z₆)(Z₇),
Z₁ to Z₇ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a dibenzofuranyl group, a dibenzothiophenyl group, a triazinyl group, a benzimidazolyl group, a phenanthrolinyl group, and -Si(Q₃₁)(Q₃₂)(Q₃₃),
wherein Q₃₁ to Q₃₃ are each independently selected from a C₁-C₁₀ alkyl group, a C₁-C₁₀ alkoxy group, a phenyl group, a biphenyl group, a terphenyl group, and a naphthyl group,
d2 is an integer selected from 0 to 2,
d3 is an integer selected from 0 to 3,
d4 is an integer selected from 0 to 4,
d5 is an integer selected from 0 to 5,
d6 is an integer selected from 0 to 6,
d8 is an integer selected from 0 to 8, and
^{∗} and ^{∗}' each indicate a binding site to a neighboring atom;
preferably wherein:
L₁ to L₄ are each independently selected from groups represented by Formulae 3-1 to 3-9, 3-25 to 3-27, and 3-31 to 3-43 and Z₁ to Z₇ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a carbazolyl group, a dibenzofuranyl group, and a dibenzothiophenyl group.

5. The organic light-emitting device of any one of the preceding claims, wherein R₁ to R₄, R₂₁, and R₂₂ are each independently selected from the group consisting of:
hydrogen, deuterium, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a biphenyl group, and a terphenyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, and -Si(Q₃₁)(Q₃₂)(Q₃₃),
wherein Q₃₁ to Q₃₃ are each independently selected from a C₁-C₁₀ alkyl group, a C₁-C₁₀ alkoxy group, a phenyl group, a biphenyl group, a terphenyl group, and a naphthyl group.

6. The organic light-emitting device of any one of the preceding claims, wherein R₁ to R₄ are each independently selected from hydrogen, deuterium, a C₁-C₂₀ alkyl group, and a group represented by any of Formulae 5-1 to 5-46, wherein at least one selected from R₁ to R₄ is selected from groups represented by Formulae 5-1 to 5-46,
R₂₁ and R₂₂ are each independently selected from a C₁-C₂₀ alkyl group and a group represented by any of Formulae 5-1 to 5-46: 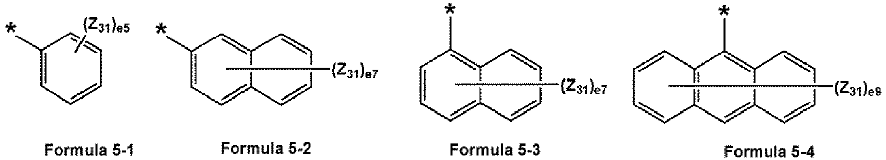 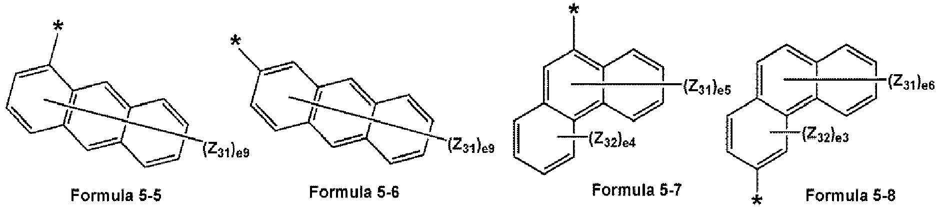 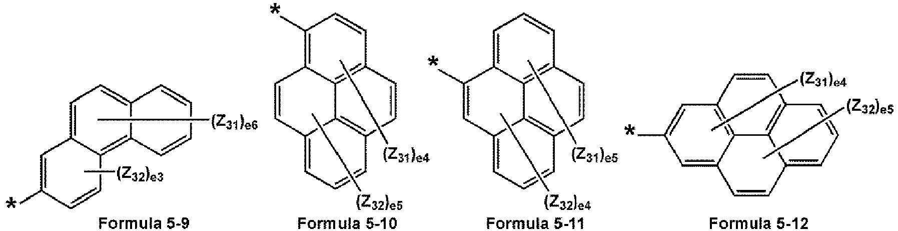 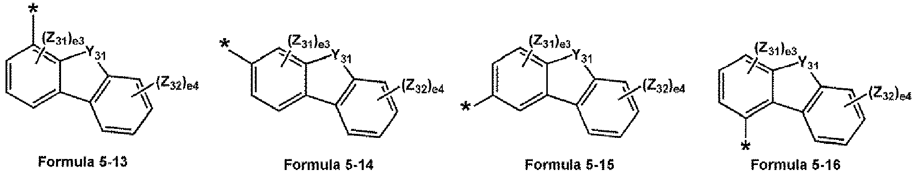 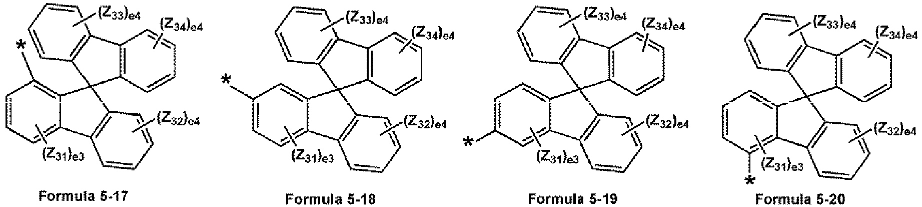 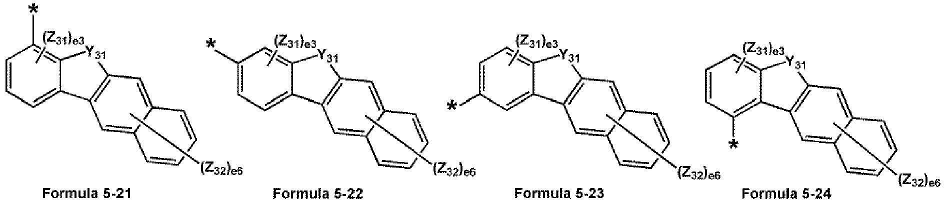 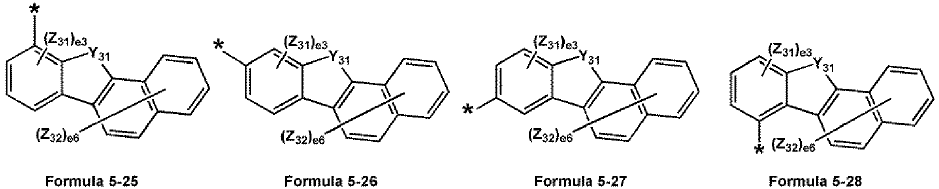 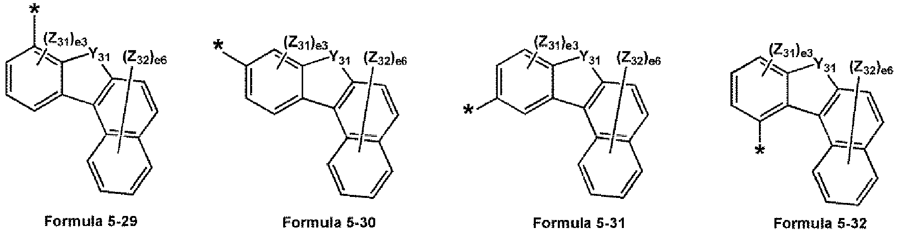 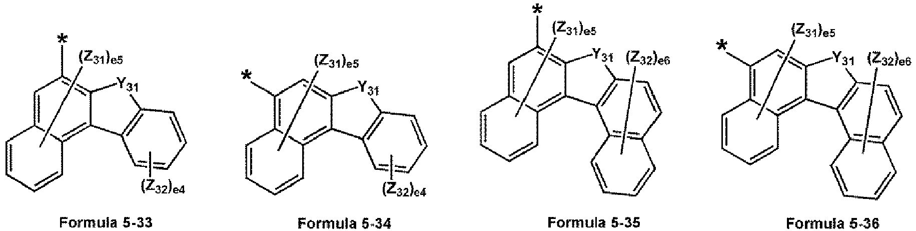 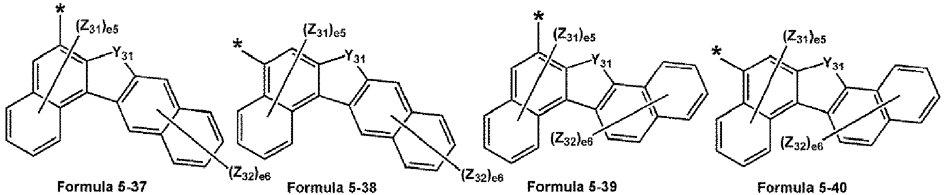 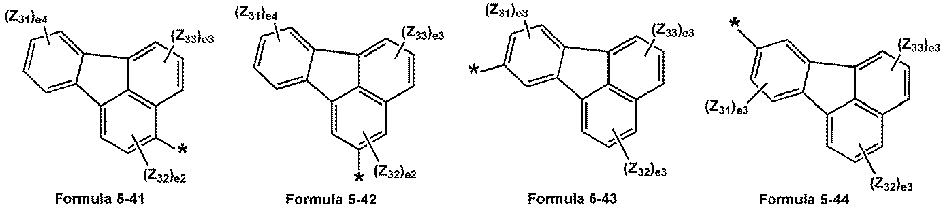 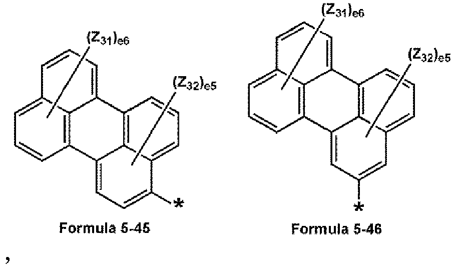 wherein, in Formulae 5-1 to 5-46,
Y₃₁ is selected from O, S, C(Z₃₃)(Z₃₄), N(Z₃₅), and Si(Z₃₆)(Z₃₇),
Z₃₁ to Z₃₇ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, and -Si(Q₃₁)(Q₃₂)(Q₃₃),
wherein Q₃₁ to Q₃₃ are each independently selected from a C₁-C₁₀ alkyl group, a C₁-C₁₀ alkoxy group, a phenyl group, a biphenyl group, a terphenyl group, and a naphthyl group,
e2 is an integer selected from 0 to 2,
e3 is an integer selected from 0 to 3,
e4 is an integer selected from 0 to 4,
e5 is an integer selected from 0 to 5,
e6 is an integer selected from 0 to 6,
e7 is an integer selected from 0 to 7,
e9 is an integer selected from 0 to 9, and
^{∗} indicates a binding site to a neighboring atom.

7. The organic light-emitting device of any one of claims 1- 5, wherein R₁ to R₄ are each independently selected from hydrogen, deuterium, a C₁-C₂₀ alkyl group, and a group represented by any of Formulae 6-1 to 6-179, wherein at least one selected from R₁ to R₄ is selected from groups represented by Formulae 6-1 to 6-179, and
R₂₁ and R₂₂ are each independently selected from a C₁-C₂₀ alkyl group and a group represented by any of Formulae 6-1 to 6-179: 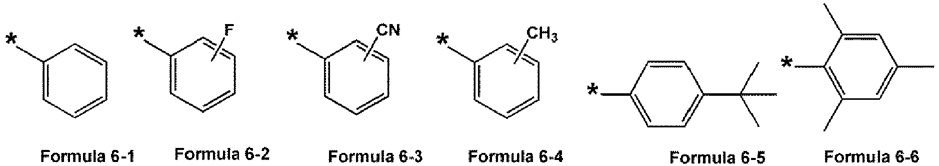 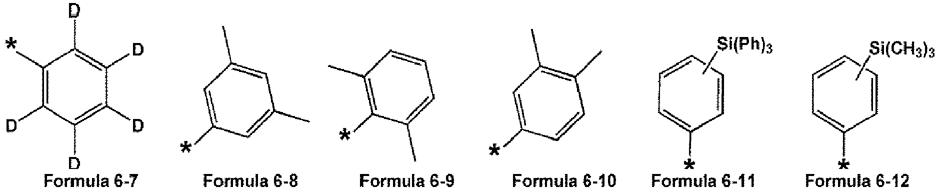 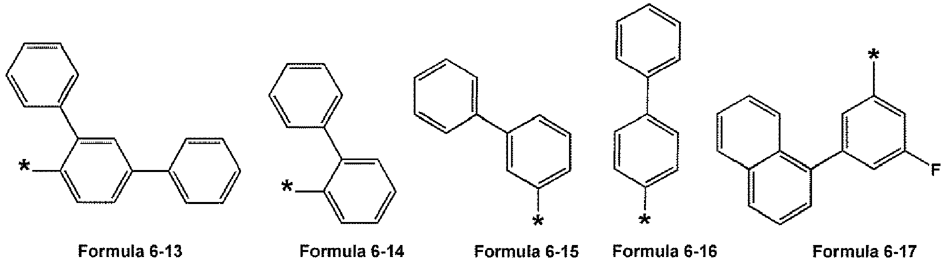 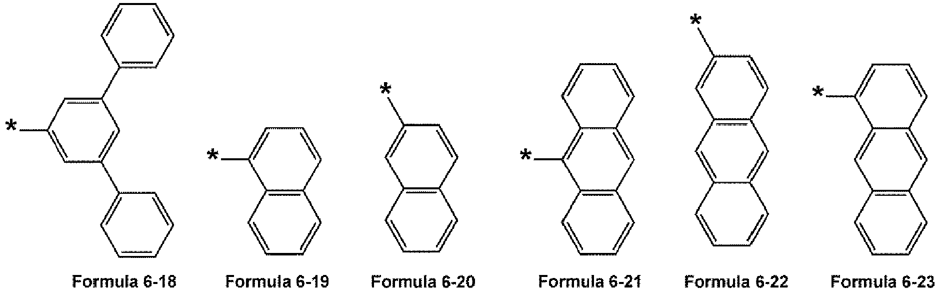 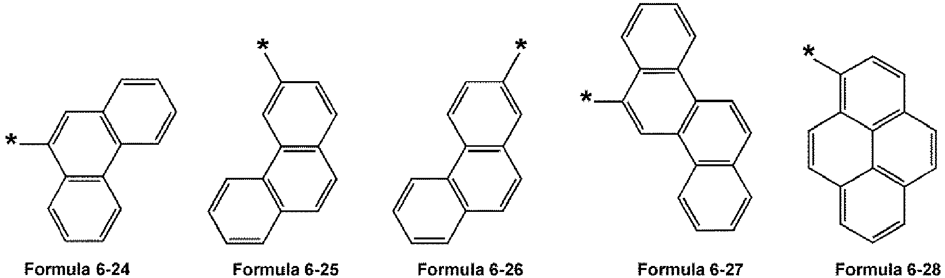 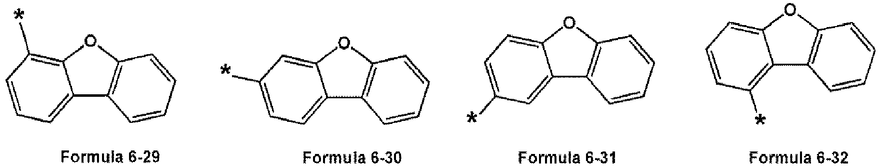 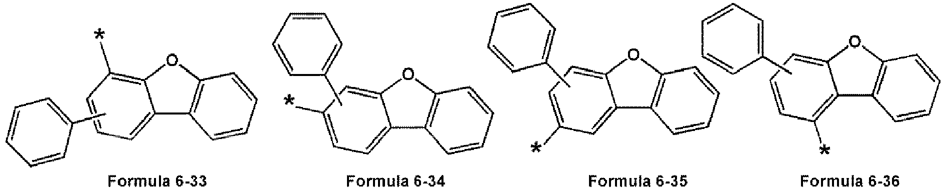 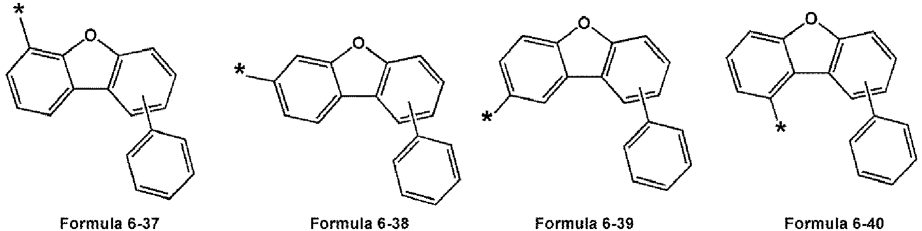 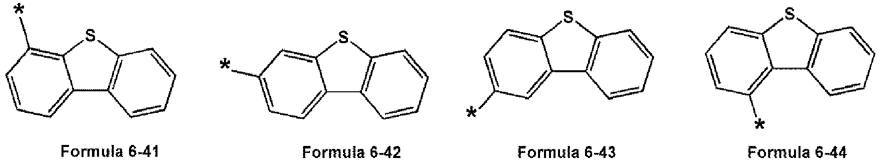 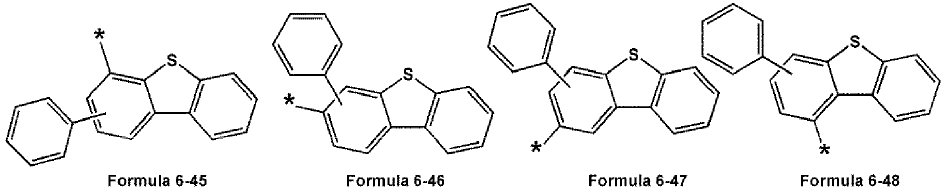 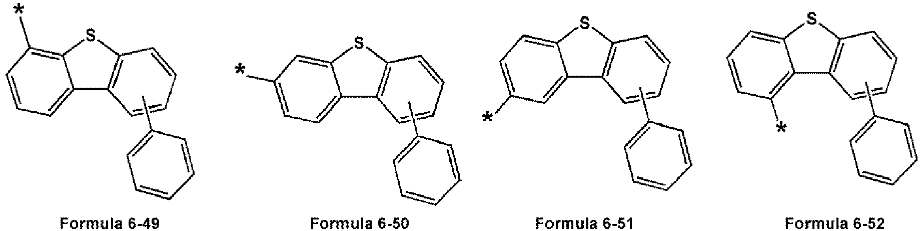 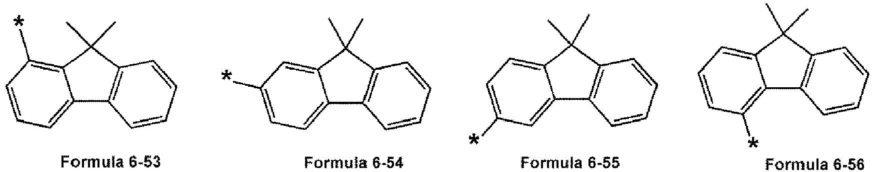 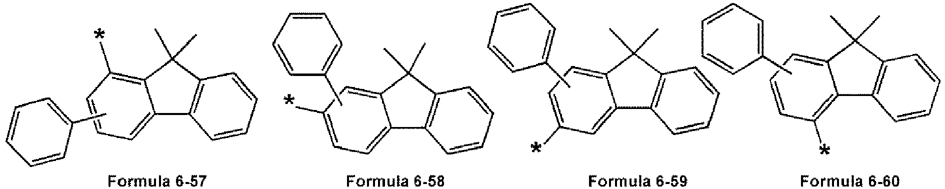 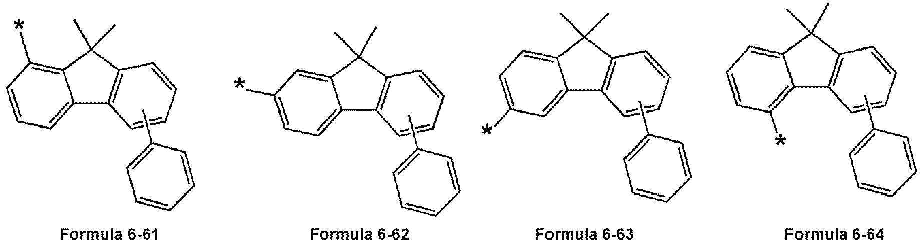 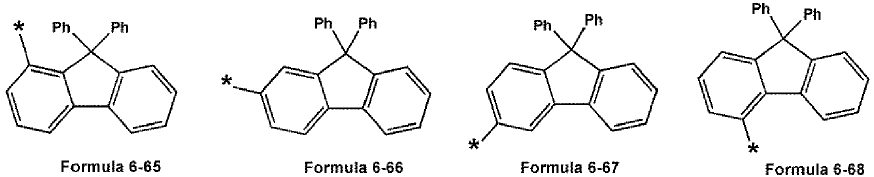 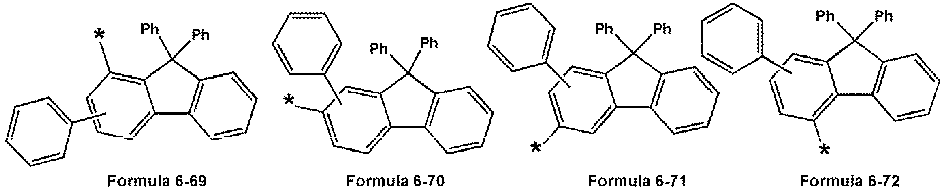 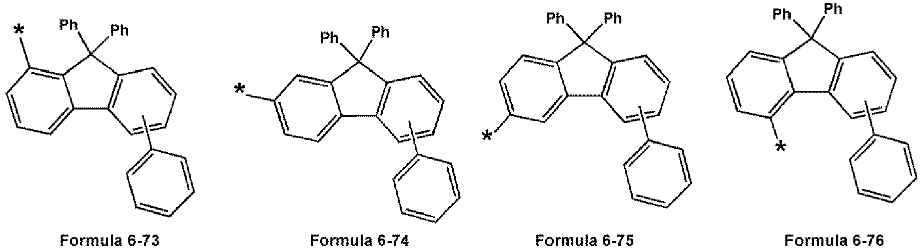 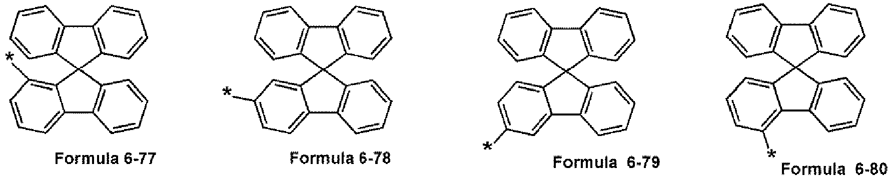 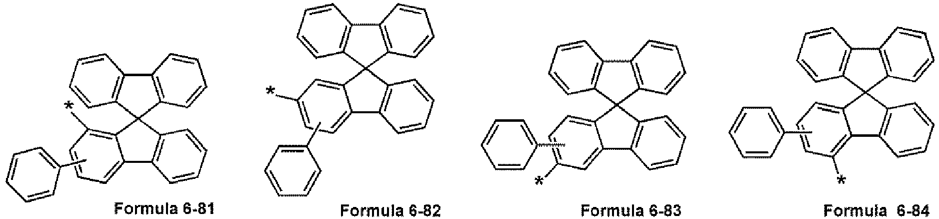 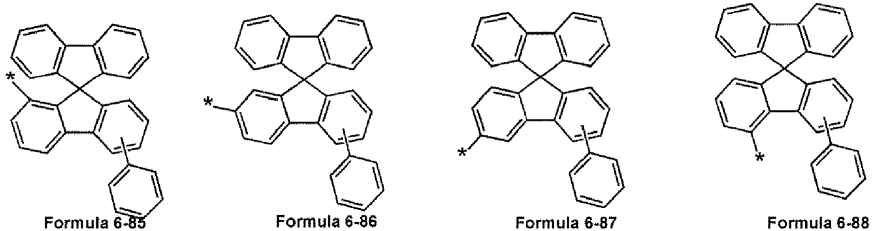 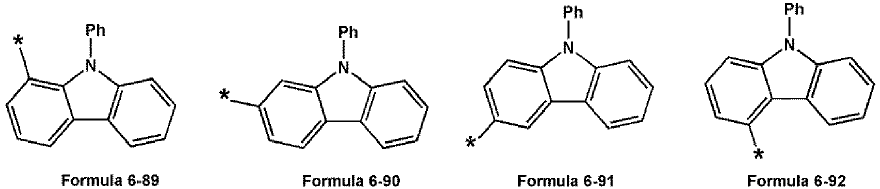 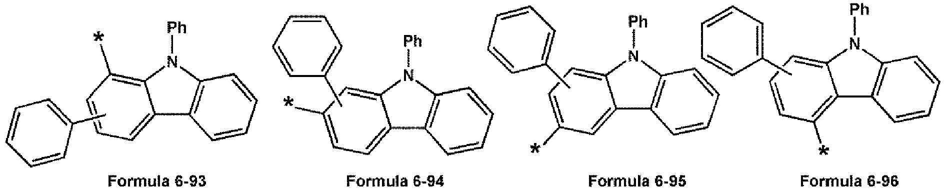 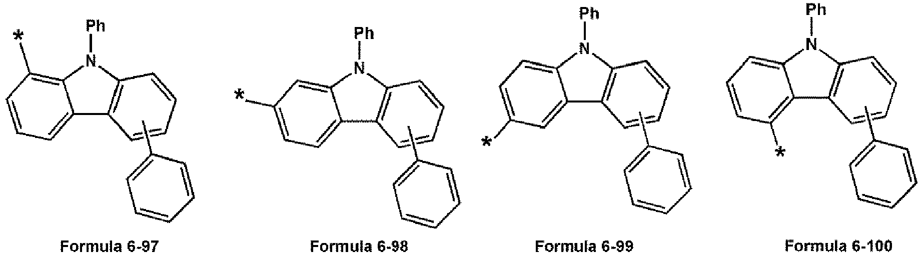 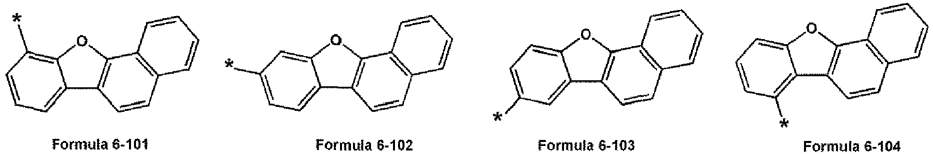 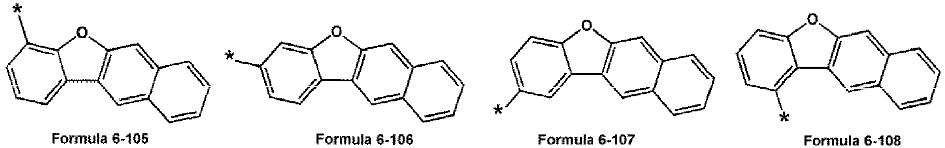 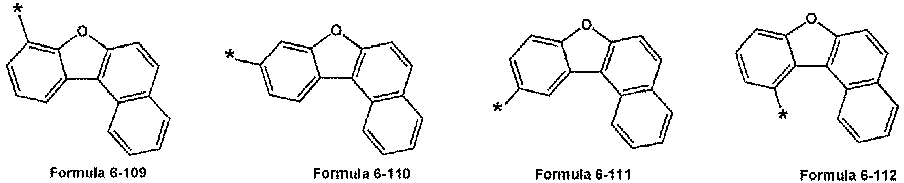 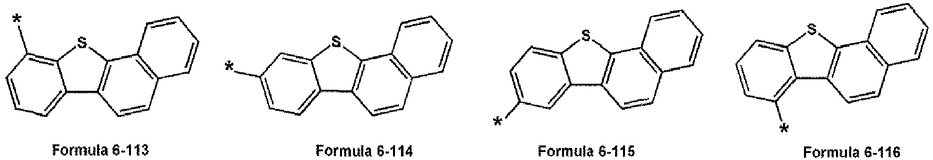 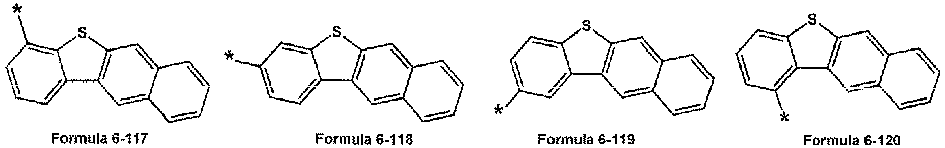 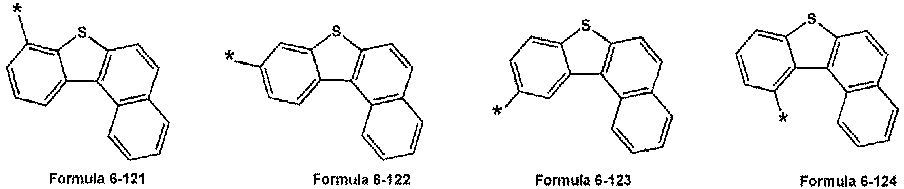 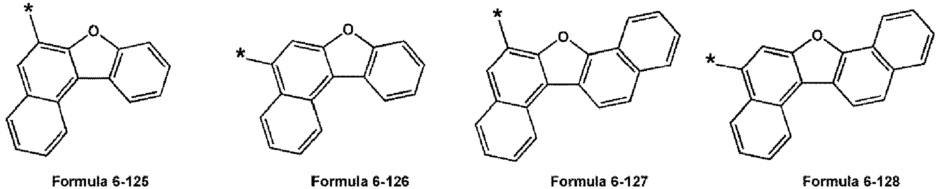 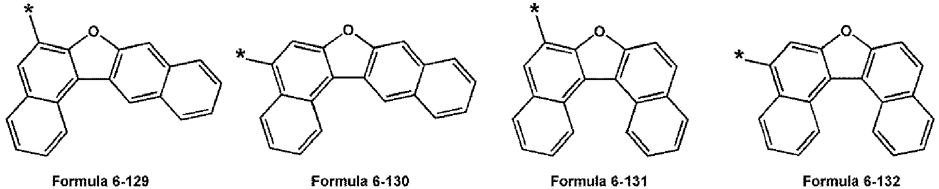 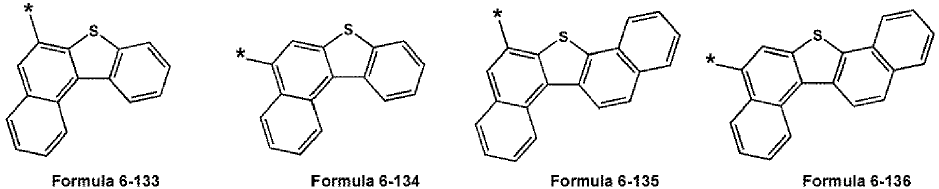 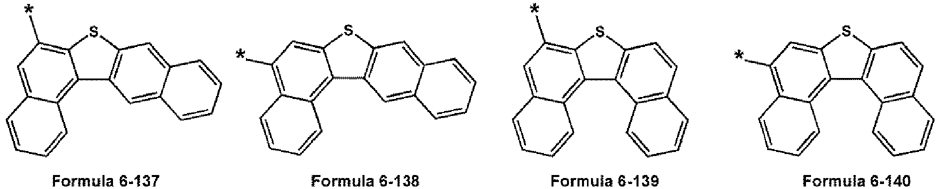 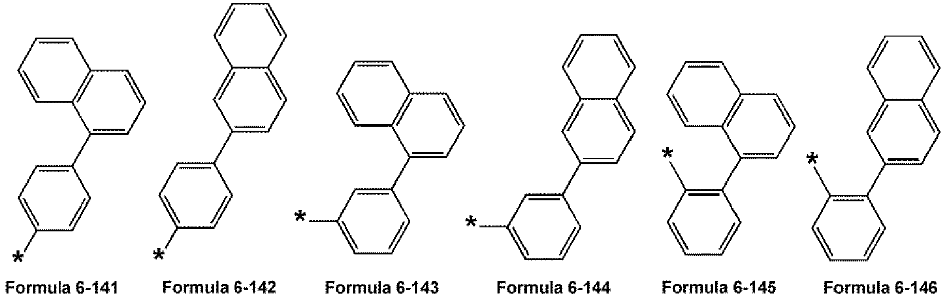 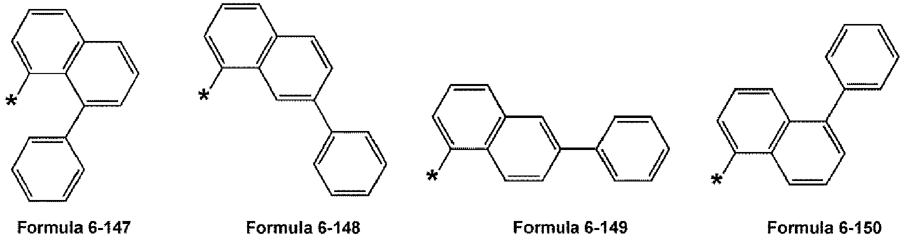 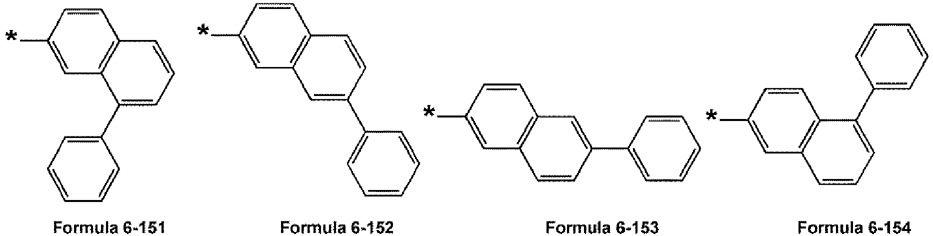 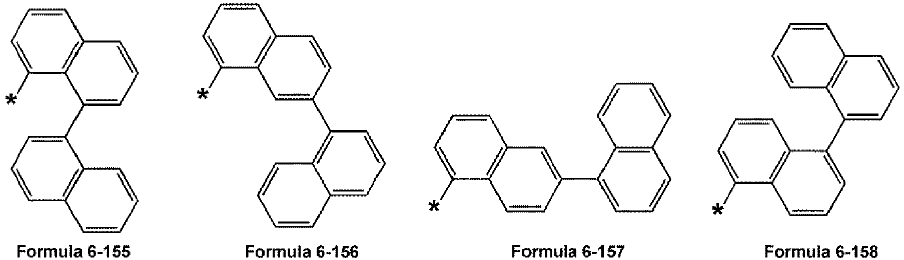 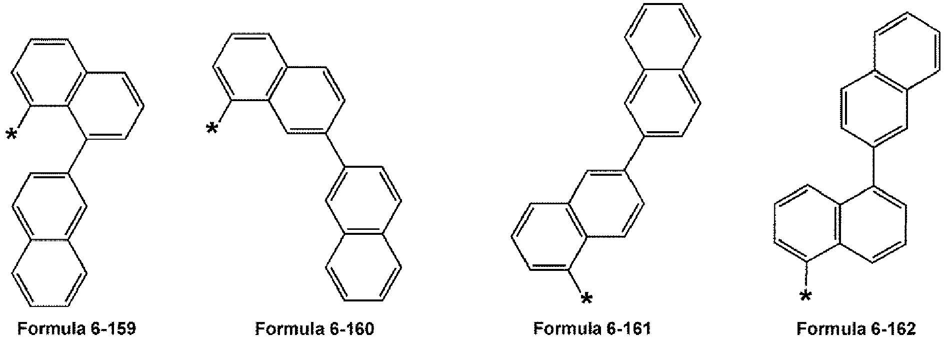 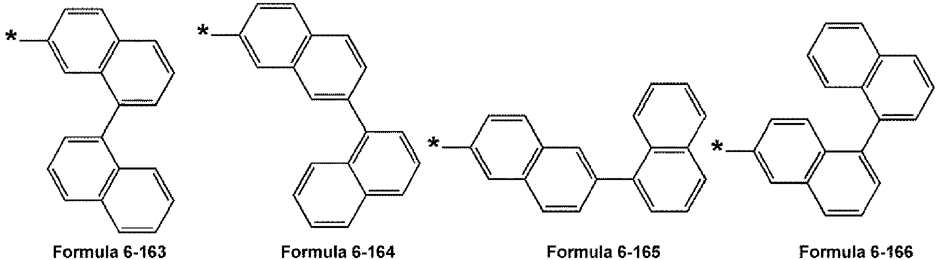 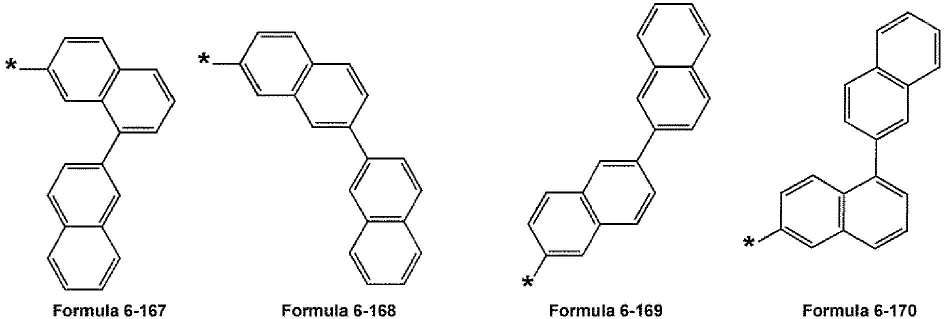 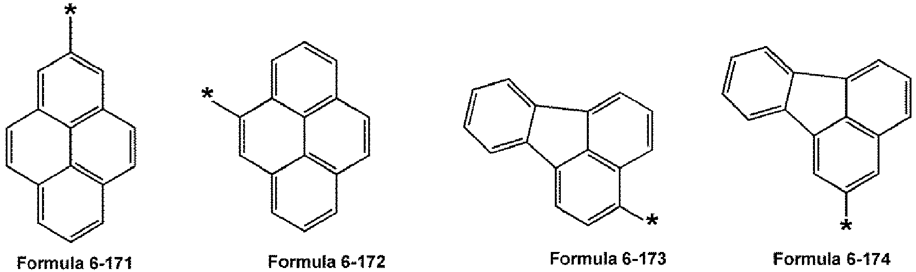 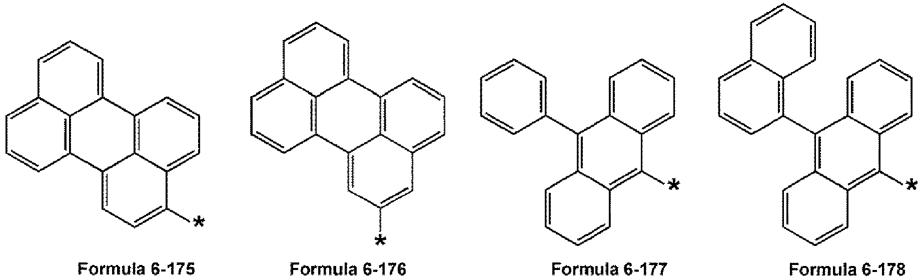 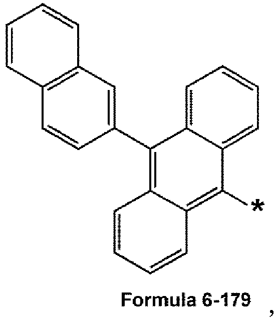 wherein, in Formulae 6-1 to 6-179, Ph indicates a phenyl group, and ^{∗} indicates a binding site to a neighboring atom.

8. The organic light-emitting device of any one of the preceding claims, wherein:
(a) X₁ is selected from C(R₂₁)(R₂₂) and Si(R₂₁)(R₂₂), wherein R₂₁ and R₂₂ are each independently selected from the group consisting of:
a C₁-C₁₀ alkyl group, a phenyl group, a biphenyl group, a terphenyl group, a naphthyl group, and an anthracenyl group; and
a phenyl group, a biphenyl group, a terphenyl group, a naphthyl group, and an anthracenyl group, each substituted with at least one selected from deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, and an anthracenyl group,
wherein R₂₁ and R₂₂ are optionally linked through a single bond; or are optionally linked through a C₁-C₃ alkylene group substituted with at least one selected from a C₁-C₁₀ alkyl group, a C₁-C₁₀ alkoxy group, a phenyl group, a biphenyl group, a terphenyl group, and a naphthyl group; and/or
(b) R₅ to R₁₂ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, and - Si(Q₁)(Q₂)(Q₃);
wherein Q₁ to Q₃ are each independently selected from a C₁-C₂₀ alkyl group, a C₁-C₂₀ alkoxy group, a phenyl group, a biphenyl group, a terphenyl group, and a naphthyl group; and/or
(c) a1 to a4 are each independently selected from 0, 1, and 2.

9. The organic light-emitting device of any one of the preceding claims, wherein the first compound represented by Formula 1 is a compound represented by at least one selected from Formulae 1-1 to 1-10: 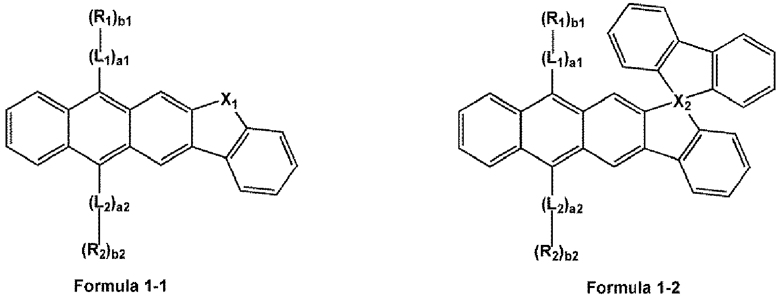 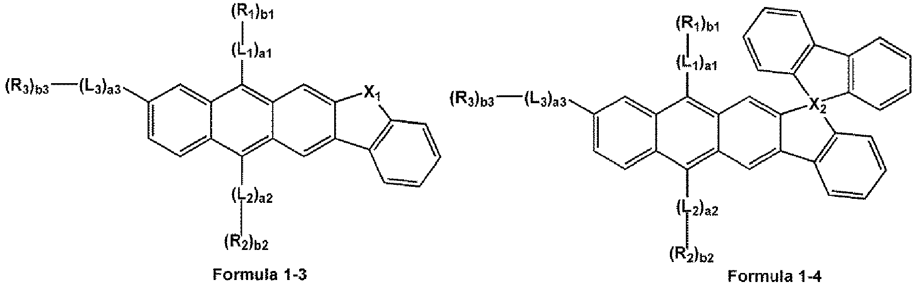 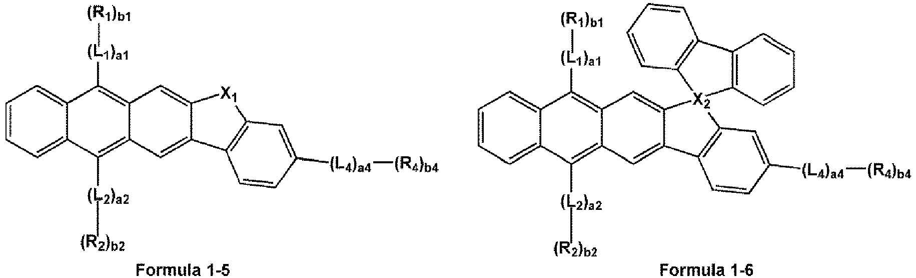 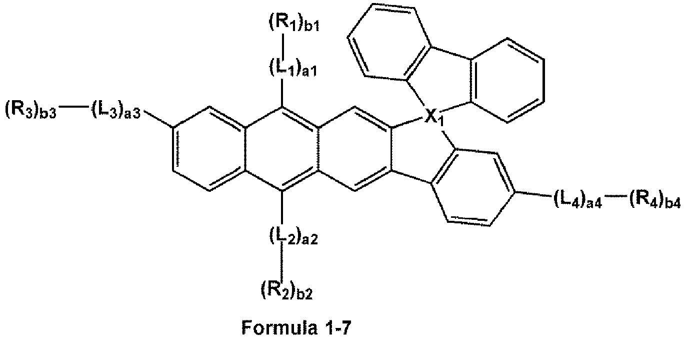 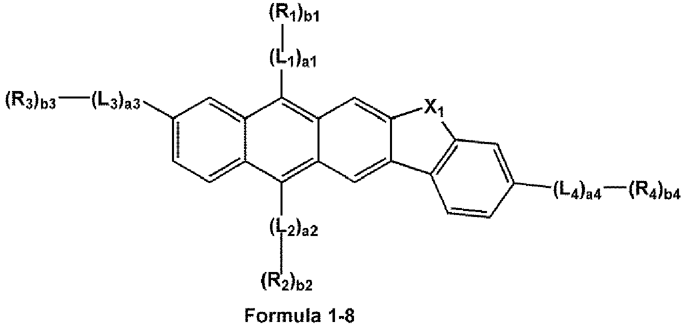 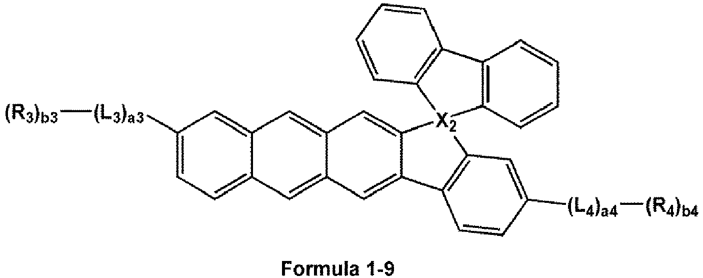 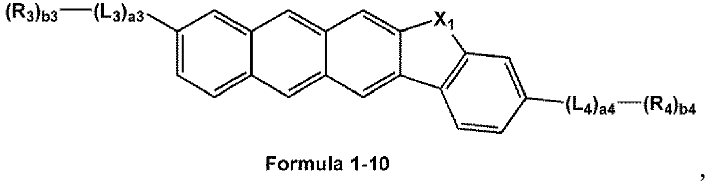 wherein, in Formulae 1-1 to 1-10,
X₁, L₁ to L₄, and a1 to a4 are each independently as defined in any of claims 1 to 4,
X₂ is selected from carbon and silicon,
R₁ to R₄ are each independently selected from the group consisting of:
a C₁-C₂₀ alkyl group and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a biphenyl group, and a terphenyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, and a dinaphthothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group a dibenzosilolyl group, a benzonaphthofuranyl group, a benzonaphthothiophenyl group, a dinaphthofuranyl group, a dinaphthothiophenyl group, and -Si(Q₃₁)(Q₃₂)(Q₃₃),
wherein Q₃₁ to Q₃₃ are each independently selected from a C₁-C₁₀ alkyl group, a C₁-C₁₀ alkoxy group, a phenyl group, a biphenyl group, a terphenyl group, and a naphthyl group, and
b1 to b4 are each independently selected from 1 and 2.

10. The organic light-emitting device of claim 1, wherein the first compound represented by Formula 1 is selected from Compounds A1 to A60, Compounds Bi to B48, Compounds C1 to C30, Compounds D1 to D30, Compounds E1 to E60, and Compounds F1 to F48:

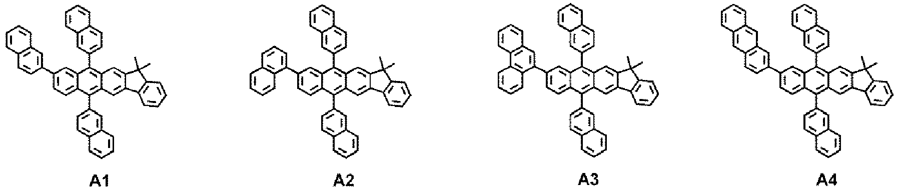

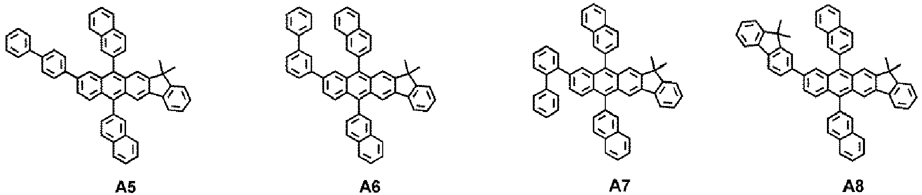

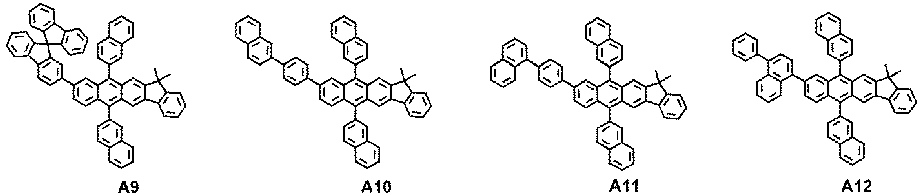

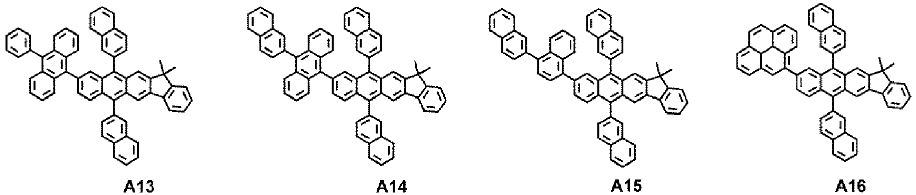

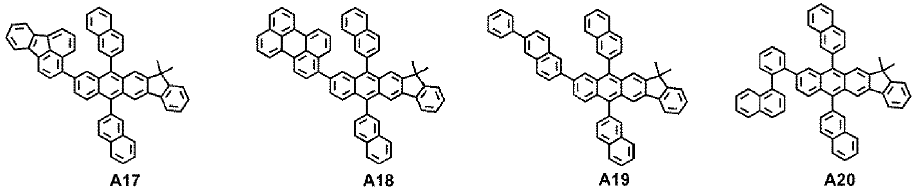

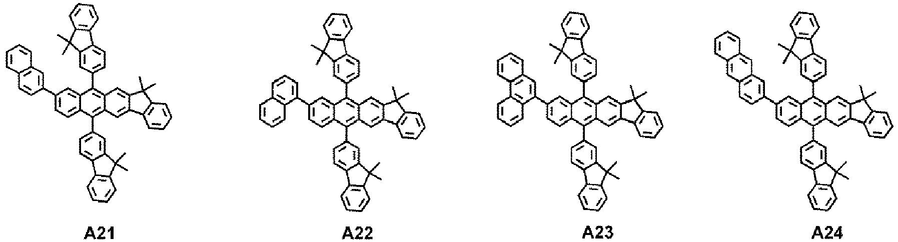

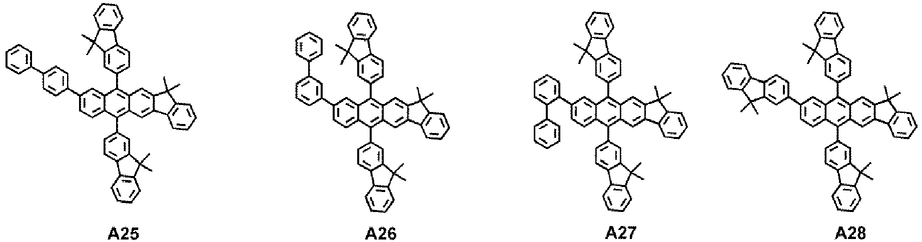

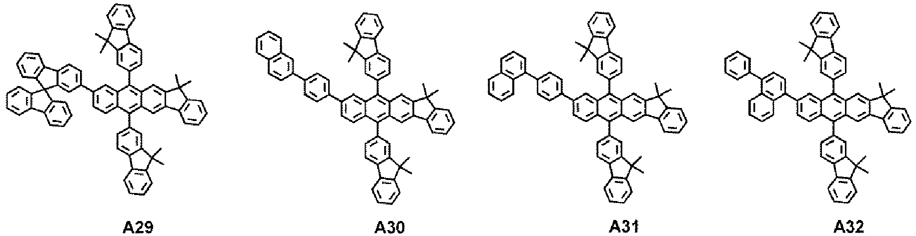

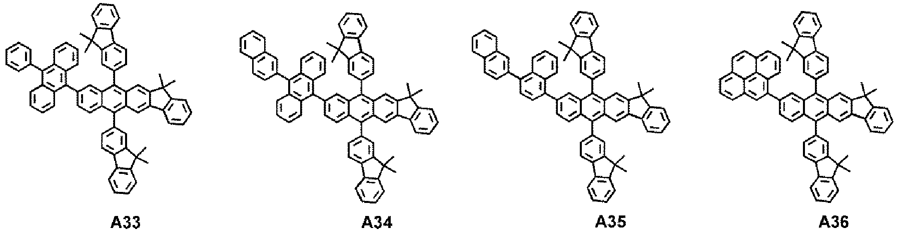

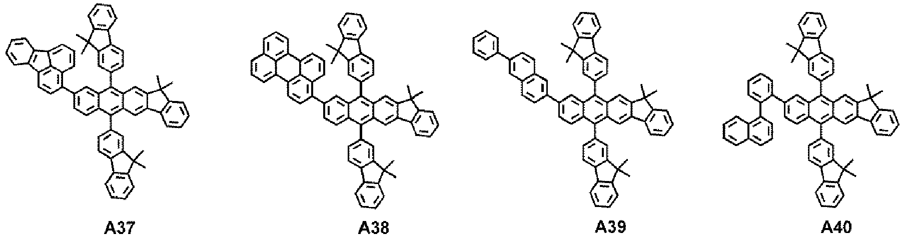

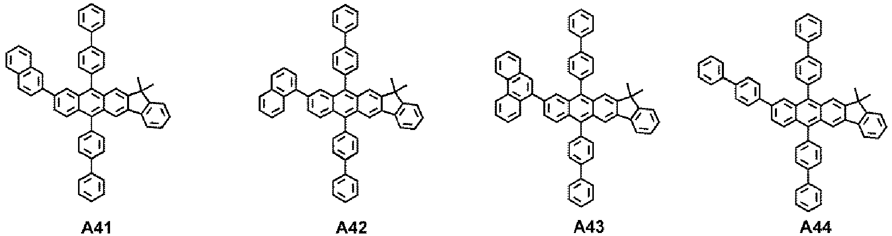

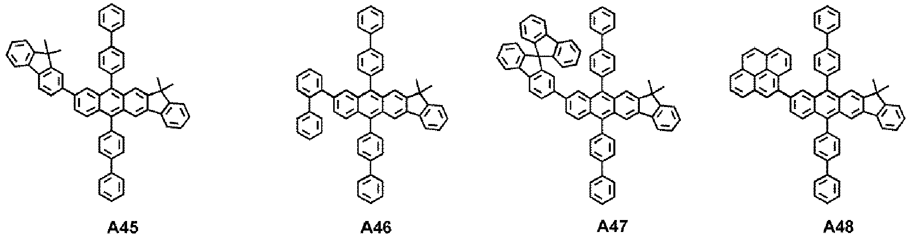

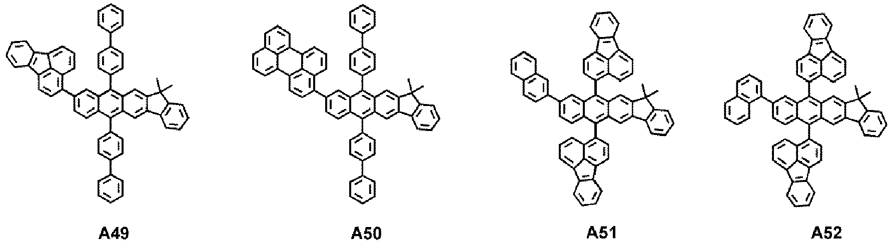

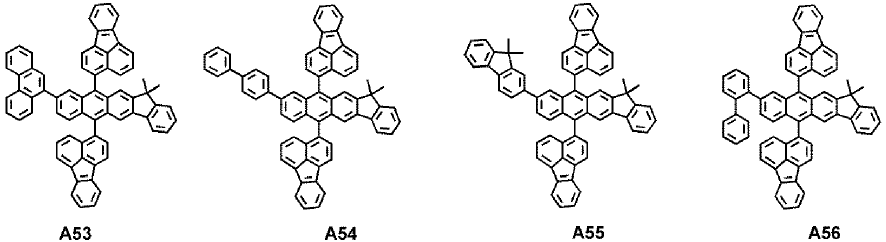

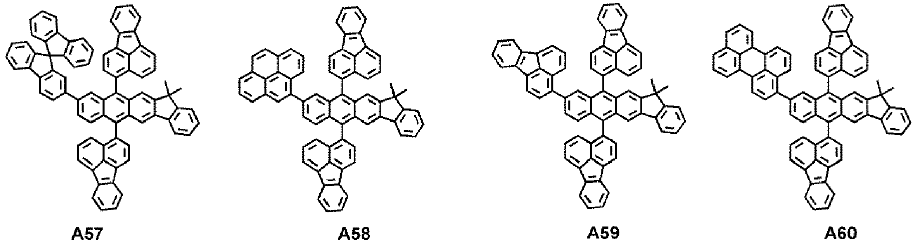

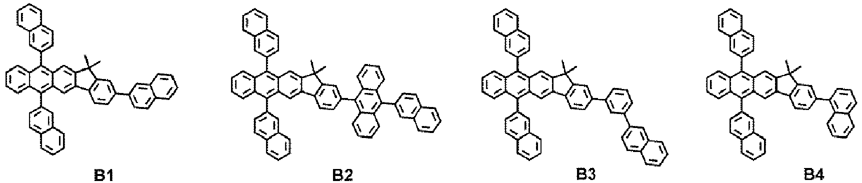

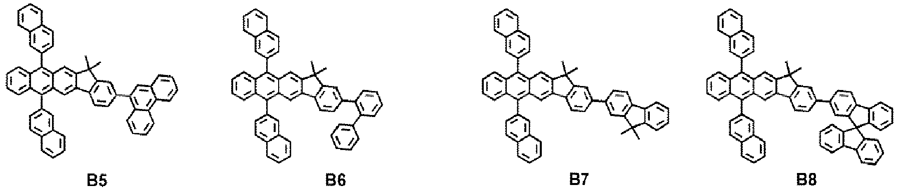

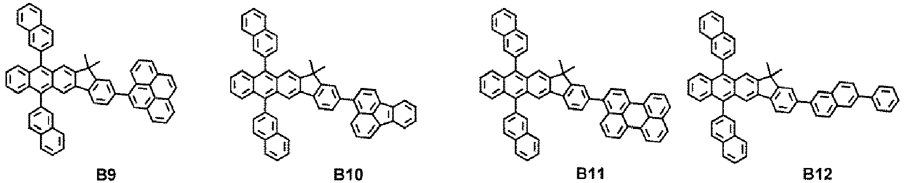

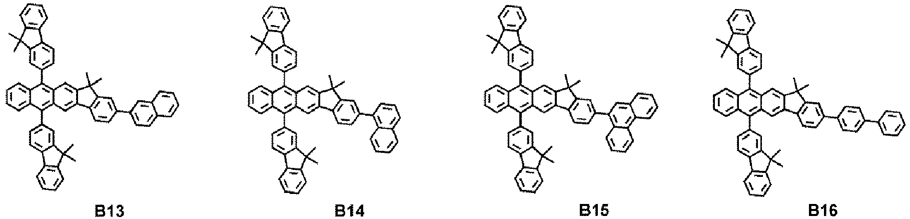

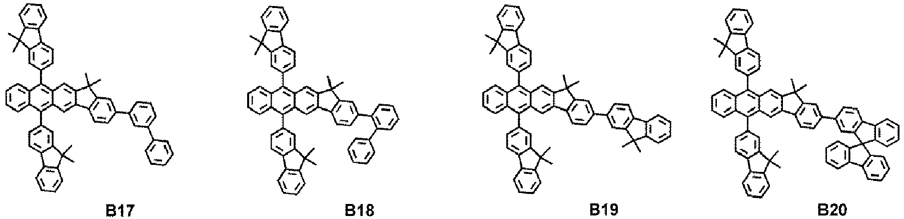

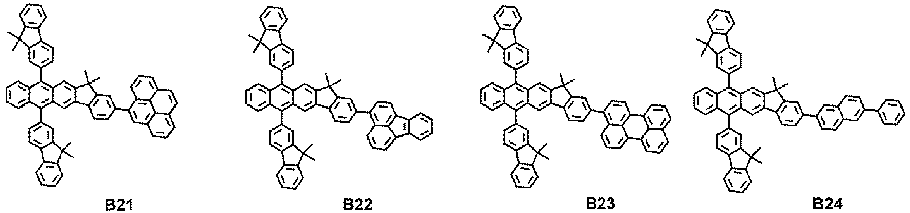

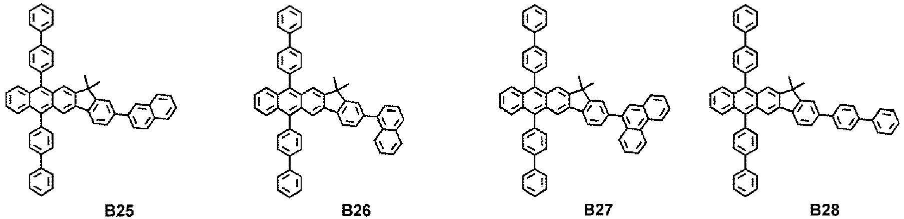

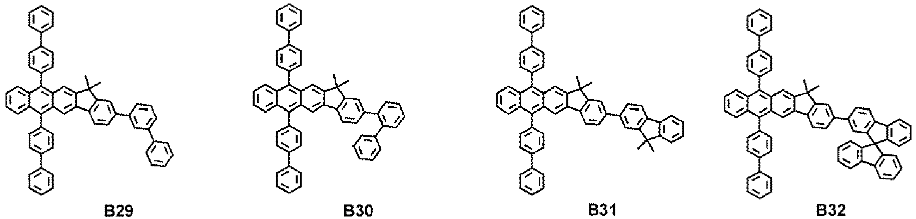

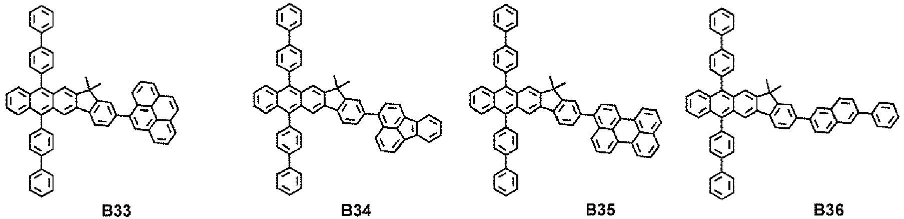

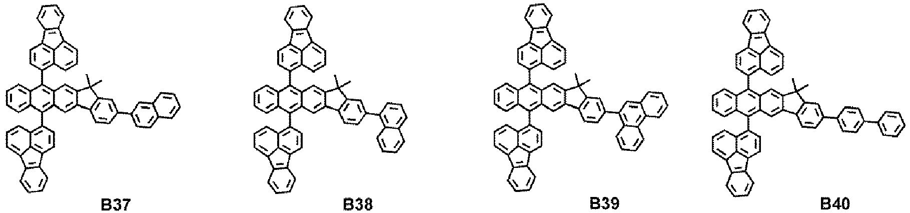

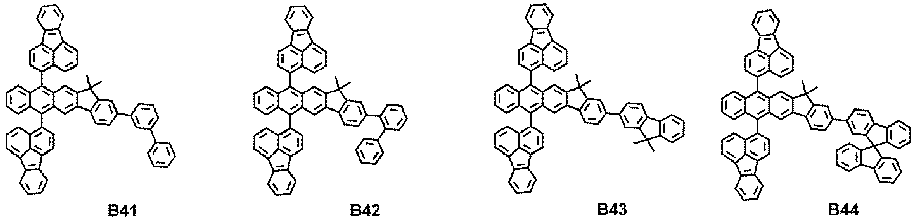

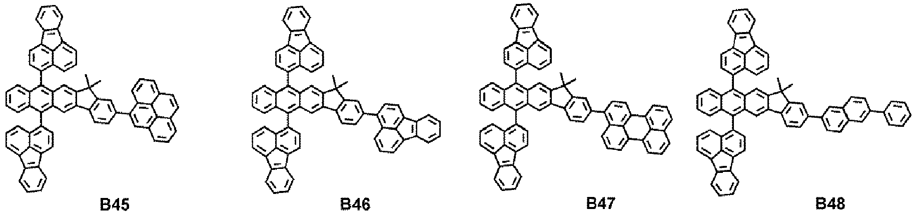

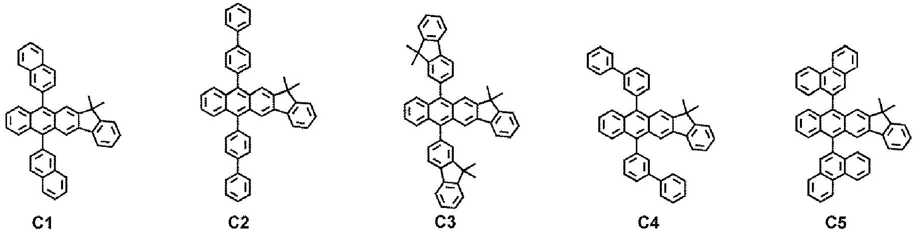

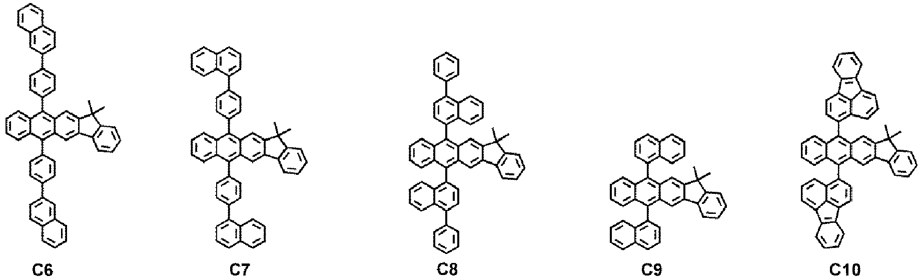

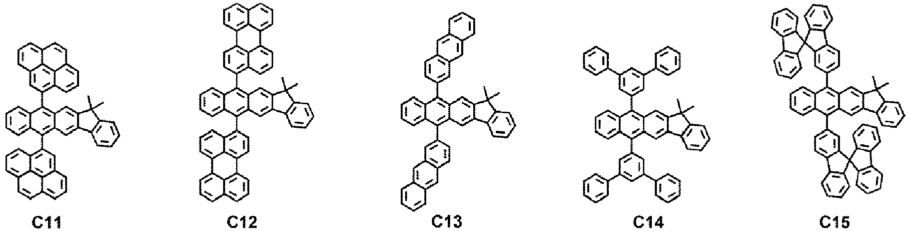

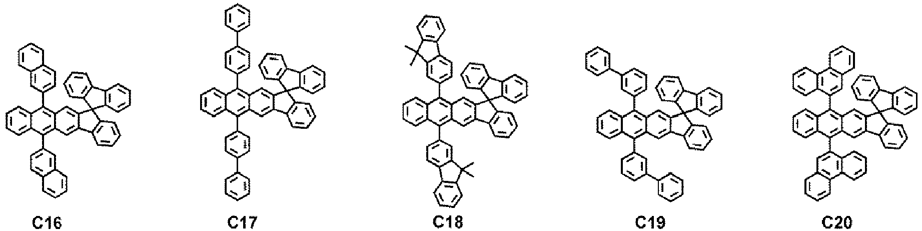

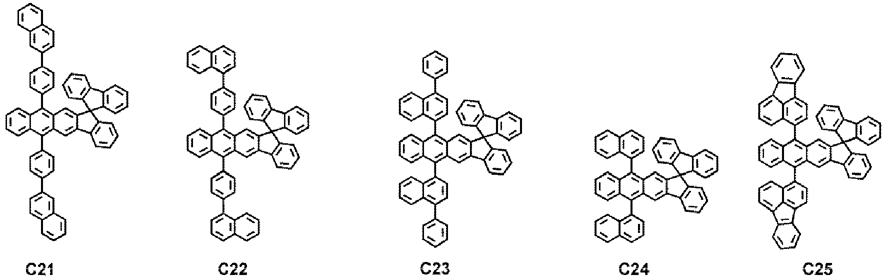

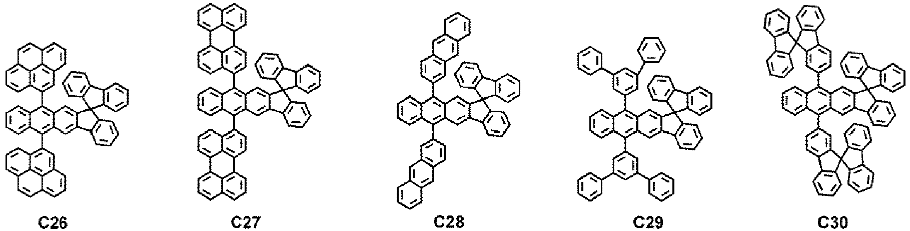

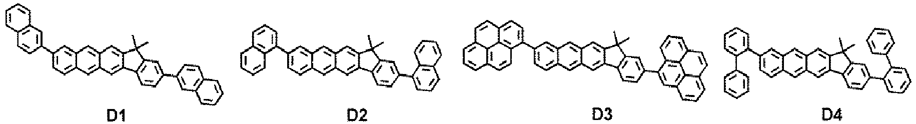

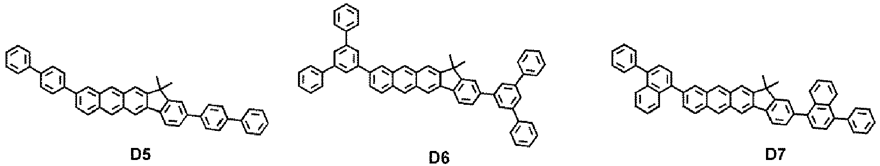

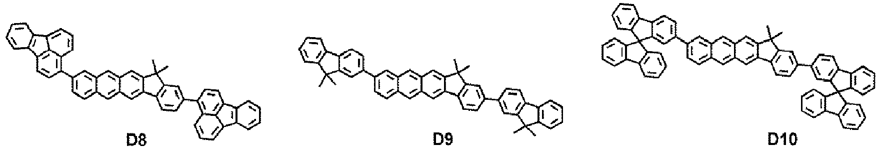

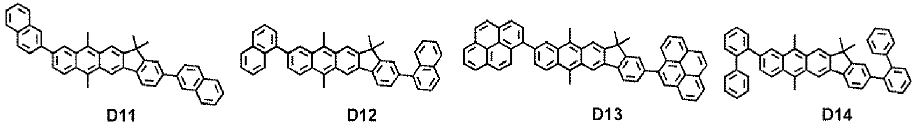

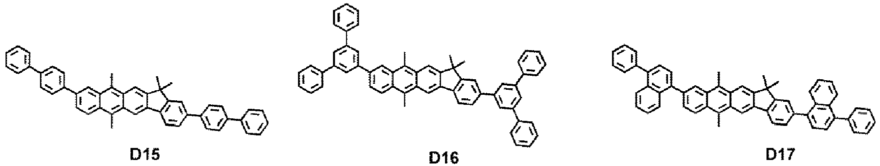

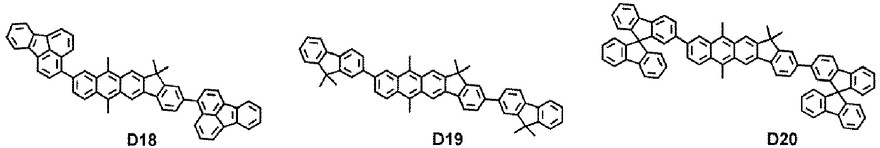

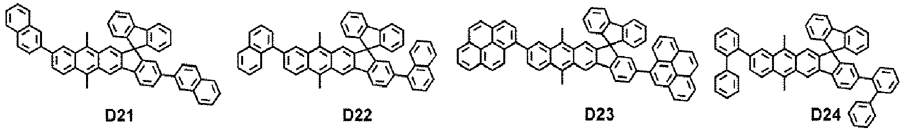

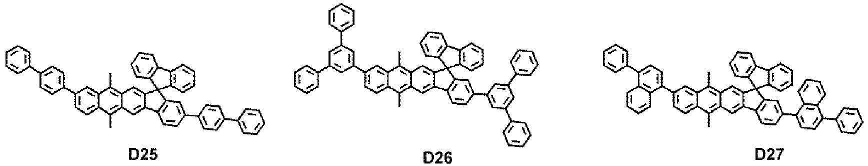

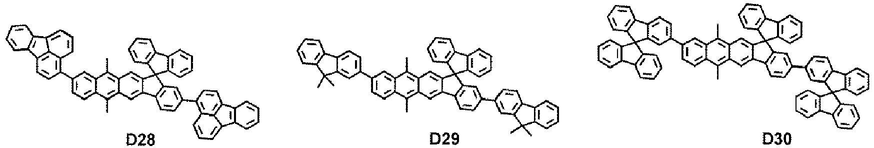

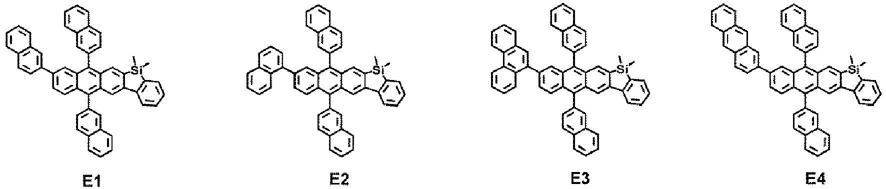

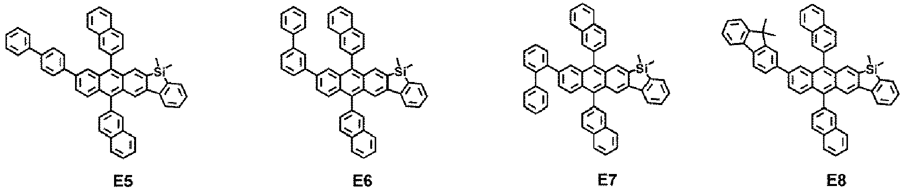

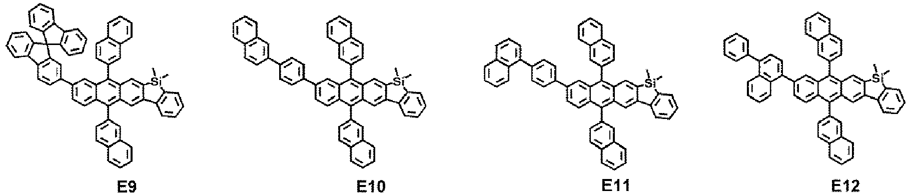

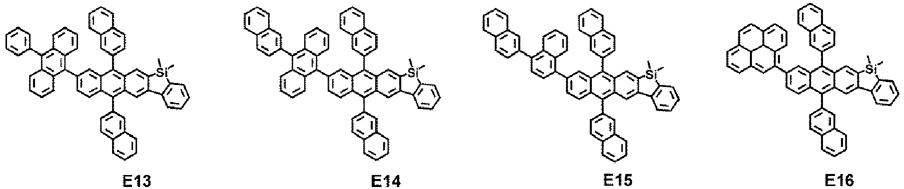

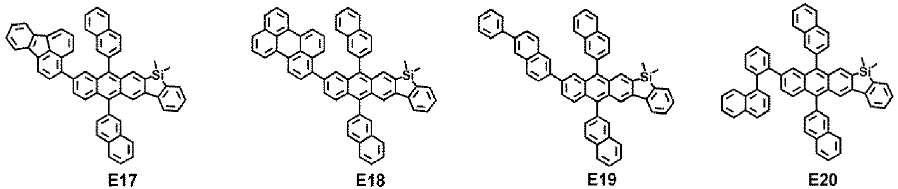

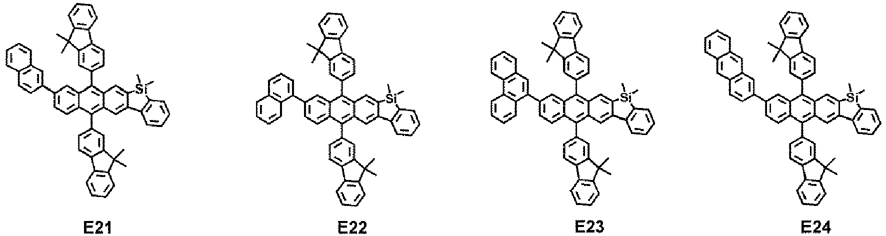

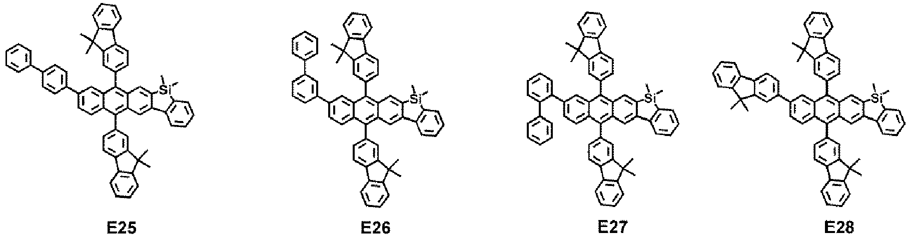

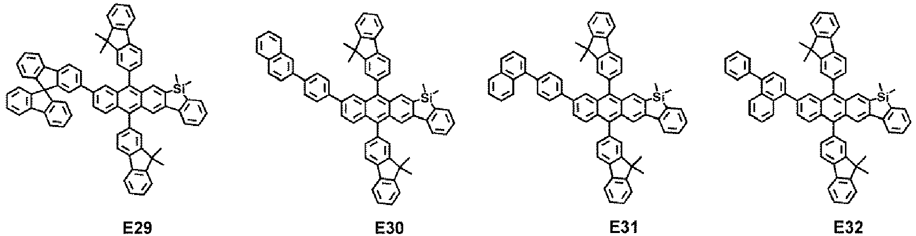

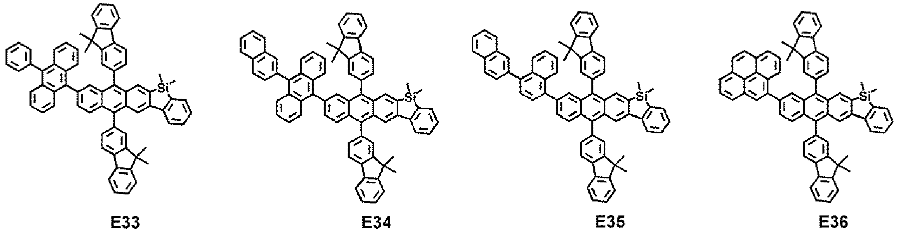

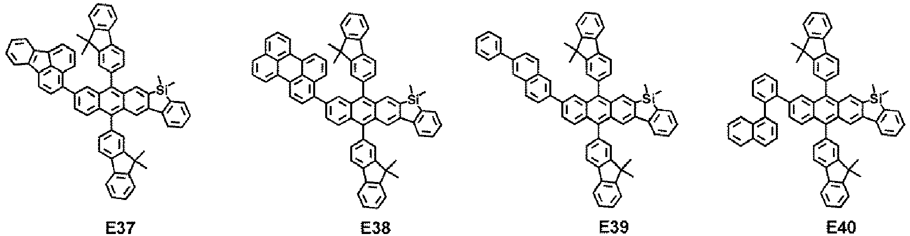

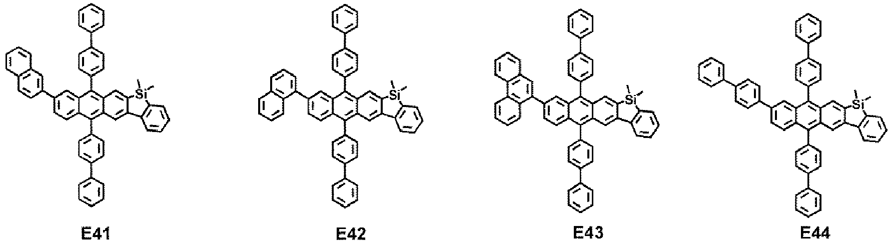

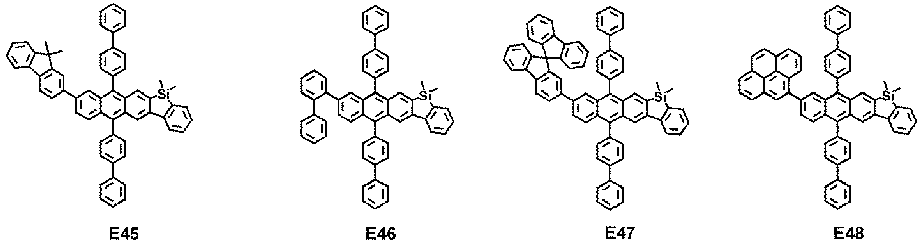

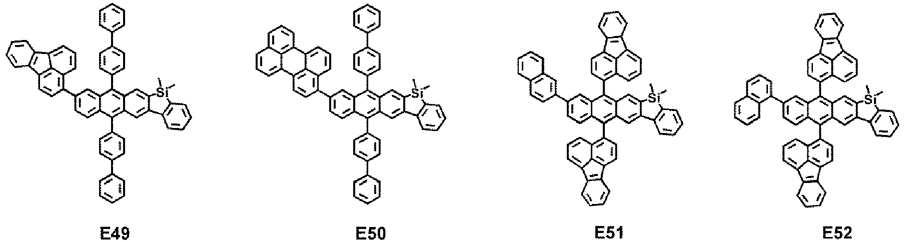

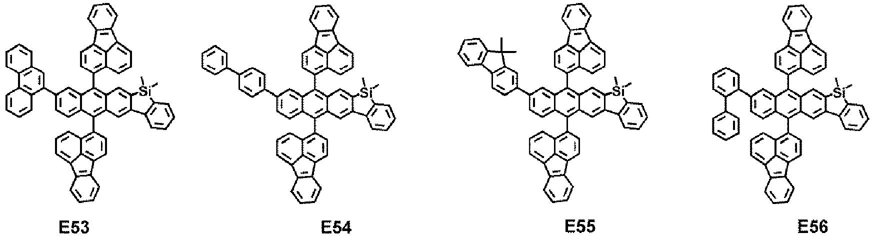

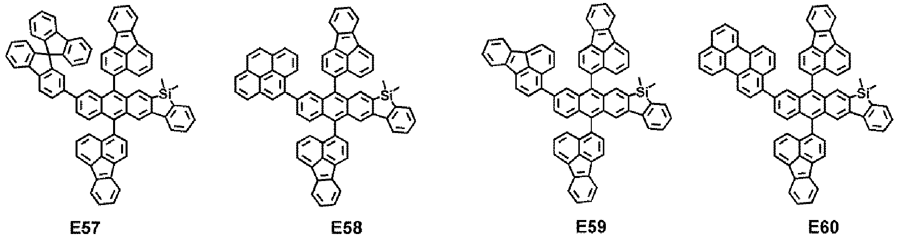

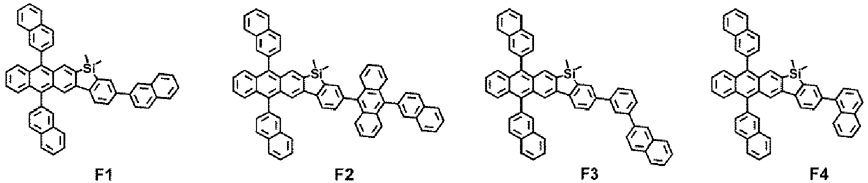

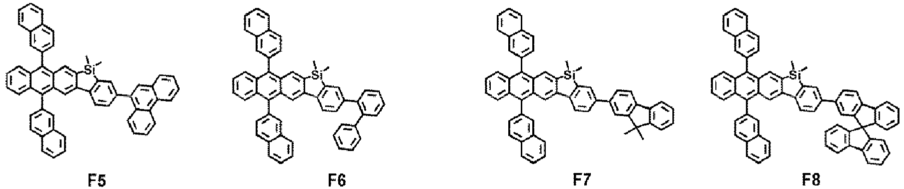

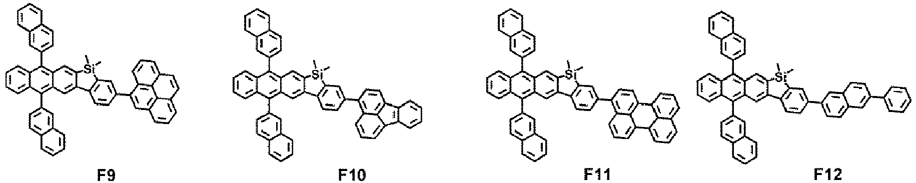

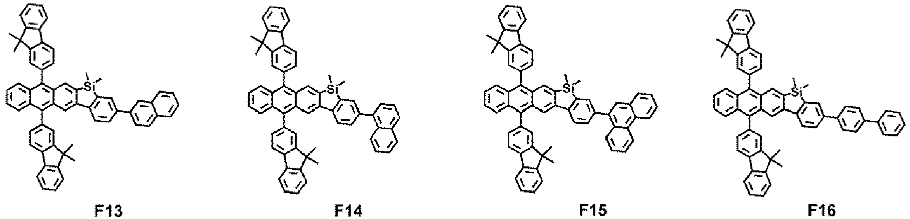

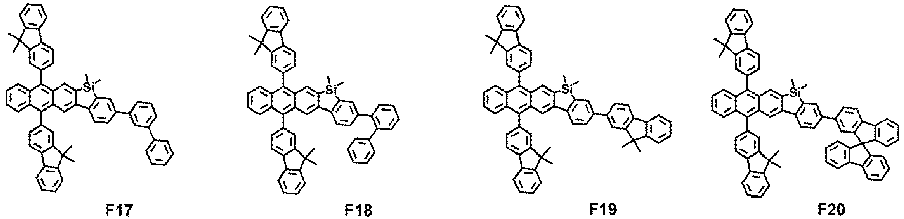

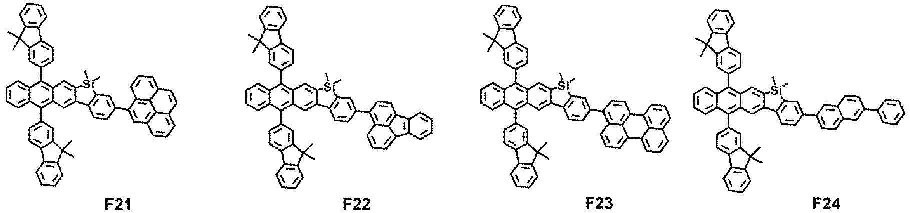

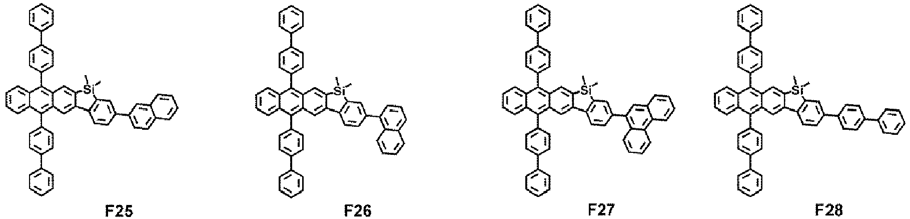

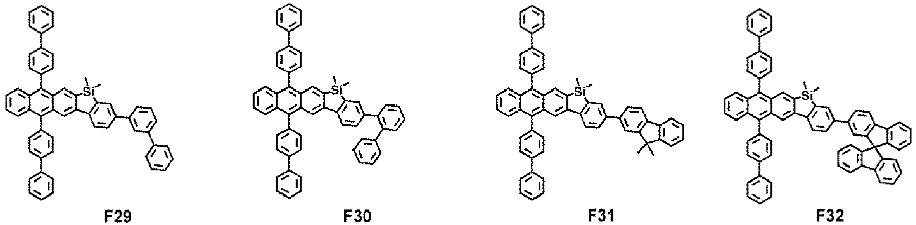

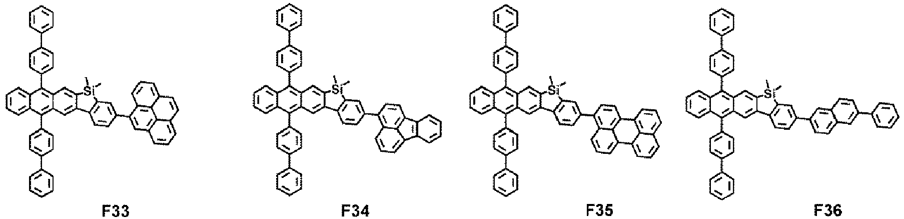

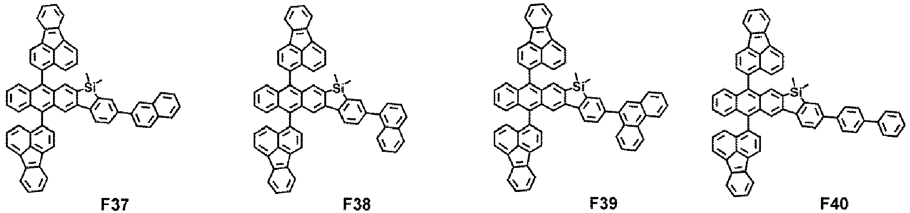

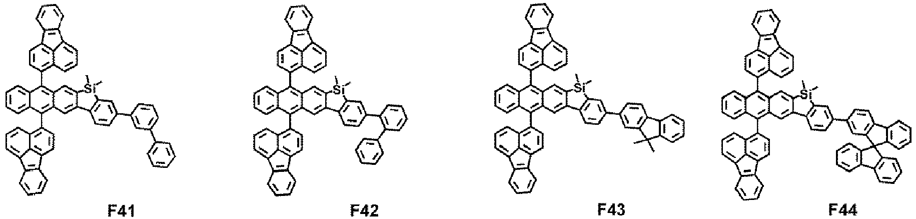

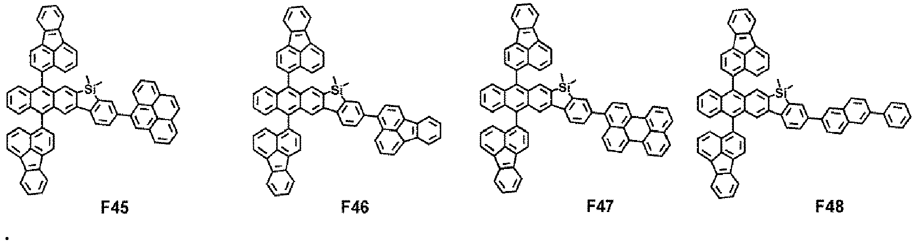

11. The organic light-emitting device of any one of the preceding claims, wherein the organic light-emitting device comprises the first auxiliary layer and the second auxiliary layer,
wherein the first auxiliary layer and the second auxiliary layer both comprise the first compound represented by Formula 1,
wherein the first compound represented by Formula 1 comprised in the first auxiliary layer is identical to the first compound represented by Formula 1 comprised in the second auxiliary layer.

12. The organic light-emitting device of any one of the preceding claims, wherein the hole transport region comprises a second compound represented by Formula 201 and/or a third compound represented by Formula 202: 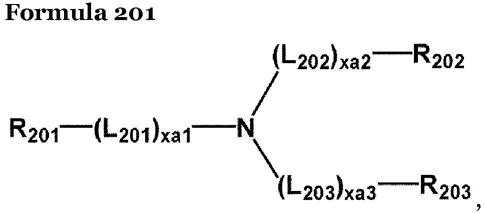 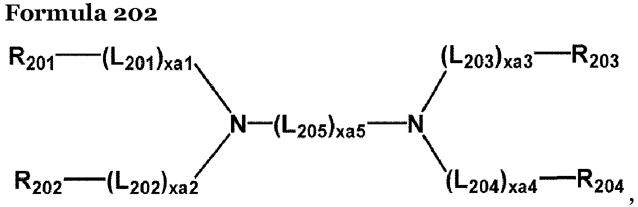 wherein, in Formulae 201 and 202,
L₂₀₁ to L₂₀₅ are each independently selected from the group consisting of:
a phenylene group, a naphthylene group, a fluorenylene group, a spiro-bifluorenylene group, a benzofluorenylne group, a dibenzofluorenylne group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, each substituted with at least one selected from deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, an isoindolyl group, a quinolinyl group, an isoquinolinyl group, a quinoxalinyl group, a quinazolinyl group, a carbazolyl group, and a triazinyl group,
xa1 to xa4 are each independently selected from 0, 1, and 2,
xa5 is selected from 1, 2, and 3,
R₂₀₁ to R₂₀₄ are each independently selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, an azulenyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group.

13. The organic light-emitting device of any one of the preceding claims, wherein
(a) at least one selected from the first auxiliary layer and second auxiliary layer further comprises an amine-based compound; and/or
(b) the organic light-emitting device comprises the first auxiliary layer and the second auxiliary layer, the first auxiliary layer and the second auxiliary layer each independently comprise the first compound represented by Formula 1, and the first auxiliary layer and the second auxiliary layer each independently comprise a second compound represented by Formula 201 and/or a third compound represented by Formula 202: 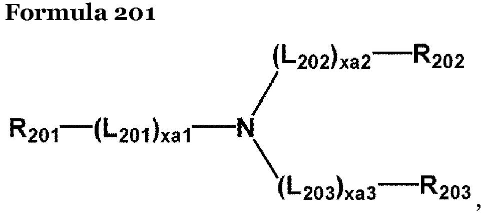 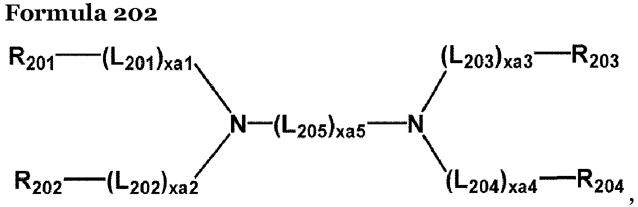
wherein, in Formulae 201 and 202,
L₂₀₁ to L₂₀₅ are each independently selected from the group consisting of:
a phenylene group, a naphthylene group, a fluorenylene group, a spiro-bifluorenylene group, a benzofluorenylne group, a dibenzofluorenylne group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, each substituted with at least one selected from deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, an isoindolyl group, a quinolinyl group, an isoquinolinyl group, a quinoxalinyl group, a quinazolinyl group, a carbazolyl group, and a triazinyl group,
xa1 to xa4 are each independently selected from 0, 1, and 2,
xa5 is selected from 1, 2, and 3, and
R₂₀₁ to R₂₀₄ are each independently selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, an azulenyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group.

14. The organic light-emitting device of any one of the preceding claims, wherein:
the first set of electrodes is a set of reflective electrode,
the second electrode is a semi-transmissive electrode, and
the organic light-emitting device satisfies Equations 1 to 3: $\frac{{λ}_{1}}{2 {n}_{1}} ⋅ {m}_{1} - \frac{{λ}_{1}}{10} \leq {D}_{11} \leq \frac{{λ}_{1}}{2 {n}_{1}} ⋅ {m}_{1} + \frac{{λ}_{1}}{10} ,$ $\frac{{λ}_{2}}{2 {n}_{2}} ⋅ {m}_{2} - \frac{{λ}_{2}}{10} \leq {D}_{12} \leq \frac{{λ}_{2}}{2 {n}_{2}} ⋅ {m}_{2} + \frac{{λ}_{2}}{10} ,$ $\frac{{λ}_{3}}{2 {n}_{3}} ⋅ {m}_{3} - \frac{{λ}_{3}}{10} \leq {D}_{13} \leq \frac{{λ}_{3}}{2 {n}_{3}} ⋅ {m}_{3} + \frac{{λ}_{3}}{10} ,$
wherein, in Equations 1 to 3,
D₁₁ indicates a distance between the electrode on the first sub-pixel and the second electrode,
D12 indicates a distance between the electrode on the second sub-pixel and the second electrode,
D₁₃ indicates a distance between the electrode on the third sub-pixel and the second electrode,
λ₁, λ₂, and λ₃ respectively and independently indicate a wavelength of the first color light, a wavelength of the second color light, and a wavelength of the third color light,
n₁ indicates a refractive index of layers between the electrode on the first sub-pixel and the second electrode;
n2 indicates a refractive index of layers between the electrode on the second sub-pixel and the second electrode,
n₃ indicates a refractive index of layers between the electrode on the third sub-pixel and the second electrode, and
m₁, m₂, and m₃ are each independently a natural number.

15. The organic light-emitting device of any one of the preceding claims, wherein the first auxiliary layer is greater in thickness than the second auxiliary layer.

## Patentansprüche

1. Organische lichtemittierende Vorrichtung, umfassend:
ein Substrat, das ein erstes Subpixel, ein zweites Subpixel und ein drittes Subpixel umfasst;
einen ersten Satz von Elektroden, der eine Elektrode auf dem ersten Subpixel des Substrats, eine Elektrode auf dem zweiten Subpixel des Substrats und eine Elektrode auf dem dritten Subpixel des Substrats umfasst;
eine zweite Elektrode, die dem ersten Satz von Elektroden gegenüberliegt;
eine Emissionsschicht zwischen dem ersten Satz von Elektroden und der zweiten Elektrode, wobei die Emissionsschicht umfasst: i) eine erste Emissionsschicht, die zwischen der Elektrode auf dem ersten Subpixel und der zweiten Elektrode angeordnet und dazu ausgestaltet ist, Licht einer ersten Farbe zu emittieren; ii) eine zweite Emissionsschicht, die zwischen der Elektrode auf dem zweiten Subpixel und der zweiten Elektrode angeordnet und dazu ausgestaltet ist, Licht einer zweiten Farbe zu emittieren; und iii) eine dritte Emissionsschicht, die zwischen der Elektrode auf dem dritten Subpixel und der zweiten Elektrode angeordnet und dazu ausgestaltet ist, Licht einer dritten Farbe zu emittieren;
einen Lochtransportbereich zwischen dem ersten Satz von Elektroden und der Emissionsschicht; und
wenigstens eine, ausgewählt aus einer ersten Hilfsschicht und einer zweiten Hilfsschicht, wobei die erste Hilfsschicht sich zwischen dem Lochtransportbereich und der ersten Emissionsschicht befindet und die zweite Hilfsschicht sich zwischen dem Lochtransportbereich und der zweiten Emissionsschicht befindet,
wobei das Licht erster Farbe rotfarbenes Licht ist, das Licht zweiter Farbe grünfarbenes Licht ist und/oder das Licht dritter Farbe blaufarbenes Licht ist, und
**dadurch gekennzeichnet, dass**
wenigstens eine, ausgewählt aus der ersten Hilfsschicht und der zweiten Hilfsschicht, eine erste Verbindung, die durch Formel 1 dargestellt ist, umfasst: 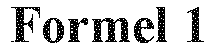 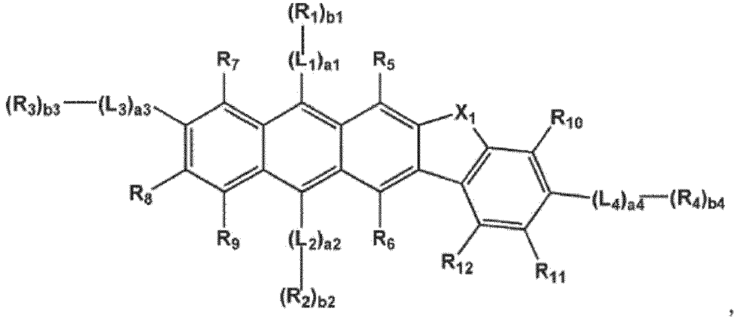
wobei in Formel 1,
X₁ ausgewählt ist aus C(R₂₁)(R₂₂), Si(R₂₁)(R₂₂), N(R₂₁), O, S, S(=O) und S(=O)₂, L₁ bis L₄ jeweils unabhängig ausgewählt sind aus einer substituierten oder nicht substituierten C₃-C₁₀-Cycloalkylengruppe, einer substituierten oder nicht substituierten C₁-C₁₀-Heterocycloalkylengruppe, einer substituierten oder nicht substituierten C₃-C₁₀-Cycloalkenylengruppe, einer substituierten oder nicht substituierten C₁-C₁₀-Heterocycloalkenylengruppe, einer substituierten oder nicht substituierten C₆-C₆₀-Arylengruppe, einer substituierten oder nicht substituierten C₁-C₆₀-Heteroarylengruppe, einer substituierten oder nicht substituierten zweiwertigen nichtaromatischen kondensierten polycyclischen C8 bis 60-Gruppe und einer substituierten oder nicht substituierten zweiwertigen nichtaromatischen kondensierten 8- bis 60gliedrigen heteropolycyclischen Gruppe,
a1 bis a4 jeweils unabhängig ausgewählt sind aus 0, 1, 2 und 3 und, wenn a1 gleich 2 oder mehr ist, 2 oder mehr L₁ gleich oder voneinander verschieden sind, wenn a2 gleich 2 oder mehr ist, 2 oder mehr L₂ gleich oder voneinander verschieden sind, wenn a3 gleich 2 oder mehr ist, 2 oder mehr L₃ gleich oder voneinander verschieden sind und, wenn a4 gleich 2 oder mehr ist, 2 oder mehr L₄ gleich oder voneinander verschieden sind,
R₁ bis R₁₂, R₂₁ und R₂₂ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer substituierten oder nicht substituierten C₁-C₆₀-Alkylgruppe, einer substituierten oder nicht substituierten C₂-C₆₀-Alkenylgruppe, einer substituierten oder nicht substituierten C₂-C₆₀-Alkinylgruppe, einer substituierten oder nicht substituierten C₁-C₆₀-Alkoxygruppe, einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten einwertigen nichtaromatischen kondensierten polycyclischen C8 bis 60-Gruppe, einer substituierten oder nicht substituierten einwertigen nichtaromatischen kondensierten 8- bis 60gliedrigen heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂), wobei eine erste Gruppe, ausgewählt aus R₁ bis R₁₂, optional mit einer zweiten Gruppe, ausgewählt aus R₁ bis R₁₂, verbunden sein kann, um eine substituierte oder nicht substituierte carbocyclische C₅-C₆₀- oder eine substituierte oder nicht substituierte heterocyclische C₁-C₆₀-Gruppe auszubilden, mit der Maßgabe, dass die erste Gruppe der zweiten Gruppe in Formel 1 benachbart ist, und mit der Maßgabe, dass die erste Gruppe oder die zweite Gruppe nicht R₁, R₂, R₃ oder R₄ ist, wenn entsprechend a1, a2, a3 oder a4 größer als Null ist; und wobei, wenn R₂₁ und R₂₂ beide vorhanden sind, sie optional verbunden sein können, um eine substituierte oder nicht substituierte carbocyclische C₅-C₆₀- oder eine substituierte oder nicht substituierte heterocyclische C₁-C₆₀-Gruppe auszubilden,
wenigstens eines, ausgewählt aus R₁ bis R₄, ausgewählt ist aus einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten einwertigen nichtaromatischen kondensierten polycyclischen C8 bis 60-Gruppe und einer substituierten oder nicht substituierten einwertigen nichtaromatischen kondensierten 8- bis 60gliedrigen heteropolycyclischen Gruppe,
b1 bis b4 jeweils unabhängig ausgewählt sind aus 1, 2 und 3 und, wenn b1 gleich 2 oder mehr ist, 2 oder mehr R₁ gleich oder voneinander verschieden sind, wenn b2 gleich 2 oder mehr ist, 2 oder mehr R₂ gleich oder voneinander verschieden sind, wenn b3 gleich 2 oder mehr ist, 2 oder mehr R₃ gleich oder voneinander verschieden sind und, wenn b4 gleich 2 oder mehr ist, 2 oder mehr R₄ gleich oder voneinander verschieden sind, und
die substituierte C₃-C₁₀-Cycloalkylengruppe, die substituierte C₁-C₁₀-Heterocycloalkylengruppe, die substituierte C₃-C₁₀-Cycloalkenylengruppe, die substituierte C₁-C₁₀-Heterocycloalkenylengruppe, die substituierte C₆-C₆₀-Arylengruppe, die substituierte C₁-C₆₀-Heteroarylengruppe, die substituierte zweiwertige nichtaromatische kondensierte polycyclische C8 bis 60-Gruppe, die substituierte zweiwertige nichtaromatische kondensierte 8- bis 60gliedrige heteropolycyclische Gruppe, die substituierte C₁-C₆₀-Alkylgruppe, die substituierte C₂-C₆₀-Alkenylgruppe, die substituierte C₂-C₆₀-Alkinylgruppe, die substituierte C₁-C₆₀-Alkoxygruppe, die substituierte C₃-C₁₀-Cycloalkylgruppe, die substituierte C₁-C₁₀-Heterocycloalkylgruppe, die substituierte C₃-C₁₀-Cycloalkenylgruppe, die substituierte C₁-C₁₀-Heterocycloalkenylgruppe, die substituierte C₆-C₆₀-Arylgruppe, die substituierte C₆-C₆₀-Aryloxygruppe, die substituierte C₆-C₆₀-Arylthiogruppe, die substituierte C₁-C₆₀-Heteroarylgruppe, die substituierte einwertige nichtaromatische kondensierte polycyclische C8 bis 60-Gruppe und die substituierte einwertige nichtaromatische kondensierte 8- bis 60gliedrige heteropolycyclische Gruppe, die substituierte carbocyclische C₅-C₆₀-Gruppe und die substituierte heterocyclische C₁-C₆₀-Gruppe mit wenigstens einem Substituenten substituiert sind, ausgewählt aus der Gruppe bestehend aus:
Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe,einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen C8 bis 60-Gruppe, einer einwertigen nichtaromatischen kondensierten 8- bis 60gliedrigen heteropolycyclischen Gruppe, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe,einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen C8 bis 60-Gruppe und einer einwertigen nichtaromatischen kondensierten 8- bis 60gliedrigen heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe,einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen C8 bis 60-Gruppe und einer einwertigen nichtaromatischen kondensierten 8- bis 60gliedrigen heteropolycyclischen Gruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen C8 bis 60-Gruppe, einer einwertigen nichtaromatischen kondensierten 8- bis 60gliedrigen heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe,einer Biphenylgruppe, einer Terphenylgruppe, einer C₁-C₆₀-Heteroarylgruppe, einer einwertigen nichtaromatischen kondensierten polycyclischen C8 bis 60-Gruppe und einer einwertigen nichtaromatischen kondensierten 8- bis 60gliedrigen heteropolycyclischen Gruppe.

2. Organische lichtemittierende Vorrichtung nach Anspruch 1, wobei X₁ ausgewählt ist aus C(R₂₁)(R₂₂) und Si(R₂₁)(R₂₂);
vorzugsweise R₂₁ und R₂₂ über eine Einfachbindung verbunden sind; oder über eine, ausgewählt aus einer C₁-C₅-Alkylengruppe und einer C₂-C₅-Alkenylengruppe, jeweils substituiert mit wenigstens einer, ausgewählt aus einer C₁-C₁₀-Alkylgruppe, einer C₁-C₁₀-Alkoxygruppe, einer Phenylgruppe, einer Biphenylgruppe, einer Terphenylgruppe und einer Naphthylgruppe, verbunden sind.

3. Organische lichtemittierende Vorrichtung nach Anspruch 1 oder Anspruch 2, wobei L₁ bis L₄ jeweils unabhängig ausgewählt sind aus der Gruppe bestehend aus:
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Fluoranthenylengruppe, einer Triphenylenylengruppe, einer Pyrenylengruppe, einer Chrysenylengruppe und einer Perylenylengruppe; und
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Fluoranthenylengruppe, einer Triphenylenylengruppe, einer Pyrenylengruppe, einer Chrysenylengruppe und einer Perylenylengruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylengruppe, einer Chrysenylgruppe und einer Perylenylgruppe.

4. Organische lichtemittierende Vorrichtung nach Anspruch 1 oder Anspruch 2, wobei L₁ bis L₄ jeweils unabhängig ausgewählt sind aus Gruppen, die durch die Formeln 3-1 bis 3-46 dargestellt sind: 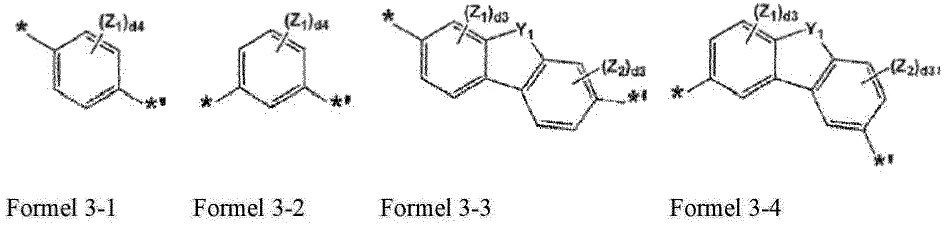 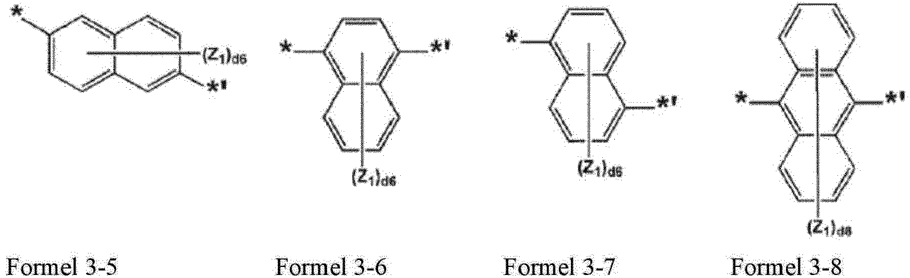 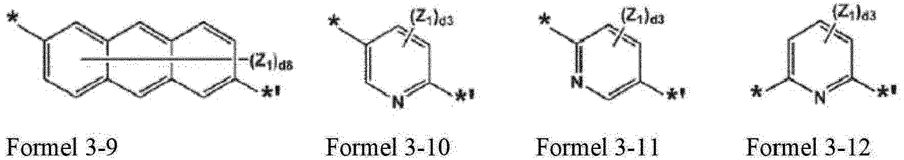 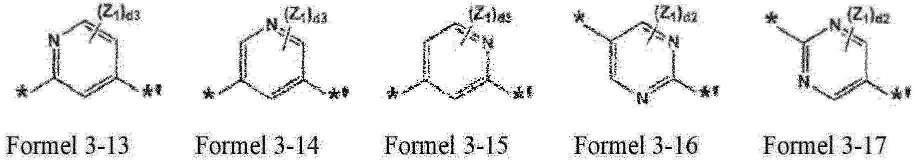 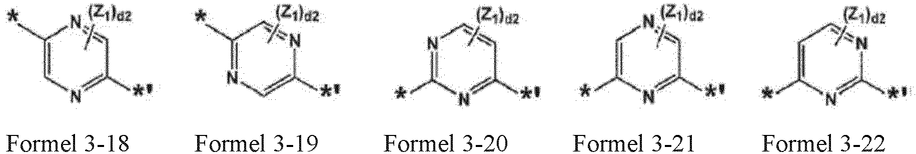 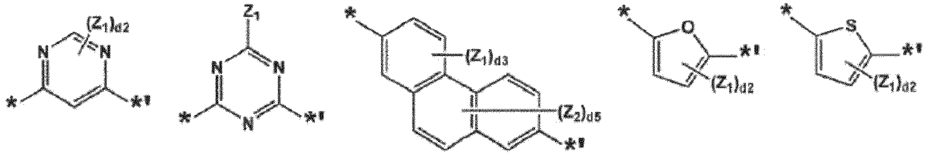 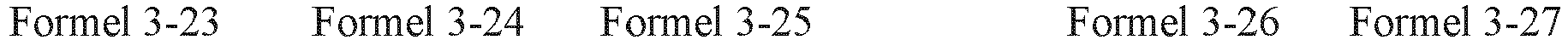 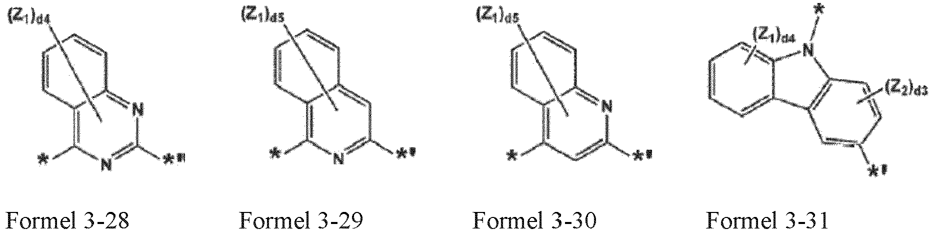 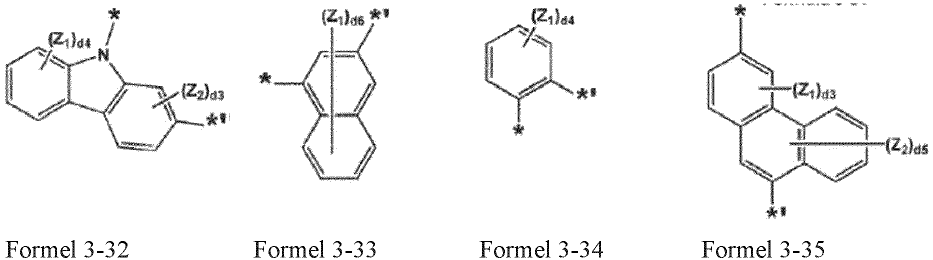 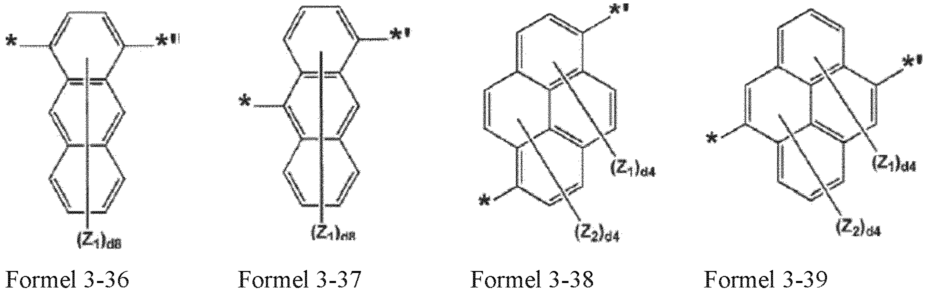 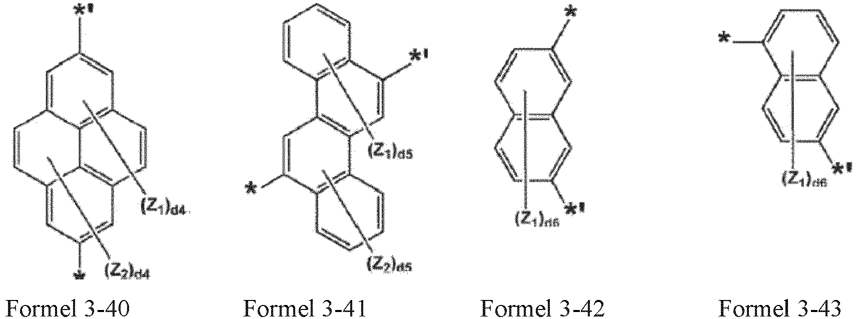 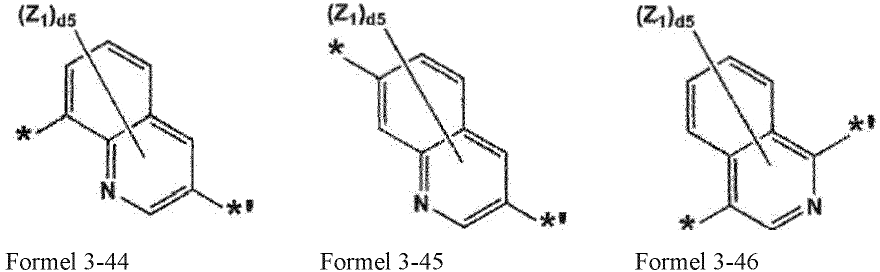 wobei in den Formeln 3-1 bis 3-46
Y₁ ausgewählt ist aus O, S, C(Z₃)(Z₄), N(Zs) und Si(Z₆)(Z₇),
Z₁ bis Z₇ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe,einer C₁-C₂₀-Alkoxygruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe, einer Dibenzofuranylgruppe, einer Dibenzothiophenylgruppe, einer Triazinylgruppe, einer Benzimidazolylgruppe, einer Phenanthrolinylgruppe und -Si(Q₃₁)(Q₃₂)(Q₃₃),
wobei Q₃₁ bis Q₃₃ jeweils unabhängig ausgewählt sind aus einer C₁-C₁₀-Alkylgruppe, einer C₁-C₁₀-Alkoxygruppe, einer Phenylgruppe, einer Biphenylgruppe, einer Terphenylgruppe und einer Naphthylgruppe,
d₂ eine ganze Zahl, ausgewählt aus 0 bis 2, ist,
d₃ eine ganze Zahl, ausgewählt aus 0 bis 3, ist,
d₄ eine ganze Zahl, ausgewählt aus 0 bis 4, ist,
d₅ eine ganze Zahl, ausgewählt aus 0 bis 5, ist,
d₆ eine ganze Zahl, ausgewählt aus 0 bis 6, ist,
d₈ eine ganze Zahl, ausgewählt aus 0 bis 8, ist und
^{∗} und ^{∗}' jeweils eine Bindungsstelle zu einem Nachbaratom angeben;
wobei vorzugsweise:
L₁ bis L₄ jeweils unabhängig ausgewählt sind aus Gruppen, die durch die Formeln 3-1 bis 3-9, 3-25 bis 3-27 und 3-31 bis 3-43 dargestellt sind, und Z₁ bis Z₇ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe,einer C₁-C₂₀-Alkoxygruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Carbazolylgruppe, einer Dibenzofuranylgruppe und einer Dibenzothiophenylgruppe.

5. Organische lichtemittierende Vorrichtung nach einem der vorangehenden Ansprüche, wobei R₁ bis R₄, R₂₁ und R₂₂ jeweils unabhängig ausgewählt sind aus der Gruppe bestehend aus:
Wasserstoff, Deuterium, einer C₁-C₂₀-Alkylgruppe und einer C₁-C₂₀-Alkoxygruppe,
einer C₁-C₂₀-Alkylgruppe und einer C₁-C₂₀-Alkoxygruppe, jeweils substituiert wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer Phenylgruppe, einer Biphenylgruppe und einer Terphenylgruppe;
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Benzonaphthofuranylgruppe, einer Benzonaphthothiophenylgruppe, einer Dinaphthofuranylgruppe und einer Dinaphthothiophenylgruppe; und
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Benzonaphthofuranylgruppe, einer Benzonaphthothiophenylgruppe, einer Dinaphthofuranylgruppe und einer Dinaphthothiophenylgruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Benzonaphthofuranylgruppe, einer Benzonaphthothiophenylgruppe, einer Dinaphthofuranylgruppe, einer Dinaphthothiophenylgruppe und -Si(Q₃₁)(Q₃₂)(Q₃₃),
wobei Q₃₁ bis Q₃₃ jeweils unabhängig ausgewählt sind aus einer C₁-C₁₀-Alkylgruppe, einer C₁-C₁₀-Alkoxygruppe, einer Phenylgruppe, einer Biphenylgruppe, einer Terphenylgruppe und einer Naphthylgruppe.

6. Organische lichtemittierende Vorrichtung nach einem der vorangehenden Ansprüche, wobei R₁ bis R₄ jeweils unabhängig ausgewählt sind aus Wasserstoff, Deuterium, einer C₁-C₂₀-Alkylgruppe und einer Gruppe, die durch beliebige der Formeln 5-1 bis 5-46 dargestellt ist, wobei wenigstens eines, ausgewählt aus R₁ bis R₄, aus Gruppen, die durch die Formeln 5-1 bis 5-46 dargestellt sind, ausgewählt ist,
R₂₁ und R₂₂ jeweils unabhängig ausgewählt sind aus einer C₁-C₂₀-Alkylgruppe und einer Gruppe, die durch beliebige der Formeln 5-1 bis 5-46 dargestellt ist: 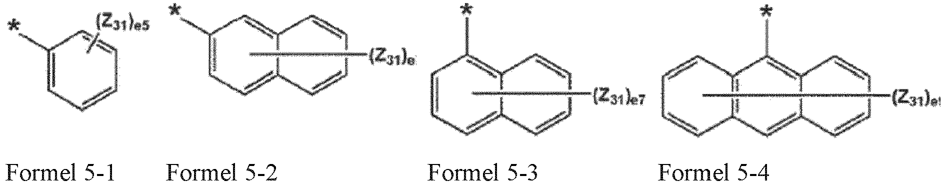 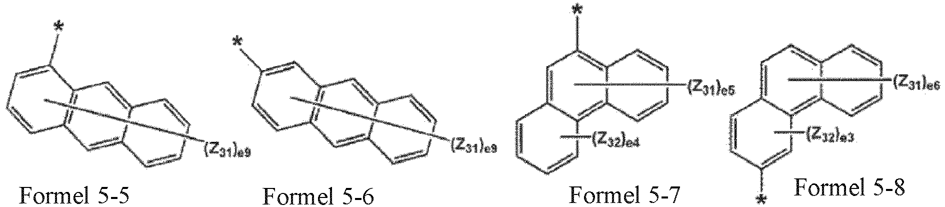 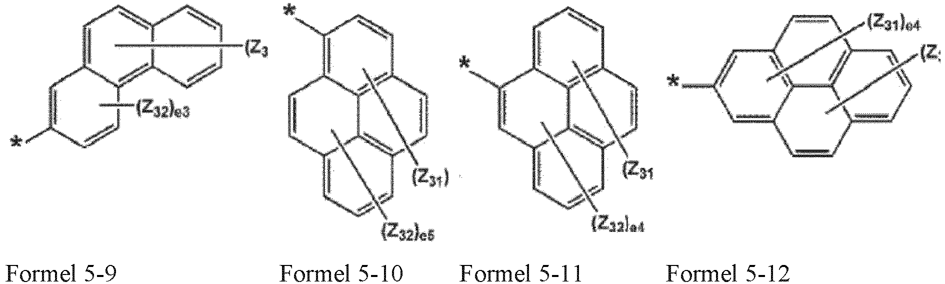 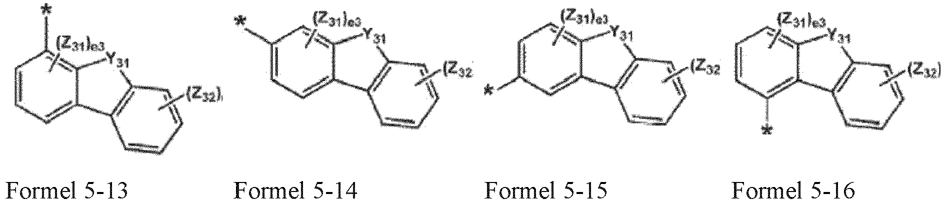 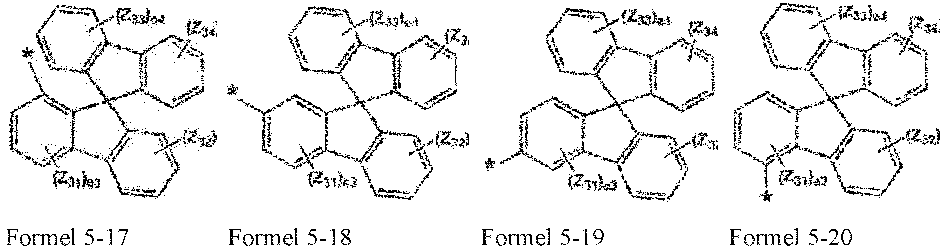 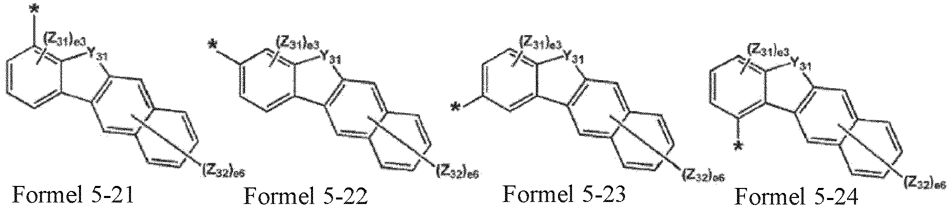 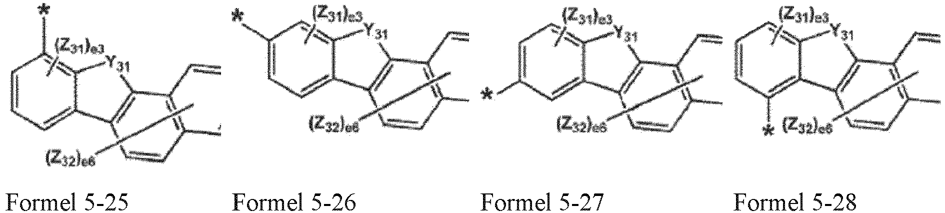 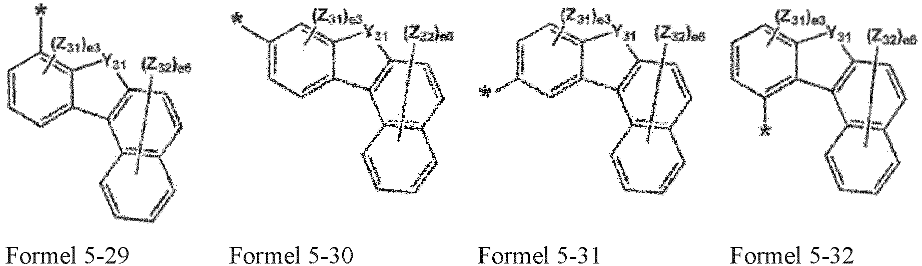 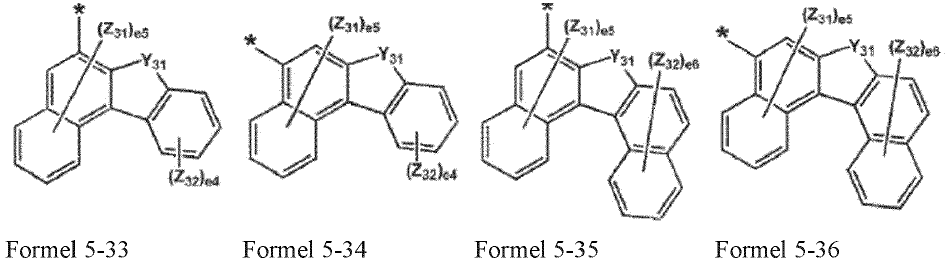 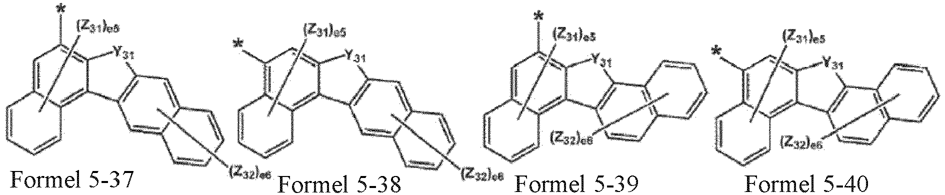 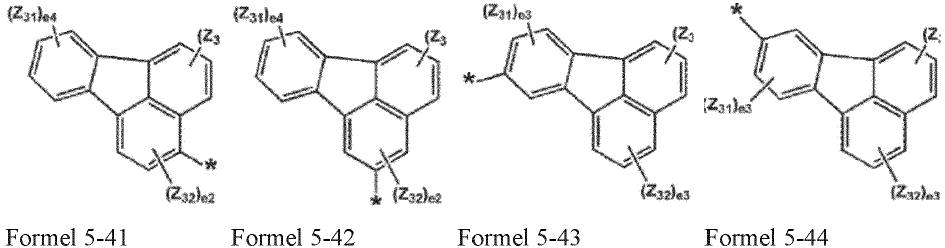 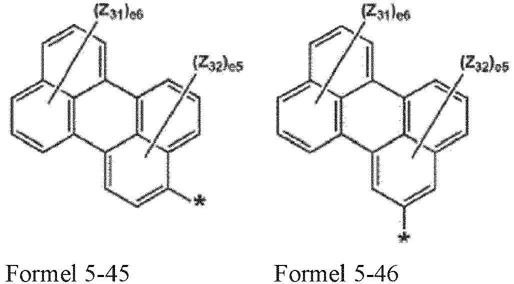 wobei in den Formeln 5-1 bis 5-46,
Y₃₁ ausgewählt ist aus O, S, C(Z₃₃)(Z₃₄), N(Z₃₅) und Si(Z₃₆)(Z₃₇),
Z₃₁ bis Z₃₇ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Benzonaphthofuranylgruppe, einer Benzonaphthothiophenylgruppe, einer Dinaphthofuranylgruppe, einer Dinaphthothiophenylgruppe und -Si(Q₃₁)(Q₃₂)(Q₃₃),
wobei Q₃₁ bis Q₃₃ jeweils unabhängig ausgewählt sind aus einer C₁-C₁₀-Alkylgruppe, einer C₁-C₁₀-Alkoxygruppe, einer Phenylgruppe, einer Biphenylgruppe, einer Terphenylgruppe und einer Naphthylgruppe,
e₂ eine ganze Zahl, ausgewählt aus 0 bis 2, ist,
e₃ eine ganze Zahl, ausgewählt aus 0 bis 3, ist,
e₄ eine ganze Zahl, ausgewählt aus 0 bis 4, ist,
e₅ eine ganze Zahl, ausgewählt aus 0 bis 5, ist,
e₆ eine ganze Zahl, ausgewählt aus 0 bis 6, ist,
e₇ eine ganze Zahl, ausgewählt aus 0 bis 7, ist,
e₉ eine ganze Zahl, ausgewählt aus 0 bis 9, ist und
^{∗} eine Bindungsstelle zu einem Nachbaratom angibt.

7. Organische lichtemittierende Vorrichtung nach einem der Ansprüche 1-5,
wobei R₁ bis R₄ jeweils unabhängig ausgewählt sind aus Wasserstoff, Deuterium, einer C₁-C₂₀-Alkylgruppe und einer Gruppe, die durch beliebige der Formeln 6-1 bis 6-179 dargestellt ist, wobei wenigstens eines, ausgewählt aus R₁ bis R₄, ausgewählt ist aus Gruppen, die durch die Formeln 6-1 bis 6-179 dargestellt sind, und
R₂₁ und R₂₂ jeweils unabhängig ausgewählt sind aus einer C₁-C₂₀-Alkylgruppe und einer Gruppe, die durch beliebige der Formeln 6-1 bis 6-179 dargestellt ist: 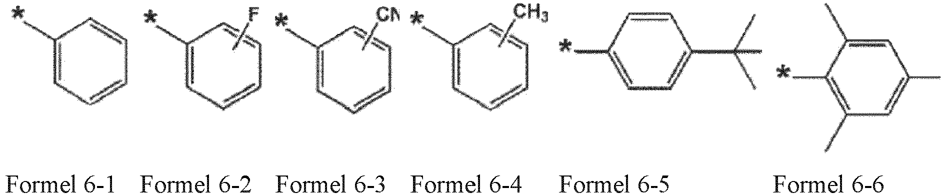 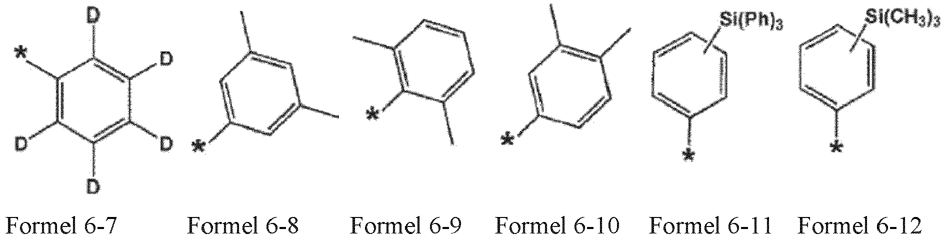 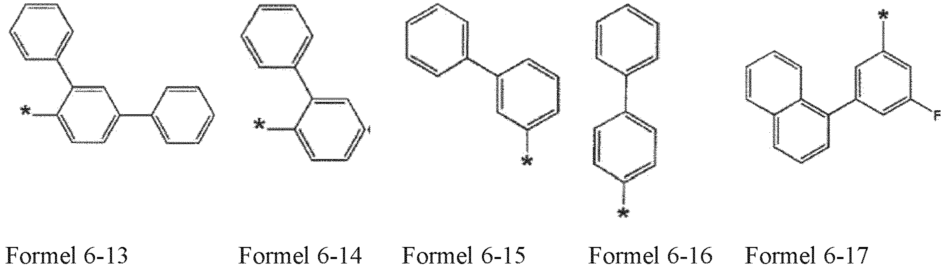 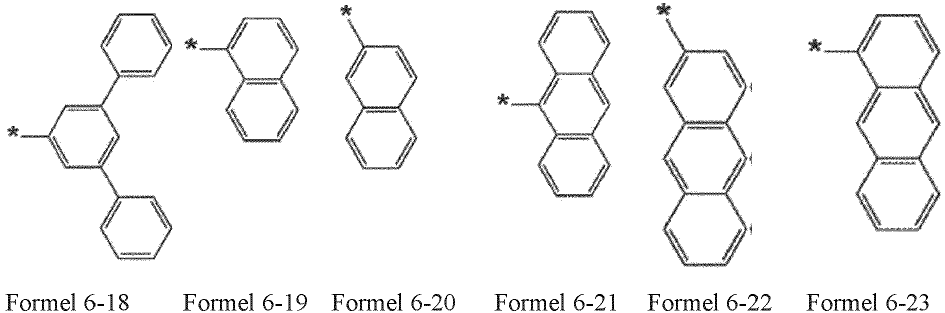 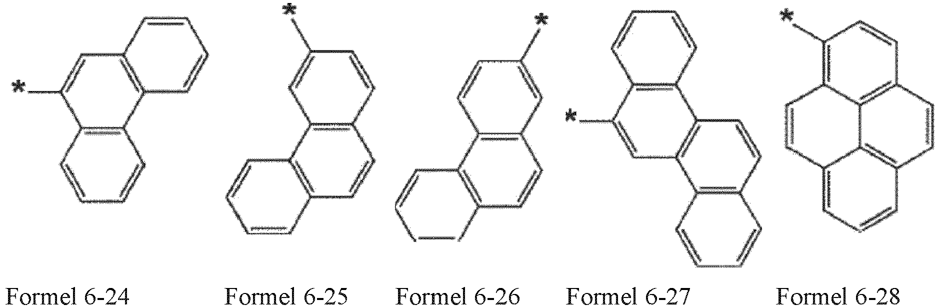 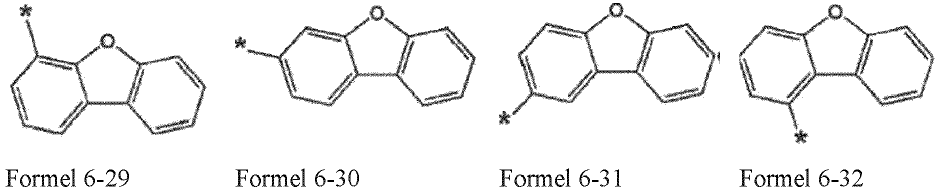 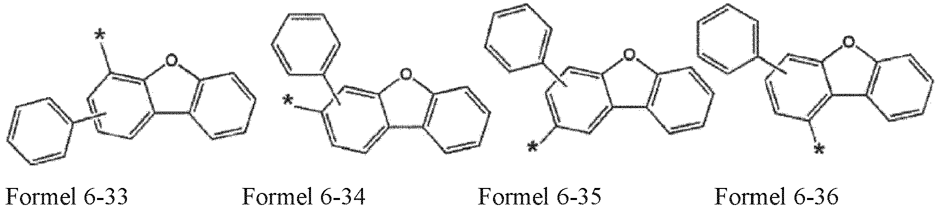 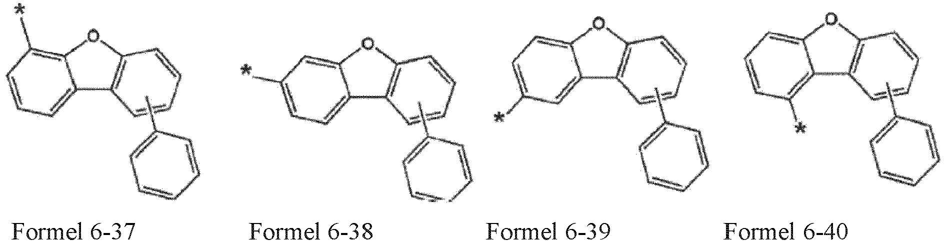 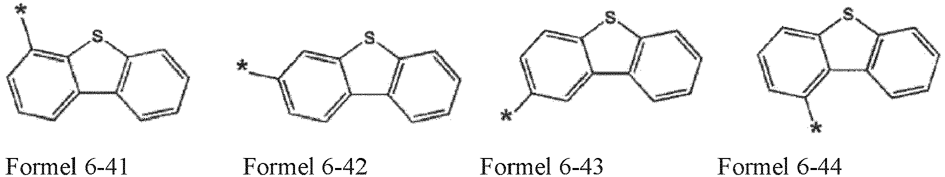 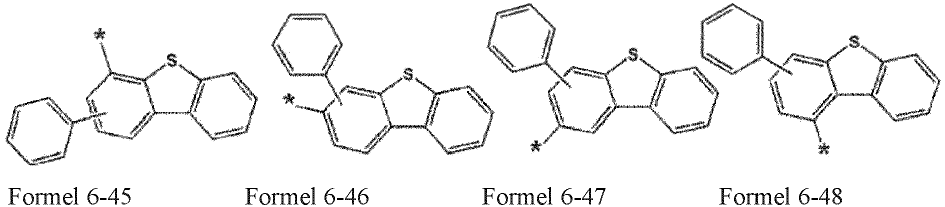 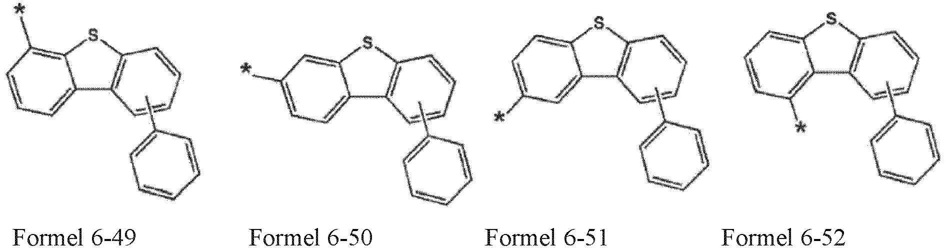 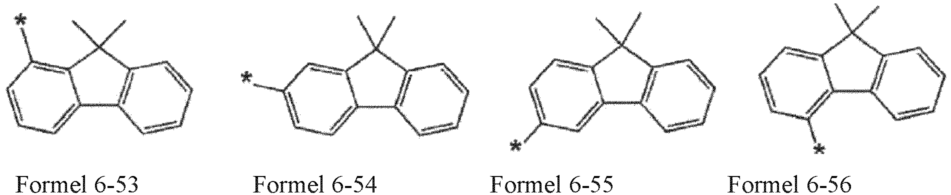 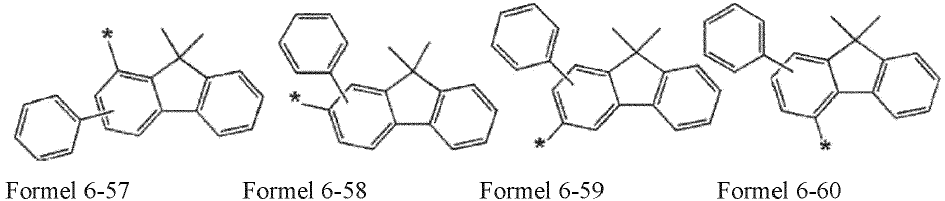 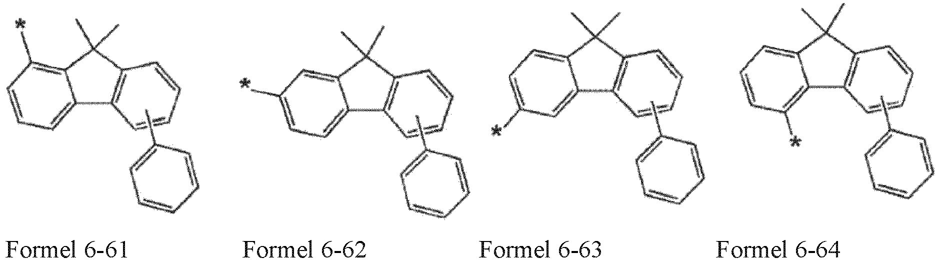 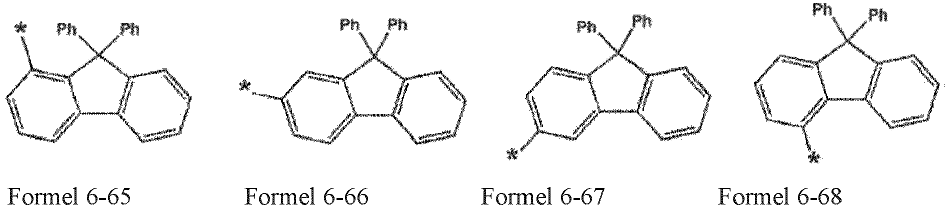 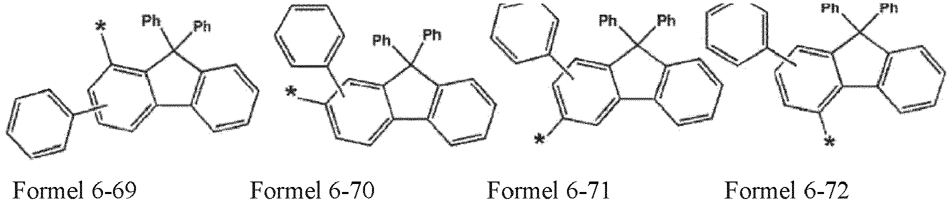 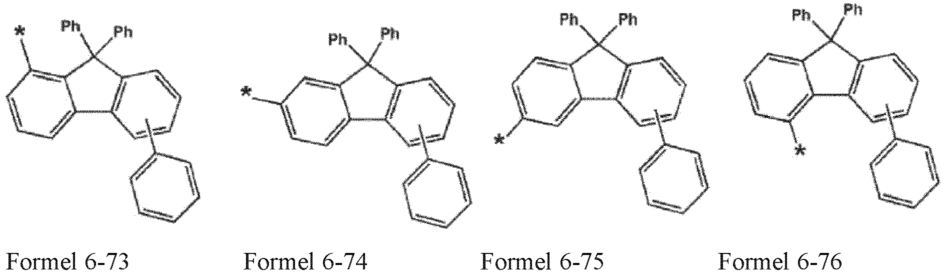 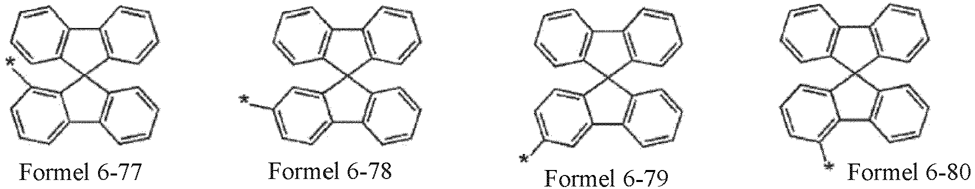 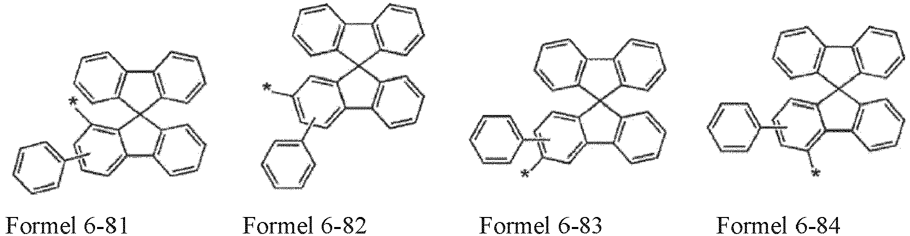 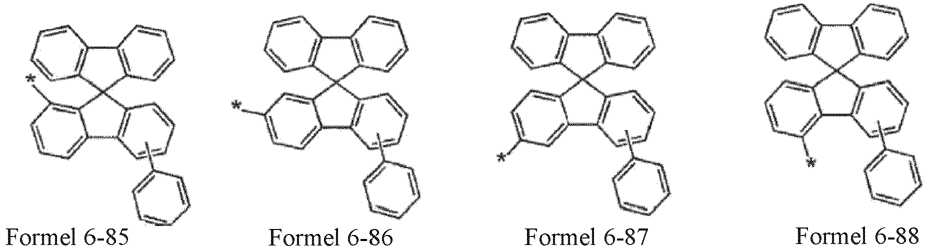 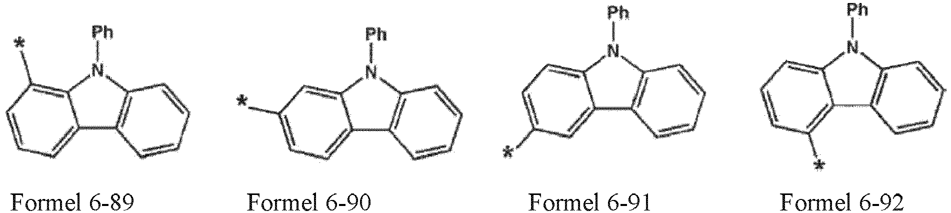 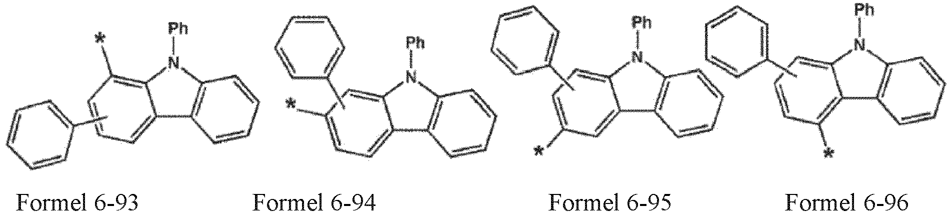 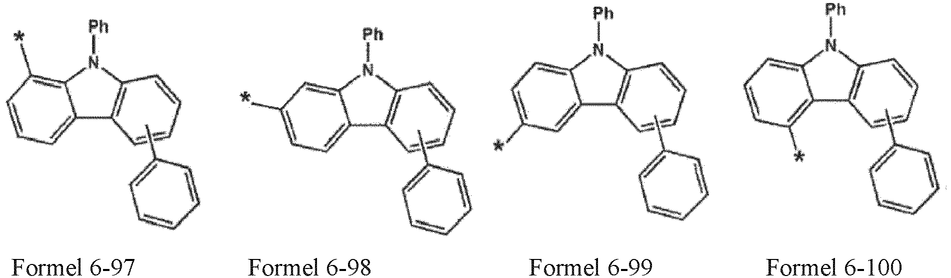 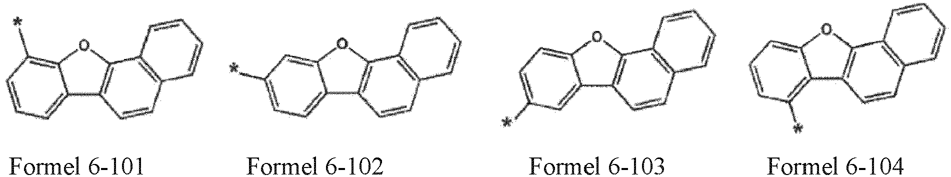 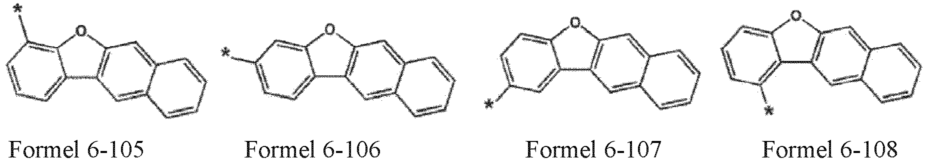 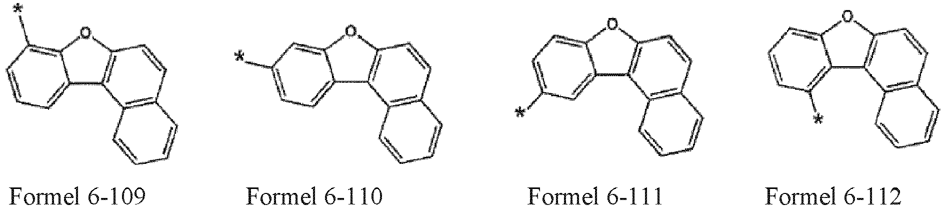 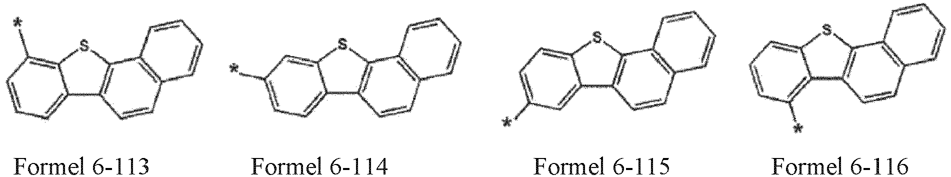 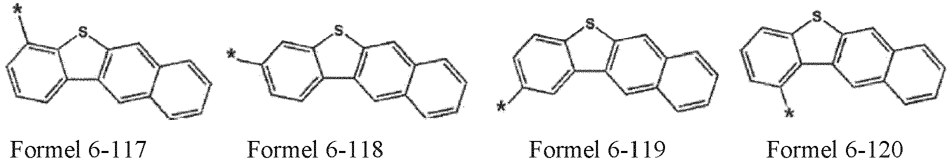 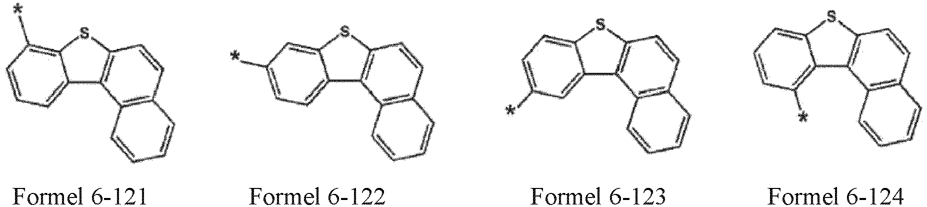 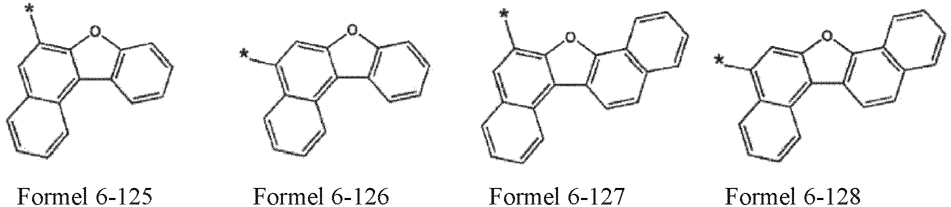 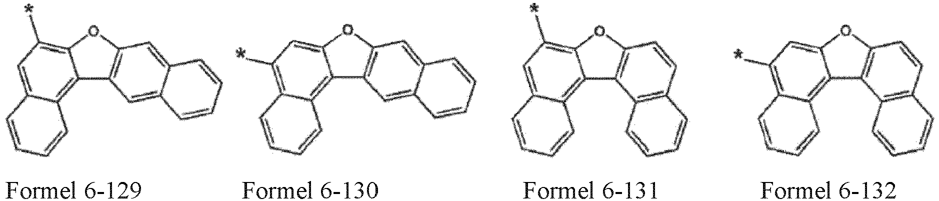 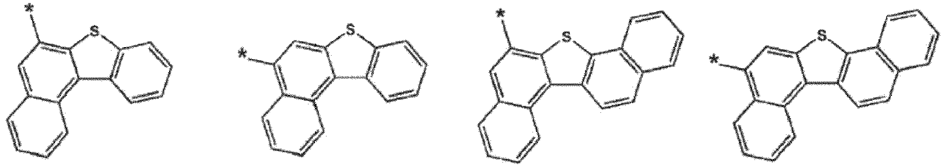 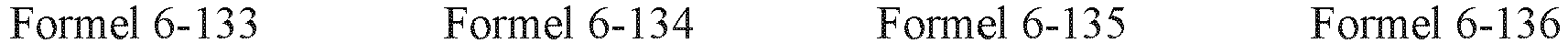 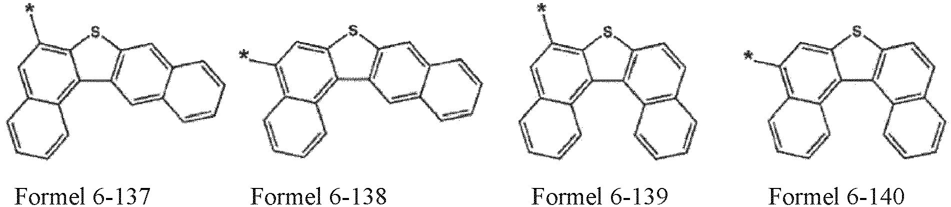 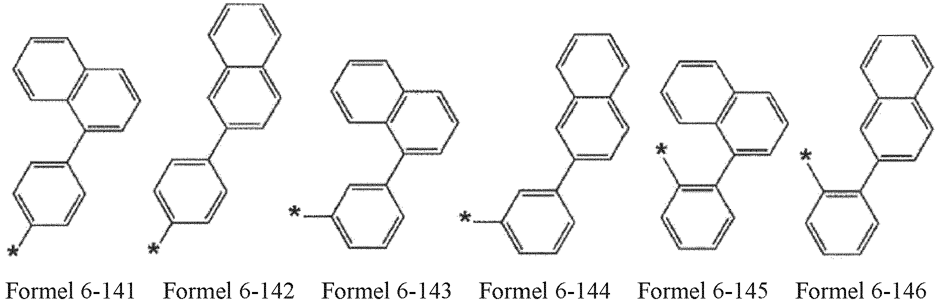 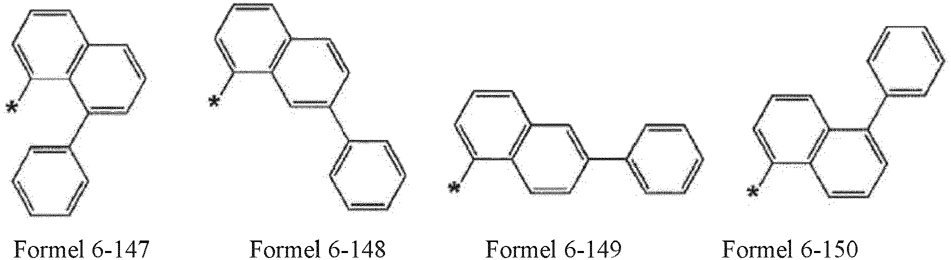 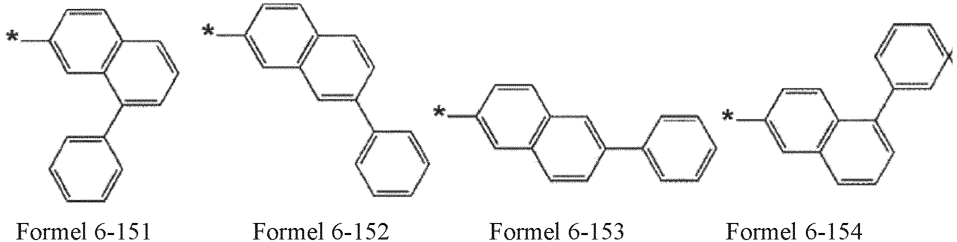 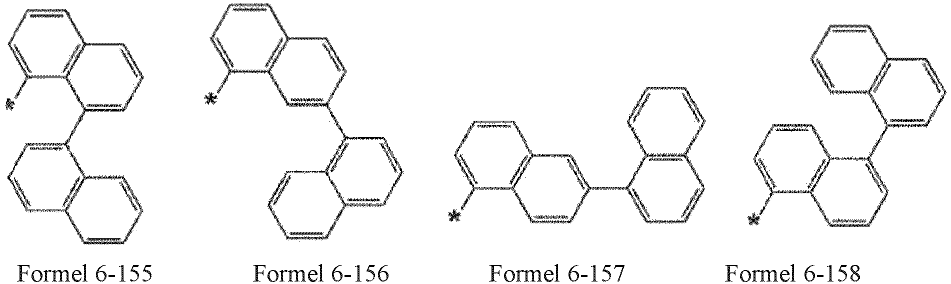 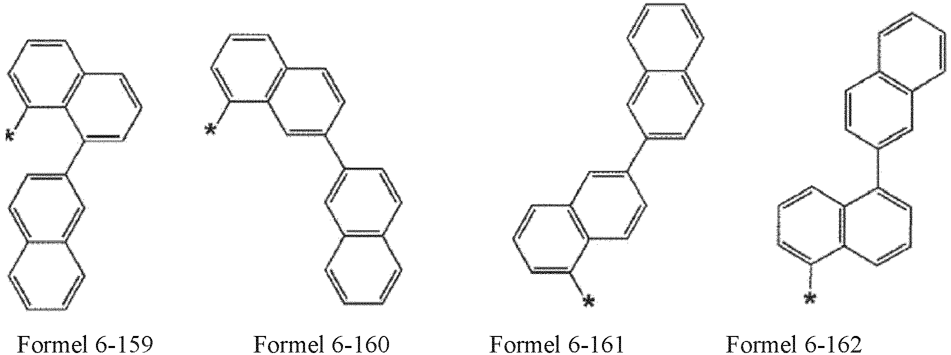 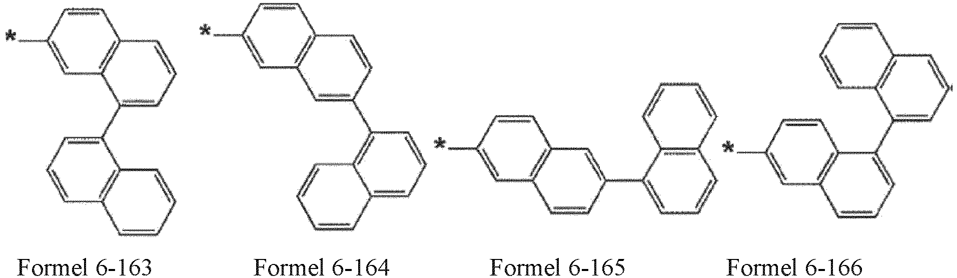 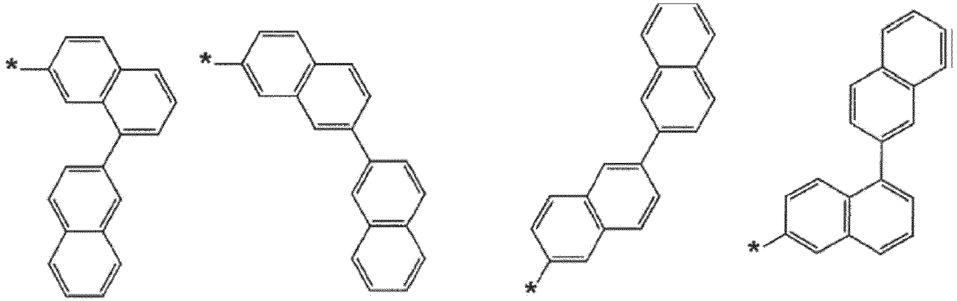 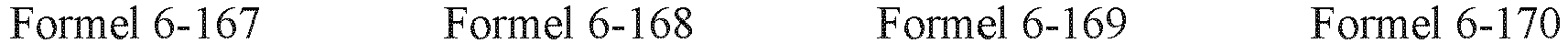 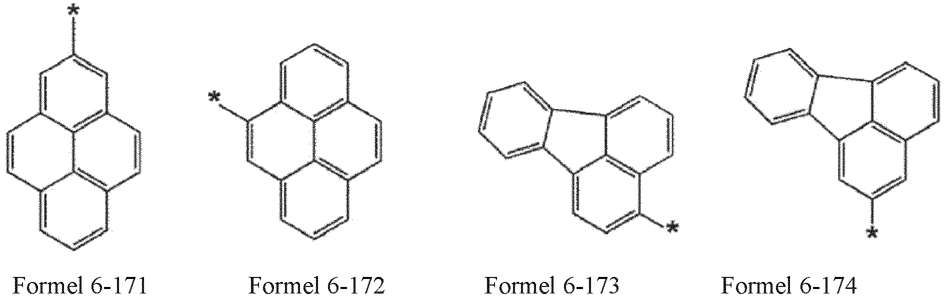 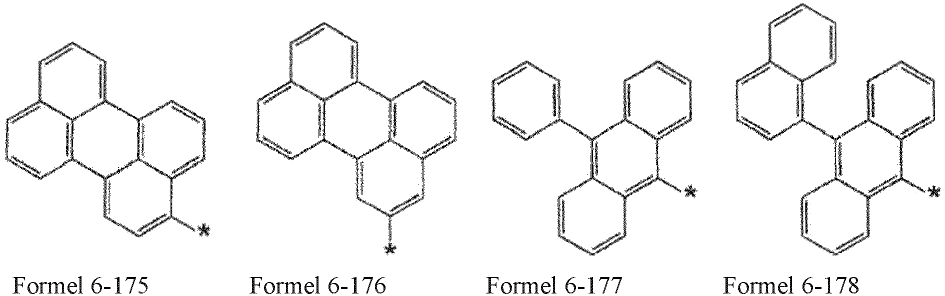 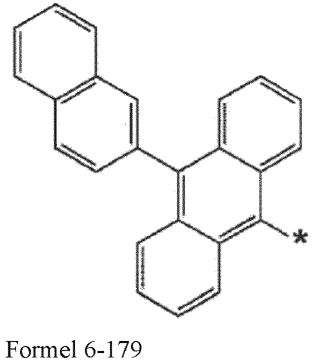
wobei in den Formeln 6-1 bis 6-179 Ph eine Phenylgruppe angibt und ^{∗} eine Bindungsstelle zu einem Nachbaratom angibt.

8. Organische lichtemittierende Vorrichtung nach einem der vorangehenden Ansprüche, wobei:
(a) X₁ ausgewählt ist aus C(R₂₁)(R₂₂) und Si(R₂₁)(R₂₂), wobei R₂₁ und R₂₂ jeweils unabhängig ausgewählt sind aus der Gruppe bestehend aus:
einer C₁-C₁₀-Alkylgruppe, einer Phenylgruppe, einer Biphenylgruppe, einer Terphenylgruppe, einer Naphthylgruppe und einer Anthracenylgruppe; und
einer Phenylgruppe, einer Biphenylgruppe, einer Terphenylgruppe, einer Naphthylgruppe und einer Anthracenylgruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe und einer Anthracenylgruppe,
wobei R₂₁ und R₂₂ optional über eine Einfachbindung verbunden sind; oder optional über eine C₁-C₃-Alkylengruppe, substituiert mit wenigstens einem, ausgewählt aus einer C₁-C₁₀-Alkylgruppe, einer C₁-C₁₀-Alkoxygruppe, einer Phenylgruppe, einer Biphenylgruppe, einer Terphenylgruppe und einer Naphthylgruppe, verbunden sind; und/oder
(b) R₅ bis R₁₂ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe und -Si(Q₁)(Q₂)(Q₃); wobei Q₁ bis Q₃ jeweils unabhängig ausgewählt sind aus einer C₁-C₂₀-Alkylgruppe, einer C₁-C₂₀-Alkoxygruppe, einer Phenylgruppe, einer Biphenylgruppe, einer Terphenylgruppe und einer Naphthylgruppe; und/oder
(c) a1 bis a4 jeweils unabhängig ausgewählt sind aus 0, 1 und 2.

9. Organische lichtemittierende Vorrichtung nach einem der vorangehenden Ansprüche, wobei die erste Verbindung, die durch Formel 1 dargestellt ist, eine Verbindung, die durch wenigstens eine, ausgewählt aus den Formeln 1-1 bis 1-10, dargestellt ist, ist: 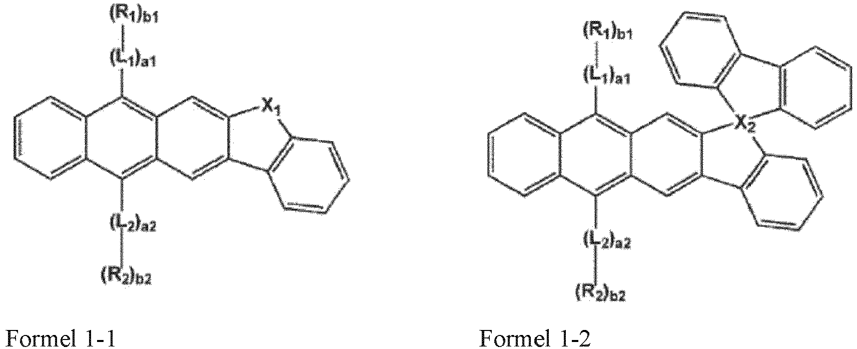 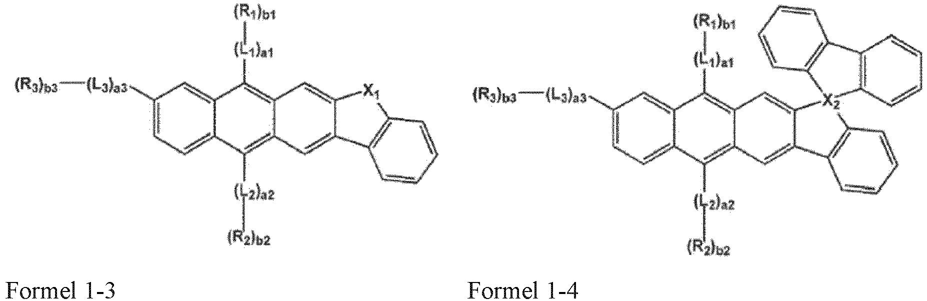 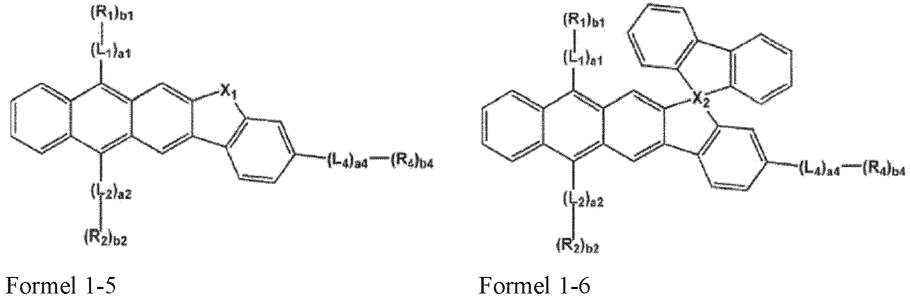 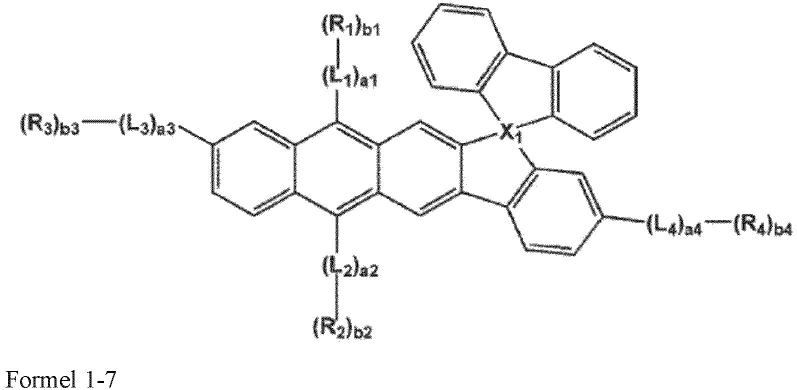 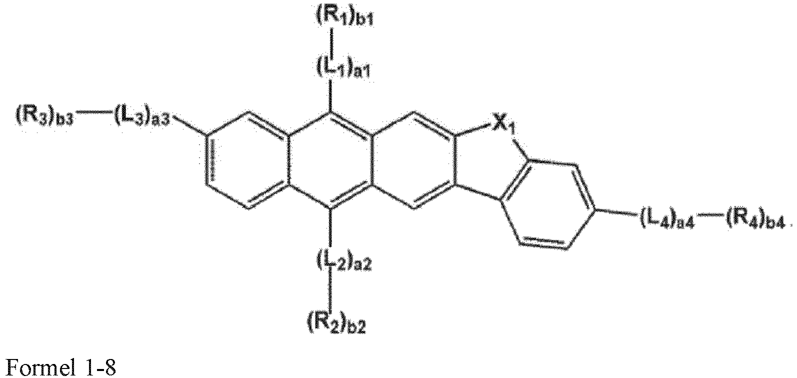 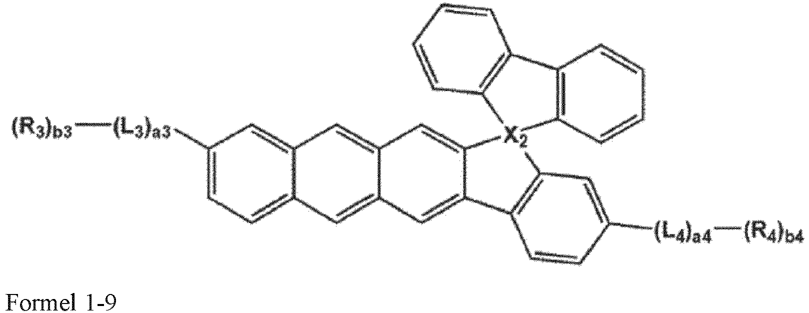 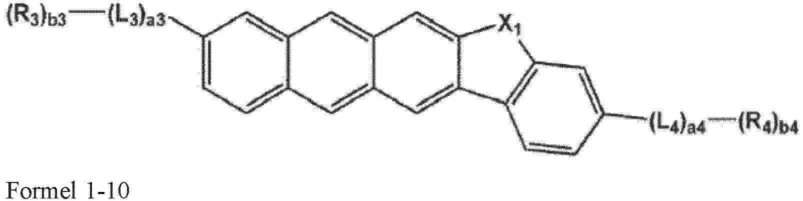 wobei in den Formeln 1-1 bis 1-10,
X₁, L₁ bis L₄ und a1 bis a4 jeweils unabhängig so sind, wie in einem der Ansprüche 1 bis 4 definiert,
X₂ ausgewählt ist aus Kohlenstoff und Silicium,
R₁ bis R₄ jeweils unabhängig ausgewählt sind aus der Gruppe bestehend aus:
einer C₁-C₂₀-Alkylgruppe und einer C₁-C₂₀-Alkoxygruppe;
einer C₁-C₂₀-Alkylgruppe und einer C₁-C₂₀-Alkoxygruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer Phenylgruppe, einer Biphenylgruppe und einer Terphenylgruppe;
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Benzocarbazolylgruppe, einer Dibenzocarbazolylgruppe einer Dibenzosilolylgruppe, einer Benzonaphthofuranylgruppe, einer Benzonaphthothiophenylgruppe, einer Dinaphthofuranylgruppe und einer Dinaphthothiophenylgruppe; und
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Benzonaphthofuranylgruppe, einer Benzonaphthothiophenylgruppe, einer Dinaphthofuranylgruppe und einer Dinaphthothiophenylgruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Benzocarbazolylgruppe, einer Dibenzocarbazolylgruppe, einer Dibenzosilolylgruppe, einer Benzonaphthofuranylgruppe, einer Benzonaphthothiophenylgruppe, einer Dinaphthofuranylgruppe, einer Dinaphthothiophenylgruppe und -Si(Q₃₁)(Q₃₂)(Q₃₃),
wobei Q₃₁ bis Q₃₃ jeweils unabhängig ausgewählt sind aus einer C₁-C₁₀-Alkylgruppe, einer C₁-C₁₀-Alkoxygruppe, einer Phenylgruppe, einer Biphenylgruppe, einer Terphenylgruppe und einer Naphthylgruppe und
b1 bis b4 jeweils unabhängig ausgewählt sind aus 1 und 2.

10. Organische lichtemittierende Vorrichtung nach Anspruch 1, wobei die erste Verbindung, die durch Formel 1 dargestellt ist, ausgewählt ist aus den Verbindungen Al bis A60, den Verbindungen B1 bis B48, den Verbindungen C1 bis C30, den Verbindungen D1 bis D30, den Verbindungen E1 bis E60 und den Verbindungen F1 bis F48:

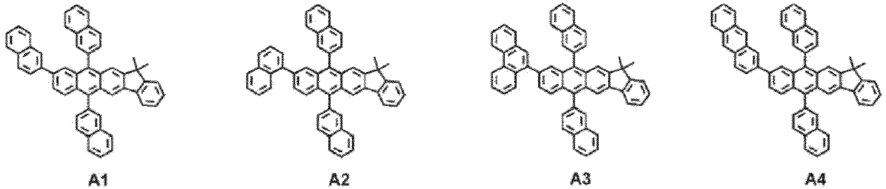

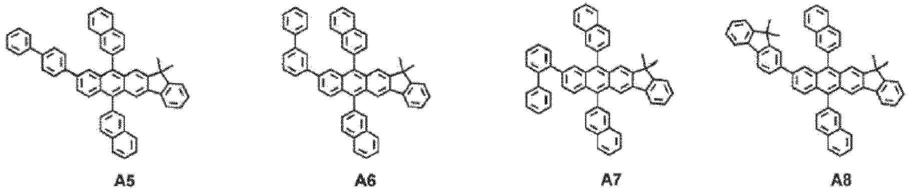

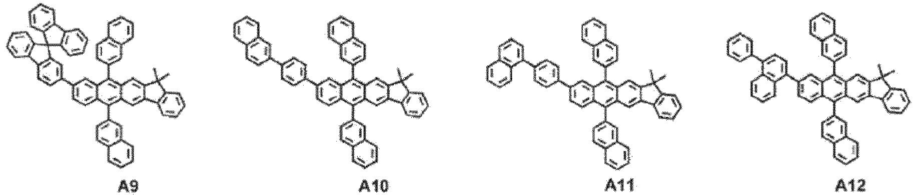

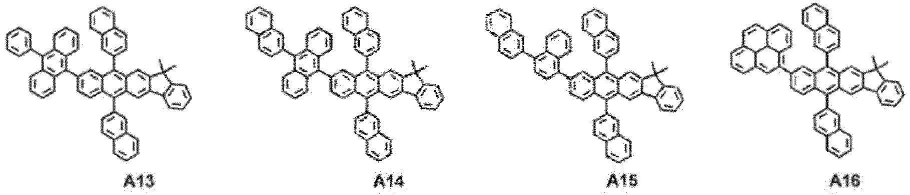

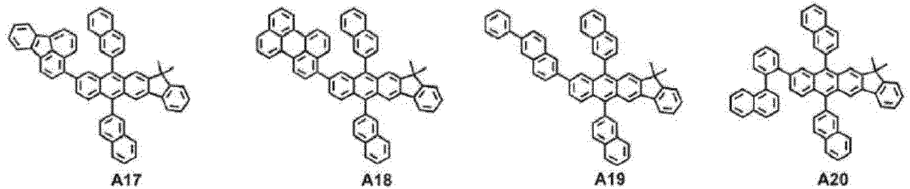

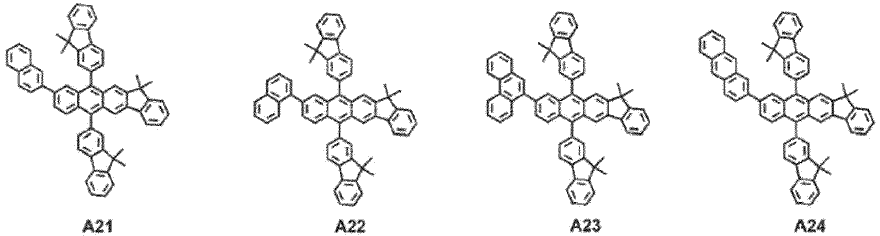

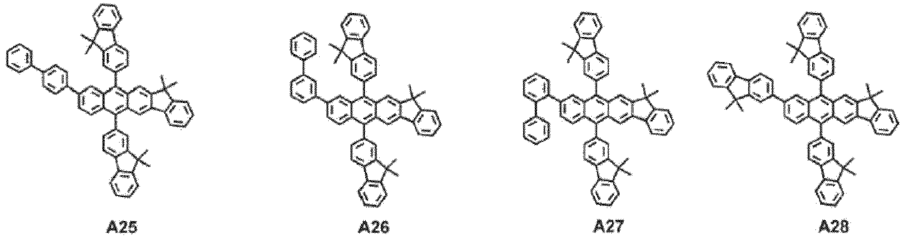

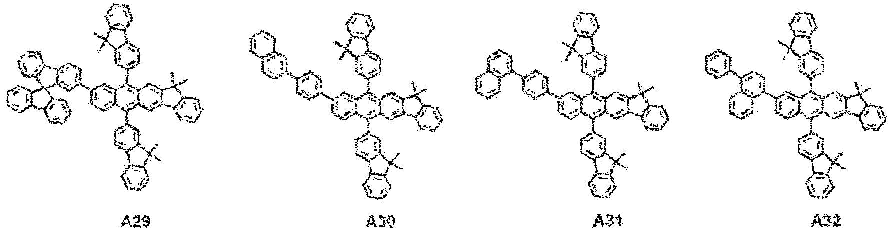

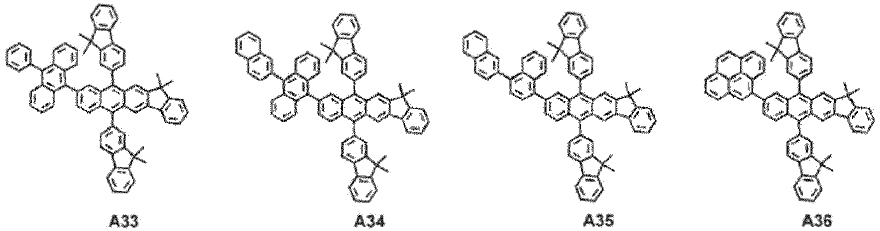

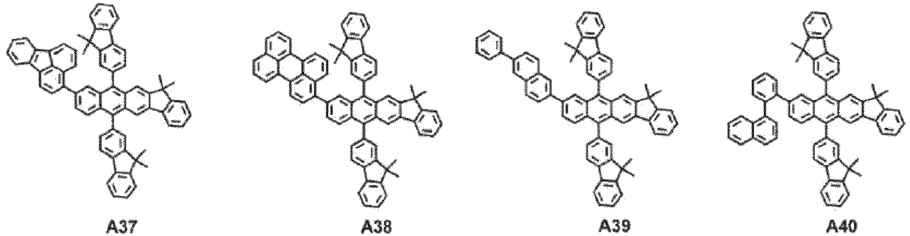

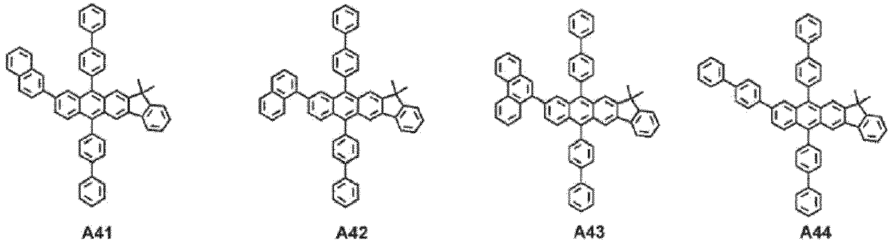

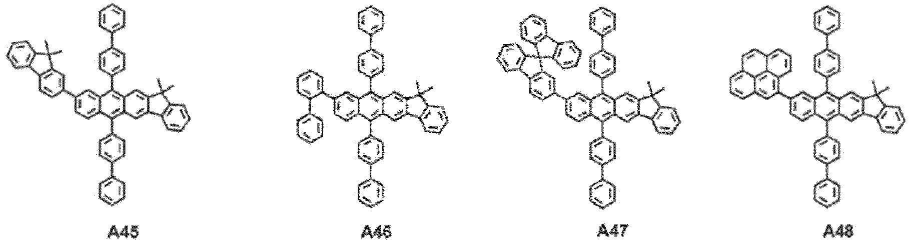

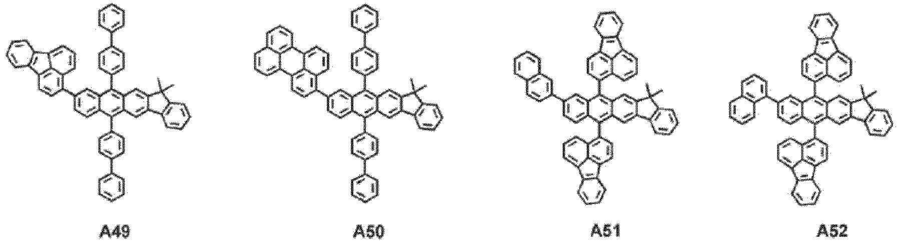

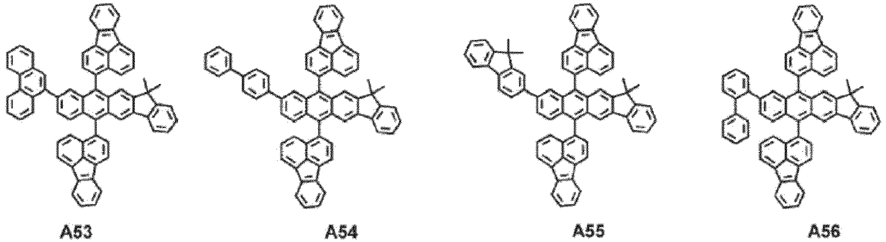

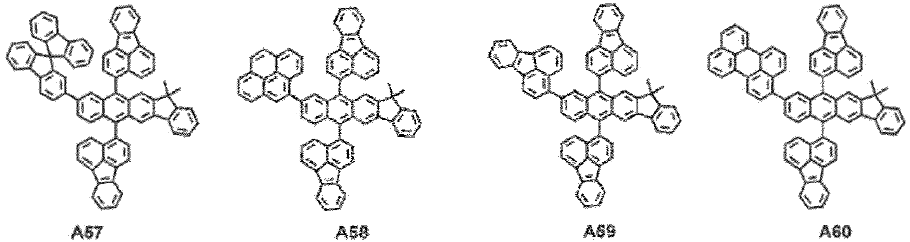

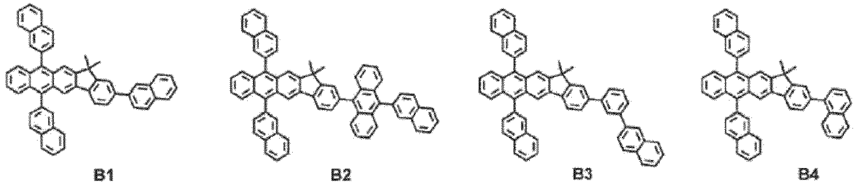

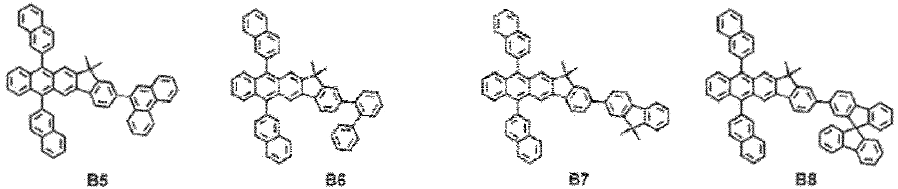

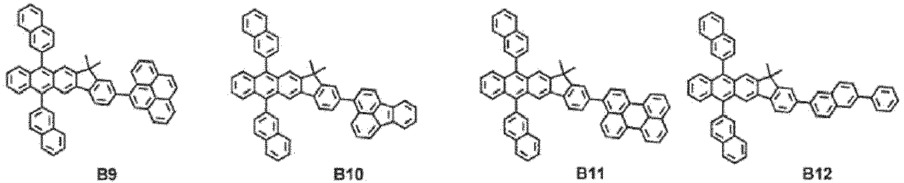

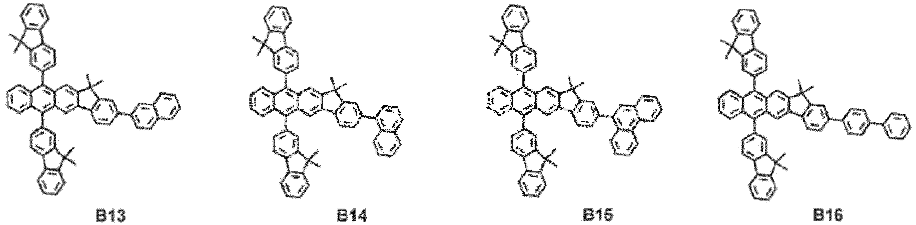

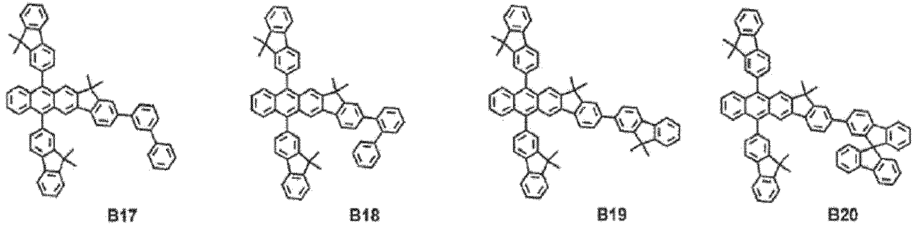

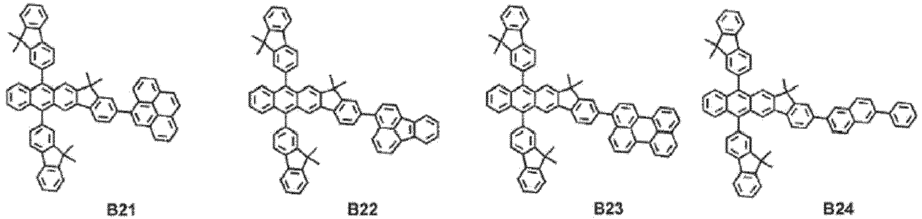

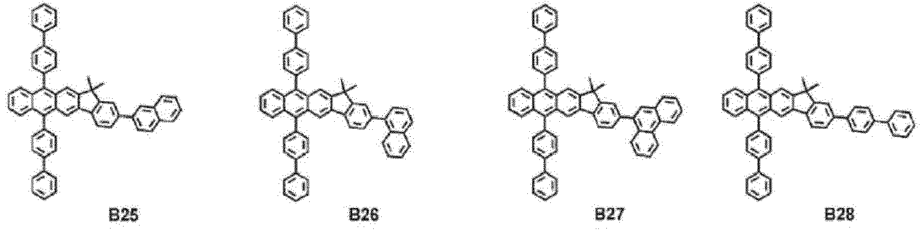

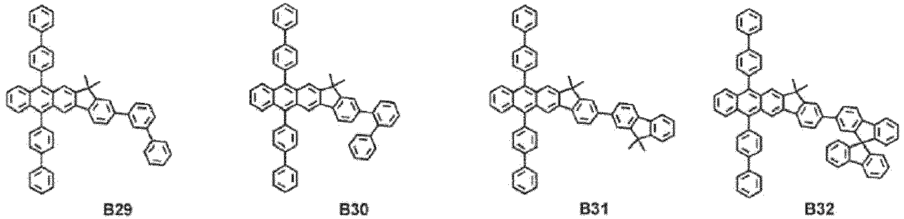

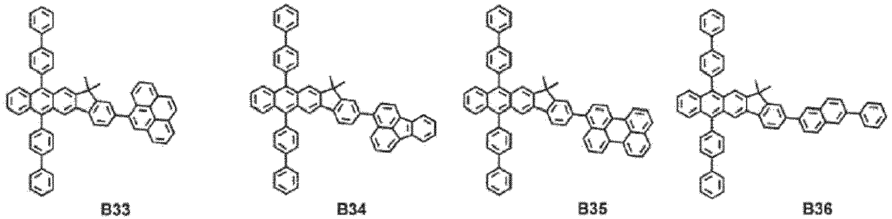

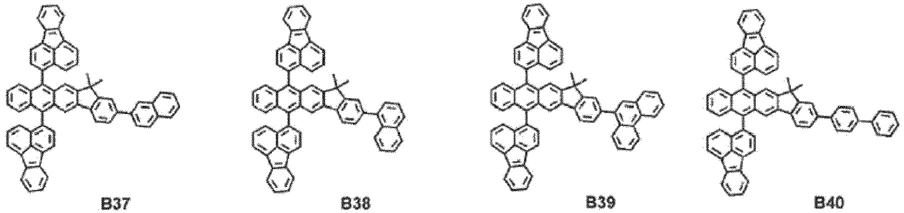

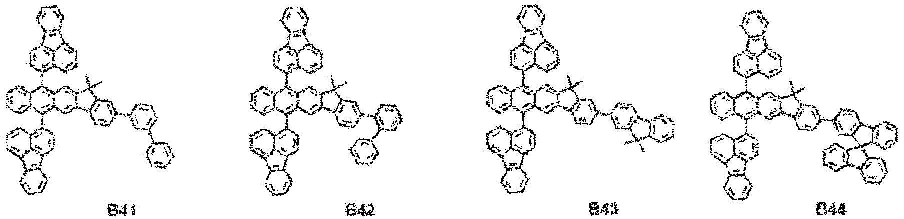

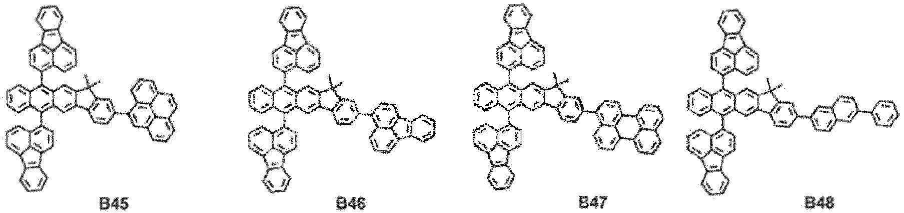

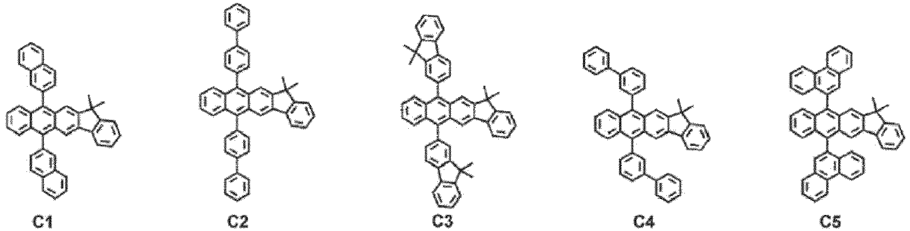

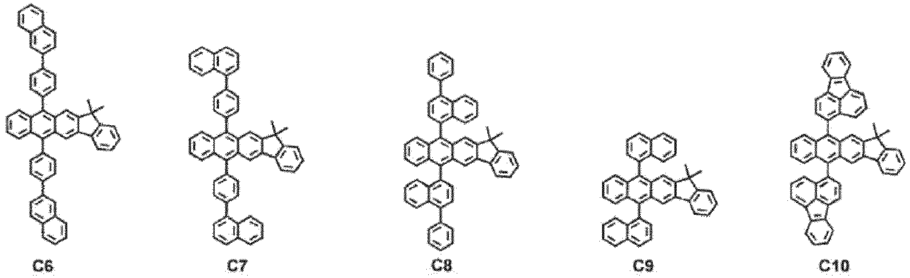

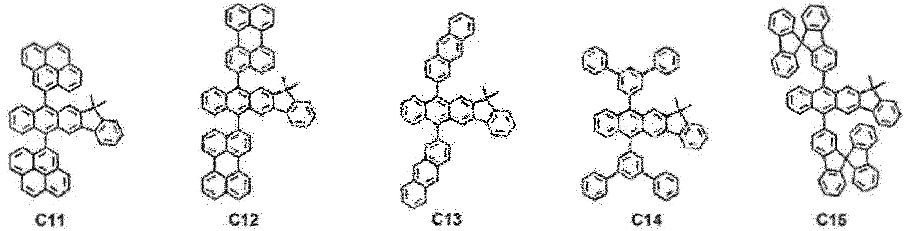

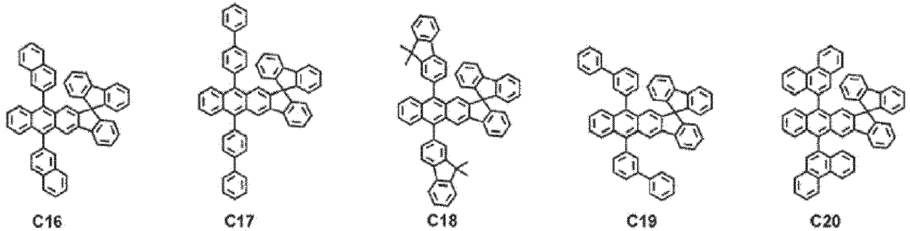

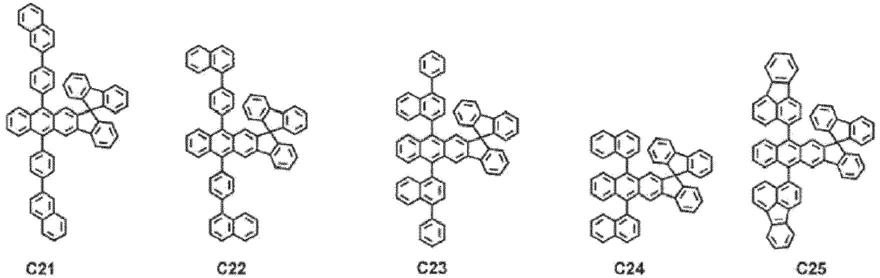

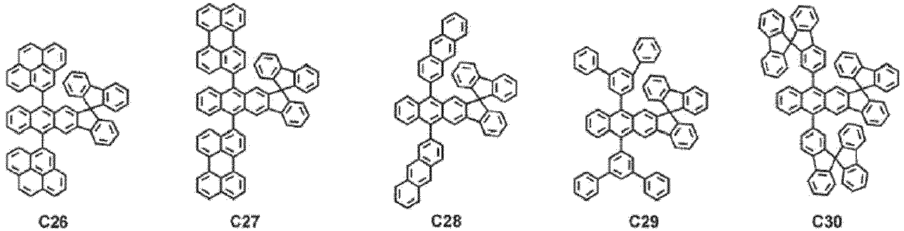

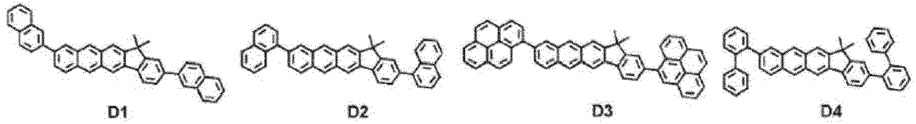

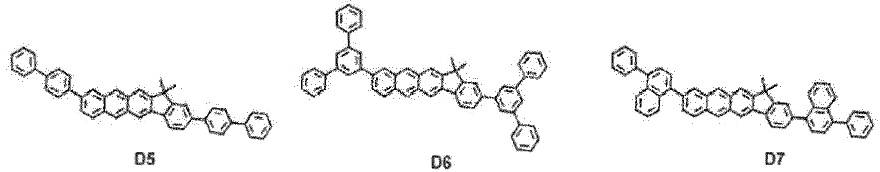

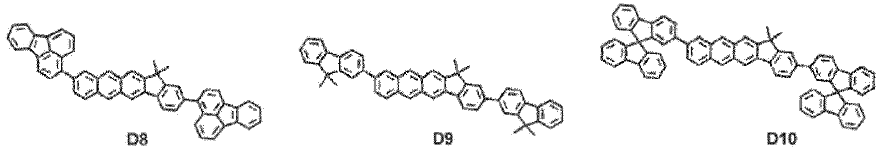

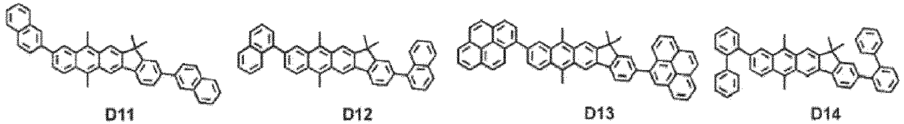

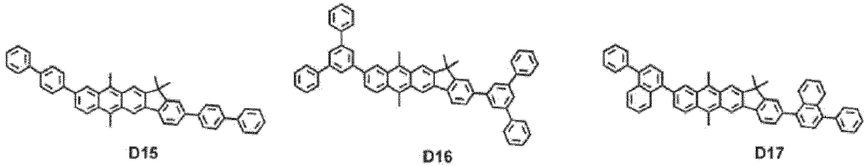

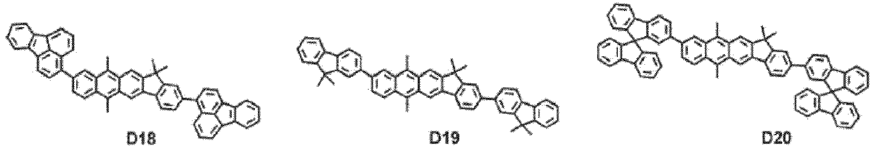

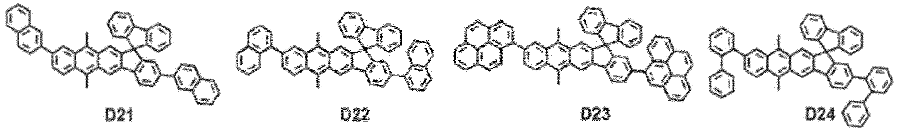

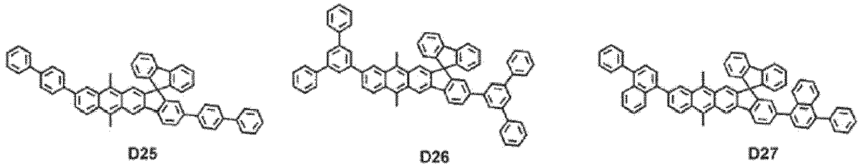

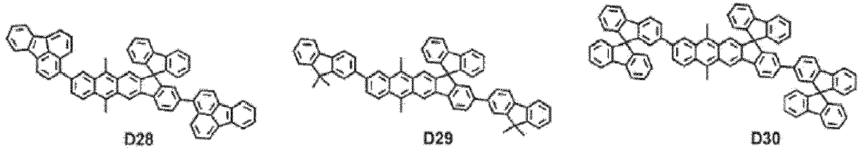

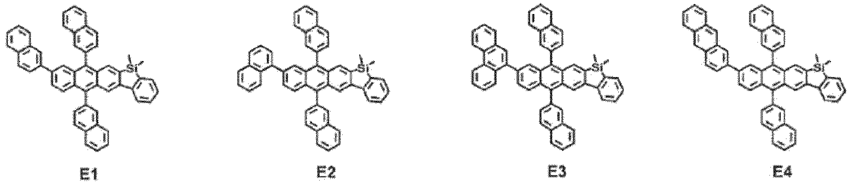

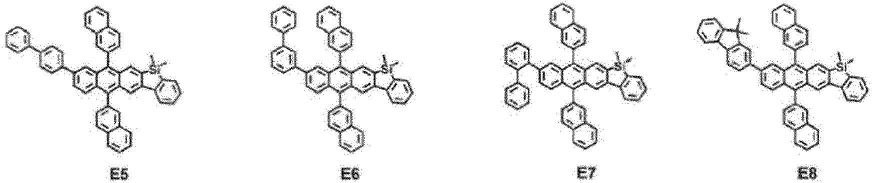

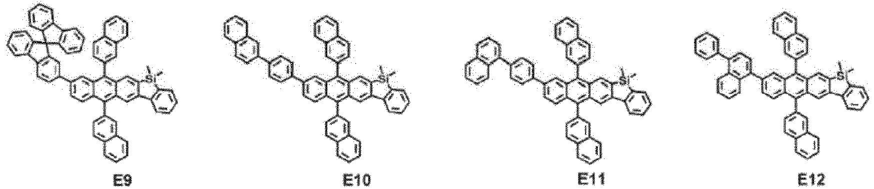

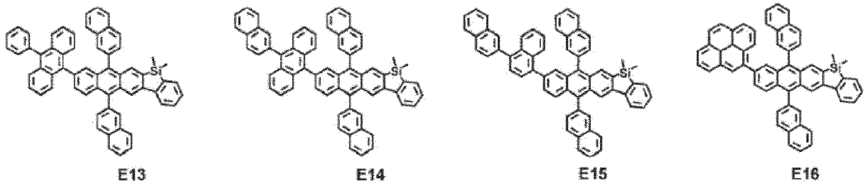

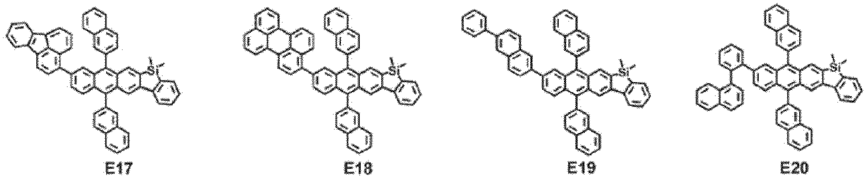

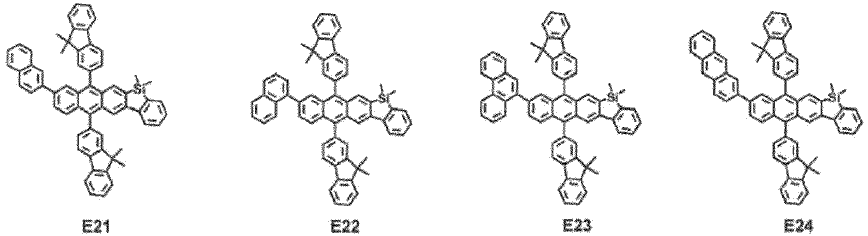

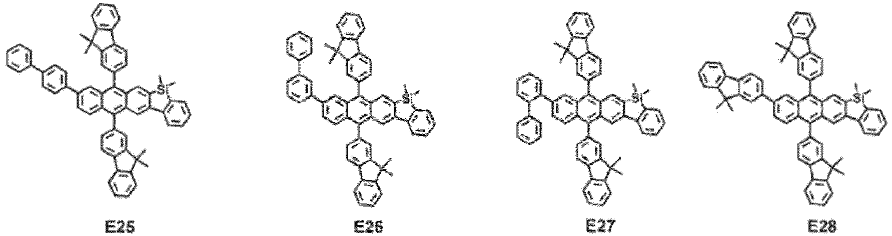

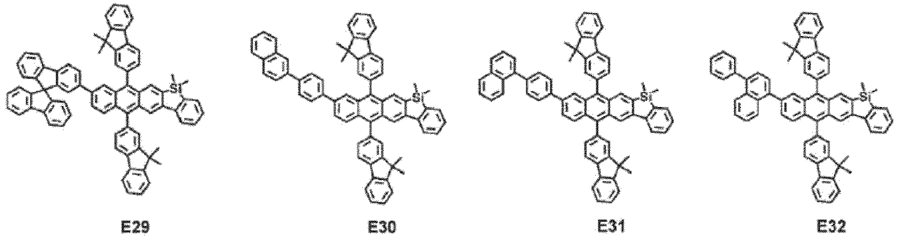

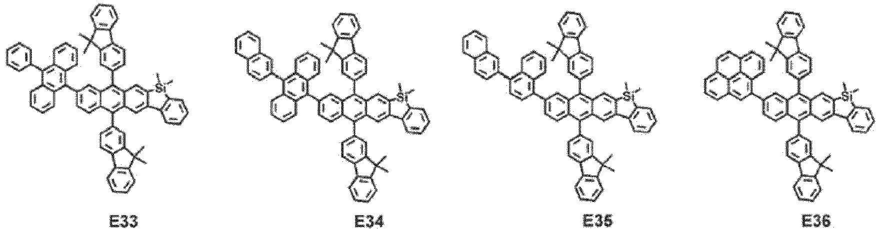

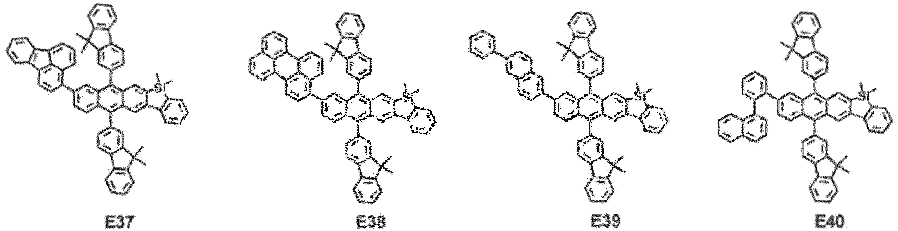

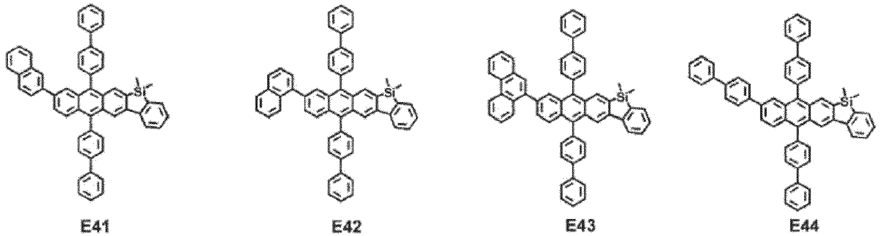

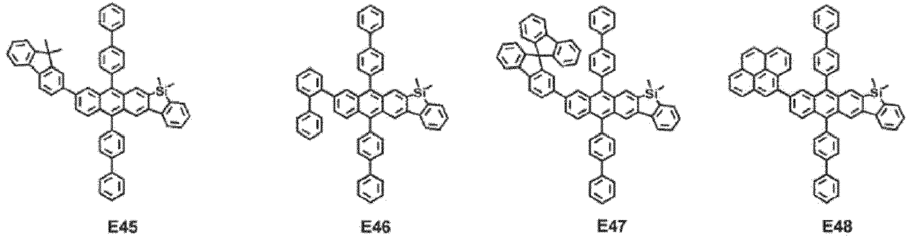

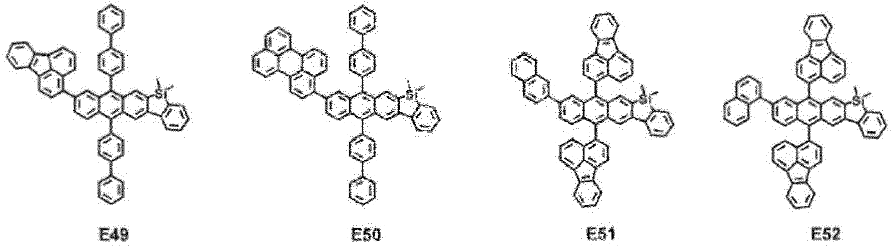

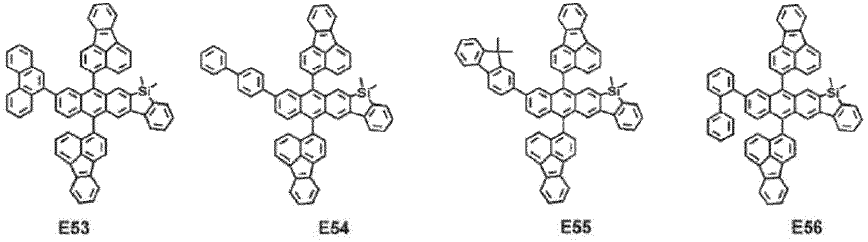

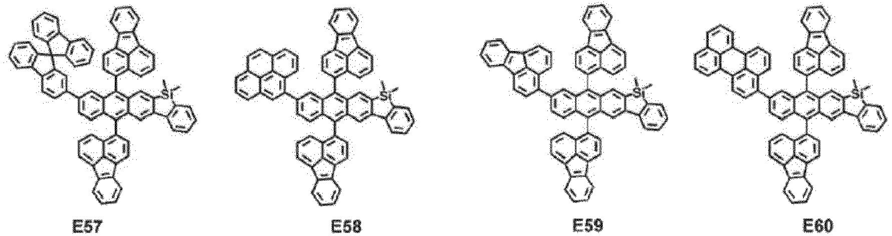

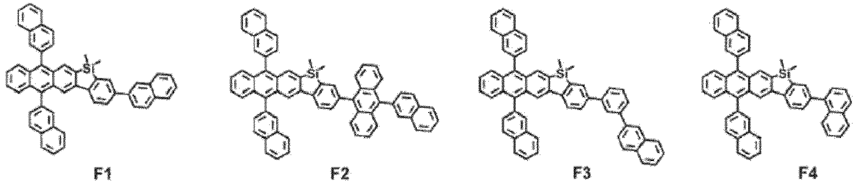

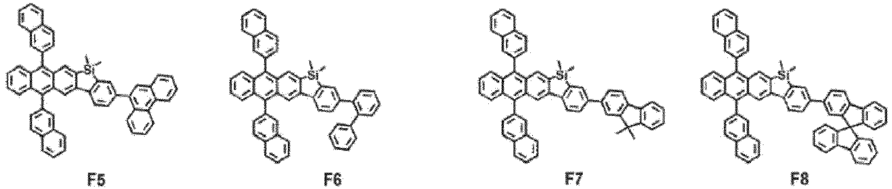

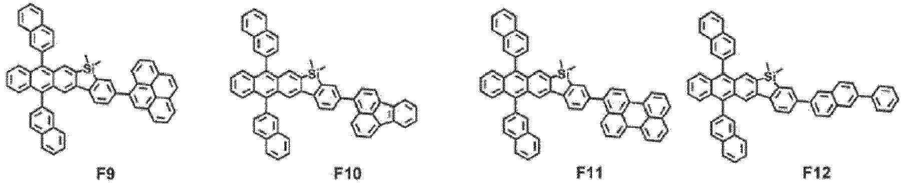

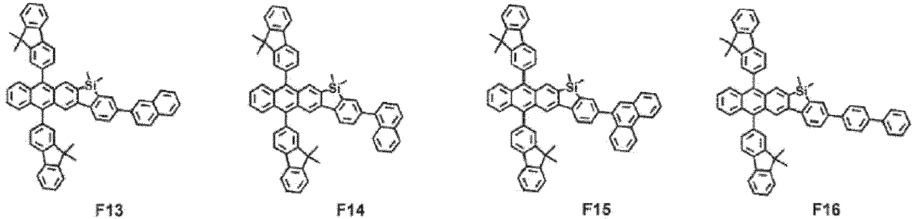

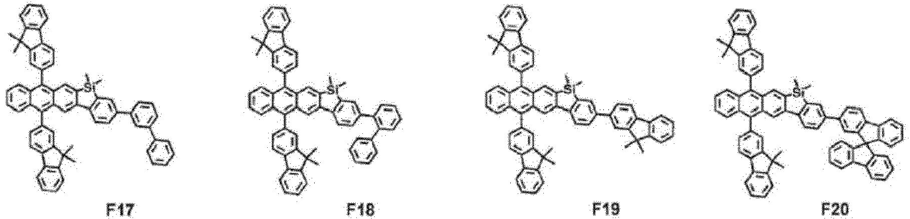

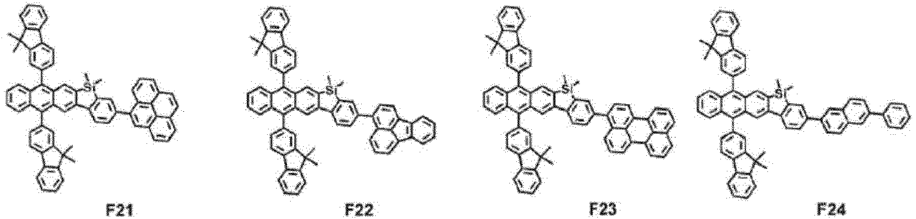

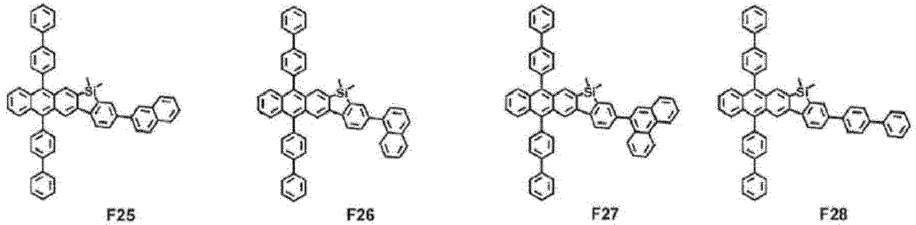

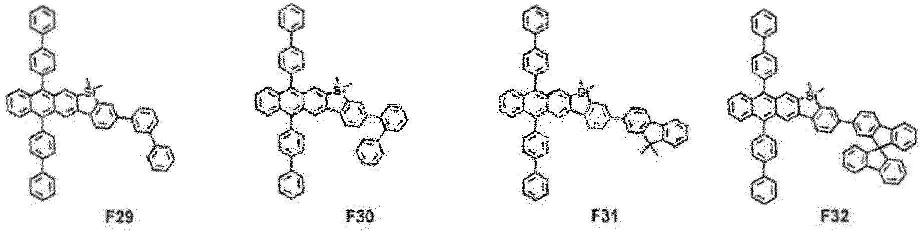

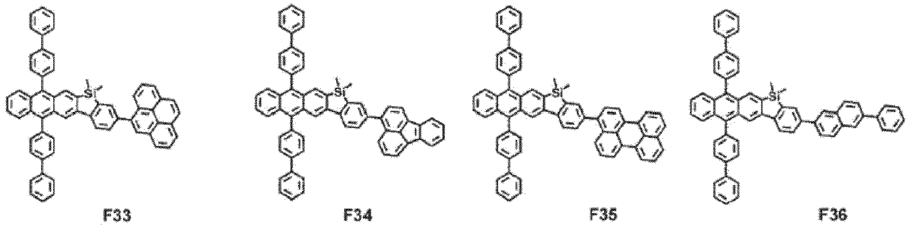

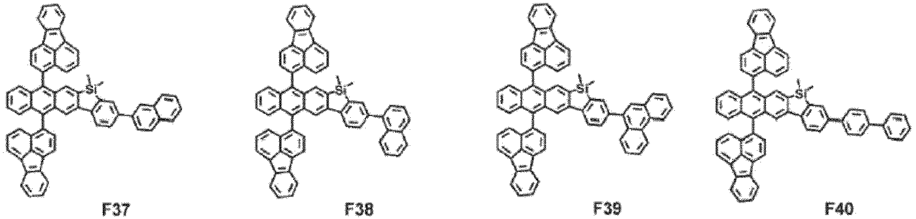

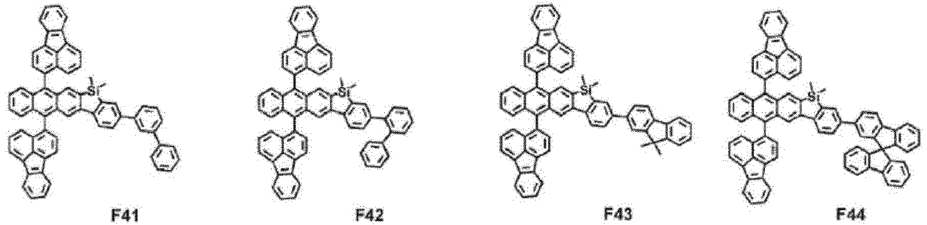

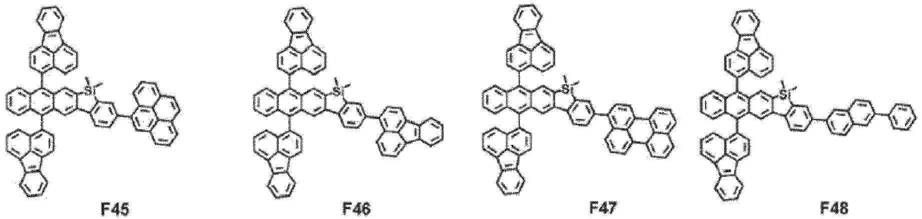

11. Organische lichtemittierende Vorrichtung nach einem der vorangehenden Ansprüche, wobei die organische lichtemittierende Vorrichtung die erste Hilfsschicht und die zweite Hilfsschicht umfasst,
wobei die erste Hilfsschicht und die zweite Hilfsschicht beide die erste Verbindung, die durch Formel 1 dargestellt ist, umfassen,
wobei die erste Verbindung, die durch Formel 1 dargestellt ist und in der ersten Hilfsschicht enthalten ist, identisch ist mit der ersten Verbindung, die durch Formel 1 dargestellt ist und in der zweiten Hilfsschicht enthalten ist.

12. Organische lichtemittierende Vorrichtung nach einem der vorangehenden Ansprüche, wobei der Lochtransportbereich eine zweite Verbindung, die durch Formel 201 dargestellt ist, und/oder eine dritte Verbindung, die durch Formel 202 dargestellt ist, umfasst: 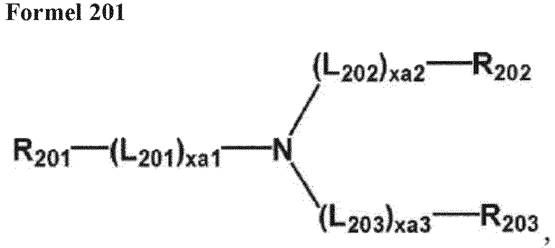 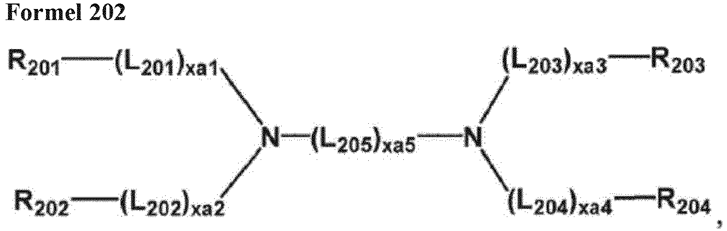 wobei in den Formeln 201 und 202
L₂₀₁ bis L₂₀₅ jeweils unabhängig ausgewählt sind aus der Gruppe bestehend aus:
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Pyrenylengruppe, einer Chrysenylengruppe, einer Pyridinylengruppe, einer Pyrazinylengruppe, einer Pyrimidinylengruppe, einer Pyridazinylengruppe, einer Chinolinylengruppe, einer Isochinolinylengruppe, einer Chinoxalinylengruppe, einer Chinazolinylengruppe, einer Carbazolylengruppe und einer Triazinylengruppe; und
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Pyrenylengruppe, einer Chrysenylengruppe, einer Pyridinylengruppe, einer Pyrazinylengruppe, einer Pyrimidinylengruppe, einer Pyridazinylengruppe, einer Chinolinylengruppe, einer Isochinolinylengruppe, einer Chinoxalinylengruppe, einer Chinazolinylengruppe, einer Carbazolylengruppe und einer Triazinylengruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Isoindolylgruppe, einer Chinolinylgruppe, einer Isochinolinylgruppe, einer Chinoxalinylgruppe, einer Chinazolinylgruppe, einer Carbazolylgruppe und einer Triazinylgruppe,
xa1 bis xa4 jeweils unabhängig ausgewählt sind aus 0, 1 und 2,
xa5 ausgewählt ist aus 1, 2 und 3,
R₂₀₁ bis R₂₀₄ jeweils unabhängig ausgewählt sind aus der Gruppe bestehend aus:
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe; und
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, einer Azulenylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe.

13. Organische lichtemittierende Vorrichtung nach einem der vorangehenden Ansprüche, wobei
(a) wenigstens eine, ausgewählt aus der ersten Hilfsschicht und der zweiten Hilfsschicht, ferner eine Verbindung auf Aminbasis umfasst; und/oder
(b) die organische lichtemittierende Vorrichtung die erste Hilfsschicht und die zweite Hilfsschicht umfasst, die erste Hilfsschicht und die zweite Hilfsschicht jeweils unabhängig die erste Verbindung, die durch Formel 1 dargestellt ist, umfassen und die erste Hilfsschicht und die zweite Hilfsschicht jeweils unabhängig eine zweite Verbindung, die durch Formel 201 dargestellt ist, und/oder eine dritte Verbindung, die durch Formel 202 dargestellt ist, umfassen: 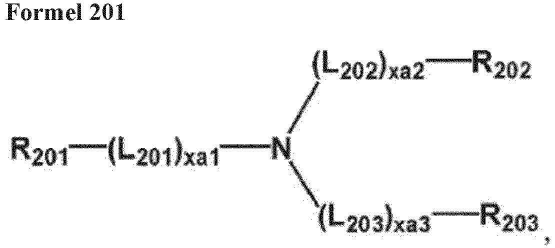 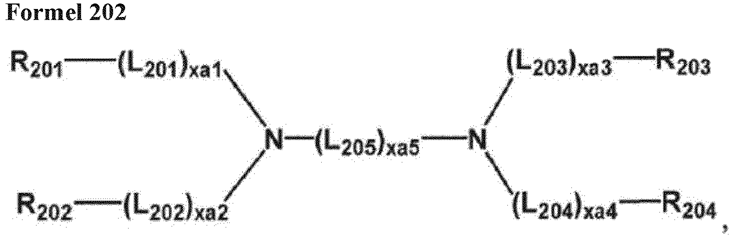
wobei in den Formeln 201 und 202
L₂₀₁ bis L₂₀₅ jeweils unabhängig ausgewählt sind aus der Gruppe bestehend aus:
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Pyrenylengruppe, einer Chrysenylengruppe, einer Pyridinylengruppe, einer Pyrazinylengruppe, einer Pyrimidinylengruppe, einer Pyridazinylengruppe, einer Chinolinylengruppe, einer Isochinolinylengruppe, einer Chinoxalinylengruppe, einer Chinazolinylengruppe, einer Carbazolylengruppe und einer Triazinylengruppe; und
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Pyrenylengruppe, einer Chrysenylengruppe, einer Pyridinylengruppe, einer Pyrazinylengruppe, einer Pyrimidinylengruppe, einer Pyridazinylengruppe, einer Chinolinylengruppe, einer Isochinolinylengruppe, einer Chinoxalinylengruppe, einer Chinazolinylengruppe, einer Carbazolylengruppe und einer Triazinylengruppe, jeweils substituiert mit wenigstens einen, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Isoindolylgruppe, einer Chinolinylgruppe, einer Isochinolinylgruppe, einer Chinoxalinylgruppe, einer Chinazolinylgruppe, einer Carbazolylgruppe und einer Triazinylgruppe,
xa1 bis xa4 jeweils unabhängig ausgewählt sind aus 0, 1 und 2,
xa5 ausgewählt ist aus 1, 2 und 3 und
R₂₀₁ bis R₂₀₄ jeweils unabhängig ausgewählt sind aus der Gruppe bestehend aus:
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe; und
einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe, jeweils substituiert mit wenigstens einem, ausgewählt aus Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, einer Azulenylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe und einer Triazinylgruppe.

14. Organische lichtemittierende Vorrichtung nach einem der vorangehenden Ansprüche, wobei:
der erste Satz von Elektroden ein Satz reflektierender Elektroden ist,
die zweite Elektrode eine halbdurchlässige Elektrode ist und
die organische lichtemittierende Vorrichtung die Gleichungen 1 bis 3 erfüllt: $\frac{{λ}_{1}}{2 {n}_{1}} ⋅ {m}_{1} - \frac{{λ}_{1}}{10} \leq {D}_{11} \leq \frac{{λ}_{1}}{2 {n}_{1}} ⋅ {m}_{1} + \frac{{λ}_{1}}{10} ,$ $\frac{{λ}_{2}}{2 {n}_{2}} ⋅ {m}_{2} - \frac{{λ}_{2}}{10} \leq {D}_{12} \leq \frac{{λ}_{2}}{2 {n}_{2}} ⋅ {m}_{2} + \frac{{λ}_{2}}{10} ,$ $\frac{{λ}_{3}}{2 {n}_{3}} ⋅ {m}_{3} - \frac{{λ}_{3}}{10} \leq {D}_{13} \leq \frac{{λ}_{3}}{2 {n}_{3}} ⋅ {m}_{3} + \frac{{λ}_{3}}{10} ,$
wobei in den Gleichungen 1 bis 3
D₁₁ einen Abstand zwischen der Elektrode auf dem ersten Subpixel und der zweiten Elektrode angibt,
D₁₂ einen Abstand zwischen der Elektrode auf dem zweiten Subpixel und der zweiten Elektrode angibt,
D₁₃ einen Abstand zwischen der Elektrode auf dem dritten Subpixel und der zweiten Elektrode angibt,
λ₁, λ₂ und λ₃ entsprechend und unabhängig eine Wellenlänge des Lichtes erster Farbe, eine Wellenlänge des Lichtes zweiter Farbe und eine Wellenlänge des Lichtes dritter Farbe angeben,
n₁ einen Brechungsindex von Schichten zwischen der Elektrode auf dem ersten Subpixel und der zweiten Elektrode angibt;
n₂ einen Brechungsindex von Schichten zwischen der Elektrode auf dem zweiten Subpixel und der zweiten Elektrode angibt,
n₃ einen Brechungsindex von Schichten zwischen der Elektrode auf dem dritten Subpixel und der zweiten Elektrode angibt und
m₁, m₂ und m₃ jeweils unabhängig eine natürliche Zahl sind.

15. Organische lichtemittierende Vorrichtung nach einem der vorangehenden Ansprüche, wobei die erste Hilfsschicht eine größere Dicke aufweist als die zweite Hilfsschicht.

## Revendications

1. Dispositif électroluminescent organique comprenant :
un substrat comprenant un premier sous-pixel, un deuxième sous-pixel, et un troisième sous-pixel ;
un premier jeu d'électrodes comprenant une électrode sur le premier sous-pixel du substrat, une électrode sur le deuxième sous-pixel du substrat, et une électrode sur le troisième sous-pixel du substrat ;
une deuxième électrode faisant face au premier jeu d'électrodes ;
une couche d'émission entre le premier jeu d'électrodes et la deuxième électrode, la couche d'émission comprenant : i) une première couche d'émission positionnée entre l'électrode sur le premier sous-pixel et la deuxième électrode, configurée pour émettre une première lumière de couleur, ii) une deuxième couche d'émission positionnée entre l'électrode sur le deuxième sous-pixel et la deuxième électrode, configurée pour émettre une deuxième lumière de couleur, et iii) une troisième couche d'émission positionnée entre l'électrode sur le troisième sous-pixel et la deuxième électrode, configurée pour émettre une troisième lumière de couleur ;
une région de transport de trous entre le premier jeu d'électrodes et la couche d'émission ; et
au moins l'une choisie parmi une première couche auxiliaire et une deuxième couche auxiliaire, la première couche auxiliaire étant entre la région de transport de trous et la première couche d'émission, et la deuxième couche auxiliaire étant entre la région de transport de trous et la deuxième couche d'émission,
la première lumière de couleur étant une lumière de couleur rouge, la deuxième lumière de couleur étant une lumière de couleur verte, et/ou la troisième lumière de couleur étant une lumière de couleur bleue, et
**caractérisé en ce que**
au moins l'une choisie parmi la première couche auxiliaire et la deuxième couche auxiliaire comprend un premier composé représenté par la formule 1 : 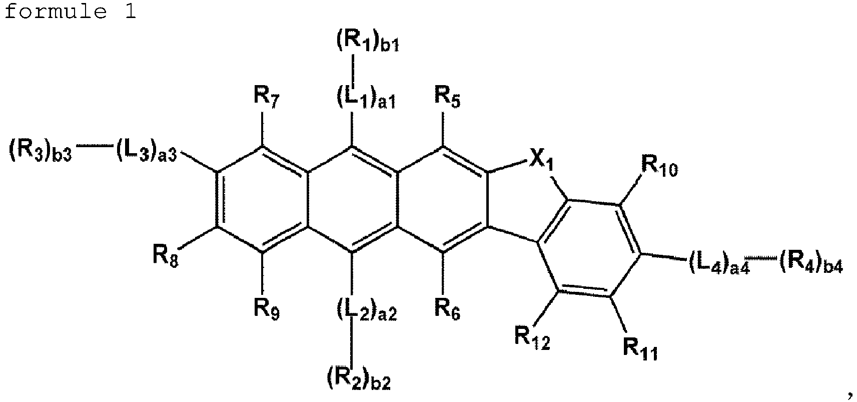
où, dans la formule 1,
X₁ est choisi parmi C(R₂₁)(R₂₂), Si(R₂₁)(R₂₂), N(R₂₁), O, S, S(=O), et S(=O)₂, chacun de L₁ à L₄ est indépendamment choisi parmi un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocyclo-alcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique en C₈ à C₆₀ condensé non aromatique divalent substitué ou non substitué, et un groupe hétéropolycyclique à 8 à 60 chaînons condensé non aromatique divalent substitué ou non substitué,
chacun de a1 à a4 est indépendamment choisi parmi 0, 1, 2 et 3, et quand a1 vaut 2 ou plus, les deux ou plus de deux L₁ sont identiques ou différents, quand a2 vaut 2 ou plus, les deux ou plus de deux L₂ sont identiques ou différents, quand a3 vaut 2 ou plus, les deux ou plus de deux L₃ sont identiques ou différents, et quand a4 vaut 2 ou plus, les deux ou plus de deux L₄ sont identiques ou différents,
chacun de R₁ à R₁₂, R₂₁, et R₂₂ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, un groupe hétéropolycyclique à 8 à 60 chaînons condensé non aromatique monovalent substitué ou non substitué, -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂), où un premier groupe choisi parmi R₁ à R₁₂ peut éventuellement être lié à un deuxième groupe choisi parmi R₁ à R₁₂ pour former un groupe carbocyclique en C₅ à C₆₀ substitué ou non substitué ou un groupe hétérocyclique en C₁ à C₆₀ substitué ou non substitué, sous réserve que le premier groupe soit adjacent au deuxième groupe dans la formule 1, et sous réserve que le premier groupe ou le deuxième groupe ne soit pas R₁, R₂, R₃ ou R₄ quand a1, a2, a3 ou a4 est supérieur à zéro, respectivement ; et où, quand R₂₁ et R₂₂ sont tous deux présents, ils peuvent être éventuellement liés pour former un groupe carbocyclique en C₅ à C₆₀ substitué ou non substitué ou un groupe hétérocyclique en C₁ à C₆₀ substitué ou non substitué,
au moins l'un choisi parmi R₁ à R₄ est choisi parmi un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, et un groupe hétéropolycyclique à 8 à 60 chaînons condensé non aromatique monovalent substitué ou non substitué,,
chacun de b1 à b4 est indépendamment choisi parmi 1, 2 et 3, et quand b1 vaut 2 ou plus, les deux ou plus de deux R₁ sont identiques ou différents, quand b2 vaut 2 ou plus, les deux ou plus de deux R₂ sont identiques ou différents, quand b3 vaut 2 ou plus, les deux ou plus de deux R₃ sont identiques ou différents, et quand b4 vaut 2 ou plus, les deux ou plus de deux R₄ sont identiques ou différents, et
le groupe cycloalkylène en C₃ à C₁₀ substitué, le groupe hétérocycloalkylène en C₁ à C₁₀ substitué, le groupe cycloalcénylène en C₃ à C₁₀ substitué, le groupe hétéro-cycloalcénylène en C₁ à C₁₀ substitué, le groupe arylène en C₆ à C₆₀ substitué, le groupe hétéroarylène en C₁ à C₆₀ substitué, le groupe polycyclique en C₈ à C₆₀ condensé non aromatique divalent substitué, le groupe hétéropolycyclique à 8 à 60 chaînons condensé non aromatique divalent substitué, le groupe alkyle en C₁ à C₆₀ substitué, le groupe alcényle en C₂ à C₆₀ substitué, le groupe alcynyle en C₂ à C₆₀ substitué, le groupe alkoxy en C₁ à C₆₀ substitué, le groupe cycloalkyle en C₃ à C₁₀ substitué, le groupe hétérocycloalkyle en C₁ à C₁₀ substitué, le groupe cycloalcényle en C₃ à C₁₀ substitué, le groupe hétérocycloalcényle en C₁ à C₁₀ substitué, le groupe aryle en C₆ à C₆₀ substitué, le groupe aryloxy en C₆ à C₆₀ substitué, le groupe arylthio en C₆ à C₆₀ substitué, le groupe hétéroaryle en C₁ à C₆₀ substitué, le groupe polycyclique en C₈ à C₆₀ condensé non aromatique monovalent substitué, et le groupe hétéropolycyclique à 8 à 60 chaînons condensé non aromatique monovalent substitué, le groupe carbocyclique en C₅ à C₆₀ substitué, et le groupe hétérocyclique en C₁ à C₆₀ substitué, sont substitués par au moins un substituant choisi dans l'ensemble constitué par :
le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, et un groupe alkoxy en C₁ à C₆₀ ;
un groupe alkyle en C₁ à C₆₀, un groupe alcényle en C₂ à C₆₀, un groupe alcynyle en C₂ à C₆₀, et un groupe alkoxy en C₁ à C₆₀, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), et -P(=O)(Q₁₁)(Q₁₂) ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -Si(Q₂₁) (Q₂₂) (Q₂₃), -N(Q₂₁)(Q₂₂), -B(Q₂₁)(Q₂₂), -C(₌O)(Q₂₁), -S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂),
où chacun de Q₁ à Q₃, Q₁₁ à Q₁₃, Q₂₁ à Q₂₃, et Q₃₁ à Q₃₃ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe biphényle, un groupe terphényle, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent.

2. Dispositif électroluminescent organique selon la revendication 1, dans lequel X₁ est choisi parmi C(R₂₁)(R₂₂) et Si(R₂₁)(R₂₂) ;
de préférence R₂₁ et R₂₂ sont liés par l'intermédiaire d'une liaison simple ; ou liés par l'intermédiaire de l'un choisi parmi un groupe alkylène en C₁ à C₅ et un groupe alcénylène en C₂ à C₅, chacun substitué par au moins l'un choisi parmi un groupe alkyle en Ci à C₁₀, un groupe alkoxy en C₁ à C₁₀, un groupe phényle, un groupe biphényle, un groupe terphényle, et un groupe naphtyle.

3. Dispositif électroluminescent organique selon la revendication 1 ou la revendication 2, dans lequel chacun de L₁ à L₄ est indépendamment choisi dans l'ensemble constitué par :
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe fluoranthénylène, un groupe triphénylénylène, un groupe pyrénylène, un groupe chrysénylène, et un groupe pérylénylène ; et
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe fluoranthénylène, un groupe triphénylénylène, un groupe pyrénylène, un groupe chrysénylène, et un groupe pérylénylène, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrénylène, un groupe chrysényle, et un groupe pérylényle.

4. Dispositif électroluminescent organique selon la revendication 1 ou la revendication 2, dans lequel chacun de L₁ à L₄ est indépendamment choisi parmi les groupes représentés par les formules 3-1 à 3-46 : 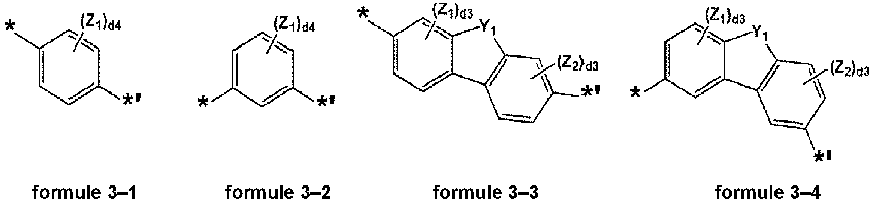 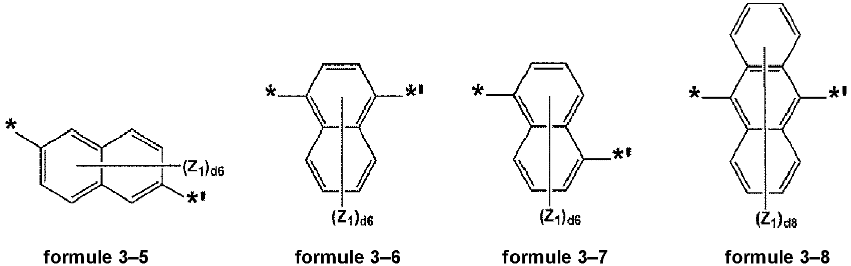 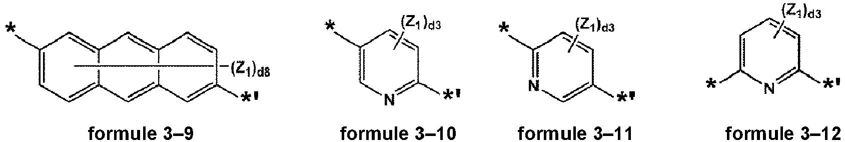 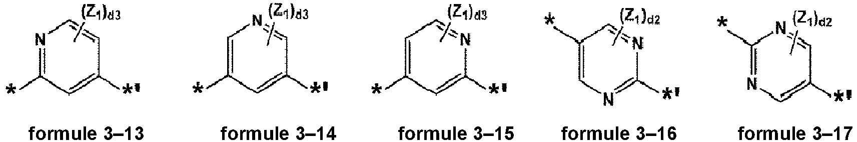 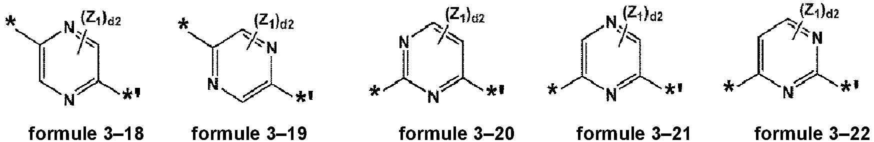 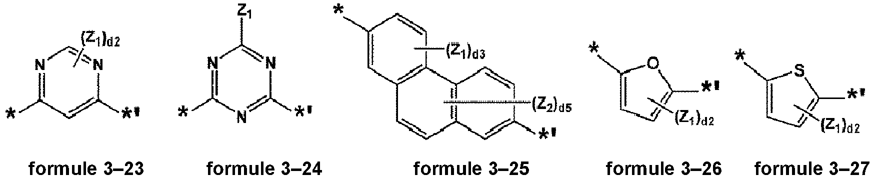 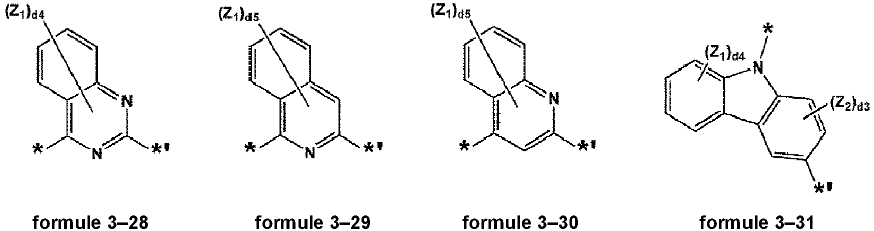 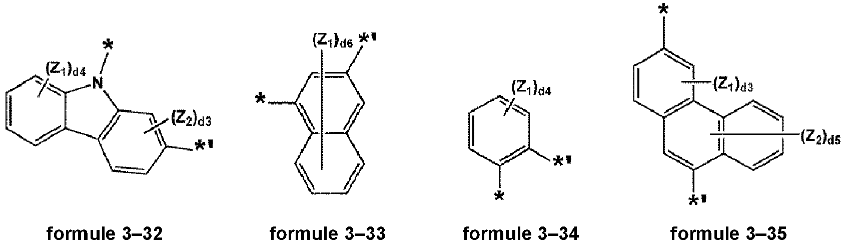 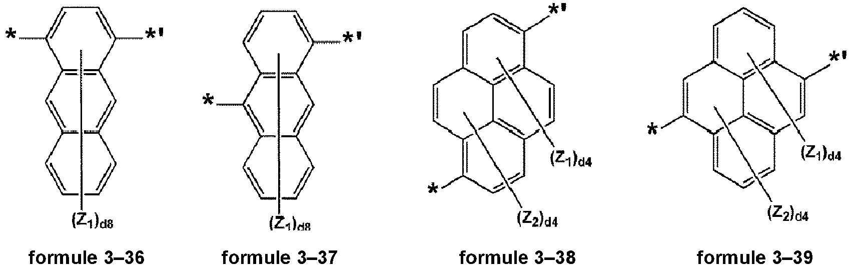 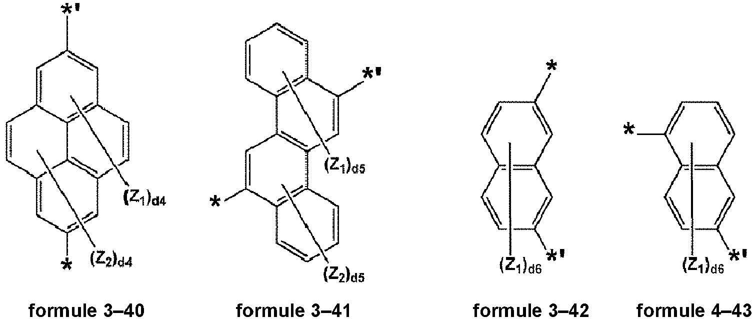 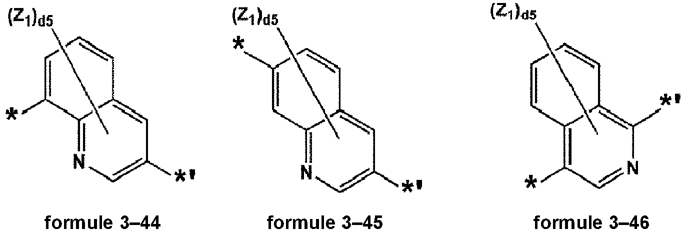 où, dans les formules 3-1 à 3-46,
Y₁ est choisi parmi O, S, C(Z₃)(Z₄),N(Z₅), et Si(Z₆)(Z₇),
chacun de Z₁ à Z₇ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, un groupe dibenzofuranyle, un groupe dibenzothiophényle, un groupe triazinyle, un groupe benzimidazolyle, un groupe phénanthrolinyle, et -Si(Q₃₁)(Q₃₂)(Q₃₃),
où chacun de Q₃₁ à Q₃₃ est indépendamment choisi parmi un groupe alkyle en C₁ à C₁₀, un groupe alkoxy en C₁ à C₁₀, un groupe phényle, un groupe biphényle, un groupe terphényle, et un groupe naphtyle,
d2 est un entier choisi parmi 0 à 2,
d3 est un entier choisi parmi 0 à 3,
d4 est un entier choisi parmi 0 à 4,
d5 est un entier choisi parmi 0 à 5,
d6 est un entier choisi parmi 0 à 6,
d8 est un entier choisi parmi 0 à 8, et
chacun de * et *' indique un site de liaison à un atome voisin ;
de préférence dans lequel :
chacun de L₁ à L₄ est indépendamment choisi parmi les groupes représentés par les formules 3-1 à 3-9, 3-25 à 3-27, et 3-31 à 3-43, et chacun de Z₁ à Z₇ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe carbazolyle, un groupe dibenzofuranyle, et un groupe dibenzothiophényle.

5. Dispositif électroluminescent organique selon l'une quelconque des revendications précédentes, dans lequel chacun de R₁ à R₄, R₂₁, et R₂₂ est indépendamment choisi dans l'ensemble constitué par :
l'hydrogène, le deutérium, un groupe alkyle en Ci à C₂₀, et un groupe alkoxy en C₁ à C₂₀ ;
un groupe alkyle en C₁ à C₂₀ et un groupe alkoxy en Ci à C₂₀, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe phényle, un groupe biphényle, et un groupe terphényle ;
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe chrysényle, un groupe pérylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe benzocarbazolyle, un groupe dibenzocarbazolyle, un groupe dibenzosilolyle, un groupe benzonaphtofuranyle, un groupe benzonaphtothiophényle, un groupe dinaphtofuranyle, et un groupe dinaphtothiophényle ; et
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe chrysényle, un groupe pérylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe benzocarbazolyle, un groupe dibenzocarbazolyle, un groupe dibenzosilolyle, un groupe benzonaphtofuranyle, un groupe benzonaphtothiophényle, un groupe dinaphtofuranyle, et un groupe dinaphtothiophényle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe chrysényle, un groupe pérylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe benzocarbazolyle, un groupe dibenzocarbazolyle, un groupe dibenzosilolyle, un groupe benzonaphtofuranyle, un groupe benzonaphtothiophényle, un groupe dinaphtofuranyle, un groupe dinaphtothiophényle, et -Si(Q₃₁)(Q₃₂)(Q₃₃),
où chacun de Q₃₁ à Q₃₃ est indépendamment choisi parmi un groupe alkyle en C₁ à C₁₀, un groupe alkoxy en C₁ à C₁₀, un groupe phényle, un groupe biphényle, un groupe terphényle, et un groupe naphtyle.

6. Dispositif électroluminescent organique selon l'une quelconque des revendications précédentes, dans lequel chacun de R₁ à R₄ est indépendamment choisi parmi l'hydrogène, le deutérium, un groupe alkyle en C₁ à C₂₀, et un groupe représenté par l'une quelconque des formules 5-1 à 5-46, dans lequel au moins l'un choisi parmi R₁ à R₄ est choisi dans les groupes représentés par les formules 5-1 à 5-46,
chacun de R₂₁ et R₂₂ est indépendamment choisi parmi un groupe alkyle en C₁ à C₂₀ et un groupe représenté par l'une quelconque des formules 5-1 à 5-46 : 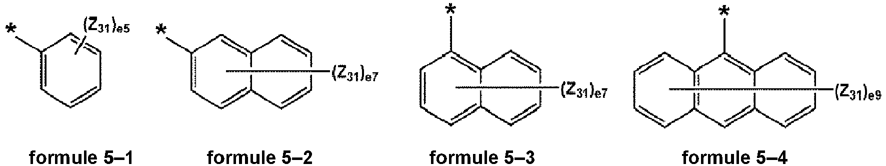 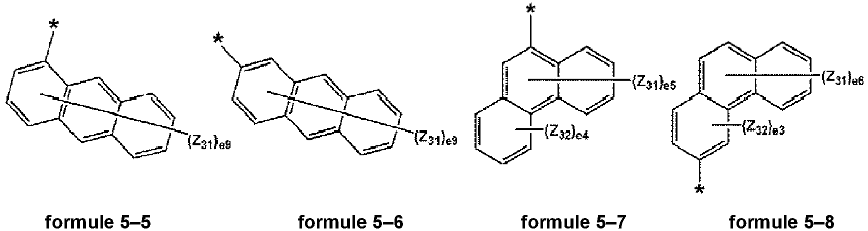 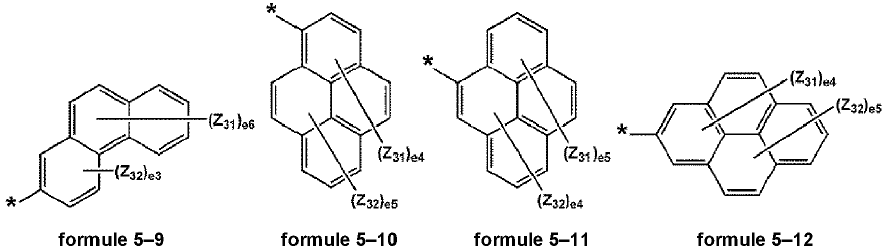 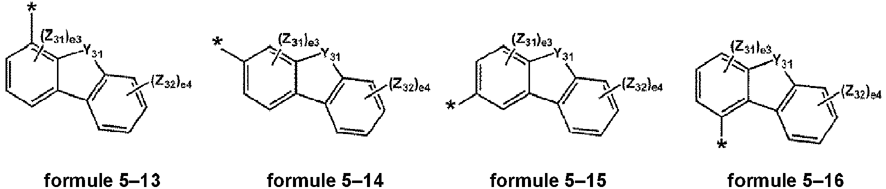 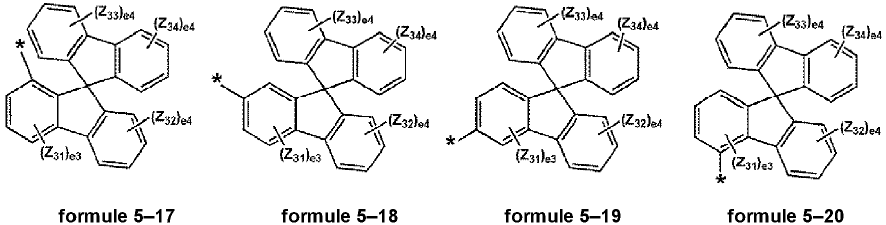 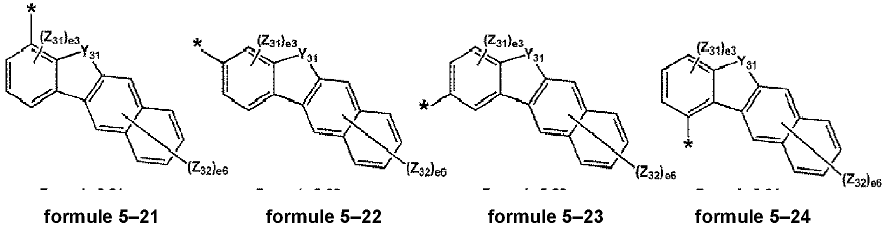 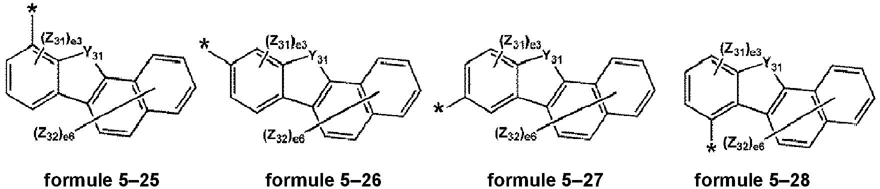 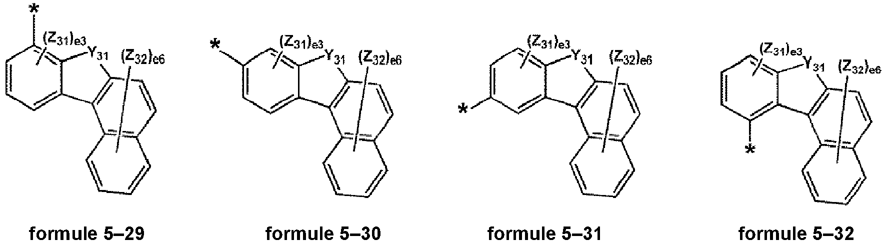 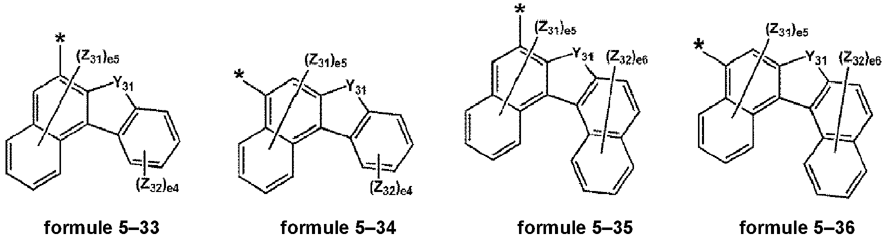 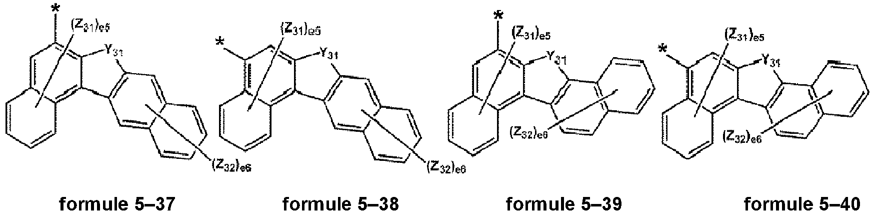 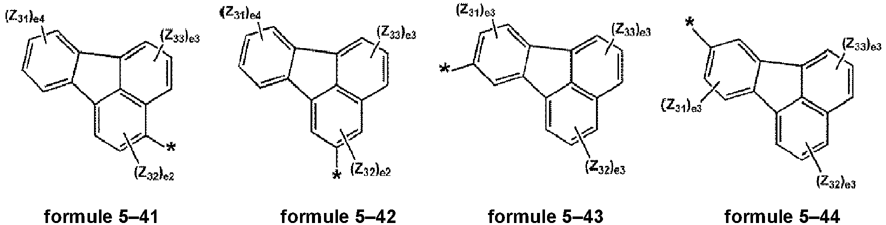 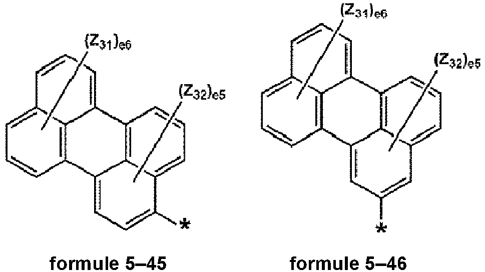 où, dans les formules 5-1 à 5-46,
Y₃₁ est choisi parmi O, S, C(Z₃₃)(Z₃₄), N(Z₃₅), et Si(Z₃₆)(Z₃₇),
chacun de Z₃₁ à Z₃₇ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe chrysényle, un groupe pérylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe benzocarbazolyle, un groupe dibenzocarbazolyle, un groupe dibenzosilolyle, un groupe benzonaphtofuranyle, un groupe benzonaphtothiophényle, un groupe dinaphtofuranyle, un groupe dinaphtothiophényle, et -Si(Q₃₁)(Q₃₂)(Q₃₃),
où chacun de Q₃₁ à Q₃₃ est indépendamment choisi parmi un groupe alkyle en C₁ à C₁₀, un groupe alkoxy en C₁ à C₁₀, un groupe phényle, un groupe biphényle, un groupe terphényle, et un groupe naphtyle,
e2 est un entier choisi parmi 0 à 2,
e3 est un entier choisi parmi 0 à 3,
e4 est un entier choisi parmi 0 à 4,
e5 est un entier choisi parmi 0 à 5,
e6 est un entier choisi parmi 0 à 6,
e7 est un entier choisi parmi 0 à 7,
e9 est un entier choisi parmi 0 à 9, et
* indique un site de liaison à un atome voisin.

7. Dispositif électroluminescent organique selon l'une quelconque des revendications 1 à 5, dans lequel
chacun de R₁ à R₄ est indépendamment choisi parmi l'hydrogène, le deutérium, un groupe alkyle en C₁ à C₂₀, et un groupe représenté par l'une quelconque des formules 6-1 à 6-179, où au moins l'un choisi parmi R₁ à R₄ est choisi parmi les groupes représentés par les formules 6-1 à 6-179, et
chacun de R₂₁ et R₂₂ est indépendamment choisi parmi un groupe alkyle en C₁ à C₂₀ et un groupe représenté par l'une quelconque des formules 6-1 à 6-179 : 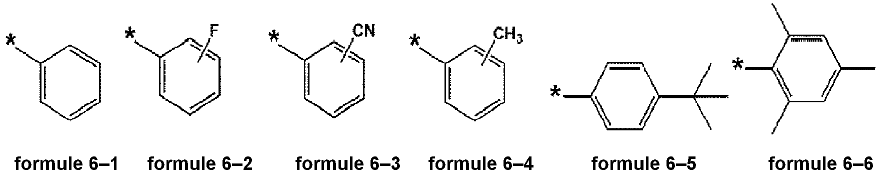 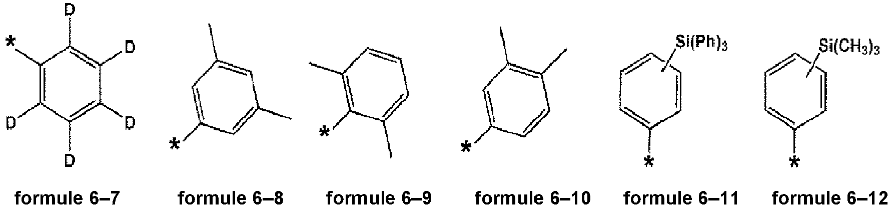 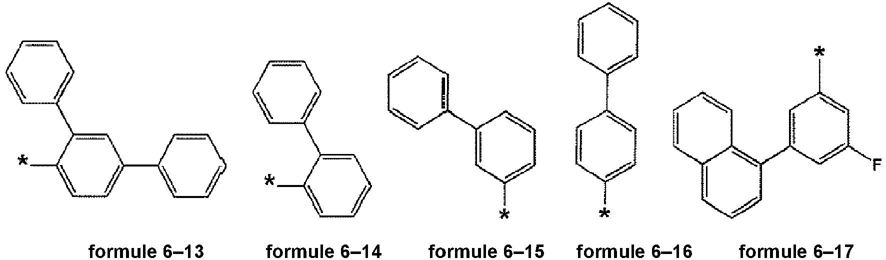 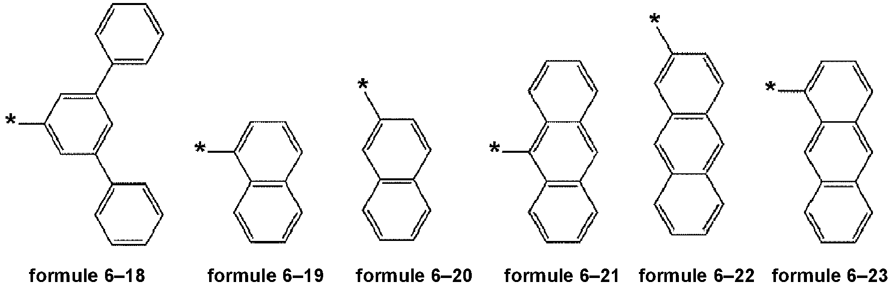 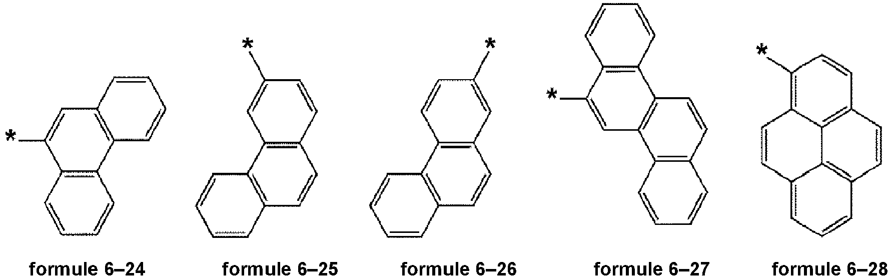 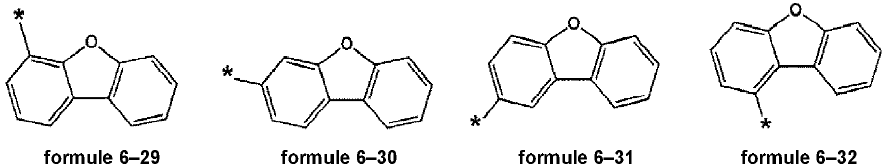 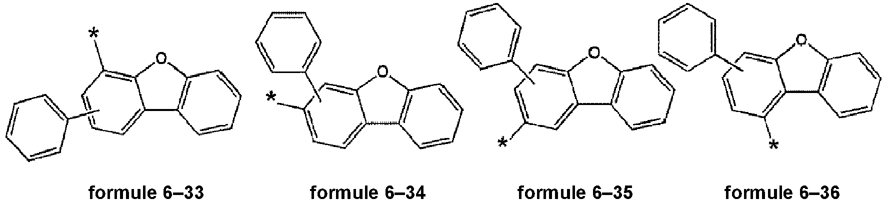 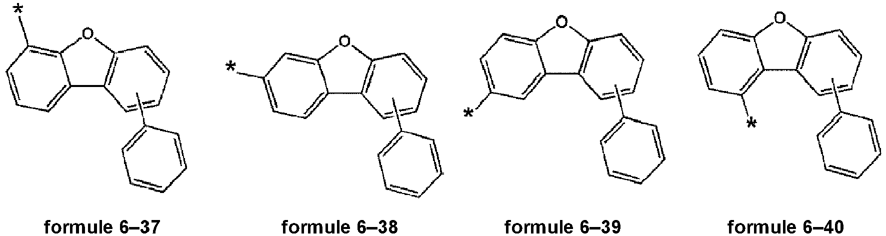 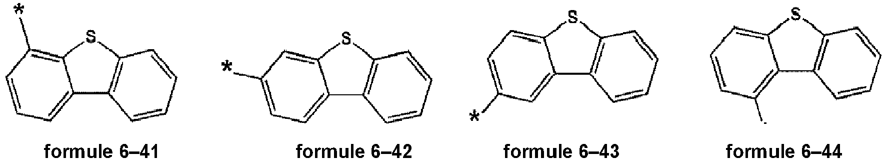 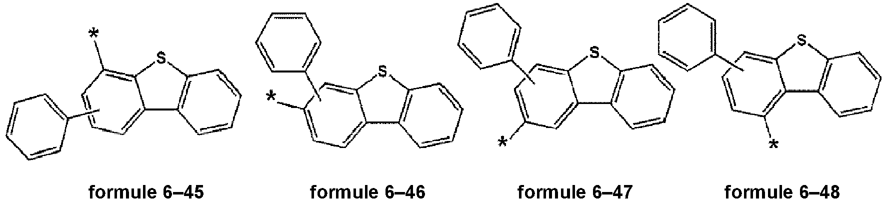 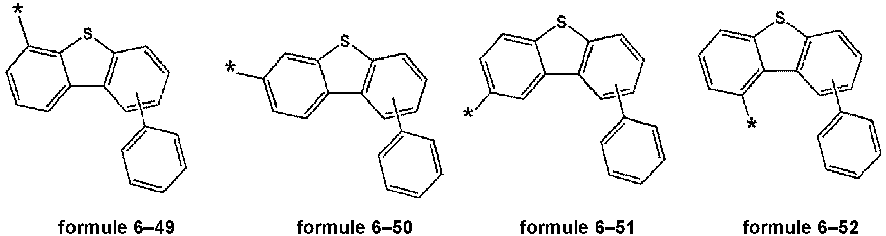 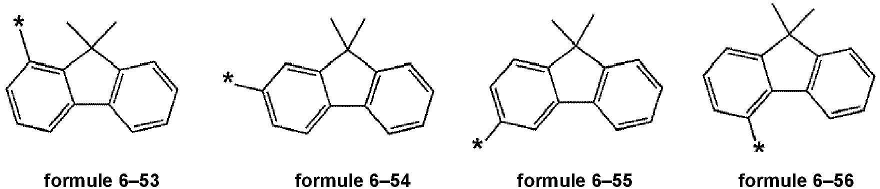 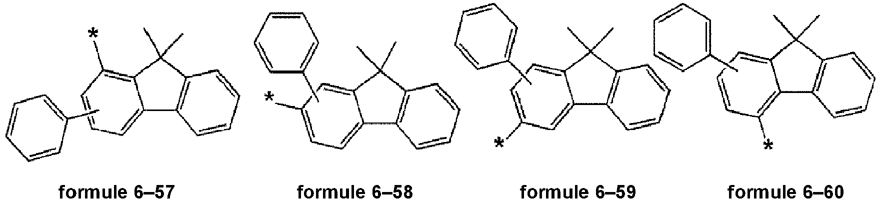 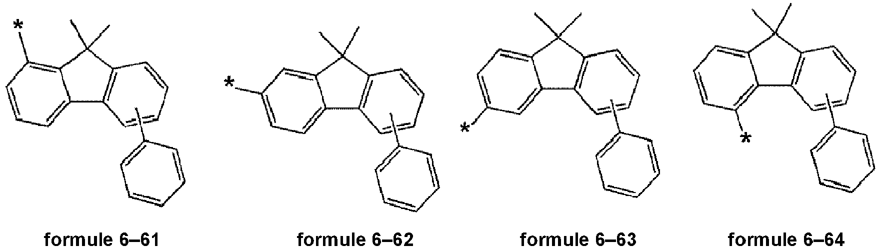 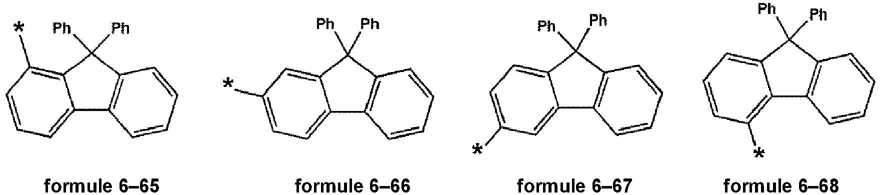 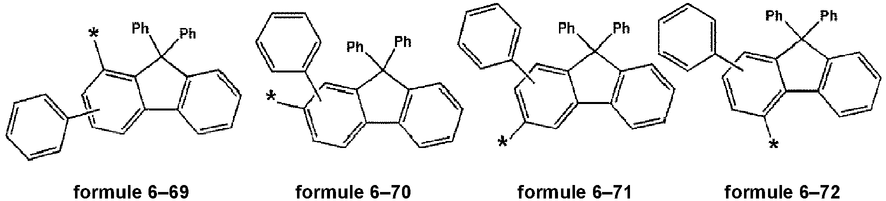 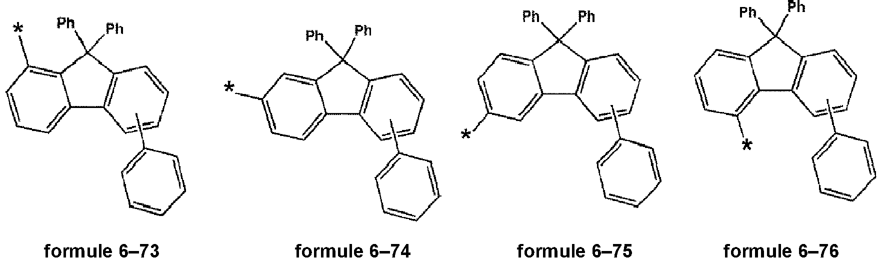 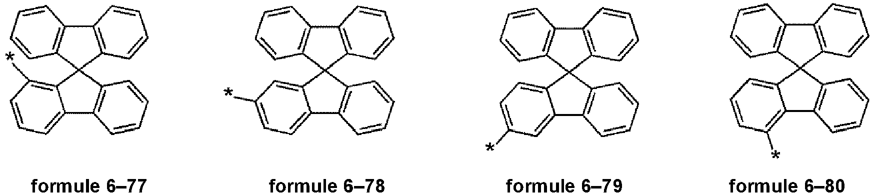 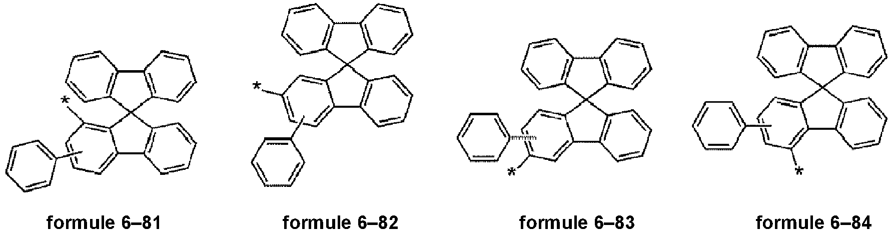 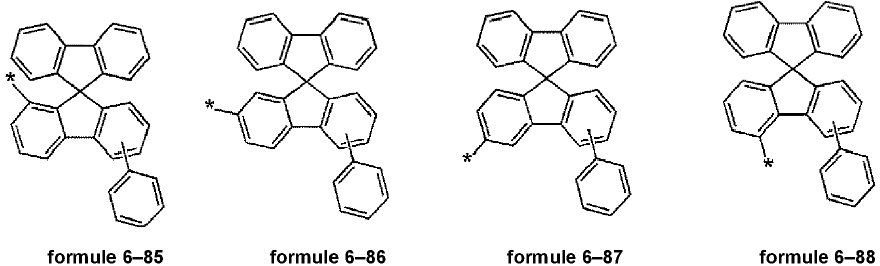 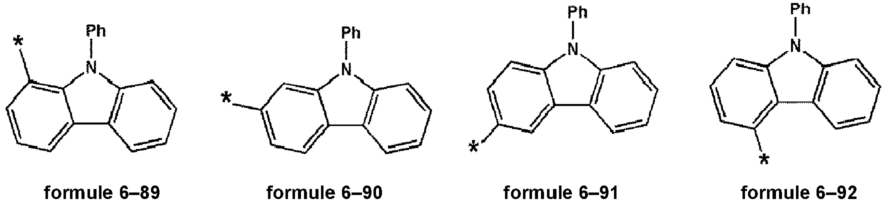 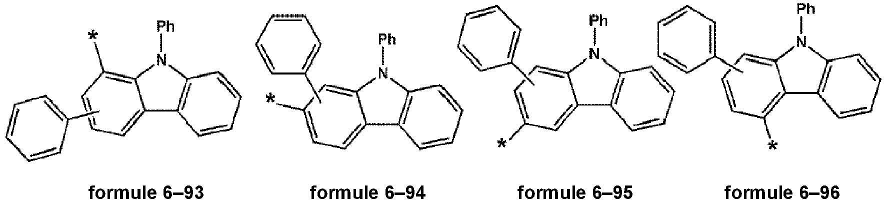 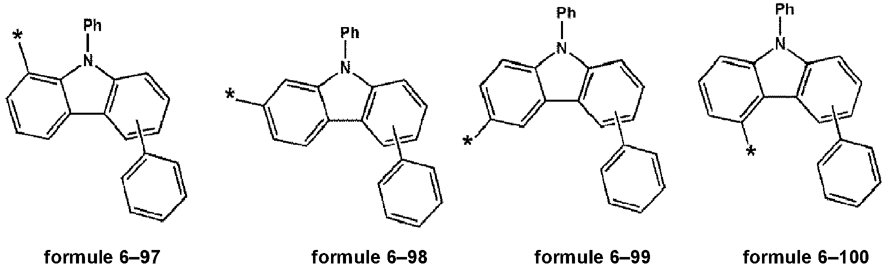 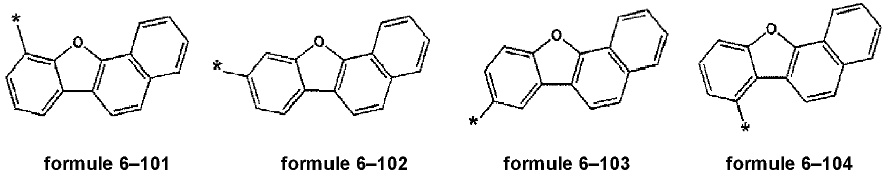 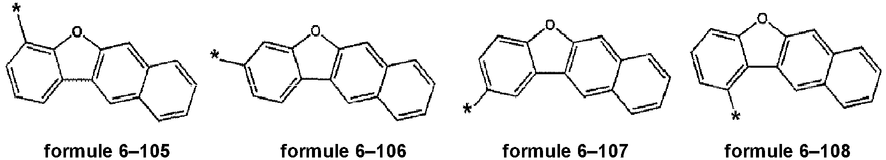 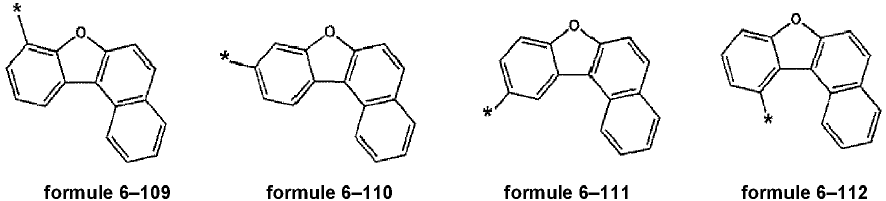 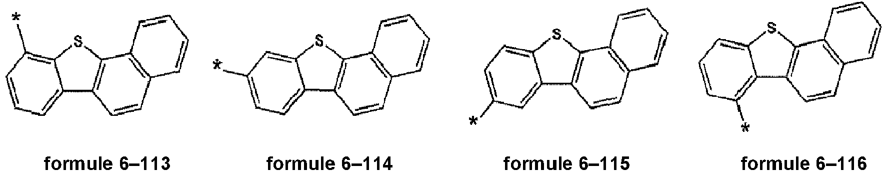 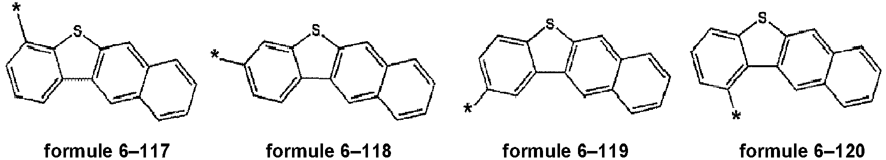 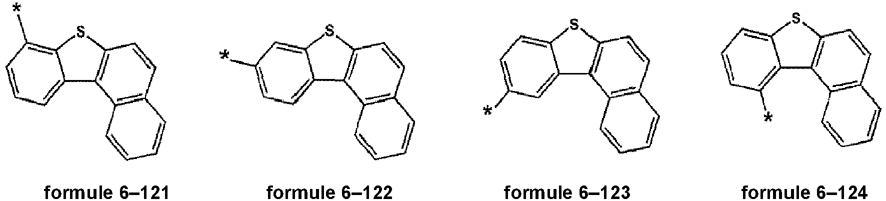 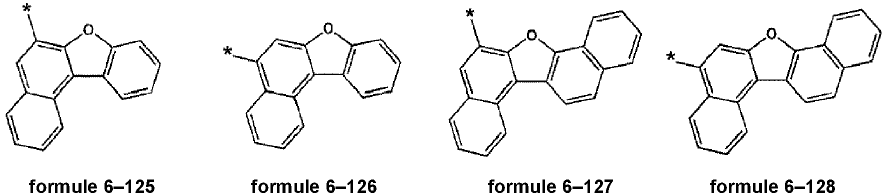 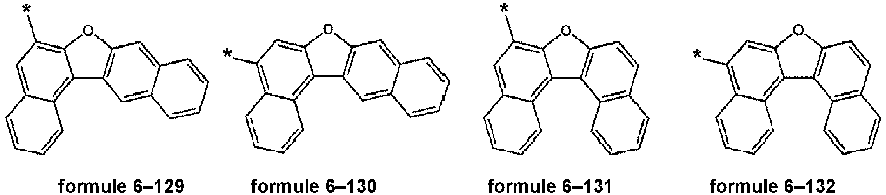 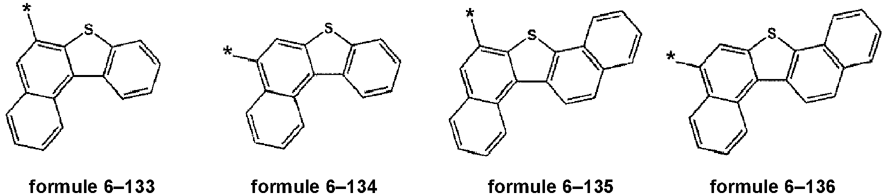 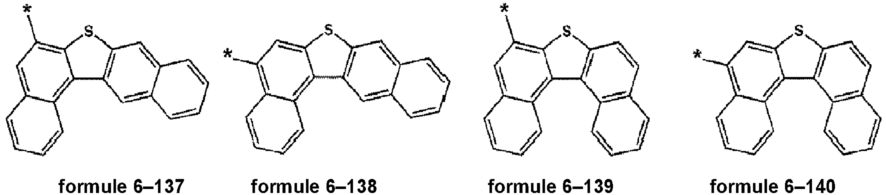 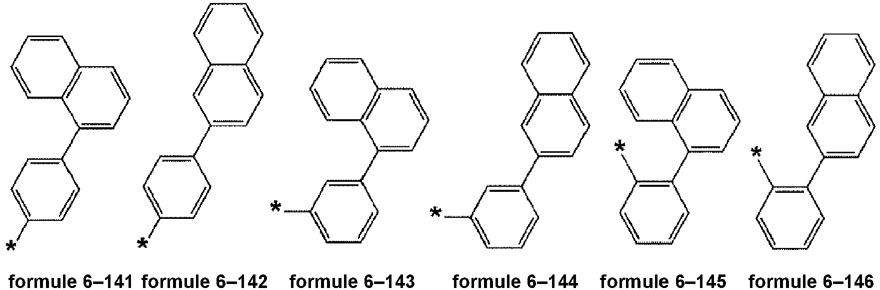 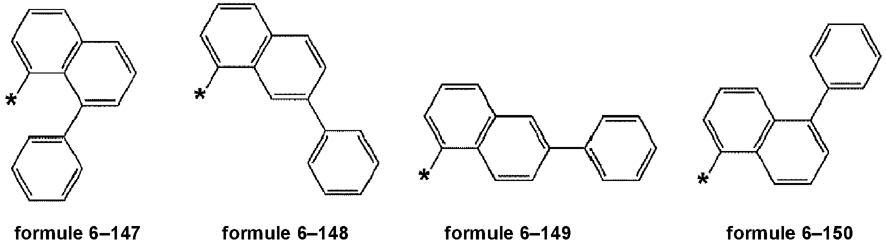 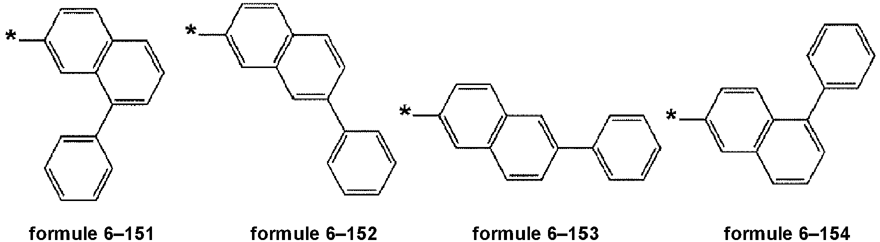 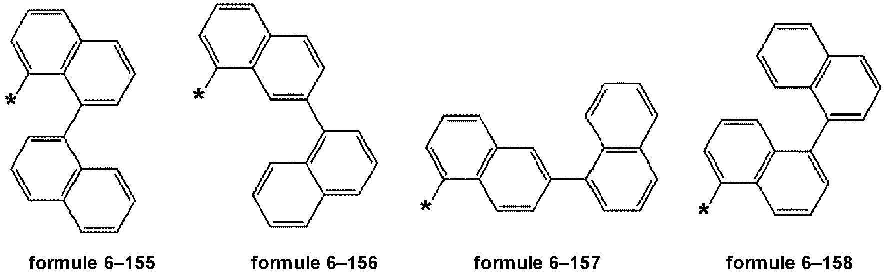 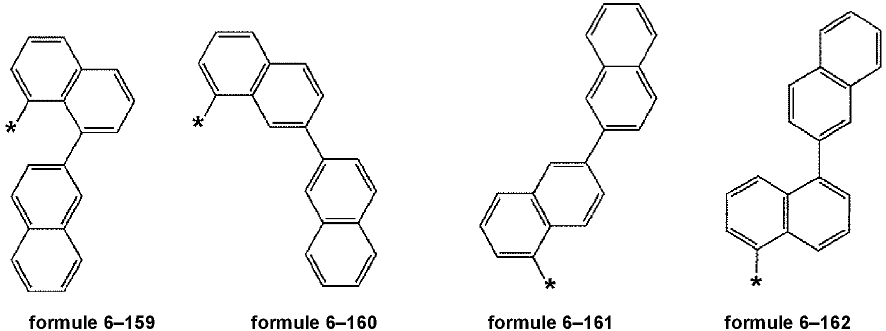 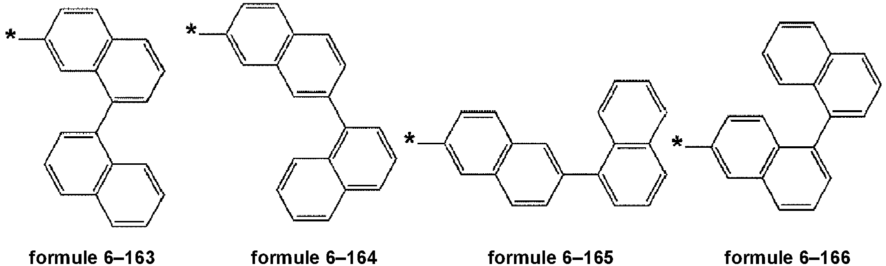 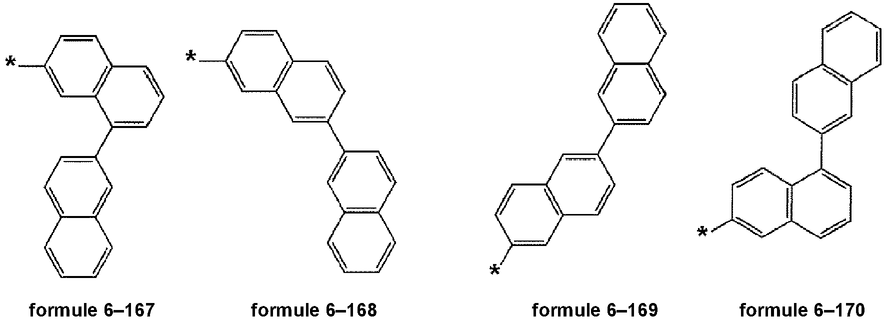 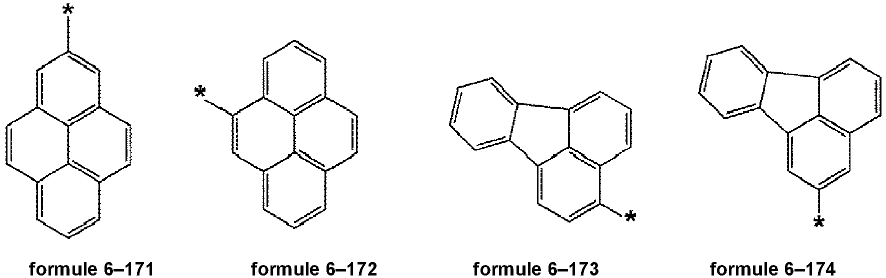 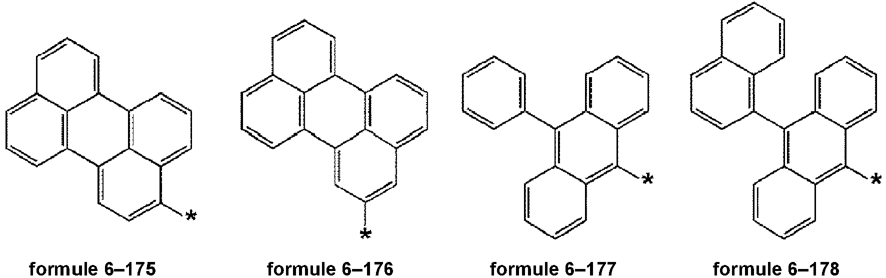 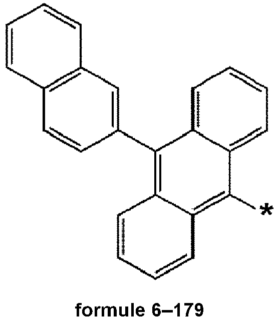
où, dans les formules 6-1 à 6-179, Ph indique un groupe phényle, et * indique un site de liaison à un atome voisin.

8. Dispositif électroluminescent organique selon l'une quelconque des revendications précédentes, dans lequel :
(a) X₁ est choisi parmi C(R₂₁)(R₂₂) et Si (R₂₁)(R₂₂), où chacun de R₂₁ et R₂₂ est indépendamment choisi dans l'ensemble constitué par :
un groupe alkyle en C₁ à C₁₀, un groupe phényle, un groupe biphényle, un groupe terphényle, un groupe naphtyle, et un groupe anthracényle ; et
un groupe phényle, un groupe biphényle, un groupe terphényle, un groupe naphtyle, et un groupe anthracényle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en Ci à C₂₀, un groupe alkoxy en C₁ à C₂₀, un groupe phényle, un groupe biphényle, un groupe terphényle, un groupe naphtyle, et un groupe anthracényle,
où R₂₁ et R₂₂ sont éventuellement liés par l'intermédiaire d'une liaison simple ; ou sont éventuellement liés par l'intermédiaire d'un groupe alkylène en C₁ à C₃ substitué par au moins l'un choisi parmi un groupe alkyle en C₁ à C₁₀, un groupe alkoxy en C₁ à C₁₀, un groupe phényle, un groupe biphényle, un groupe terphényle, et un groupe naphtyle ; et/ou
(b) chacun de R₅ à R₁₂ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe naphtyle, et -Si(Q₁)(Q₂)(Q₃) ;
où chacun de Q₁ à Q₃ est indépendamment choisi parmi un groupe alkyle en C₁ à C₂₀, un groupe alkoxy en C₁ à C₂₀, un groupe phényle, un groupe biphényle, un groupe terphényle, et un groupe naphtyle ; et/ou
(c) chacun de a1 à a4 est indépendamment choisi parmi 0, 1 et 2.

9. Dispositif électroluminescent organique selon l'une quelconque des revendications précédentes, dans lequel le premier composé représenté par la formule 1 est un composé représenté par au moins l'une choisie parmi les formules 1-1 à 1-10 : 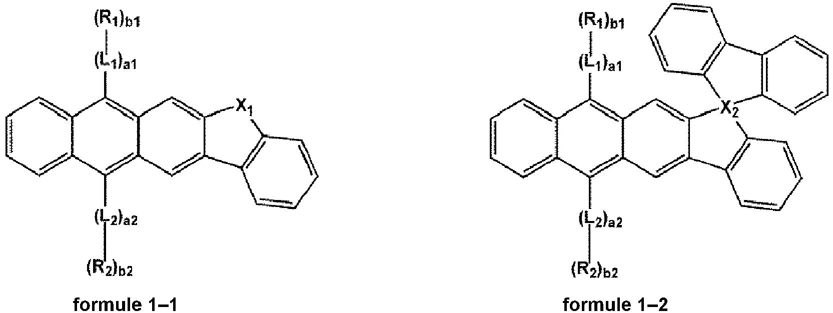 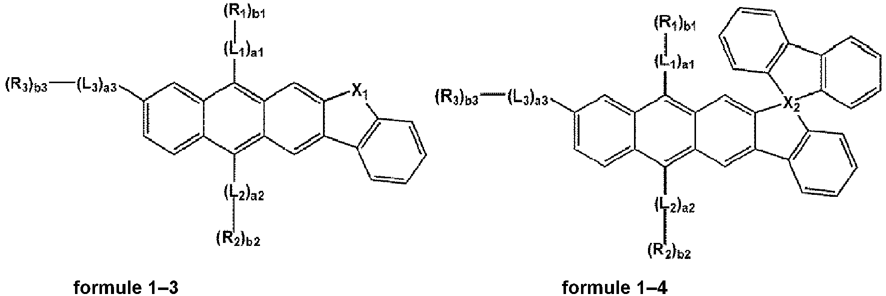 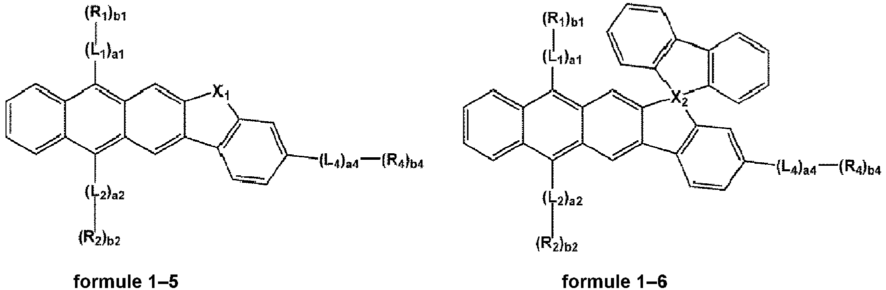 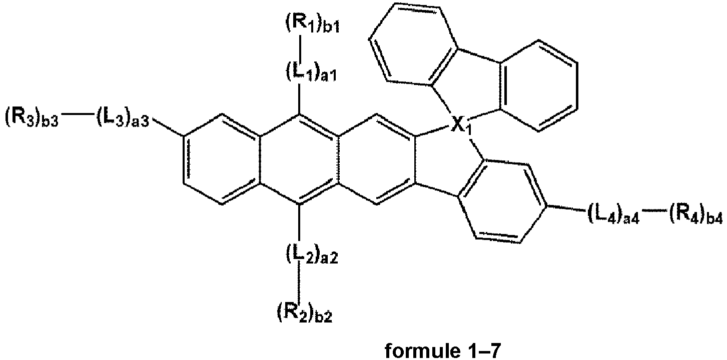 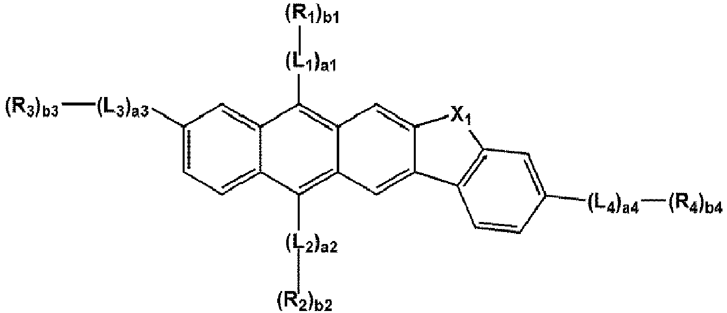 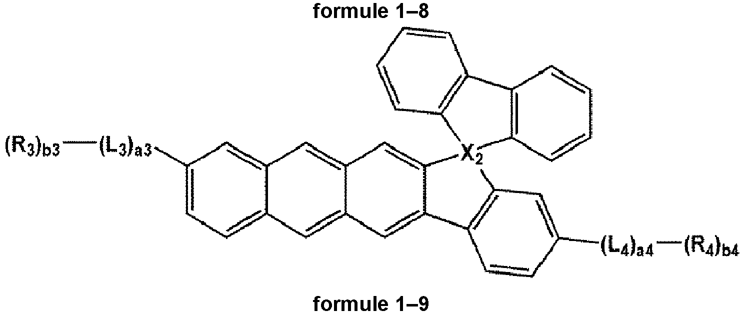 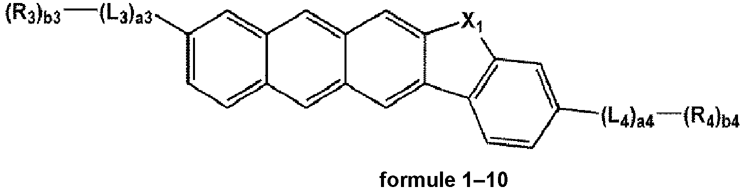 où, dans les formules 1-1 à 1-10,
chacun de X₁, L₁ à L₄, et a1 à a4 est indépendamment tel que défini dans l'une quelconque des revendications 1 à 4,
X₂ est choisi parmi le carbone et le silicium,
chacun de R₁ à R₄ est indépendamment choisi dans l'ensemble constitué par :
un groupe alkyle en C₁ à C₂₀ et un groupe alkoxy en C₁ à C₂₀ ;
un groupe alkyle en C₁ à C₂₀ et un groupe alkoxy en C₁ à C₂₀, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe phényle, un groupe biphényle, et un groupe terphényle ;
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe chrysényle, un groupe pérylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe benzocarbazolyle, un groupe dibenzocarbazolyle, un groupe dibenzosilolyle, un groupe benzonaphtofuranyle, un groupe benzonaphtothiophényle, un groupe dinaphtofuranyle, et un groupe dinaphtothiophényle ; et
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe chrysényle, un groupe pérylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe benzocarbazolyle, un groupe dibenzocarbazolyle, un groupe dibenzosilolyle, un groupe benzonaphtofuranyle, un groupe benzonaphtothiophényle, un groupe dinaphtofuranyle, et un groupe dinaphtothiophényle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe chrysényle, un groupe pérylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe benzocarbazolyle, un groupe dibenzocarbazolyle, un groupe dibenzosilolyle, un groupe benzonaphtofuranyle, un groupe benzonaphtothiophényle, un groupe dinaphtofuranyle, un groupe dinaphtothiophényle, et -Si(Q₃₁)(Q32)(Q₃₃),
où chacun de Q₃₁ à Q₃₃ est indépendamment choisi parmi un groupe alkyle en C₁ à C₁₀, un groupe alkoxy en C₁ à C₁₀, un groupe phényle, un groupe biphényle, un groupe terphényle, et un groupe naphtyle, et
chacun de bl à b4 est indépendamment choisi parmi 1 et 2.

10. Dispositif électroluminescent organique selon la revendication 1, dans lequel le premier composé représenté par la formule 1 est choisi parmi les composés Al à A60, les composés Bl à B48, les composés C1 à C30, les composés D1 à D30, les composés El à E60, et les composés F1 à F48 :

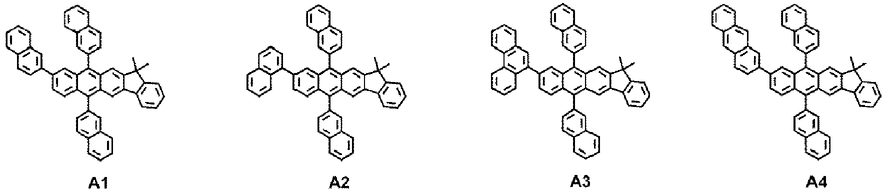

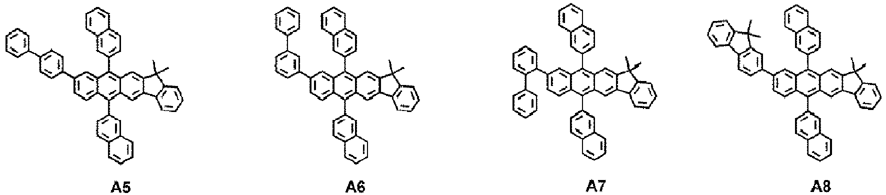

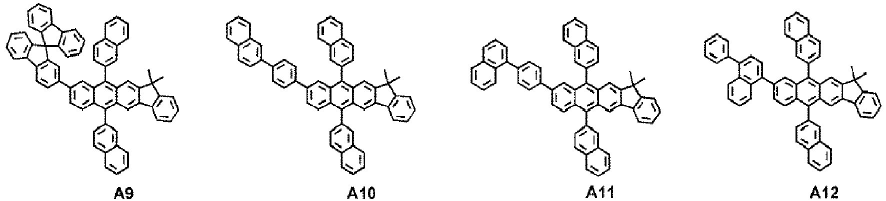

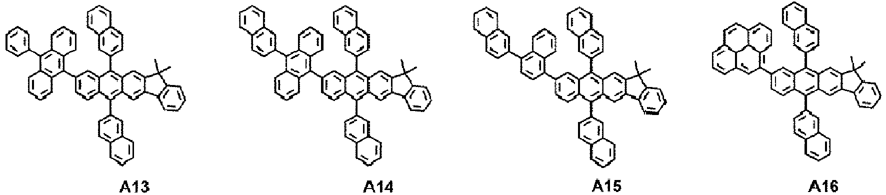

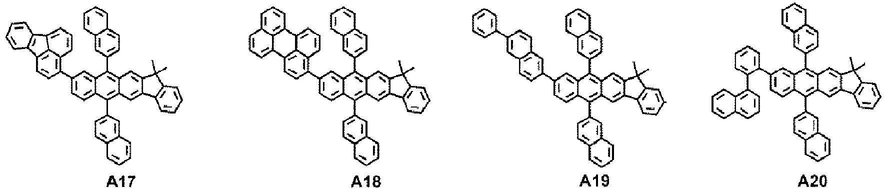

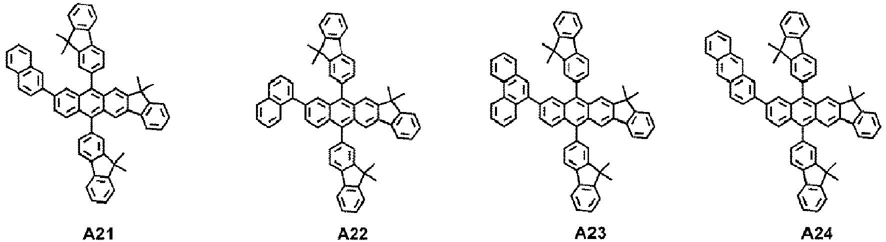

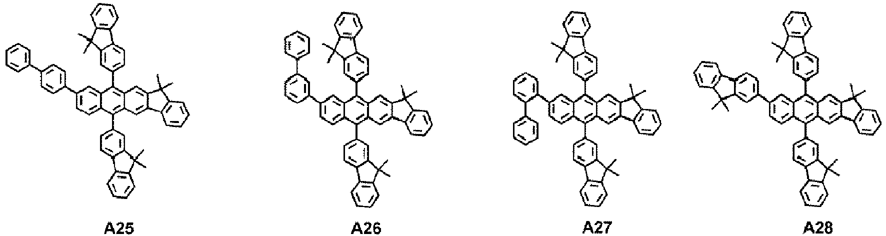

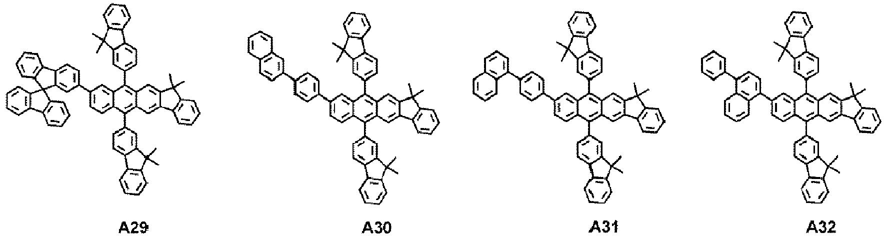

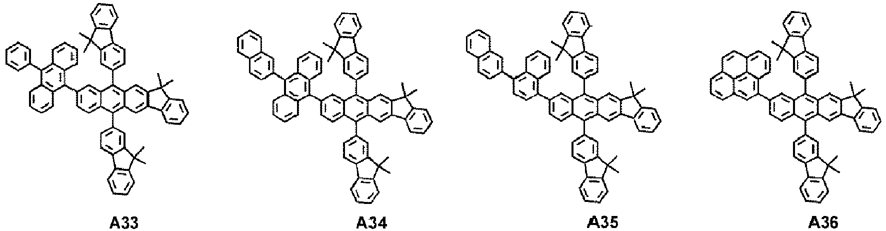

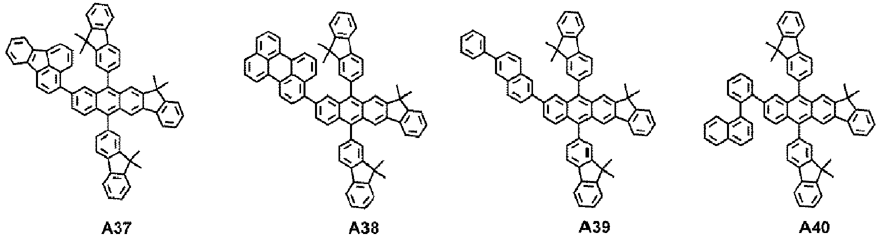

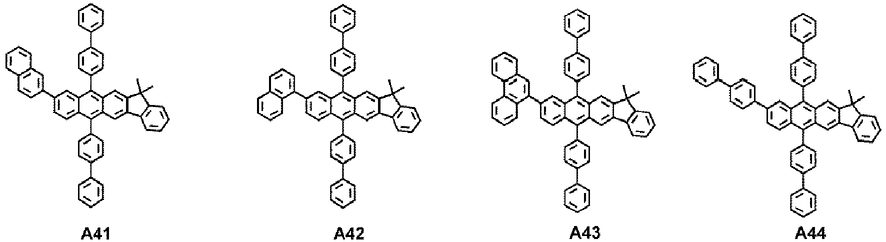

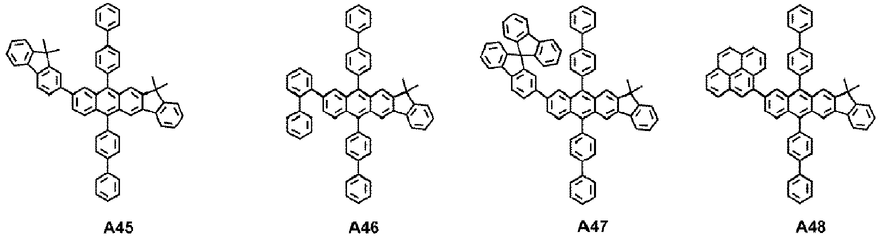

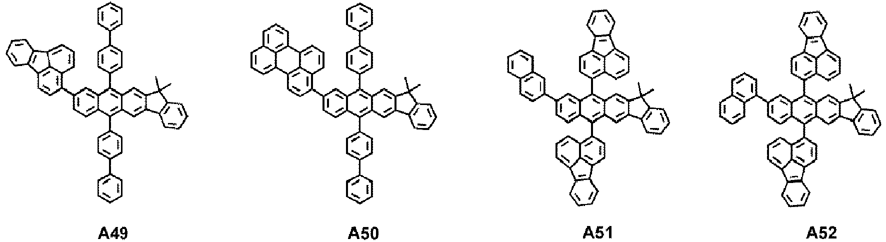

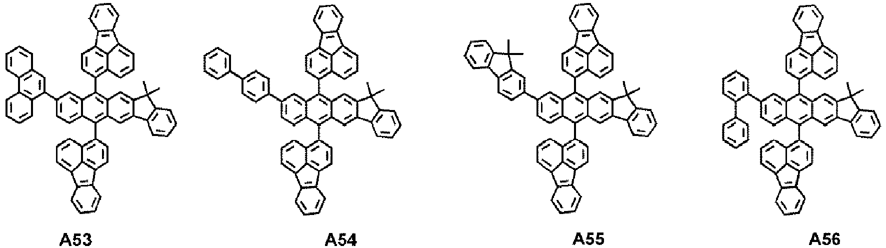

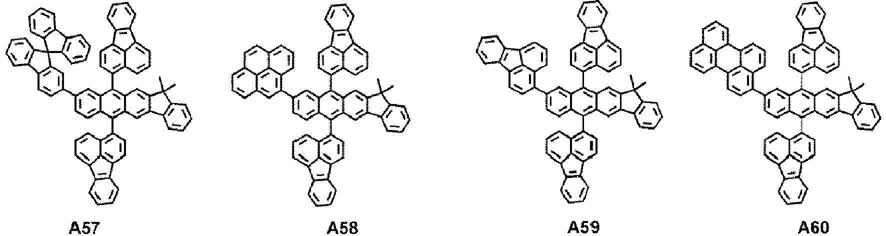

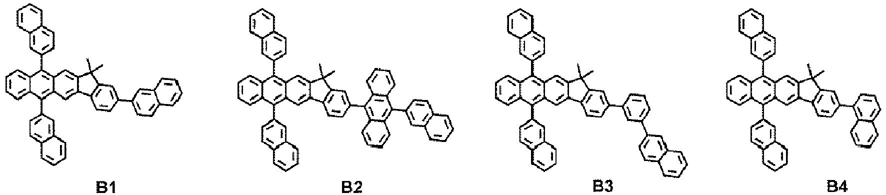

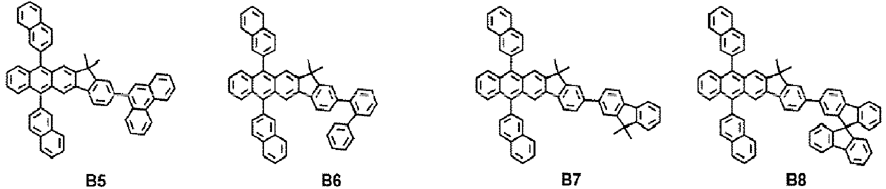

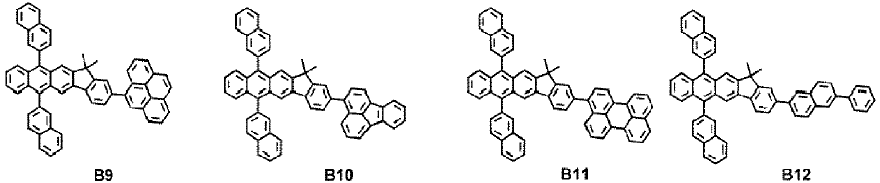

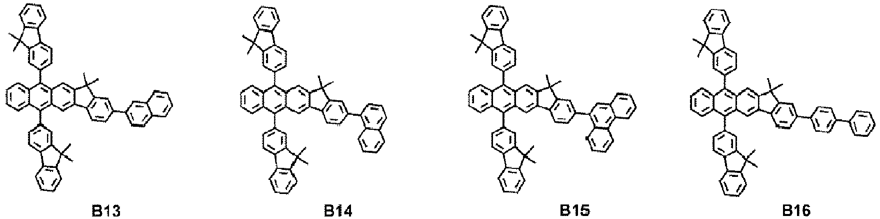

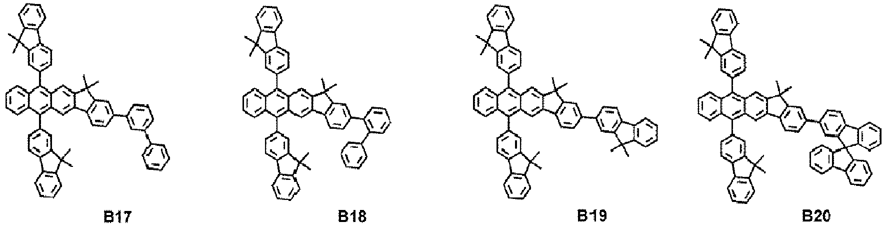

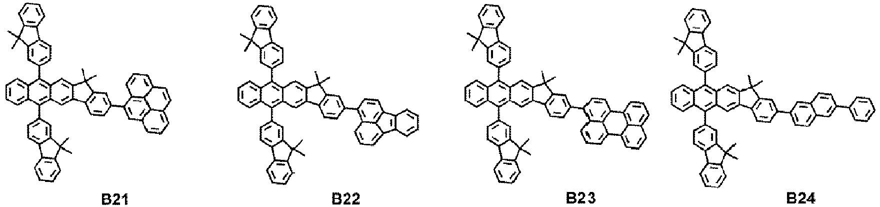

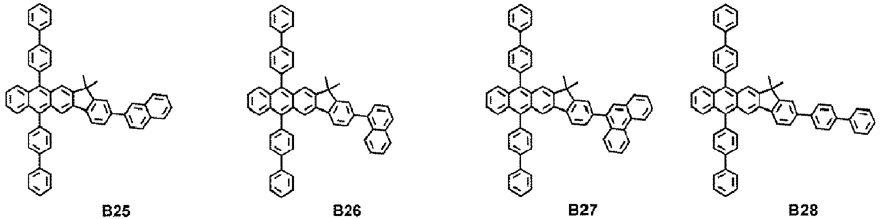

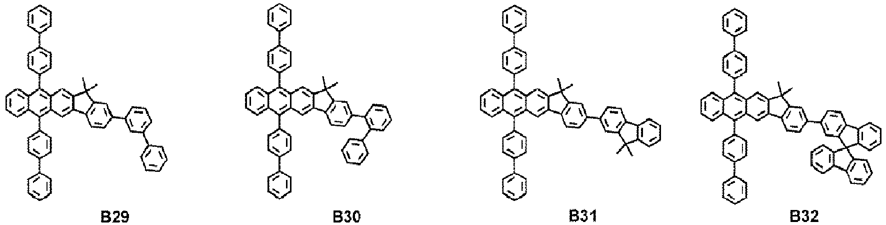

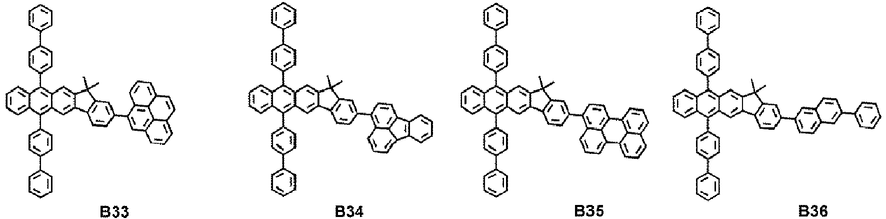

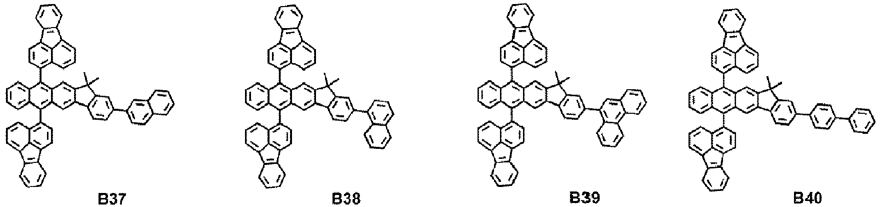

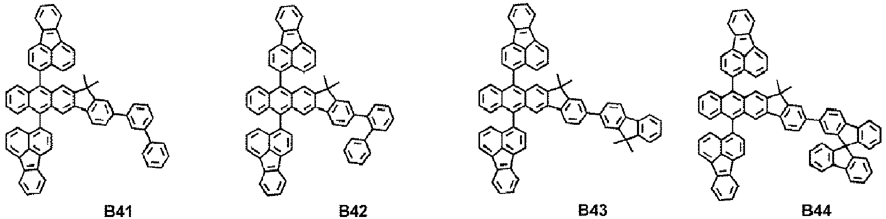

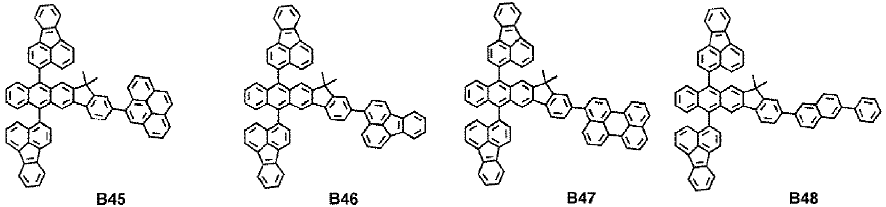

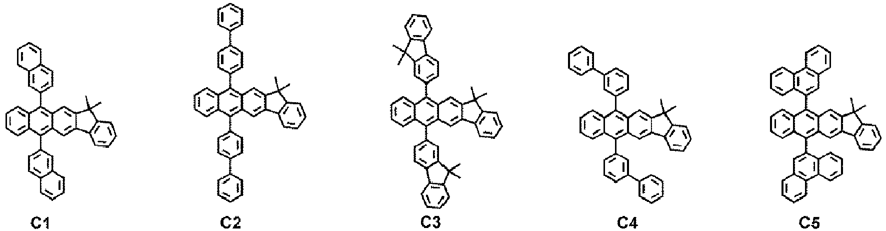

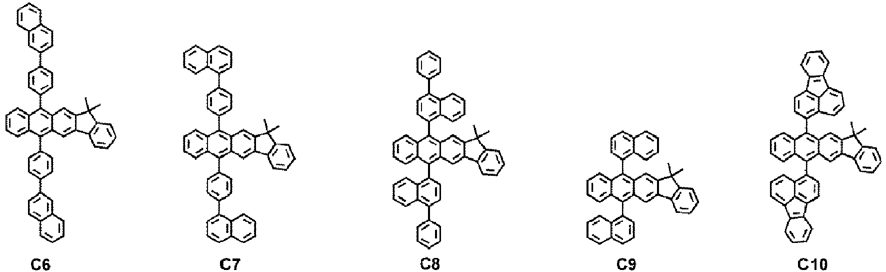

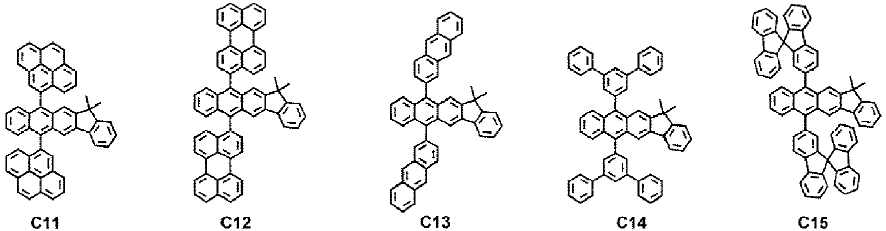

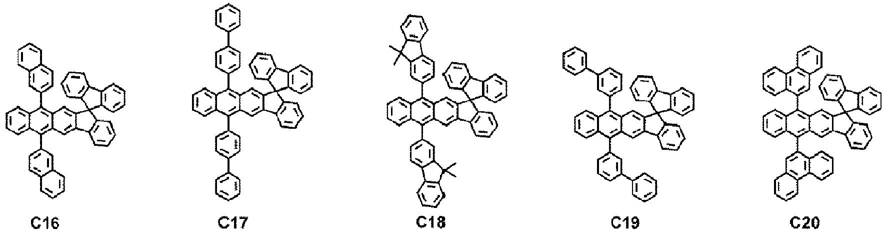

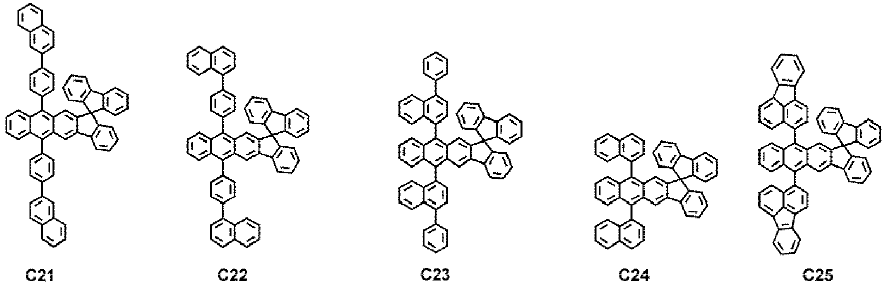

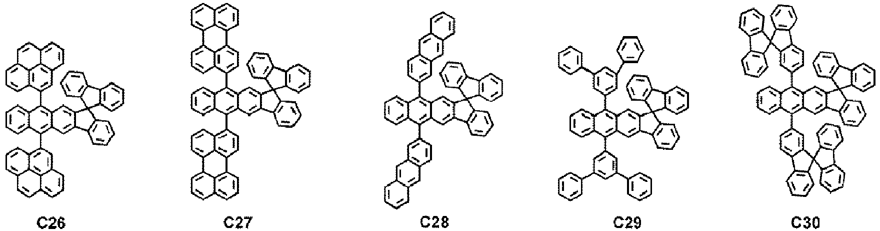

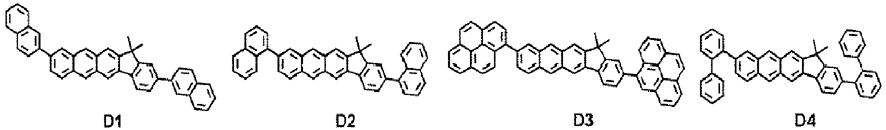

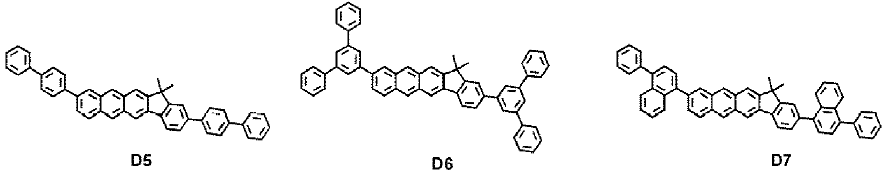

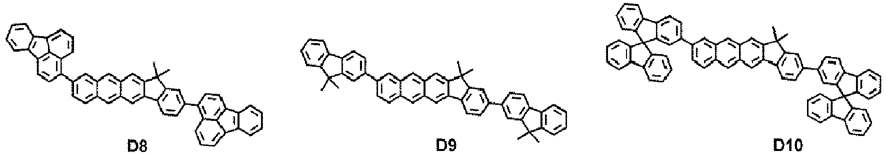

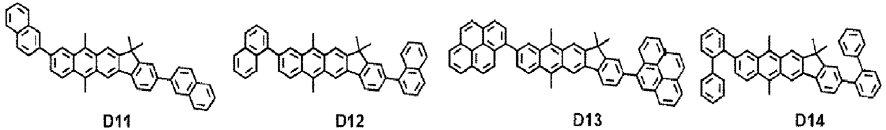

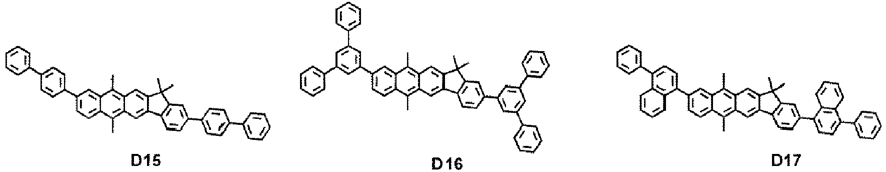

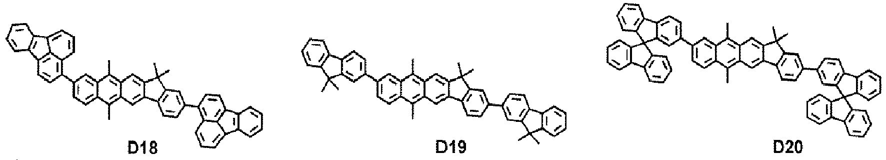

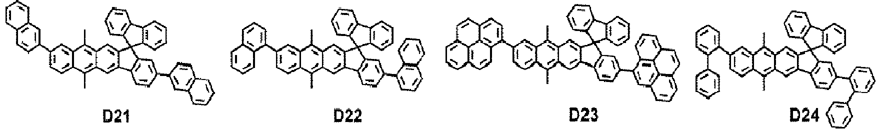

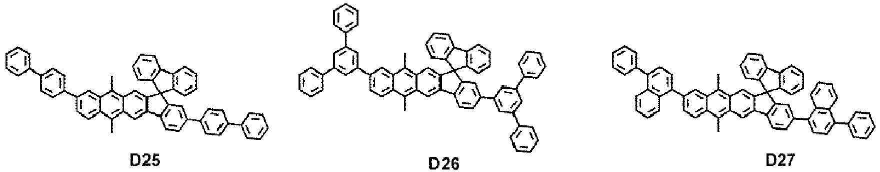

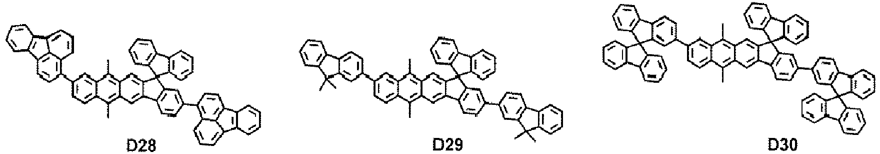

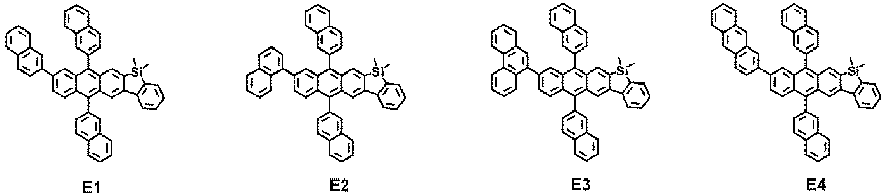

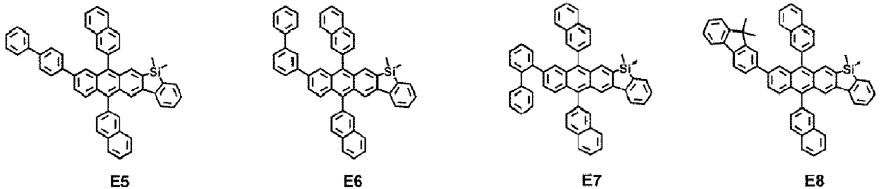

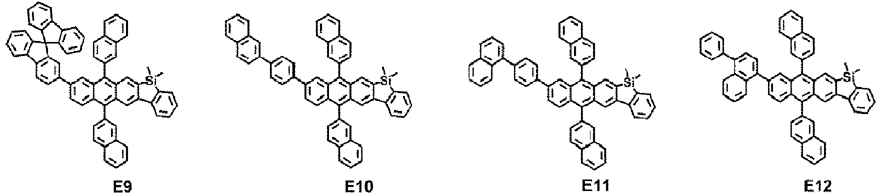

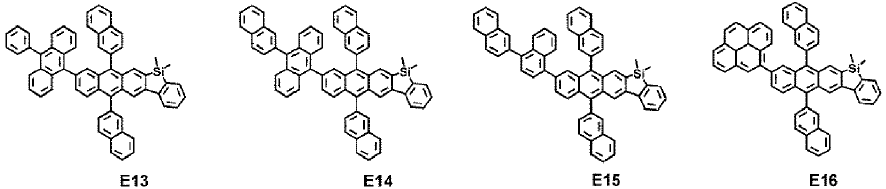

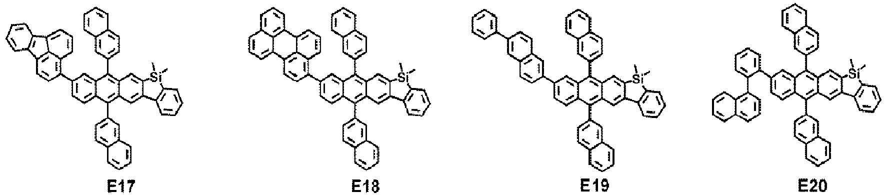

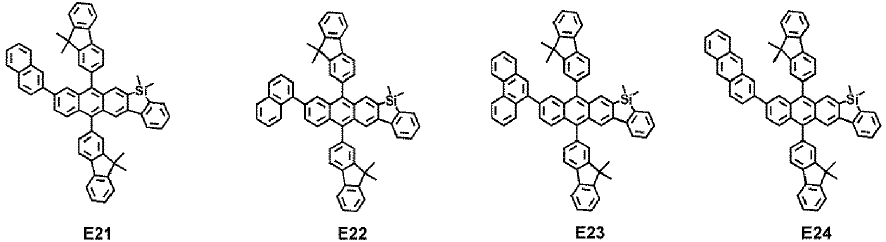

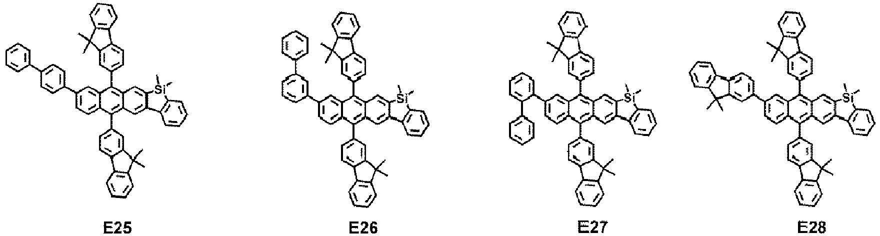

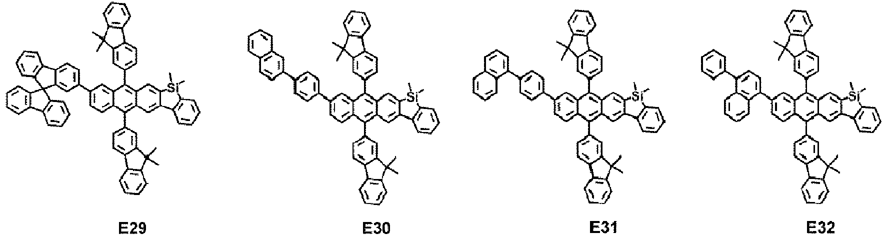

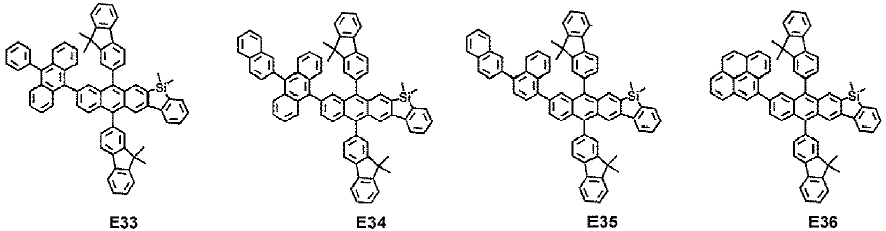

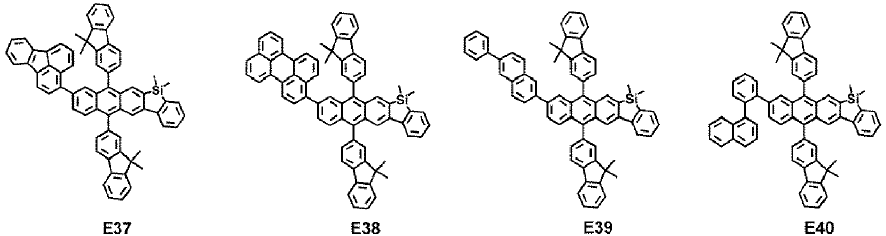

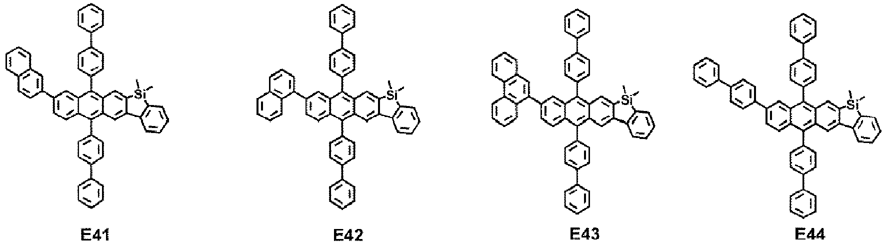

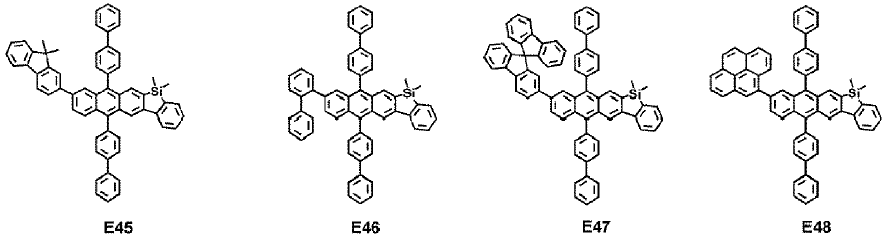

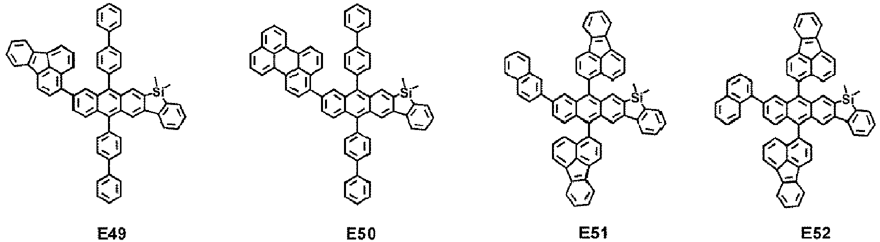

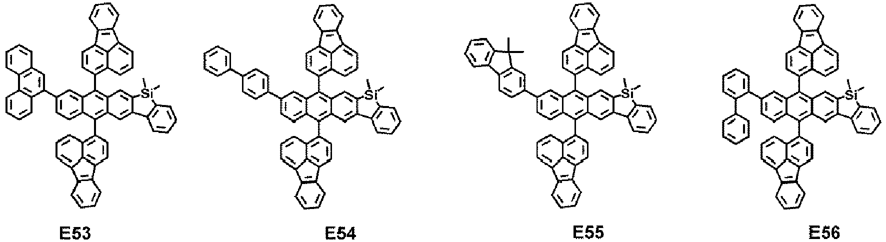

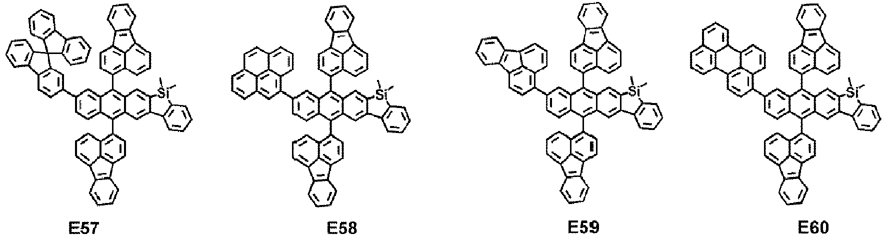

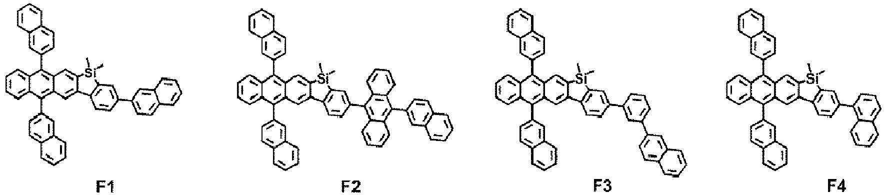

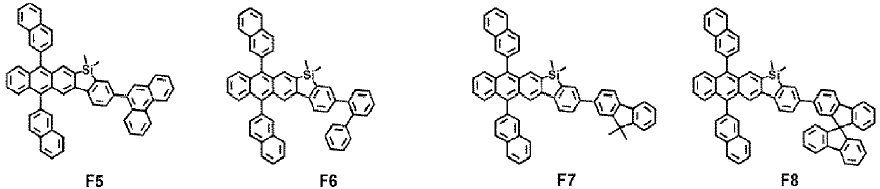

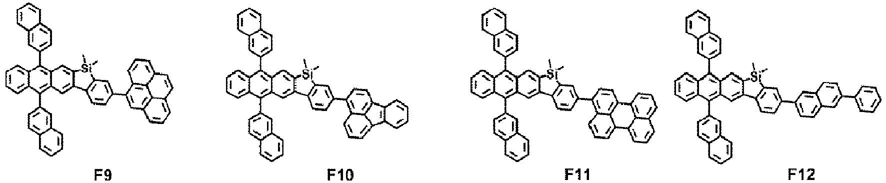

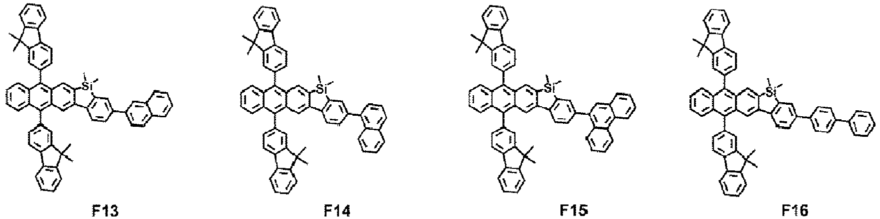

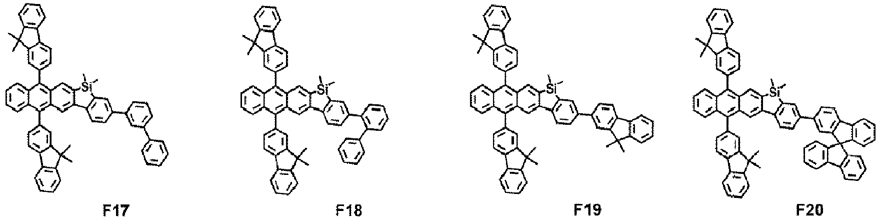

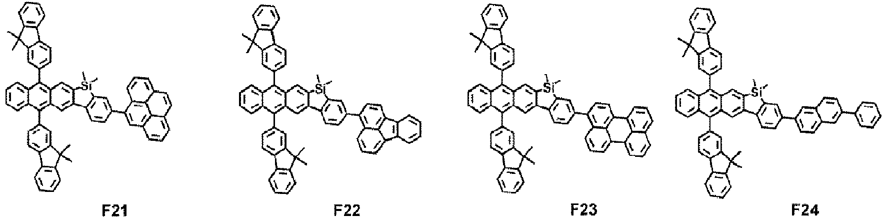

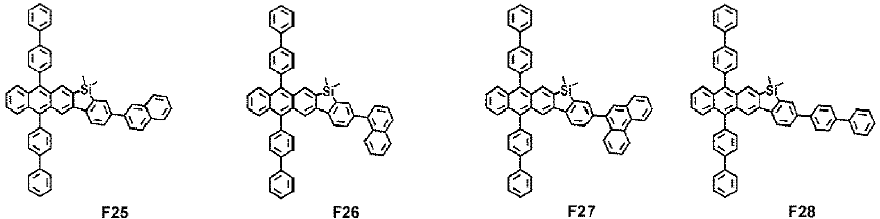

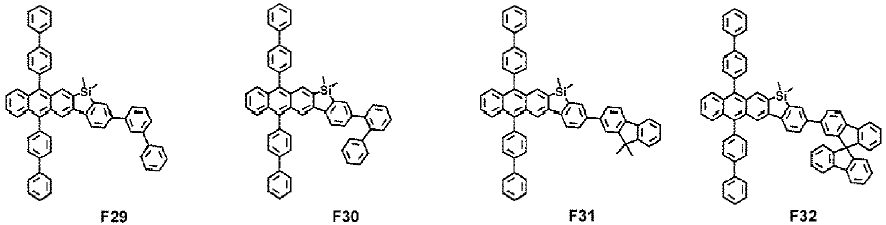

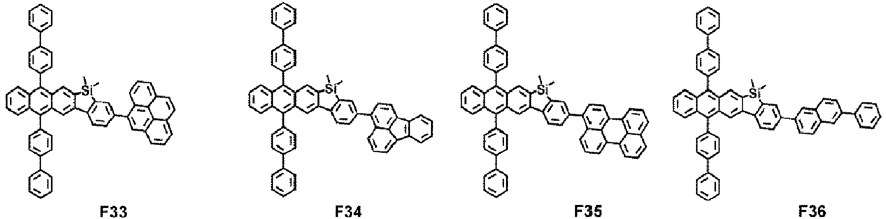

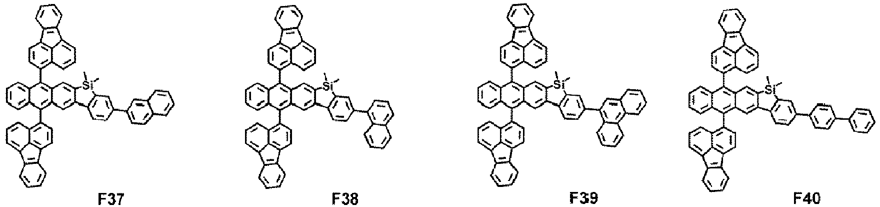

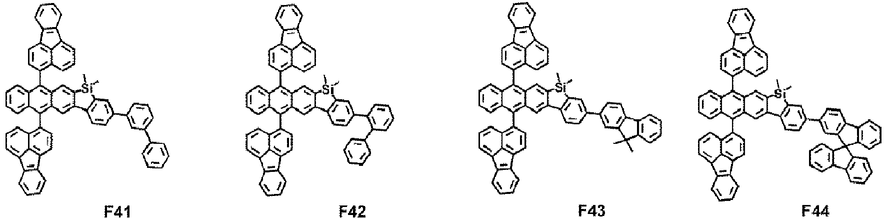

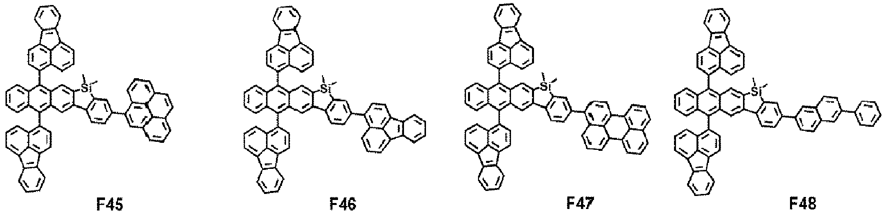

11. Dispositif électroluminescent organique selon l'une quelconque des revendications précédentes, où le dispositif électroluminescent organique comprend la première couche auxiliaire et la deuxième couche auxiliaire,
dans lequel la première couche auxiliaire et la deuxième couche auxiliaire comprennent toutes deux le premier composé représenté par la formule 1,
dans lequel le premier composé représenté par la formule 1 compris dans la première couche auxiliaire est identique au premier composé représenté par la formule 1 compris dans la deuxième couche auxiliaire.

12. Dispositif électroluminescent organique selon l'une quelconque des revendications précédentes, dans lequel la région de transport de trous comprend un deuxième composé représenté par la formule 201 et/ou un troisième composé représenté par la formule 202 : 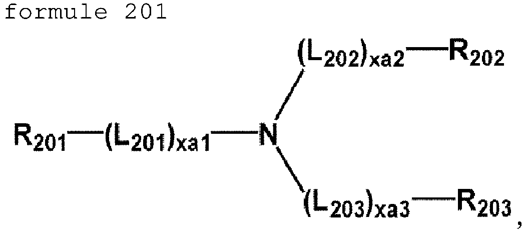 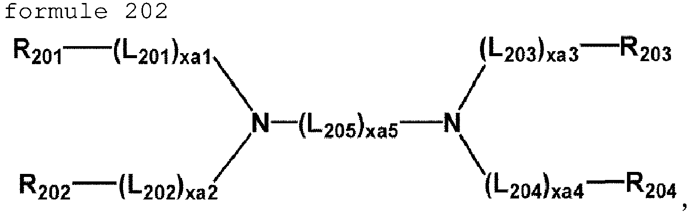 où, dans les formules 201 et 202,
chacun de L₂₀₁ à L₂₀₅ est indépendamment choisi dans l'ensemble constitué par :
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe pyrénylène, un groupe chrysénylène, un groupe pyridinylène, un groupe pyrazinylène, un groupe pyrimidinylène, un groupe pyridazinylène, un groupe quinolinylène, un groupe isoquinolinylène, un groupe quinoxalinylène, un groupe quinazolinylène, un groupe carbazolylène, et un groupe triazinylène ; et
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe pyrénylène, un groupe chrysénylène, un groupe pyridinylène, un groupe pyrazinylène, un groupe pyrimidinylène, un groupe pyridazinylène, un groupe quinolinylène, un groupe isoquinolinylène, un groupe quinoxalinylène, un groupe quinazolinylène, un groupe carbazolylène, et un groupe triazinylène, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe isoindolyle, un groupe quinolinyle, un groupe isoquinolinyle, un groupe quinoxalinyle, un groupe quinazolinyle, un groupe carbazolyle, et un groupe triazinyle,
chacun de xa1 à xa4 est indépendamment choisi parmi 0, 1 et 2,
xa5 est choisi parmi 1, 2 et 3,
chacun de R₂₀₁ à R₂₀₄ est indépendamment choisi dans l'ensemble constitué par :
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle ; et
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe naphtyle, un groupe azulényle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle.

13. Dispositif électroluminescent organique selon l'une quelconque des revendications précédentes, dans lequel
(a) au moins l'une choisie parmi la première couche auxiliaire et la deuxième couche auxiliaire comprend en outre un composé à base d'amine ; et/ou
(b) le dispositif électroluminescent organique comprend la première couche auxiliaire et la deuxième couche auxiliaire, chacune parmi la première couche auxiliaire et la deuxième couche auxiliaire comprend indépendamment le premier composé représenté par la formule 1, et chacune parmi la première couche auxiliaire et la deuxième couche auxiliaire comprend indépendamment un deuxième composé représenté par la formule 201 et/ou un troisième composé représenté par la formule 202 : 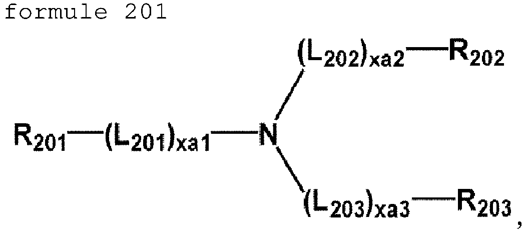 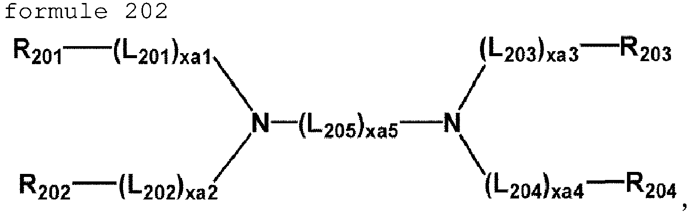
où, dans les formules 201 et 202,
chacun de L₂₀₁ à L₂₀₅ est indépendamment choisi dans l'ensemble constitué par :
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe pyrénylène, un groupe chrysénylène, un groupe pyridinylène, un groupe pyrazinylène, un groupe pyrimidinylène, un groupe pyridazinylène, un groupe quinolinylène, un groupe isoquinolinylène, un groupe quinoxalinylène, un groupe quinazolinylène, un groupe carbazolylène, et un groupe triazinylène ; et
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe pyrénylène, un groupe chrysénylène, un groupe pyridinylène, un groupe pyrazinylène, un groupe pyrimidinylène, un groupe pyridazinylène, un groupe quinolinylène, un groupe isoquinolinylène, un groupe quinoxalinylène, un groupe quinazolinylène, un groupe carbazolylène, et un groupe triazinylène, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe isoindolyle, un groupe quinolinyle, un groupe isoquinolinyle, un groupe quinoxalinyle, un groupe quinazolinyle, un groupe carbazolyle, et un groupe triazinyle,
chacun de xa1 à xa4 est indépendamment choisi parmi 0, 1 et 2,
xa5 est choisi parmi 1, 2 et 3, et
chacun de R₂₀₁ à R₂₀₄ est indépendamment choisi dans l'ensemble constitué par :
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle ; et
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe naphtyle, un groupe azulényle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, et un groupe triazinyle.

14. Dispositif électroluminescent organique selon l'une quelconque des revendications précédentes, dans lequel :
le premier jeu d'électrodes est un jeu d'électrodes réfléchissantes,
la deuxième électrode est une électrode semi-émissive, et
le dispositif électroluminescent organique satisfait aux équations 1 à 3 : $\frac{{λ}_{1}}{2 {n}_{1}} ⋅ {m}_{1} - \frac{{λ}_{1}}{10} \leq {D}_{11} \leq \frac{{λ}_{1}}{2 {n}_{1}} ⋅ {m}_{1} + \frac{{λ}_{1}}{10} ,$ $\frac{{λ}_{2}}{2 {n}_{2}} ⋅ {m}_{2} - \frac{{λ}_{2}}{10} \leq {D}_{12} \leq \frac{{λ}_{2}}{2 {n}_{2}} ⋅ {m}_{2} + \frac{{λ}_{2}}{10} ,$ $\frac{{λ}_{3}}{2 {n}_{3}} ⋅ {m}_{3} - \frac{{λ}_{3}}{10} \leq {D}_{13} \leq \frac{{λ}_{3}}{2 {n}_{3}} ⋅ {m}_{3} + \frac{{λ}_{3}}{10} ,$
où, dans les équations 1 à 3,
D₁₁ indique la distance entre l'électrode sur le premier sous-pixel et la deuxième électrode,
D₁₂ indique la distance entre l'électrode sur le deuxième sous-pixel et la deuxième électrode,
D₁₃ indique la distance entre l'électrode sur le troisième sous-pixel et la deuxième électrode,
λ₁, λ₂ et λ₃, respectivement et indépendamment, indiquent la longueur d'onde de la première lumière de couleur, la longueur d'onde de la deuxième lumière de couleur, et la longueur d'onde de la troisième lumière de couleur,
n₁ indique l'indice de réfraction de couches entre l'électrode sur le premier sous-pixel et la deuxième électrode ;
n₂ indique l'indice de réfraction de couches entre l'électrode sur le deuxième sous-pixel et la deuxième électrode ;
n₃ indique l'indice de réfraction de couches entre l'électrode sur le troisième sous-pixel et la deuxième électrode ; et
chacun de m₁, m₂ et m₃ est indépendamment un entier naturel.

15. Dispositif électroluminescent organique selon l'une quelconque des revendications précédentes, dans lequel l'épaisseur de la première couche auxiliaire est supérieure à celle de la deuxième couche auxiliaire.
